# EUROPEAN PATENT APPLICATION

(11) **EP 2 897 184 A1**
(43) Date of publication of application: **22.07.2015**
(21) Application number: 13836272.8
(22) Date of filing: 11.09.2013
(51) Int. Cl.: H01L 51/50, C07F 5/02, C07F 7/22, C07F 9/6584, C09K 11/06, G09F 9/30, H01L 27/32

(54) **MATERIAL FOR ORGANIC ELECTROLUMINESCENT ELEMENTS, ORGANIC ELECTROLUMINESCENT ELEMENT, DISPLAY DEVICE, AND LIGHTING DEVICE**

(30) Priority: 11.09.2012 JP 2012199232; 03.07.2013 JP 2013140007
(71) Applicant: JNC Corporation, Chiyoda-ku Tokyo 100-8105 (JP); Kyoto University, Sakyo-ku Kyoto-shi Kyoto 606-8501 (JP)
(72) Inventor: ONO Yohei, Ichihara-shi, Chiba 290-8551 (JP); SHIREN Kazushi, Ichihara-shi, Chiba 290-8551 (JP); IKUTA Toshiaki, Ichihara-shi, Chiba 290-8551 (JP); NI Jingping, Ichihara-shi, Chiba 290-8551 (JP); MATSUSHITA Takeshi, Ichihara-shi, Chiba 290-8551 (JP); HATAKEYAMA Takuji, Uji-shi, Kyoto 611-0011 (JP); NAKAMURA Masaharu, Uji-shi, Kyoto 611-0011 (JP); HASHIMOTO Siguma, Uji-shi, Kyoto 611-0011 (JP)
(74) Representative: Hoffmann Eitle
(86) International application number: PCT/JP2013/074561
(87) International publication number: WO 2014/042197

(57) **Abstract**

Provided is an organic electroluminescent element which has improved driving voltage and improved current efficiency. An organic electroluminescent element having the above-mentioned improved characteristics is provided by using, as a material for organic electroluminescent elements, a polycyclic aromatic compound in which a nitrogen atom and another heteroatom or a metal atom (X) are adjacent to each other in a non-aromatic ring.

## Description

### Technical Field

The present invention relates to an organic electroluminescent element, a display device and a lighting device, which use a polycyclic aromatic compound.

### Background Art

Conventionally, various display devices using luminescent elements that emit light by electroluminescence have been studied since they can save electrical power and can be made thinner, and organic electroluminescent elements formed of organic materials have been actively considered since weight saving and increasing in size are easy. Especially, the development of organic materials having luminescence properties including blue, which is one of the three primary colors of light, and the development of organic materials having charge transportability for holes, electrons and the like (they have possibilities to be semiconductors or superconductors) have been actively studied until now regardless of polymer compounds or low-molecular-weight compounds.

An organic electroluminescent element has a structure formed of a pair of electrodes formed of an anode and a cathode, and one or plural layer(s) containing an organic compound, which is/are disposed between the pair of electrodes. The layers containing an organic compound include luminescent layers, and charge transport/injection layers that transport or inject electrical charges such as holes and electrons, and as the organic compound, various organic materials have been developed.

As a material for a luminescent layer, for example, benzofluorene compounds and chrysene compounds have been developed (WO 2004/061047 and WO 2008/147721). As a hole transport material, for example, triphenylamine compounds and carbazole compounds have been developed (JP 2001-172232 A, JP 2006-199679 A, JP 2005-268199 A, JP 2007-088433 A, WO 2003/078541 and WO 2003/080760). As an electron transport material, for example, anthracene compounds and compounds having the main skeleton as bianthracene, binaphthalene or a combined body of naphthalene and anthracene have been developed (JP 2005-170911 A, JP 2003-146951 A, JP 08-12600A, JP 2003-123983 A and JP 11-297473 A).

In addition, in recent years, as materials used in organic electronics, pigments, sensors and liquid layer displays, polycyclic aromatic hydrocarbons (PAHs) attract attention, and a synthesis example of a dibenzochrysene compound having a B-N bond moiety has also been reported (J. Am. Chem. Soc., 2011, 133, 18614-18617).

### Citation List

### Patent Literatures

Patent Literature 1: WO 2004/061047
Patent Literature 2: WO 2008/147721
Patent Literature 3: JP 2001-172232 A
Patent Literature 4: JP 2006-199679 A
Patent Literature 5: JP 2005-268199 A
Patent Literature 6: JP 2007-088433 A
Patent Literature 7: WO 2003/078541
Patent Literature 8: WO 2003/080760
Patent Literature 9: JP 2005-170911 A
Patent Literature 10: JP 2003-146951 A
Patent Literature 11: JP 08-12600 A
Patent Literature 12: JP 2003-123983 A
Patent Literature 13: JP 11-297473 A

### Non-Patent Literature

Non-Patent Literature 1: J. Am. Chem. Soc., 2011, 133, 18614-18617

### Summary of Invention

### Technical Problem

As described above, various compounds have been developed as materials used in an organic electroluminescent element, but when a dibenzochrysene compound having a B-N bond moiety as reported in Non-Patent Literature 1 is applied to the element, it has not been known how much performance the compound has yet.

### Solution to Problem

The present inventors intensively studied so as to solve the above-mentioned problems, and consequently found a novel polycyclic aromatic compound in which a nitrogen atom and another heteroatom or a metal atom (X) are adjacent in a non-aromatic ring and succeeded in production of the compound. The present inventors found that an organic electroluminescent element having improved driving voltage and current efficiency can be obtained by constituting an organic electroluminescent element by disposing a layer containing the polycyclic aromatic compound between a pair of electrodes, and completed the present invention. That is, the present invention provides a polycyclic aromatic compound mentioned below or a salt thereof and also a material for an organic electroluminescent element containing a polycyclic aromatic compound mentioned below or a salt thereof.
[1] A material for organic electroluminescent element, containing a polycyclic aromatic compound having a partial structure represented by the following general formula (I) or a salt thereof: 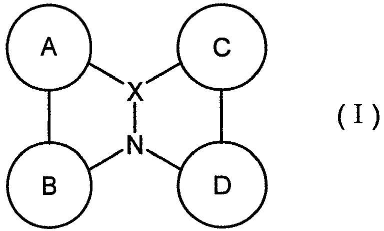 (in the formula (I),
   X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
   ring A, ring B, ring C and ring D are each independently an optionally substituted aromatic ring or an optionally substituted heteroaromatic ring, two adjacent rings may form a ring therebetween together with a connecting group or a single bond, and
   the partial structure represented by the above described formula (I) has at least one hydrogen and at least one hydrogen in the partial structure may be substituted with deuterium.)
[2] The material for organic electroluminescent element according to [1], containing a polycyclic aromatic compound having a partial structure represented by the following general formula (II) or a salt thereof: 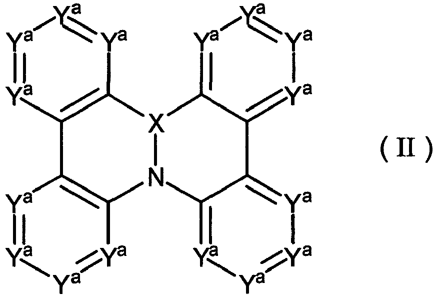 (in the formula (II),
   X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
   Y^{a}s each independently represent C or N; or two adjacent Y^{a}s on the same ring, together with a bond therebetween, may form N, O, S, or Se, rings may be each independently substituted or may form a cyclohexane ring, a benzene ring or a pyridine ring by connecting adjacent substituents in the same ring, or two adjacent rings may form a ring therebetween together with a connecting group or a single bond, and
   the partial structure represented by the above described formula (II) has at least one hydrogen and at least one hydrogen in the partial structure may be substituted with deuterium.)
[3] The material for organic electroluminescent element according to [1], containing a polycyclic aromatic compound having a partial structure represented by the following general formula (III-1) or a salt thereof: 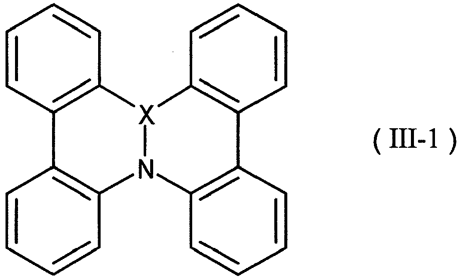 (in the formula (III-1),
   X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
   benzene ring in the formula may be each independently substituted or may form a cyclohexane ring, a benzene ring or a pyridine ring by connecting adjacent substituents in the same ring,
   adjacent two benzene rings in the above formula may form a ring therebetween with a connecting group or a single bond, and
   the partial structure represented by the above described formula (III-1) has at least one hydrogen and at least one hydrogen in the partial structure may be substituted with deuterium.)
[4] The material for organic electroluminescent element according to [1], containing a polycyclic aromatic compound having a partial structure represented by any of the following general formulae (III-11) to (111-13) and general formulae (111-33) to (111-36) or a salt thereof: 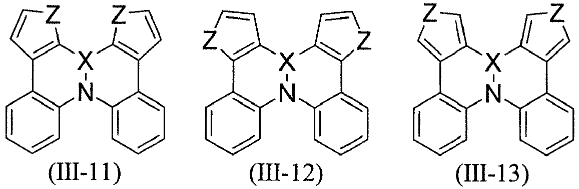 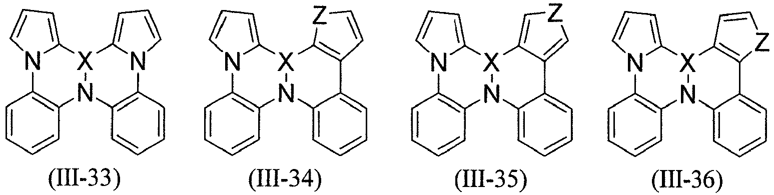 (in the above described each formula,
   X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
   Z represents N, O, S or Se,
   a benzene ring and a five-membered ring in the above described each formula may be each independently substituted or may form a cyclohexane ring, a benzene ring or a pyridine ring by connecting adjacent substituents in the same ring,
   adjacent two benzene rings in the above described each formula may form a ring therebetween with a connecting group or a single bond, and
   the partial structure represented by the above described each formula has at least one hydrogen and at least one hydrogen in the partial structure may be substituted with deuterium.)
[5] The material for organic electroluminescent element according to [1], containing a polycyclic aromatic compound having a partial structure represented by any of the following general formula (III-33) and general formulae (III-55) to (III-57) or a salt thereof: 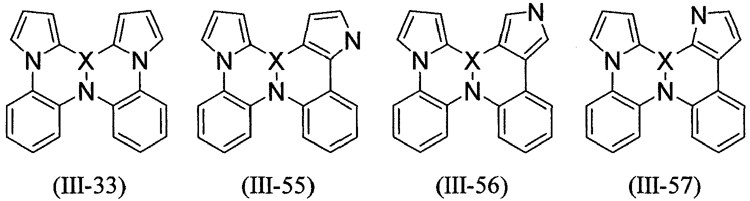 (in the above described each formula,
   X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
   a benzene ring and five-membered ring in the above described each formula may be each independently substituted or may form a cyclohexane ring, a benzene ring or a pyridine ring by connecting adjacent substituents in the same ring,
   adjacent two benzene rings in the above described each formula may form a ring therebetween with a connecting group or a single bond, and
   the partial structure represented by the above described each formula has at least one hydrogen and at least one hydrogen in the partial structure may be substituted with deuterium.)
[6] The material for organic electroluminescent element according to [1], containing a polycyclic aromatic compound having a partial structure represented by any of the following general formula (III-32) and general formulae (III-5) to (III-7) or a salt thereof: 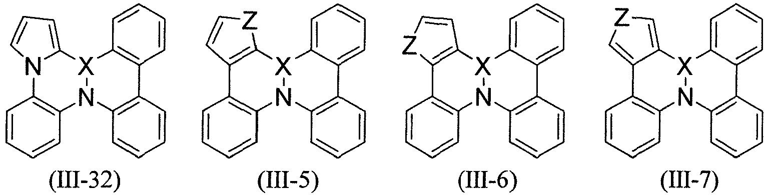 (in the above described each formula,
   X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
   Z represents N, O, S or Se,
   a benzene ring and a five-membered ring in the above described each formula may be each independently substituted or may form a cyclohexane ring, a benzene ring or a pyridine ring by connecting adjacent substituents in the same ring,
   adjacent two benzene rings in the above formula may form a ring therebetween with a connecting group or a single bond, and
   the partial structure represented by the above described each formula has at least one hydrogen and at least one hydrogen in the partial structure may be substituted with deuterium.)
[7] The material for organic electroluminescent element according to [1], containing a polycyclic aromatic compound having a partial structure represented by any of the following general formula (III-32) and general formulae (III-58) to (III-60) or a salt thereof: 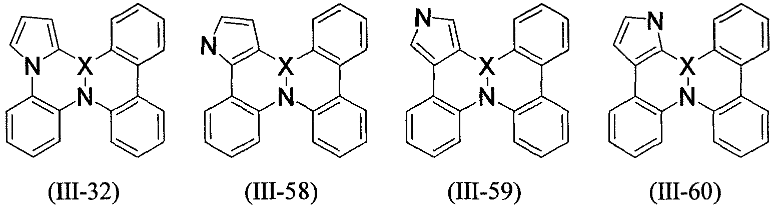 (in the above described each formula,
   X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
   a benzene ring and a five-membered ring in the above described each formula may be each independently substituted or may form a cyclohexane ring, a benzene ring or a pyridine ring by connecting adjacent substituents in the same ring,
   adjacent two benzene rings in the above formula may form a ring therebetween with a connecting group or a single bond, and
   the partial structure represented by the above described each formula has at least one hydrogen and at least one hydrogen in the partial structure may be substituted with deuterium.)
[8] The material for organic electroluminescent element according to [1], containing a polycyclic aromatic compound represented by the following general formula (V-1), general formula (V-3), general formula (V-5), general formula (V-15) or general formula (V-16) or a salt thereof: 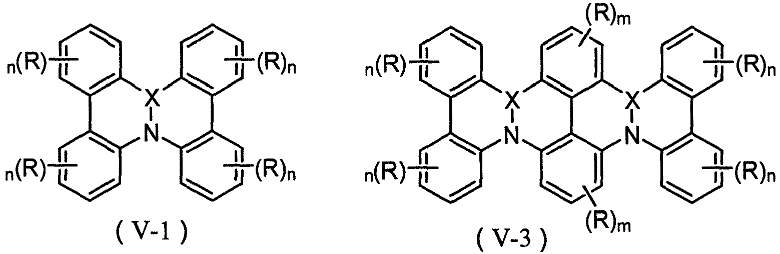 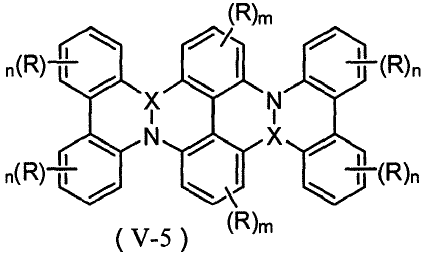 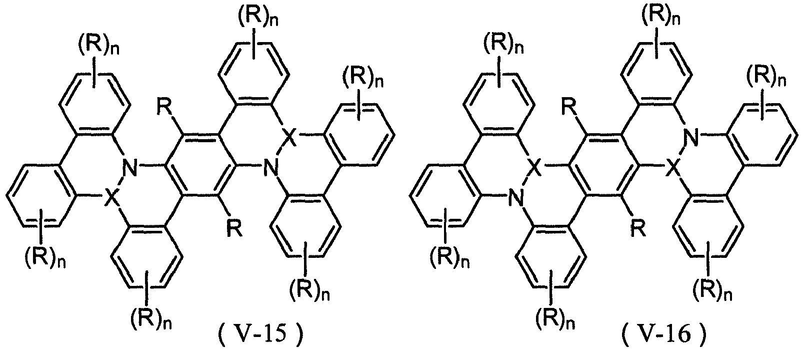 (in the above described each formula,
   X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
   R represents hydrogen, fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein, R^{a} each independently represents optionally substituted alkyl, optionally substituted aryl or optionally substituted heteroaryl),
   adjacent two Rs in the same ring may be combined and form a cyclohexane ring, a benzene ring or a pyridine ring,
   adjacent two benzene rings in the above described each formula may form a ring therebetween by connecting with a single bond, a bond with CH₂, CHR^{a}, C(R^{a})₂, NR^{a}, Si(R^{a})₂, BR^{a} (wherein R^{a} is as defined above), Se, S or O,
   n represents an integer of 0 to 4, m represents an integer of 0 to 3, and
   at least one hydrogen in the compound represented by the above described each formula or a salt thereof may be substituted with deuterium.)
[9] The material for organic electroluminescent element according to [1], containing a polycyclic aromatic compound represented by the following general formulae (V-27) to (V-30) or a salt thereof: 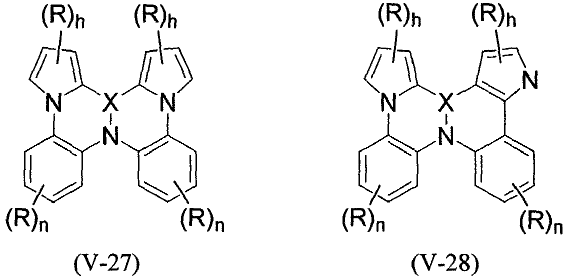 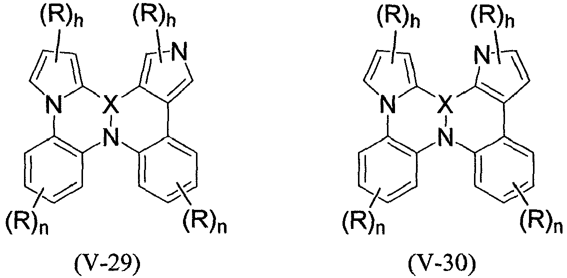 (in the above described each formula,
   X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
   R represents hydrogen, fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein R^{a} each independently represents optionally substituted alkyl, optionally substituted aryl or optionally substituted heteroaryl),
   adjacent two Rs in the same ring may be combined and form a cyclohexane ring, a benzene ring or a pyridine ring,
   adjacent two benzene rings in the above described each formula may form a ring therebetween by connecting with a single bond, a bond with CH₂, CHR^{a}, C(R^{a})₂, NR^{a}, Si(R^{a})₂, BR^{a} (wherein R^{a} is as defined above), Se, S or O,
   n represents an integer of 0 to 4, h represents an integer of 0 to 3, and
   at least one hydrogen in the compound represented by the above described each formula or a salt thereof may be substituted with deuterium.)
[10] The material for organic electroluminescent element according to [1], containing a polycyclic aromatic compound represented by the following general formulae (V-31) to (V-34) or a salt thereof: 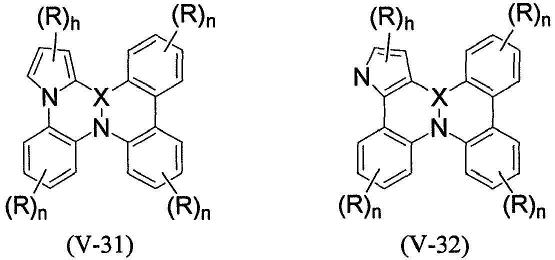 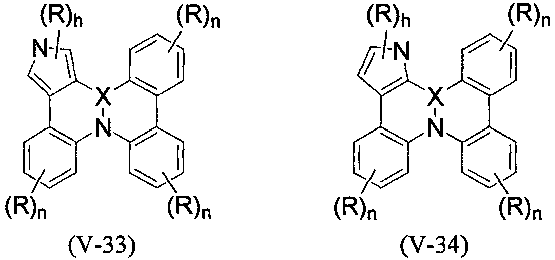 (in the above described each formula,
   X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
   R represents hydrogen, fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein, R^{a} each independently represents optionally substituted alkyl, optionally substituted aryl or optionally substituted heteroaryl),
   adjacent two Rs in the same ring may be combined and form a cyclohexane ring, a benzene ring or a pyridine ring,
   adjacent two benzene rings in each formula described above may form a ring therebetween by connecting with a single bond, a bond with CH₂, CHR^{a}, C(R^{a})₂, NR^{a}, Si(R^{a})₂, BR^{a} (wherein R^{a} is as defined above), Se, S or O,
   n represents an integer of 0 to 4, h represents an integer of 0 to 3, and
   at least one hydrogen in the compound represented by the above described each formula and a salt thereof may be substituted with deuterium.)
[11] The material for organic electroluminescent element according to [1], containing a polycyclic aromatic compound represented by the following general formulae (V-1') to (V-3') or a salt thereof: 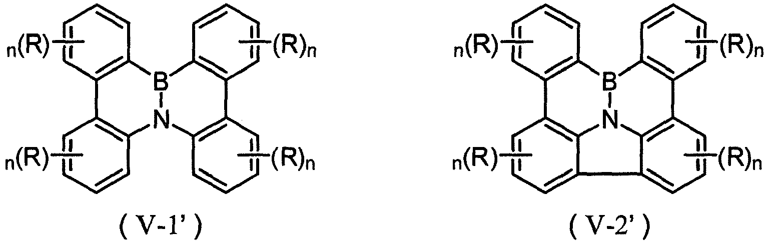 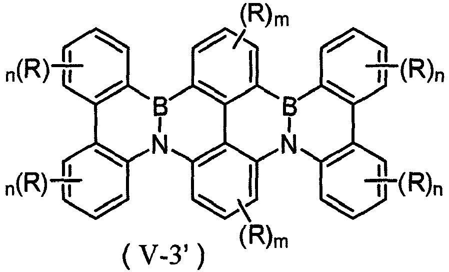 (in the above described each formula,
   R represents fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein R^{a} each independently represents optionally substituted alkyl, optionally substituted aryl or optionally substituted heteroaryl),
   adjacent two Rs in the same ring may be combined and form a cyclohexane ring, a benzene ring or a pyridine ring,
   n represents an integer of 0 to 4, m represents an integer of 0 to 3, and
   at least one hydrogen in the compound represented by the above described each formula and a salt thereof may be substituted with deuterium.)
[12] The material for organic electroluminescent element according to [1], containing a polycyclic aromatic compound represented by the following general formula (V-27') or a salt thereof: 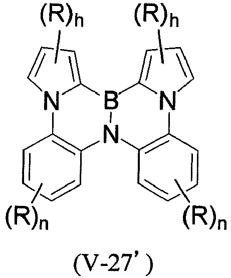 (in the above described formula,
   R represents fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein R^{a} each independently represents optionally substituted alkyl, optionally substituted aryl or optionally substituted heteroaryl),
   adjacent two Rs in the same ring may be combined and form a cyclohexane ring, a benzene ring or a pyridine ring,
   n represents an integer of 0 to 4, h represents an integer of 0 to 3, and
   at least one hydrogen in the compound represented by the above described formula and a salt thereof may be substituted with deuterium.)
[13] The material for organic electroluminescent element according to [1], containing a polycyclic aromatic compound represented by the following general formula (V-32') or a salt thereof: 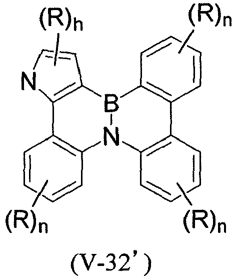 (in the above described formula,
   R represents fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein R^{a} each independently represents optionally substituted alkyl, optionally substituted aryl or optionally substituted heteroaryl),
   adjacent two Rs in the same ring may be combined and form a cyclohexane ring, a benzene ring or a pyridine ring,
   n represents an integer of 0 to 4, h represents an integer of 0 to 3, and
   at least one hydrogen in the compound represented by the above described formula and a salt thereof may be substituted with deuterium.)
[14] The material for organic electroluminescent element according to [1], containing a polycyclic aromatic compound represented by the following general formula (1), (66), (197), (198) or (251) or a salt thereof: 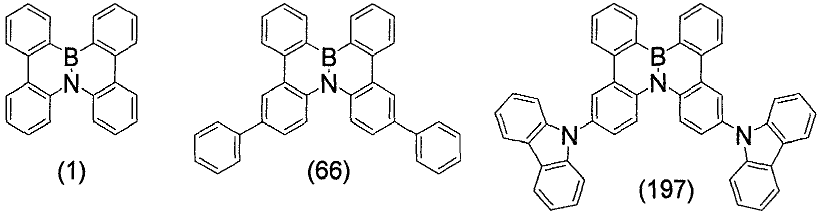 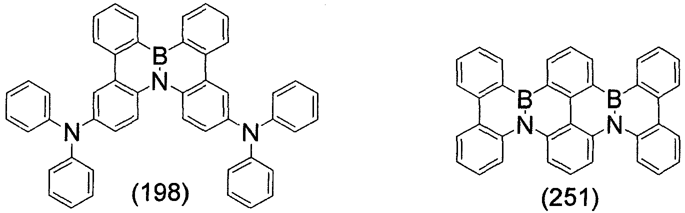
[15] The material for organic electroluminescent element according to [1], containing a polycyclic aromatic compound represented by the following general formula (301), (391), (392), (501), (551) or (687) or a salt thereof: 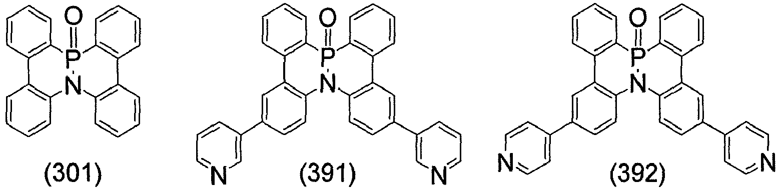 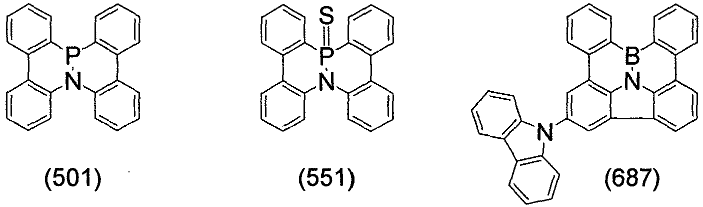
[16] The material for organic electroluminescent element according to [1], containing a polycyclic aromatic compound represented by the following general formula (26), (48), (51), (84), (86), (209), (210), (212), (214), (215), (366) or (424) or a salt thereof: 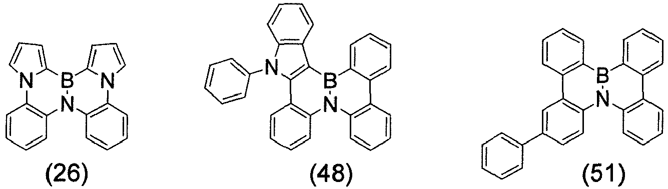 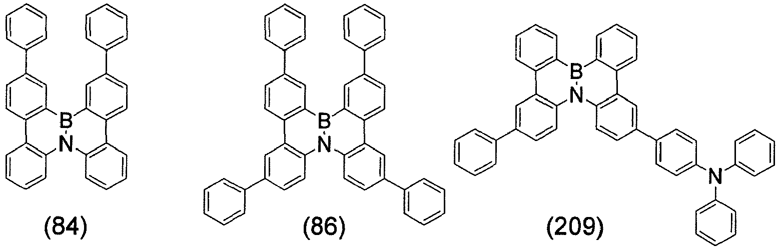 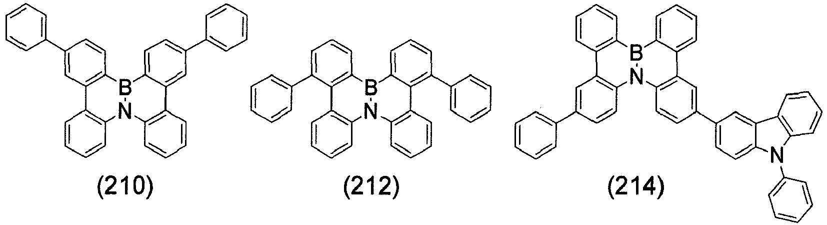 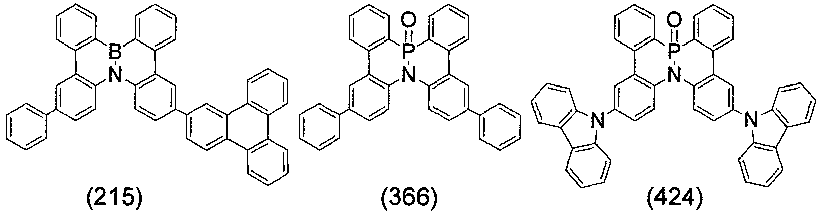
[17] The material for organic electroluminescent element according to any of [1] to [16], which is a material for a luminescent layer.
[18] The material for organic electroluminescent element according to any of [1] to [16], which is a material for a hole injection layer or a hole transport layer.
[19] The material for organic electroluminescent element according to any of [1] to [16], which is a material for a hole inhibition layer or an electron transport layer.
[20] An organic electroluminescent element having a pair of electrodes constituted with the anode and the cathode and a luminescent layer that is disposed between a pair of the electrodes and contains the material for a luminescent layer according to [17].
[21] An organic electroluminescent element having a pair of electrodes constituted with the anode and the cathode, a luminescent layer that is disposed between a pair of the electrodes, and the hole injection layer and/or the hole transport layer that is disposed between the anode and the luminescent layer and contains the hole layer material according to [18].
[22] An organic electroluminescent element having a pair of electrodes constituted with the anode and the cathode, a luminescent layer that is disposed between a pair of the electrodes, and the hole inhibition layer and/or the electron transport layer that is disposed between the cathode and the luminescent layer and contains the material for the hole inhibition layer or the electron transport layer according to [19].
[23] The organic electroluminescent element according to [20] or [21], further having an electron transport layer and/or an electron injection layer that is disposed between the cathode and the luminescent layer, wherein at least one of the electron transport layer and the electron injection layer contains at least one selected from the group consisting of a quinolinol metal complex, a pyridine derivative, a phenanthroline derivative, a borane derivative and a benzimidazole derivative.
[24] The organic electroluminescent element according to [22], wherein at least one of the hole inhibition layer and the electron transport layer contains at least one selected from the group consisting of a quinolinol metal complex, a pyridine derivative, a phenanthroline derivative, a borane derivative and a benzimidazole derivative.
[25] The organic electroluminescent element according to [23] or [24], wherein the hole inhibition layer, the electron transport layer and/or the electron injection layer further contains at least one selected from the group consisting of alkali metals, alkali earth metals, rare-earth metals, oxides of alkali metals, halides of alkali metals, oxides of alkali earth metals, halides of alkali earth metals, oxides of rare-earth metals, halides of rare-earth metals, organic complexes of alkali metals, organic complexes of alkali earth metals and organic complexes of rare-earth metals.
[26] A display device, having the organic electroluminescent element according to any of [20] to [25].
[27] A lighting device, having the organic electroluminescent element according to any of [20] to [25].

### Advantageous Effect of Invention

According to the preferable embodiments of the present invention, for example, a polycyclic aromatic compound having excellent properties as a material for an organic electroluminescent element can be provided, and an organic electroluminescent element having improved driving voltage and current efficiency can be provided by use of this polycyclic aromatic compound.

### Brief Description of Drawings

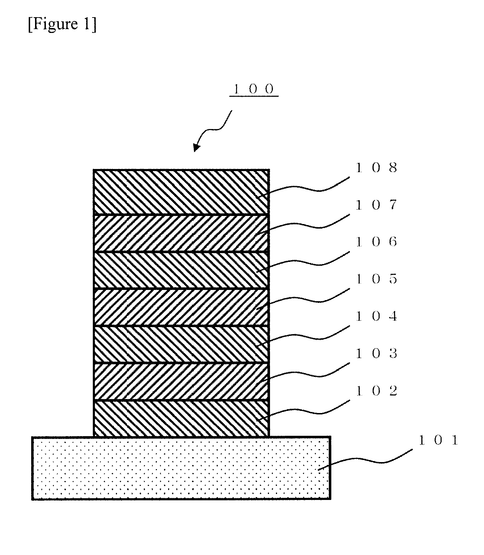

Fig. 1 is a schematic cross-sectional view showing the organic electroluminescent element according to this exemplary embodiment.

### Description of Embodiments

### 1. Partial structure constituting polycyclic aromatic compound

The polycyclic aromatic compound of the present invention (and a salt thereof) has a partial structure represented by the general formula (I) described below, and is useful as a material for organic electroluminescent element. Note that respective signs in the formula are as described above.

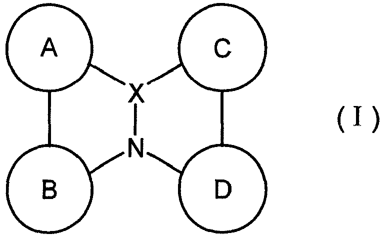

A specific example of the partial structure represented by the general formula (I) described above includes a partial structure represented by the general formula (II) or (II') described below. Note that respective signs in the formula are as described above.

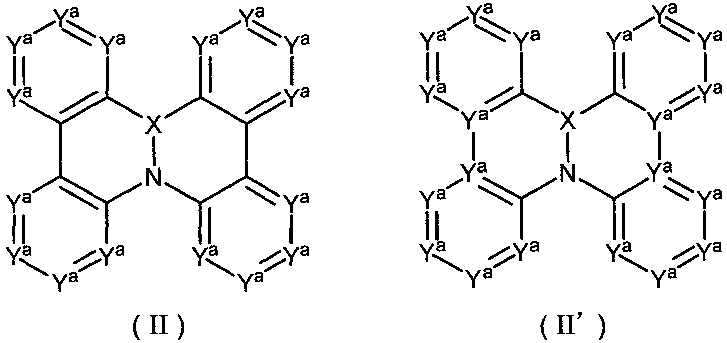

Specific examples of the partial structure represented by the general formula (II) or (II') described above include a partial structure represented by the general formulae (III-1) to (III-54) and the general formulae (III-55) to (III-60) described below. Note that, in each formula, X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table, and Z represents N, O, S or Se. A benzene ring and a five-membered ring described in each formula may be each independently substituted or may form a cyclohexane ring, a benzene ring or a pyridine ring by connecting adjacent substituents in the same ring. In addition, adjacent two benzene rings in each formula may form a ring therebetween with a connecting group or a single bond, and each partial structure has at least one hydrogen and at least one hydrogen in the partial structure may be substituted with deuterium. Note that, about Z, explanation of the definition of "adjacent two Y^{a}s in the same ring together with a bond therebetween form N, O, S or Se" described later can be referred.

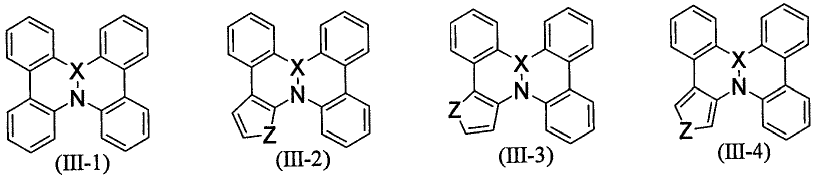

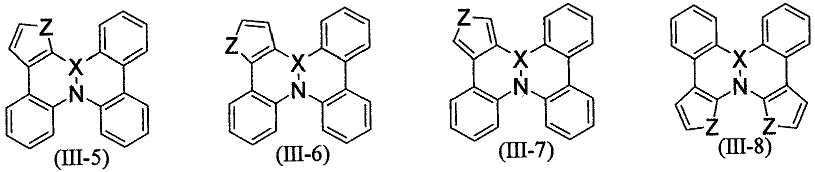

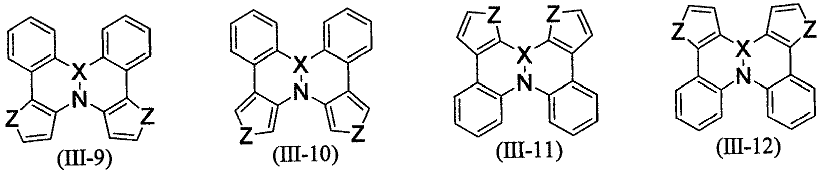

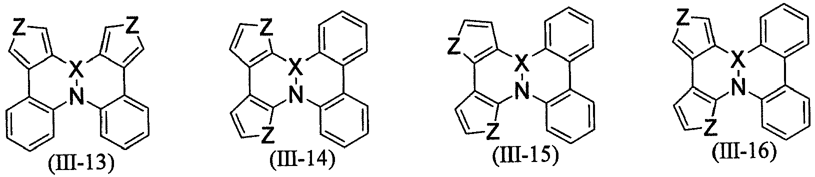

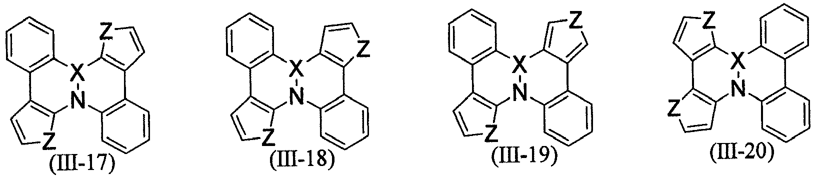

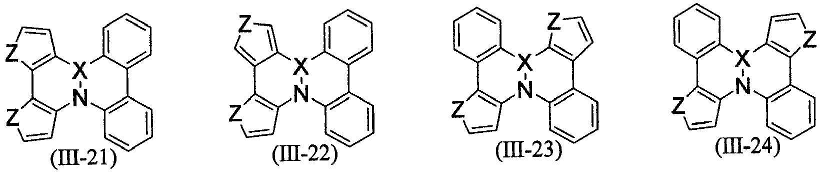

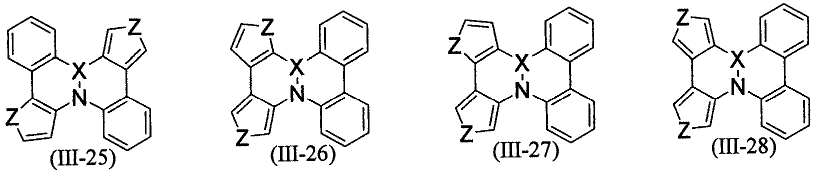

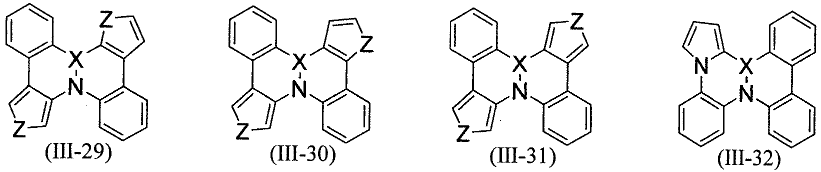

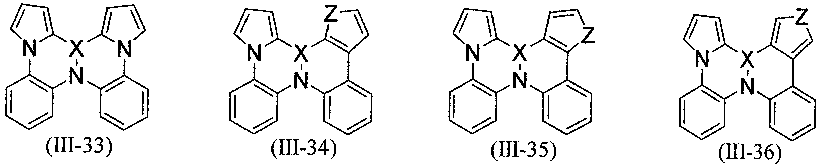

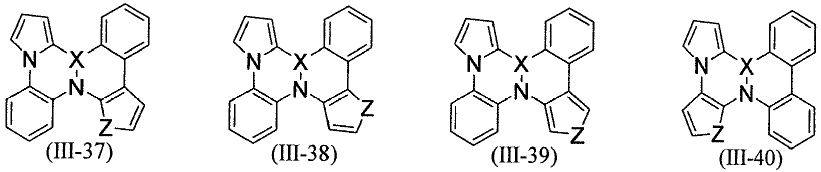

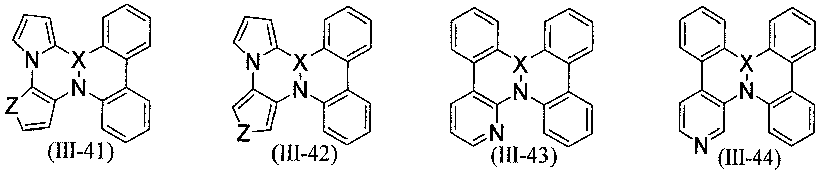

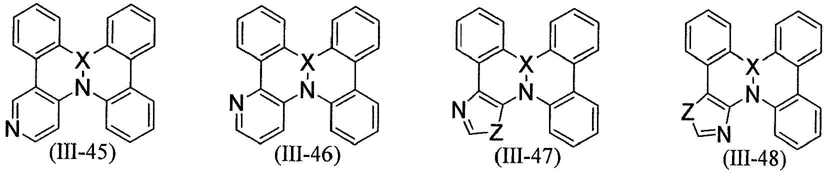

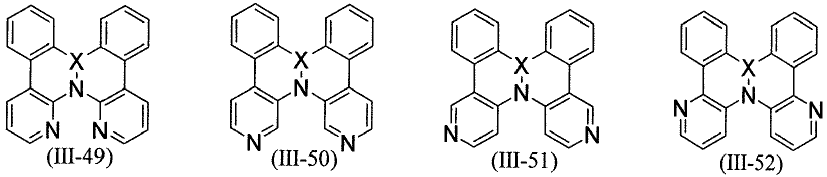

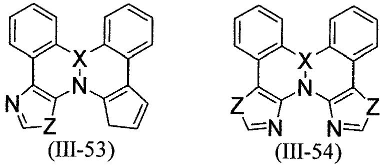

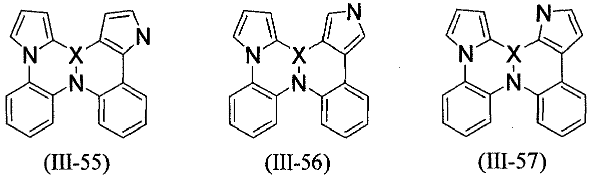

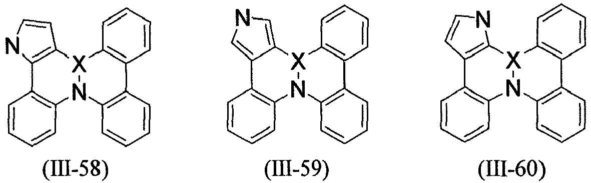

### 2. Entire structure of polycyclic aromatic compound

The polycyclic aromatic compound of the present invention (and a salt thereof) is a compound containing the above mentioned partial structure (e.g., constituted with repetition of the partial structure), and specific examples include compounds represented by the general formulae (IV-1) to (IV-22) described below.

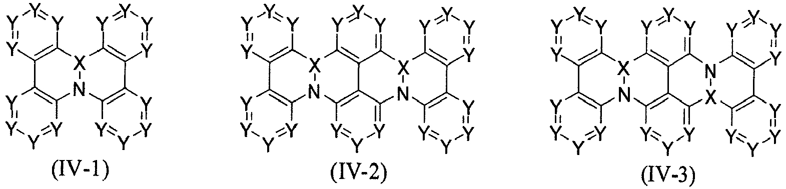

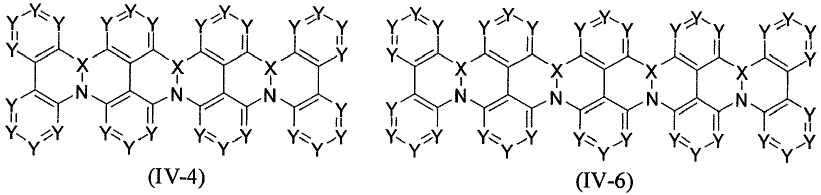

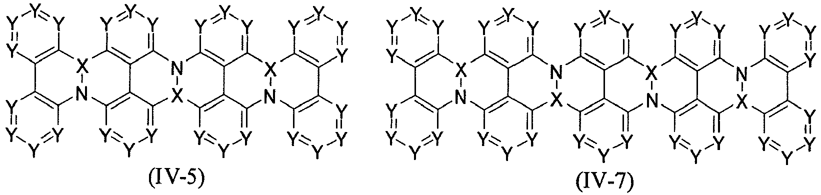

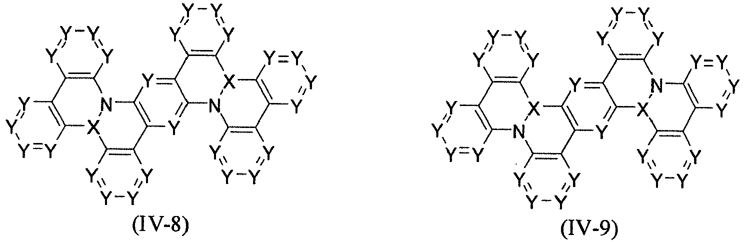

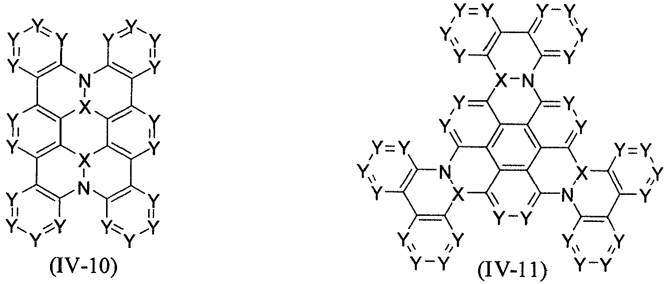

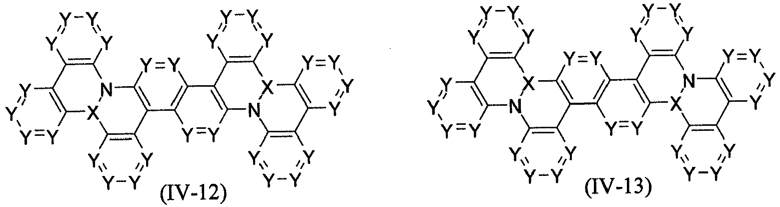

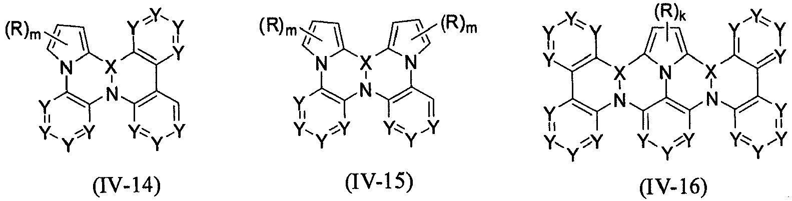

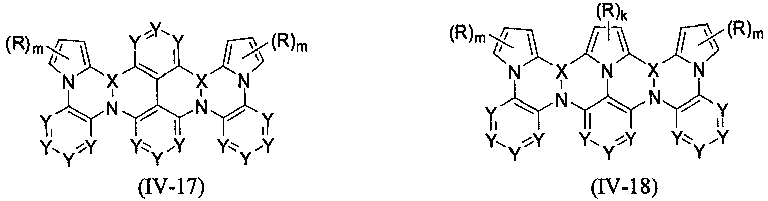

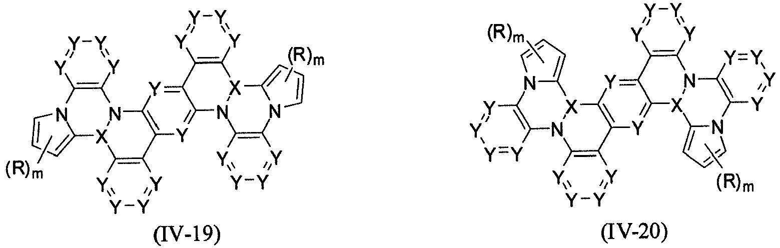

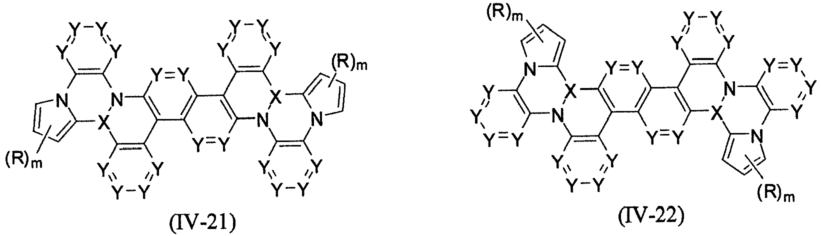

In the formulae (IV-1) to (IV-22), Ys each independently represent CR (R is described later) or N; or two adjacent Ys on the same ring, together with a bond therebetween, may form NR (R is described later), O, S, or Se.

X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table.

In the formulae (IV-1) to (IV-22), R (including R in the above mentioned CR and NR) represents hydrogen, halogen, C₁₋₂₀ alkyl, hydroxy C₁₋₂₀ alkyl, trifluoromethyl, C₂₋₁₂ perfluoroalkyl, C₃₋₈ cycloalkyl, C₂₋₂₀ alkenyl, C₂₋₂₀ alkynyl, mono- or di-aryl-substituted alkenyl, mono- or di-heteroaryl-substituted alkenyl, arylethynyl, heteroarylethynyl, hydroxy, C₁₋₂₀ alkoxy, aryloxy, trifluoromethoxy, trifluoroethoxy, C₂₋₁₂ perfluoroalkoxy, C₁₋₂₀ alkylcarbonyl, C₁₋₂₀ alkylsulfonyl, cyano, nitro, amino, monoalkylamino, monoarylamino, monoheteroarylamino, diarylamino, carbazolyl, C₁₋₂₀ alkoxycarbonylamino, carbamoyl, mono- or di-alkylcarbamoyl, sulfamoyl, mono- or di-alkylsulfamoyl, C₁₋₂₀ alkylsulfonylamino, C₁₋₂₀ alkylcarbonylamino, optionally substituted aryl, optionally substituted heteroaryl, C₁₋₂₀ alkoxycarbonyl, carboxyl, 5-tetrazolyl, sulfo (-SO₂OH), fluorosulfonyl, SR^{a}, N(^{R}a)₂, B(R^{a})₂, Si(R^{a})₃, or -C≡C-Si(R^{a})₃ (wherein R^{a} each independently represents optionally substituted alkyl, optionally substituted aryl, or optionally substituted heteroaryl; or two R^{a}s, together with an atom bound thereto, may form a bicyclic group or a tricyclic group optionally having a heteroatom).

Provided that the alkyl, the alkenyl, the alkynyl group, and the alkoxy are each optionally substituted with 1 to 3 atoms or groups, selected from the group consisting of halogen atom, hydroxy, C₁₋₂₀ alkoxy, aryloxy, amino, carbazolyl, N(R^{a})₂ (wherein R^{a} is as defined above), trifluoromethyl, C₂₋₁₂ perfluoroalkyl, C₃₋₈ cycloalkyl, aryl, and heteroaryl; and the aryl group, aryl moiety, heteroaryl group, heteroaryl moiety, and carbazole group are each optionally substituted with 1 to 5 groups, selected from the group consisting of halogen, C₁₋₂₀ alkyl, hydroxy C₁₋₂₀ alkyl, trifluoromethyl, C₂₋₁₂ perfluoroalkyl, C₃₋₈ cycloalkyl, C₂₋₂₀ alkenyl, C₂₋₂₀ alkynyl, mono- or di-aryl-substituted alkenyl, mono- or di-heteroaryl-substituted alkenyl, arylethynyl, heteroarylethynyl, hydroxy, C₁₋₂₀ alkoxy, aryloxy, trifluoromethoxy, trifluoroethoxy, C₂₋₁₂ perfluoroalkoxy, cyano, nitro group, amino, carbazolyl, monoalkylamino, monoarylamino, monoheteroarylamino, N(R^{a})₂ (wherein R^{a} is as defined above), carbamoyl, mono- or di-alkylcarbamoyl, sulfamoyl, mono- or di-alkylsulfamoyl, C₁₋₂₀ alkylcarbonyl, C₁₋₂₀ alkylsulfonyl, C₁₋₂₀ alkylsulfonylamino, C₁₋₂₀ alkylcarbonylamino, methylenedioxy, heteroaryl, and aryl (wherein the aryl is optionally substituted with 1 to 5 groups, selected from the group consisting of halogen, C₁₋₂₀ alkyl, C₃₋₈ cycloalkyl, C₂₋₂₀ alkenyl, C₂₋₂₀ alkynyl, hydroxy, trifluoromethyl, C₂₋₁₂ perfluoroalkyl, hydroxy, C₁₋₂₀ alkoxy, aryloxy, trifluoromethoxy, trifluoroethoxy, C₂₋₁₂ perfluoroalkoxy, C₁₋₂₀ alkylcarbonyl, C₁₋₂₀ alkylsulfonyl, methylenedioxy, cyano, nitro, amino, carbazolyl, and N(R^{a})₂ (wherein R^{a} is as defined above)).

Two adjacent Rs, together with carbon atom bound thereto, form a five- or six-membered monocyclic group, bicyclic group, or tricyclic group optionally having a heteroatom; for example, forming a cyclohexane ring, a benzene ring or a pyridine ring can be exemplified. Furthermore, three adjacent Rs form, together with carbon atom bound thereto, a bicyclic group or a tricyclic group optionally having a heteroatom. When two adjacent Rs are Rs substituted in adjacent rings, the two Rs form a single bond, CH₂, CHR^{a}, CR^{a}₂, NR^{a}, Si(R^{a})₂, BR^{a} (wherein R^{a} is as defined above), Se, S or O and may form two adjacent rings. At least one hydrogen in the entire structure may be substituted with deuterium.

m represents an integer of 0 to 3, preferably an integer of 0 to 2, more preferably an integer of 0 or 1, and further more preferably 0. k represents an integer of 0 to 2, preferably an integer of 0 or 1, and more preferably 0.

More specific examples of the polycyclic aromatic compound of the present invention (and a salt thereof) include compounds represented by the general formulae (V-1) to (V-26) and general formulae (V-27) to (V-34) described below.

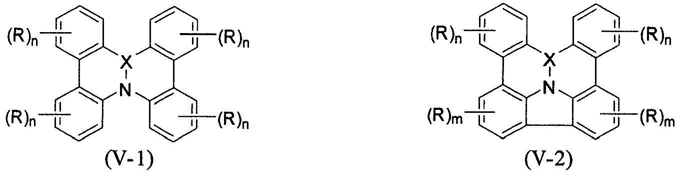

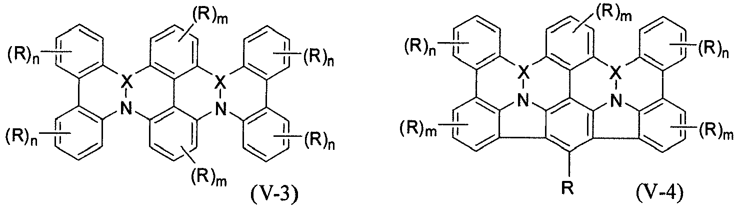

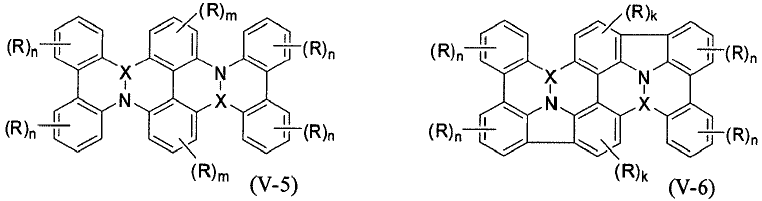

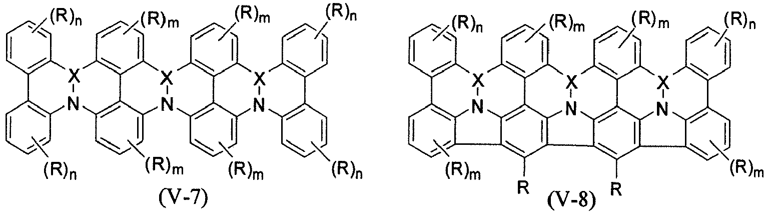

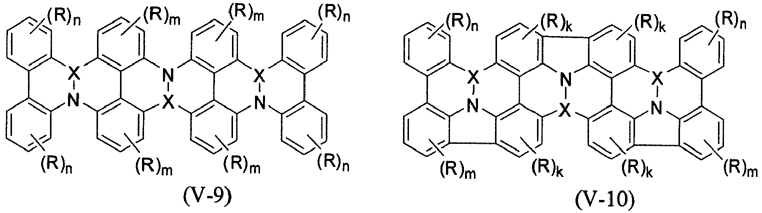

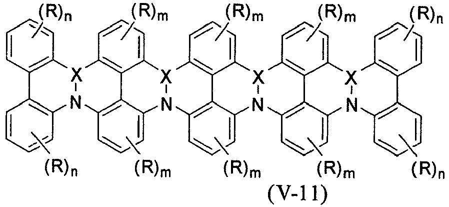

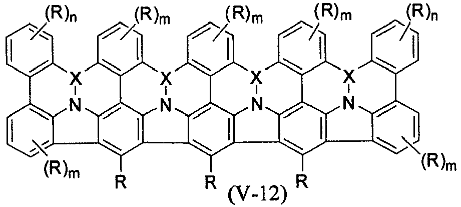

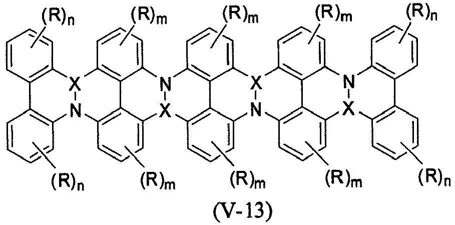

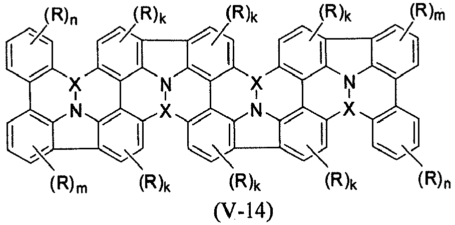

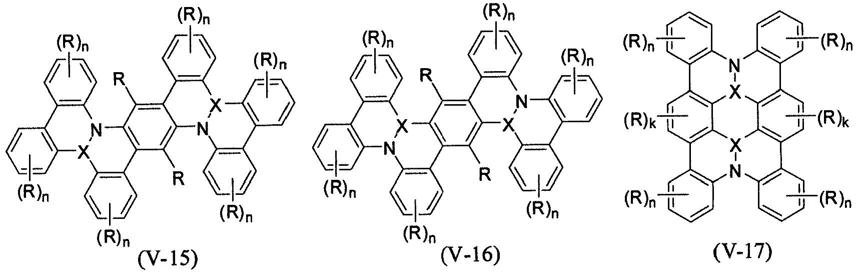

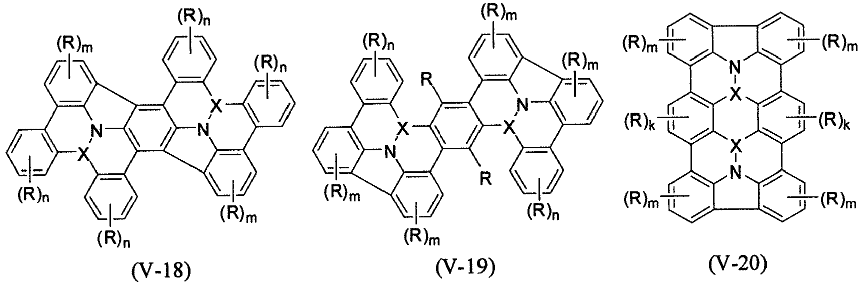

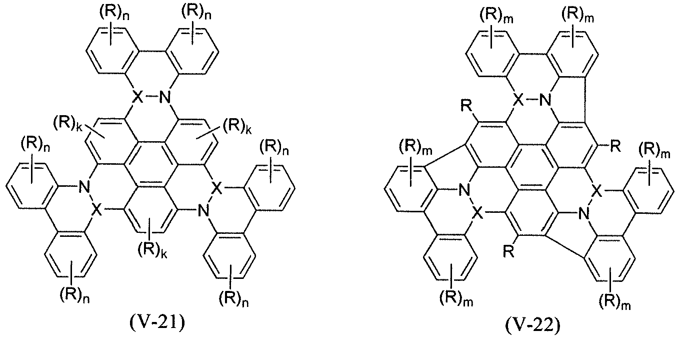

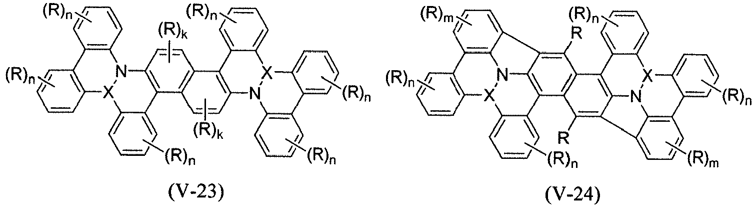

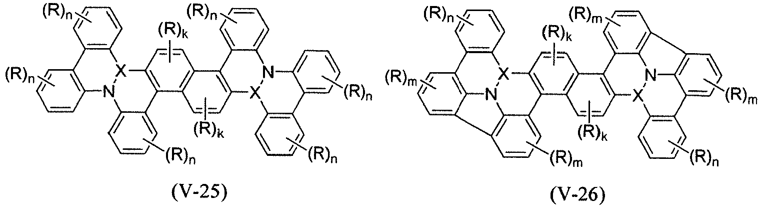

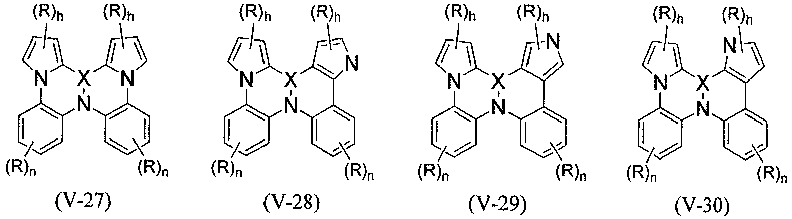

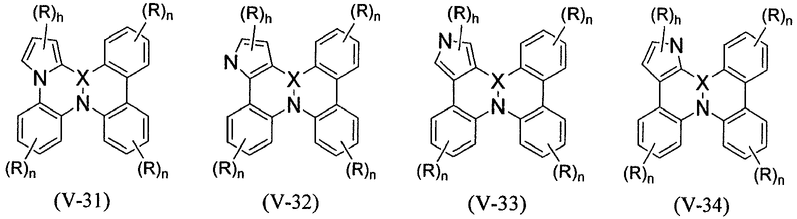

In the formulae (V-1) to (V-26) and (V-27) to (V-34), X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table.

In the above described formulae (V-1) to (V-26) and (V-27) to (V-34), R denotes hydrogen, fluorine-substituted or non-substituted C₁₋₂₀ alkyl, C₃₋₈ cycloalkyl, C₂₋₂₀ alkenyl, mono- or di-aryl-substituted C₂₋₁₂ alkenyl, mono- or di-heteroaryl-substituted C₂₋₁₂ alkenyl, fluorine-substituted or non-substituted C₁₋₂₀ alkoxy, C₁₋₂₀ alkylcarbonyl, cyano, nitro, diarylamino, optionally substituted aryl, optionally substituted heteroaryl, B(R^{a})₂, or Si(R^{a})_{3 3} (wherein R^{a} each independently represents an optionally substituted alkyl, optionally substituted aryl, or optionally substituted heteroaryl). Note that among pyrrole rings in the formulae (V-27) to (V-34), hydrogen is basically connected to N (>N-H) in a pyrrole ring (e.g., a pyrrole ring in the formula (V-32)) except for pyrrole rings in which N relates to condensation (e.g., a pyrrole ring in the formula (V-27)), but may be substituent R may also be connected (>N-R). Detailed explanation with a figure can refer to explanation of "two adjacent Y^{a}s on the same ring, together with a bond therebetween, form N, O, S, or Se" described later.

Adjacent two Rs in the same ring may be connected and form a cyclohexane ring, a benzene ring or a pyridine ring. Adjacent two benzene rings in each formula described above may form a ring therebetween by connecting with a single bond, a bond with CH₂, CHR^{a}, C(R^{a})₂, NR^{a}, Si(R^{a})₂, BR^{a} (wherein R^{a} is as defined above), Se, S or O. At least one hydrogen in the entire structure may be substituted with deuterium.

n represents an integer of 0 to 4, preferably an integer of 0 to 2, more preferably an integer of 0 or 1, and further more preferably 0. m represents an integer of 0 to 3, preferably an integer of 0 to 2, more preferably an integer of 0 or 1, and further more preferably 0. k represents an integer of 0 to 2, preferably an integer of 0 or 1, and more preferably 0. h represents an integer of 0 to 3, preferably an integer of 0 to 2, more preferably an integer of 0 or 1, and further more preferably 0.

More specific examples of the polycyclic aromatic compound of the present invention (and a salt thereof) include a compound represented by the general formula (V-1'), (V-2') or (V-3') described below and a compound represented by the general formula (V-27') or (V-32') described below. These compounds correspond to compounds wherein B element is selected as X in each of the above described general formula (V-1), (V-2) or (V-3) and the above described general formula (V-27) or (V-32). In the formula, R, n, m and h are as defined above.

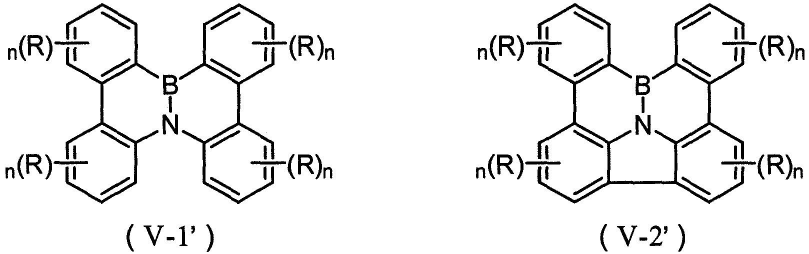

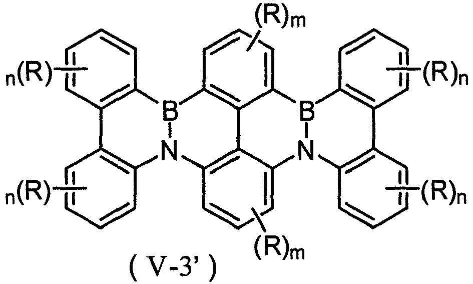

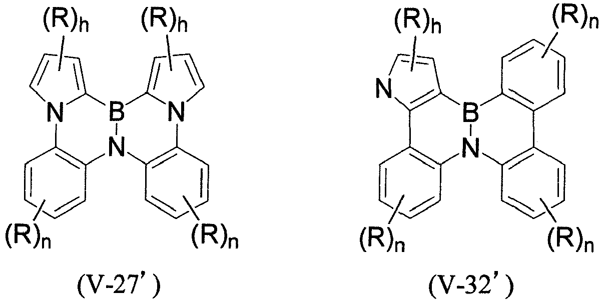

In particular, for a compound in which substituent R is aryl in the above described general formulae (V-1'), (V-27') and (V-32'), specific examples of R include phenyl, (2-,3-,4-)biphenylyl, terphenylyl (m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, p-terphenyl-4-yl), (1-,2-)naphthyl, (1-,2-)triphenylenyl or (1-,2-,3-,4-,9-)carbazolyl, and phenyl, biphenylyl or terphenylyl is preferable.

Regarding a substitution position of R, as for a benzene ring (corresponding to B ring and/or D ring in the formula (I)) binding to N in the above described general formulae (V-1'), (V-27') and (V-32'), substitution to a para position is preferable based on a position of carbon binding to N, a para position in one ring of B ring or D ring may be substituted or para positions in the both rings may be substituted, and substitution of para positions in the both rings is preferable. In addition, as for a benzene ring (corresponding to A ring and/or C ring in the formula (I)) binding to B in the above described general formulae (V-1') and (V-32'), substitution to a ortho position is preferable based on a position of carbotn binding to B is preferable, a ortho position in one ring of A ring or C ring may be substituted or ortho positions in the both rings may be substituted.

Specifically, compounds represented by the formulae (51) to (86) described later are preferable, compounds represented by the formulae (66) to (83) and (86) are more preferable, and compounds represented by the formulae (66) to (74) are further more preferable.

Substituent R (aryl) may be further substituted. For example, substitution with a phenyl group, a diarylamino group, or an optionally substituted carbazolyl group is included. Examples of "aryl" in the diarylamino group include aryl (e.g., phenyl and naphthyl) described layer, and examples of a substituent into the carbazolyl group include alkyl (e.g., C₁₋₃ alkyl) and aryl (e.g., phenyl, biphenylyl and naphthyl) described later. Specifically, compounds represented by the formulae (192), (196), (199), (205) and (209) described later are preferable,

Regarding a compound in which substituent R has an N-containing structure in the above described general formulae (V-1'), (V-27') and (V-32'), specific examples of R include a diarylamino group, an optionally substituted carbazolyl group, and the like. Examples of "aryl" in the diarylamino group include aryl (e.g., phenyl and naphthyl) described later, and examples of a substituent into the carbazolyl group include alkyl (e.g., C₁₋₃ alkyl) described later and aryl (e.g., phenyl, biphenylyl and naphthyl) described later.

Regarding substitution position of R, as for a benzene ring (corresponding to B ring and/or D ring in the formula (I)) binding to N in the above described general formulae (V-1'), (V-27') and (V-32'), substitution to a para position is preferable based on a position of carbotn binding to N, a para position in one ring of B ring or D ring may be substituted or para positions in the both rings may be substituted.
Specifically, compounds represented by the formulae (188) to (191), (193) to (195), (197), (198), (200) to (204) and (206) to (208) described later are preferable.

Specific examples of the polycyclic aromatic compound of the present invention (and a salt thereof) further include compounds represented by the general formulae (VI-1) to (VI-149) described below (these compounds may be further substituted, and these substituents may be combined each other and form a cyclohexane ring, a benzene ring or a pyridine ring). Note that, in each formula, X and Z are as defined above.

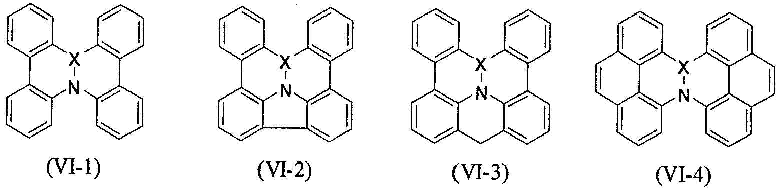

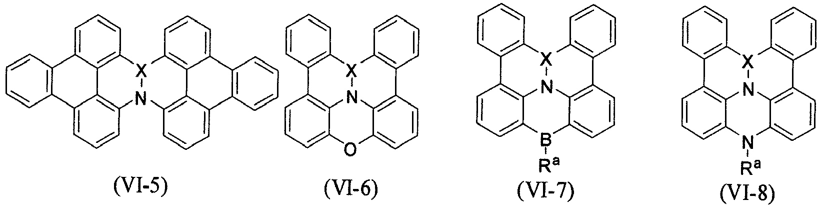

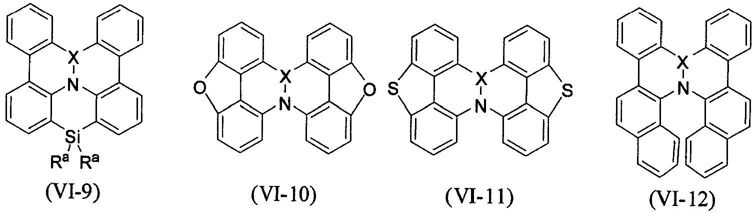

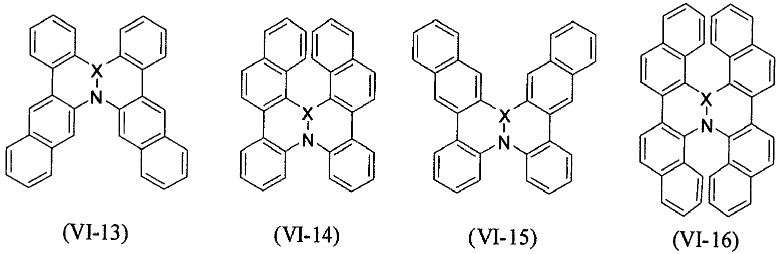

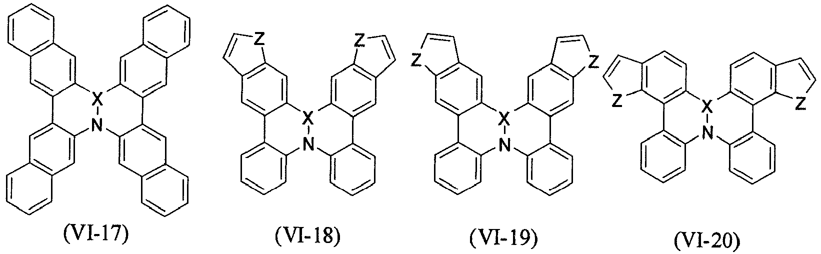

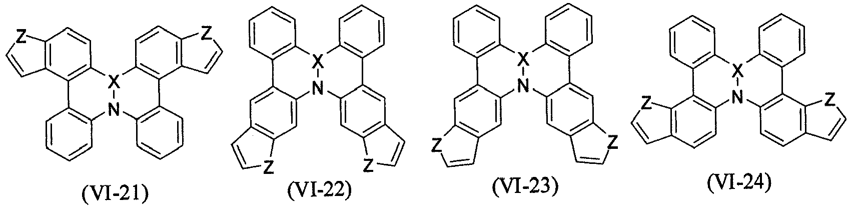

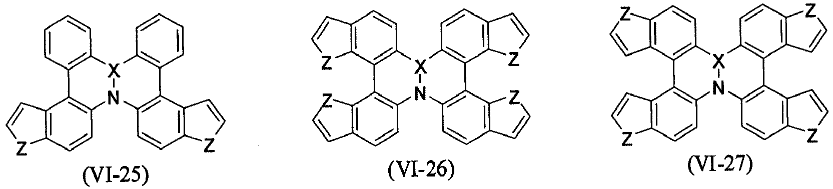

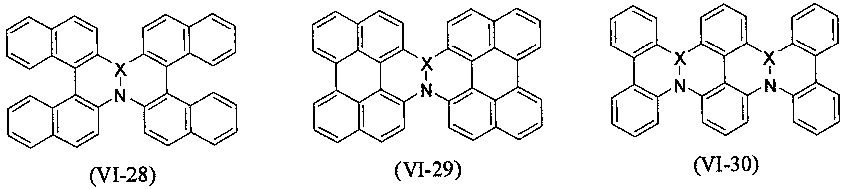

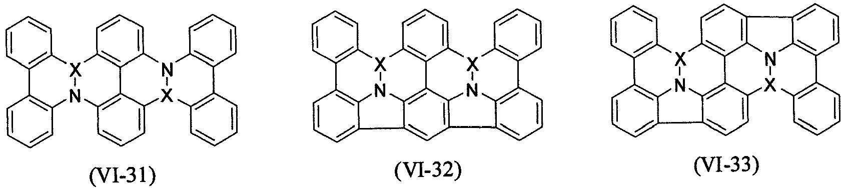

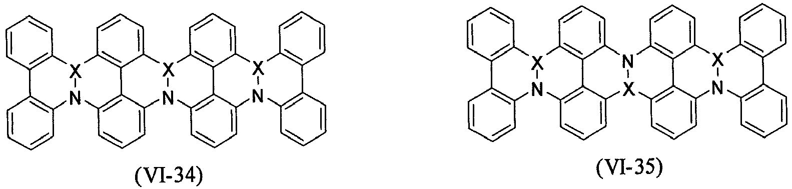

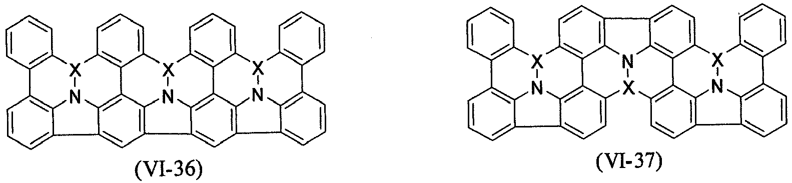

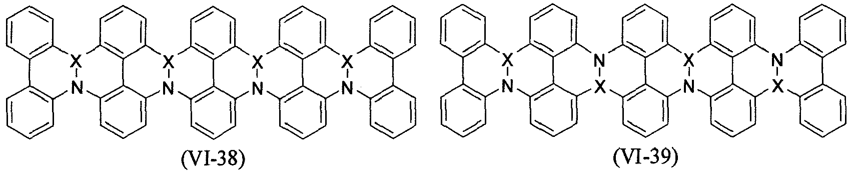

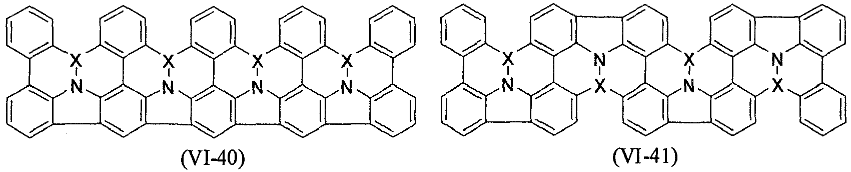

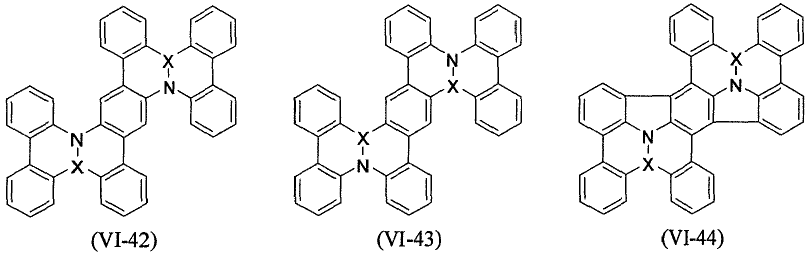

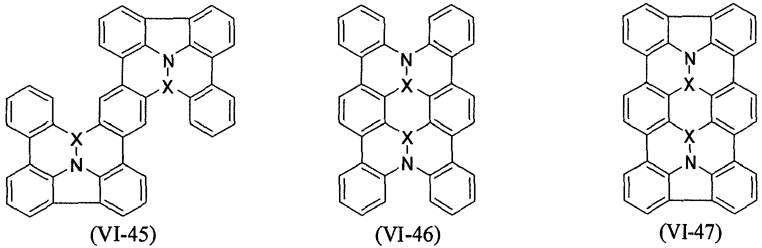

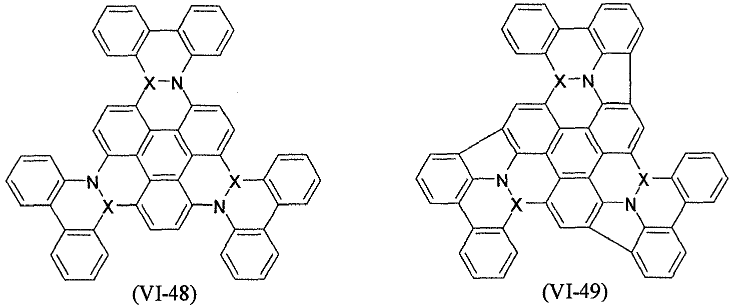

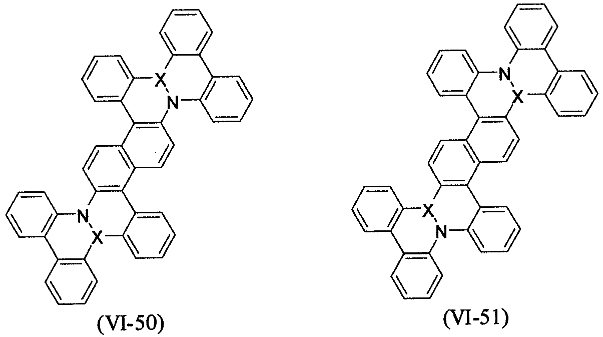

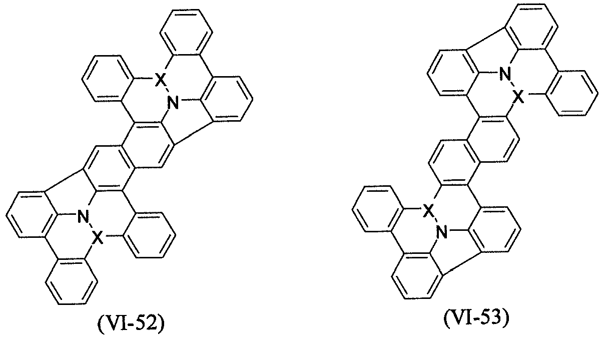

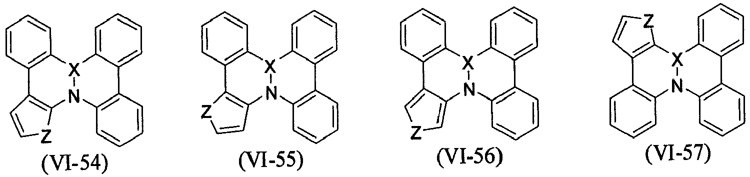

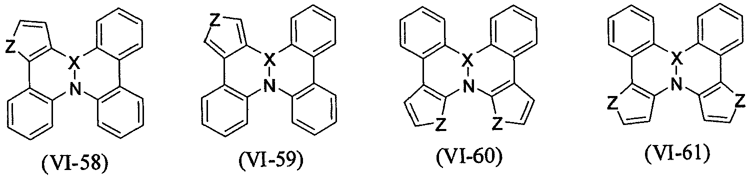

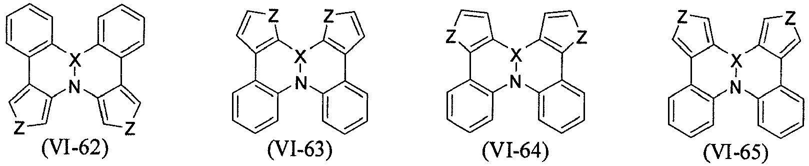

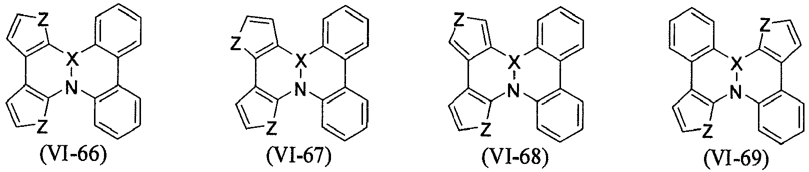

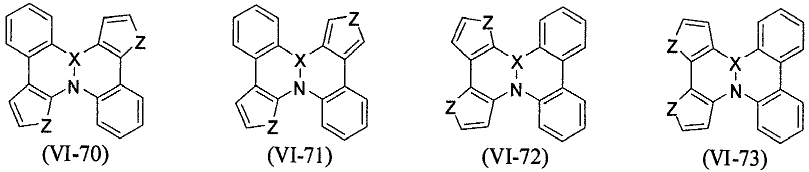

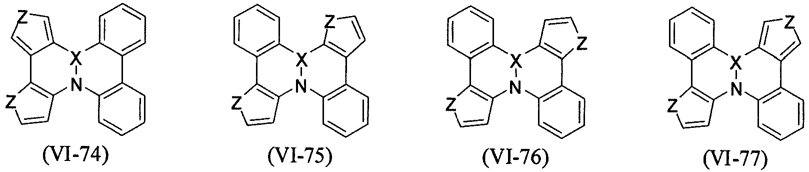

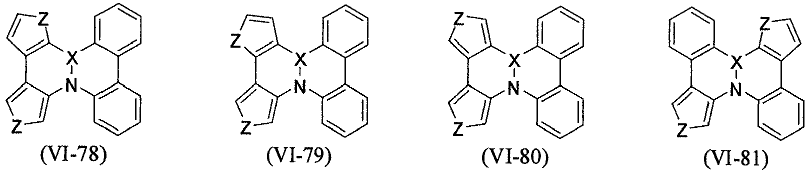

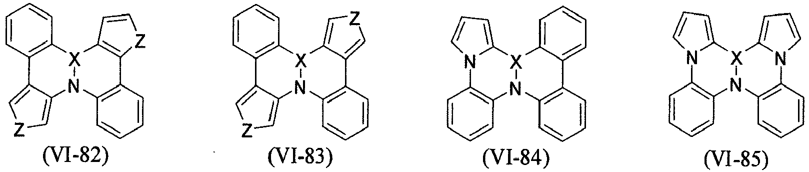

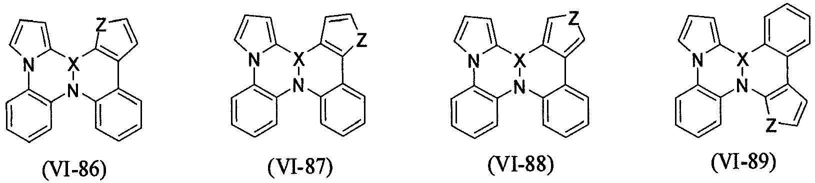

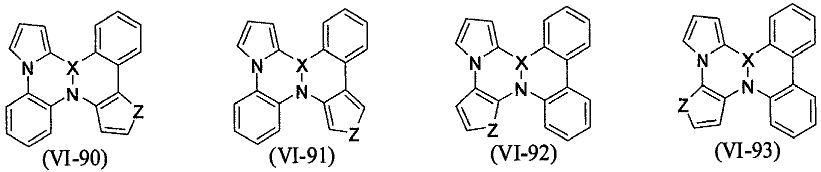

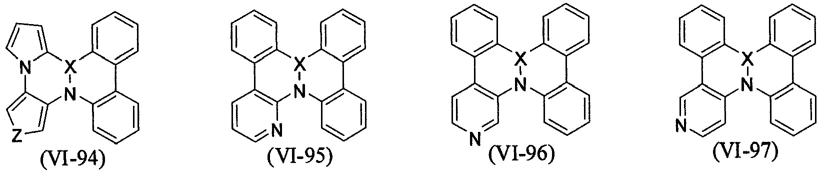

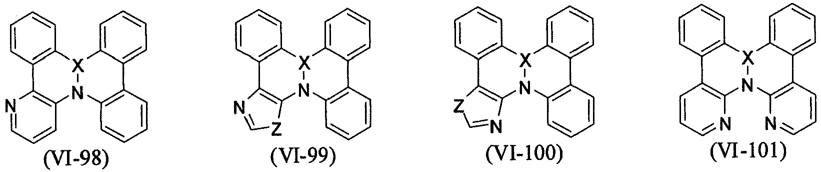

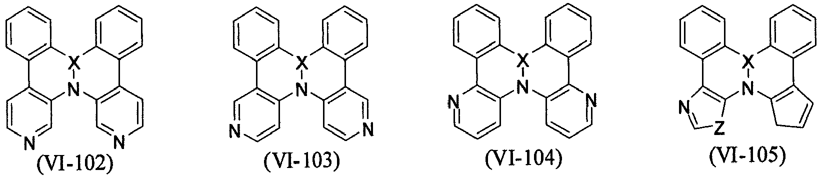

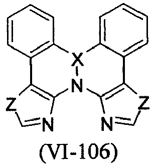

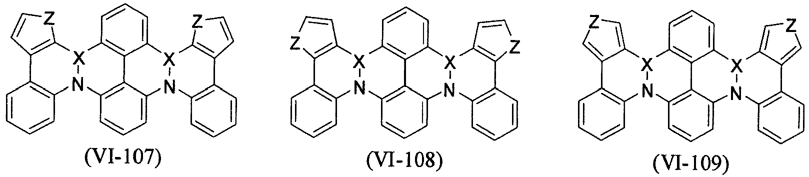

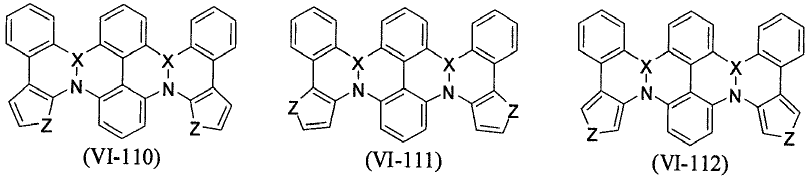

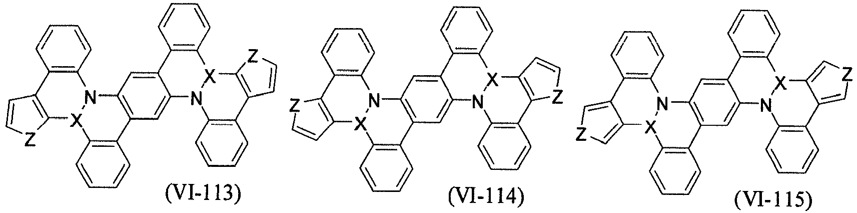

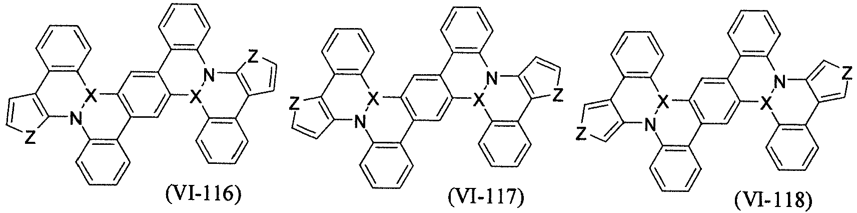

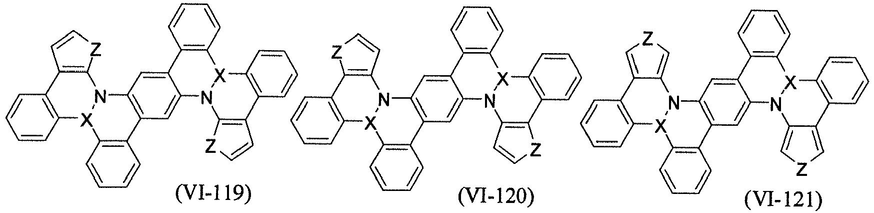

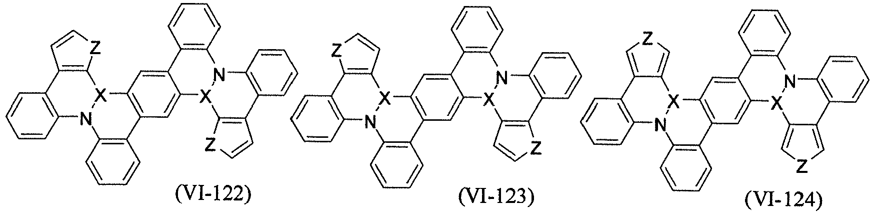

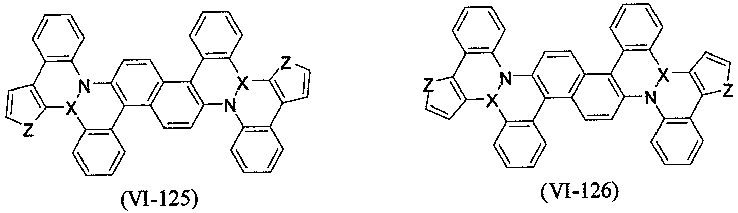

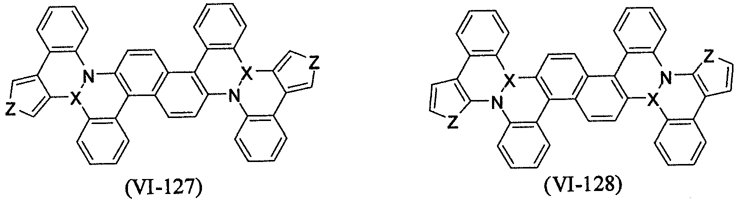

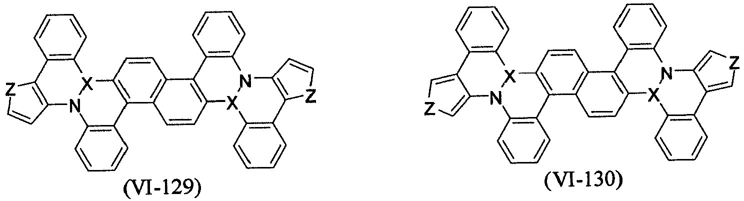

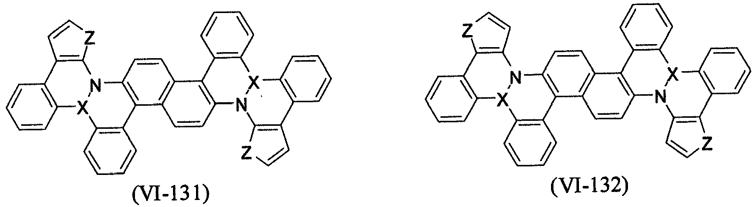

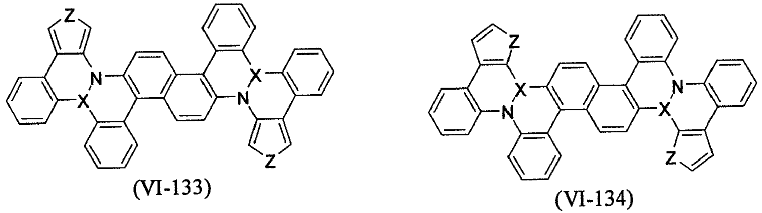

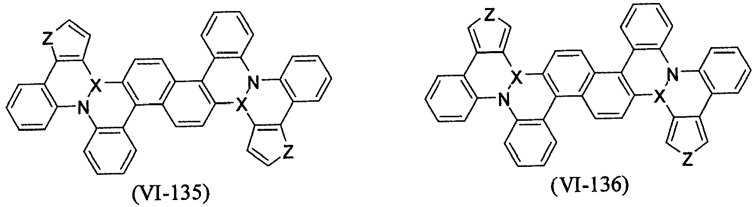

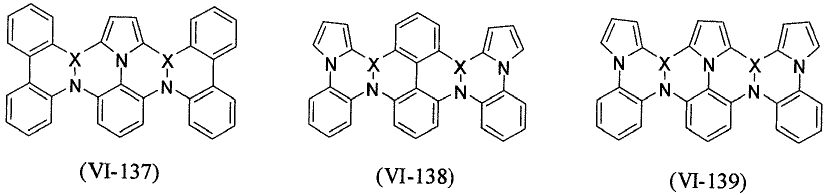

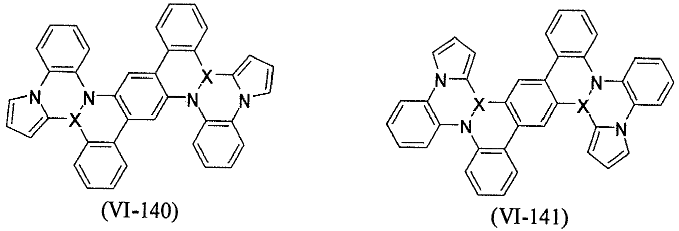

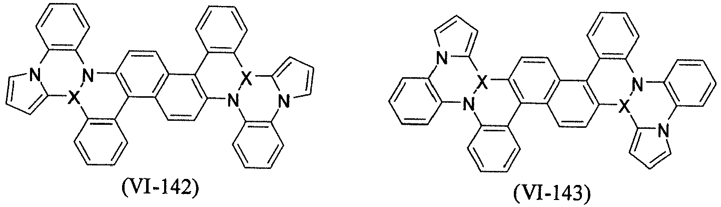

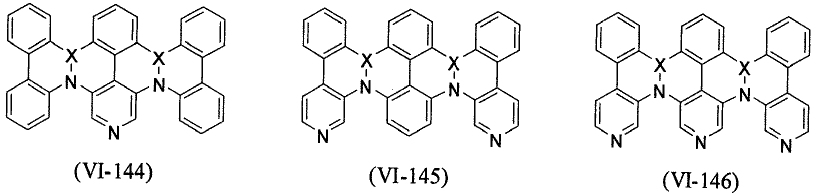

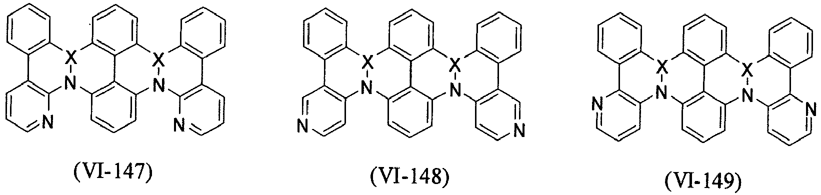

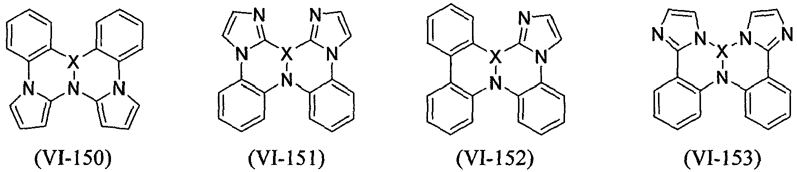

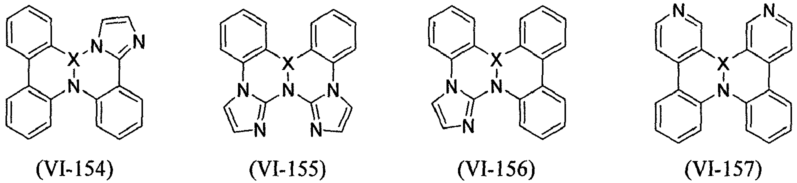

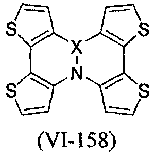

Examples of metal elements in groups 3 to 11 of the periodic table and metal elements or metalloid elements in group 13 or 14 of the periodic table, represented by X, include those described below.
Group 3: Sc, Y, lanthanoid
Group 4: Ti, Zr, Hf
Group 5: V, Nb, Ta
Group 6: Cr, Mo, W
Group 7: Mn, Tc, Re
Group 8: Fe, Ru, Os
Group 9: Co, Rh, Ir
Group 10: Ni, Pd, Pt
Group 11: Cu, Ag, Au
Group 13: Al, Ga, In, T1
Group 14: Si, Ge, Sn, Pb

The metal elements in groups 3 to 11 of the periodic table and the metal elements or metalloid elements in group 13 or 14 of the periodic table, represented by X, are each optionally substituted. Here, "optionally substituted" means that the metal elements or metalloid elements may include 1 to 3 substituent groups R (wherein R is as defined above), or 1 to 3 neutral ligands R¹. Examples of neutral ligands R¹ include aromatic compounds having a nitrogen atom as a ring atom, such as pyridine, bipyridine, phenanthroline, terpyridine, imidazole, pyrimidine, pyrazine, quinoline, isoquinoline, and acridine; and derivatives thereof. However, when X has both R and R¹, R and R¹ may form a single compound (8-hydroxyquinoline), as in the following Case (3).

For example, a compound having a neutral ligand R¹ can be produced in the following manner. (In the formulae, (R) indicates that R¹ is the R group defined above, and (R¹) indicates that R¹ is a neutral ligand.)

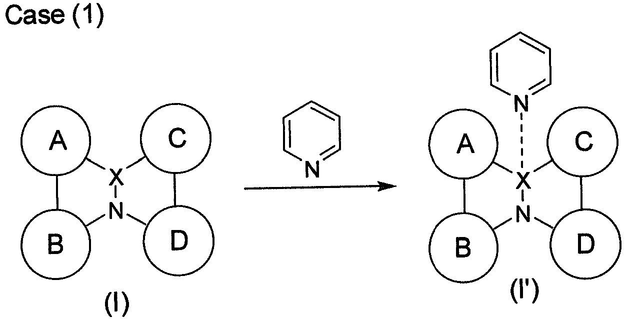

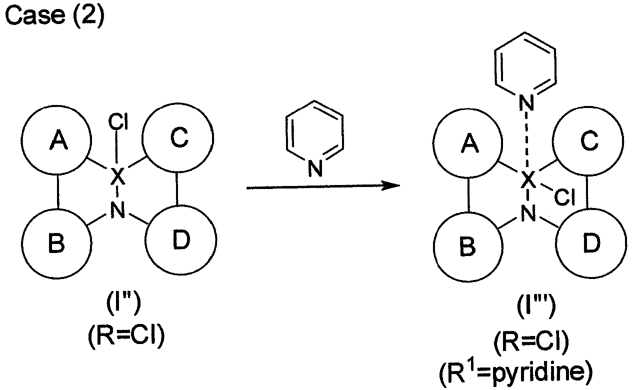

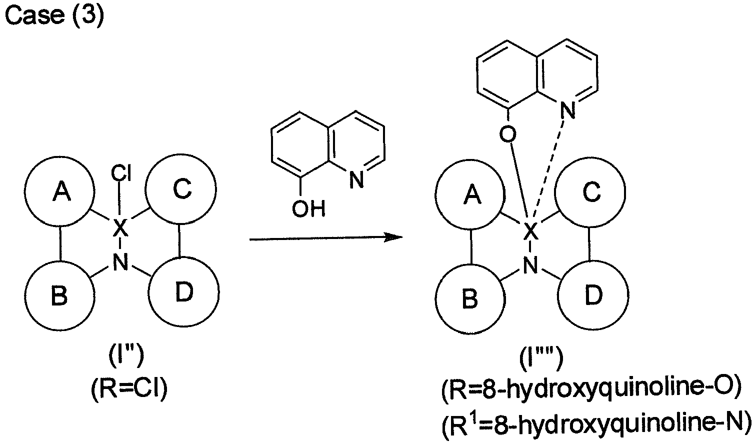

Case (1) represents a case where a neutral ligand (R¹) binds to X (metal element or metalloid element) of the formula (I) to obtain compound (I').

Case (2) represents a case where a neutral ligand (R¹) further binds to (I") in which R=C1 and X (metal element or metalloid element) is substituted with the R group, to obtain compound (I"').

Case (3) represents a method for obtaining compound (I"") having (R) and (R¹), by causing 8-hydroxyquinoline to act on (I") in which R=C1 and X (metal element or metalloid element) is substituted with the R group, to substitute Cl, which is the R group, with an oxygen atom of a phenolic hydroxyl group; and to simultaneously cause coordination of an endocyclic N atom (R¹ group) of quinoline, which is a neutral ligand.

A compound having a neutral ligand can be easily produced by those skilled in the art by referring to Case (1) to Case (3).

X₁ can be changed to X₂ in a manner described below.

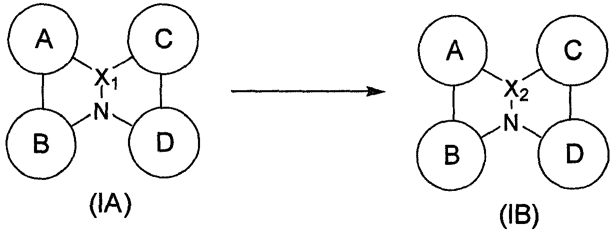

X₁ and X₂ can be changed when the electronegativities thereof are about the same as, or are, X₁ < X₂. For example, when X₁=Ge-R, X₂ can be changed as B, P, P=O, P=S, P=Se, As, As=O, As=S, As=Se, Sb, Sb=O, Sb=S, Sb=Se, Mo, W, Ru, Os, Rh, Ir, Pd, Pt, Au, or Pb (these metal elements are optionally substituted).

As the changing method, with respect to compound (IA) having X₁, 1 mol to an excessive amount of a halide, an alkoxy derivative, an aryloxy derivative, an acyloxy derivative, or a haloamino derivative of X₂, 0 mole to an excessive amount of a Lewis acid, 0 mole to an excessive amount of a base are added and allowed to react by stirring for 30 minutes to 24 hours at a temperature of room temperature to about 250°C in a solvent or under a nonsolvent condition to obtain compound (IB) having X₂.

Examples of the solvents that can be used include anhydrous ether solvents such as anhydrous diethyl ether, anhydrous THF, and anhydrous dibutyl ether; aromatic hydrocarbon solvents such as benzene, toluene, xylene, and mesitylene; aromatic halide-based solvents such as chlorobenzene and 1,2-dichlorobenzene; and the like.

Examples of the Lewis acid that can be used include AlCl₃, AlBr₃, BF₃·OEt₂, BCl₃, BBr₃, GaCl₃, GaBr₃, InCl₃, InBr₃, In(OTf)₃, SnCl₄, SnBr₄, AgOTf, Sc(OTf)₃, ZnCl₂, ZnBr₂, Zn(OTf)₂, MgCl₂, MgBr₂, Mg(OTf)₂, and the like.

Examples of the base that can be used include diisopropylethylamine, 2,2,6,6,-tetra methyl piperidine, 1,2,2,6,6,-pentamethylpiperidine, 2,4,6-collidine, 2,6-lutidine, triethylamine, triisobutylamine, and the like. When X₂=P, a compound in which X₂ is P=S can be directly obtained by conducting the reaction that uses the Lewis acid and the base in the presence of sulfur (S8). A compound having bound thereto a sulfur atom can also be similarly obtained when X₂ is other elements such as As and Sb.

Although a description of the compound having the partial structure of the general formula (I) has been provided above, a neutral ligand can be introduced, and a conversion of X₁ to X₂ is similarly possible, with all partial structures and entire structures, which have been described above.

Examples of preferable X group include B, P, P=O, P=S, Si-R, Ge-R, Ga, Pt, Ru, Ir, Au, and the like.

The terms "two adjacent rings" and "two adjacent benzene rings" in the present specification mean ring A and ring B, ring C and ring D, ring A and ring C, and ring B and ring D, respectively, as explained by use of the above mentioned general formula (I).

"The partial structure has at least one hydrogen" in the present specification means that all atoms forming ring A, ring B, ring C and ring D cannot be connected with other structures, but at least one atom certainly binds to hydrogen to terminate, as explained by use of the above mentioned general formula (I), and for example, heterofullerene or heterocarbon nanotube, which is obtained by substituting a part of a carbon skeleton of fullerene or carbon nanotube with boron or nitrogen is not included in a polycyclic aromatic compound containing a partial structure represented by the above mentioned general formula (I) (e.g., constituted with repetition of the partial structure) or a salt thereof.

In the present specification, "two adjacent Ys on the same ring, together with a bond therebetween, form N, O, S, or Se" means that when adjacent Y^{a}s are connected by a double bond as y^{a}=Y^{a}, "Y^{a}=Y^{a}" can be N, O, S or Se, and when adjacent Y^{a}s are connected by a single bond as Y^{a}-Y^{a}, Y^{a}-Y^{a} can be a structure as the formula described below (in the formula, Y^{a} is as defined above). In addition, hydrogen basically binds to an atomic bonding stretching from N (>N-H), but when a 5 membered ring is substituted, a substituent may be connected with N (>N-R).

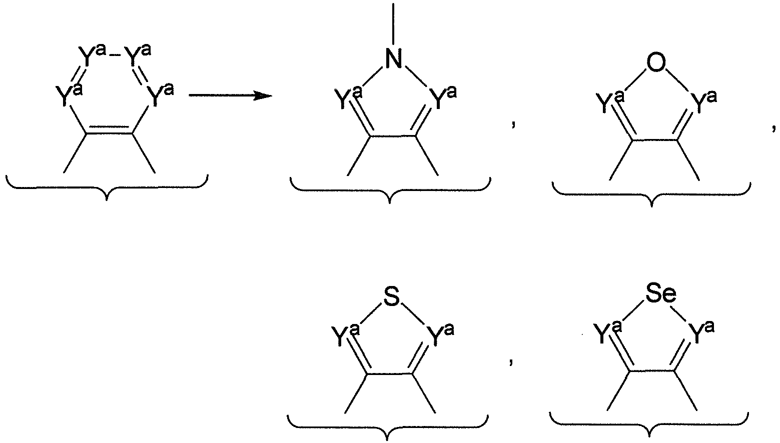

The term "two adjacent Ys on the same ring, together with a bond therebetween, form NR, O, S, or Se" has the same meaning.

In the present specification, "adjacent R groups" may be adjacent groups on the same ring, or the closest R groups each existing on adjacent rings.

Examples of aromatic rings described as "an optionally substituted aromatic ring" include a benzene ring, a naphthalene ring, an azulene ring, a biphenylene ring, a fluorene ring, an anthracene ring, an indacene ring, a phenanthrene ring, a phenalene ring, a pyrene ring, a chrysene ring, a triphenylene ring, a fluoranthene ring, an acephenanthrylene ring, an aceanthrylene ring, a picene ring, a naphthacene ring, a perylene ring, an acenaphthylene ring, an acenaphthene ring, an indane ring, an indene ring, and a tetrahydronaphthalene ring.

Examples of heteroaromatic rings described as "an optionally substituted heteroaromatic ring" include a furan ring, a thiophene ring, a selenophene ring, a pyrrole ring, an imidazole ring, a thiazole ring, an isothiazole ring, an oxazole ring, an isoxazole ring, a triazole ring, a borole ring, a phosphole ring, a silole ring, an azaborine ring, a pyridine ring, a pyrimidine ring, a triazine ring, a pyran ring, an indole ring, an isoindole ring, a quinoline ring, an isoquinoline ring, a quinoxaline ring, a benzoxazole ring, a benzothiazole ring, a benzisoxazole ring, a benzisothiazole ring, a benzofuran ring, a benzothiophene ring, a benzopyran ring, a benzimidazole ring, a benzoborole ring, a benzophosphole ring, a benzosilole ring, a benzazaborine ring, a carbazole ring, an indolizine ring, an acridine ring, a phenazine ring, a phenanthridine ring, a phenanthroline ring, a phenoxazine ring, a phenothiazine ring, a benzoselenophene ring, a naphthofuran ring, a naphthoxazole ring, a naphthothiazole ring, a naphthoisoxazole ring, a naphthoimidazole ring, a naphthoborole ring, a naphthophosphole ring, a naphthosilole ring, a naphthoazaborine ring, a naphthopyran ring, a benzoindole ring, a benzisoindole ring, a benzoquinoline ring, a benzisoquinoline ring, a benzoquinoxaline ring, and those in the following formulae (in the formulae, R^{a} is as defined above):

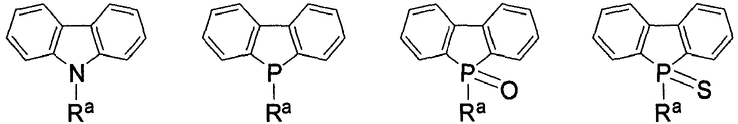

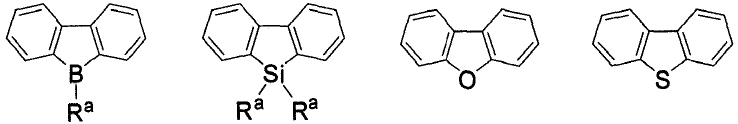

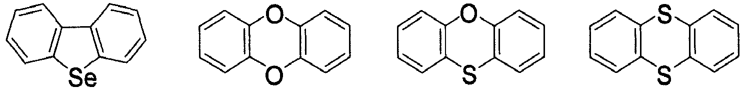

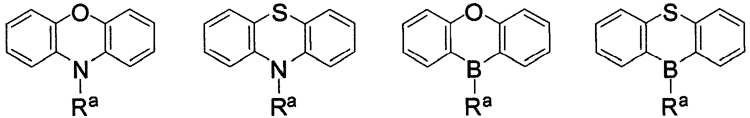

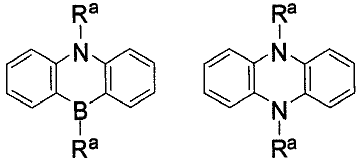

The number of substituent groups of an optionally substituted aromatic ring or an optionally substituted heteroaromatic ring is 1 to 4, and preferably 1, 2, or 3. Examples of the substituent group of an optionally substituted aromatic ring or an optionally substituted heteroaromatic ring include groups represented by R.

Examples of "a five- or six-membered monocyclic group, bicyclic group, or tricyclic group optionally having a heteroatom" include benzene, naphthalene, azulene, biphenylene, fluorene, anthracene, indacene, phenanthrene, phenalene, acenaphthylene, acenaphthene, indane, indene, tetrahydronaphthalene, cyclopentadiene, cyclohexadiene, furan, thiophene, selenophene, pyrrole, imidazole, triazole, isothiazole, oxazole, isoxazole, triazole, borole, phosphole, silole, azaborine, pyridine, pyrimidine, triazine, pyran, indole, isoindole, quinoline, isoquinoline, quinoxaline, benzoxazole, benzothiazole, benzisoxazole, benzisothiazole, benzofuran, benzothiophene, benzopyran, benzimidazole, benzoborole, benzophosphole, benzosilole, benzazaborine, indolizine, acridine, phenazine, phenanthridine, phenanthroline, benzoselenophene, naphthofuran, naphthoxazole, naphthothiazole, naphthoisoxazole, naphthoimidazole, naphthoborole, naphthophosphole, naphthosilole, naphthoazaborine, naphthopyran, benzoindole, benzisoindole, benzoquinoline, benzisoquinoline, benzoquinoxaline, those in the following formulae (in the formulae, R^{a} is as defined above), or a five- or six-membered ring group having X group:

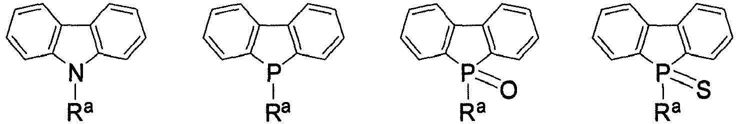

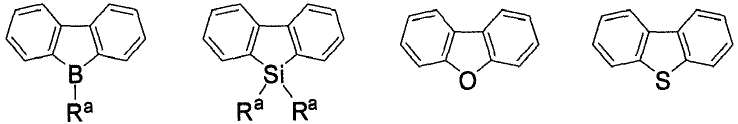

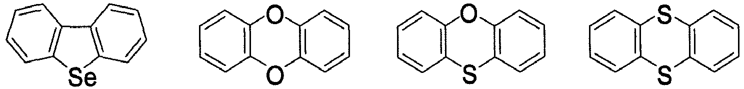

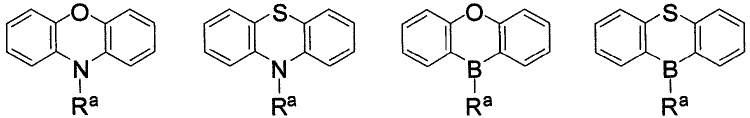

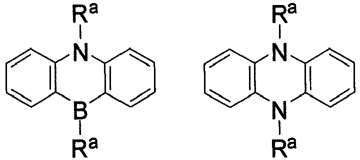

Examples of "a bicyclic group or a tricyclic group optionally having a heteroatom" include naphthalene, azulene, biphenylene, fluorene, anthracene, indacene, phenanthrene, phenalene, acenaphthylene, acenaphthene, indane, indene, tetrahydronaphthalene, indole, isoindole, quinoline, isoquinoline, quinoxaline, benzoxazole, benzothiazole, benzisoxazole, benzisothiazole, benzofuran, benzothiophene, benzopyran, benzimidazole, benzoborole, benzophosphole, benzosilole, benzazaborine, indolizine, acridine, phenazine, phenanthridine, phenanthroline, benzoselenophene, naphthofuran, naphthoxazole, naphthothiazole, naphthoisoxazole, naphthoimidazole, naphthoborole, naphthophosphole, naphthosilole, naphthoazaborine, naphthopyran, benzoindole, benzisoindole, benzoquinoline, benzisoquinoline, benzoquinoxaline, and those in the following formulae (in the formulae, R^{a} is as defined above):

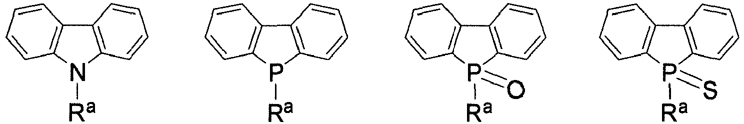

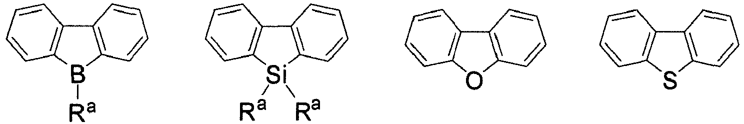

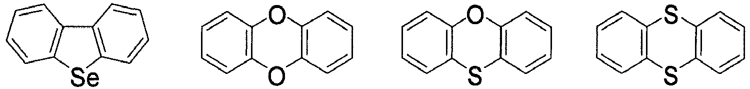

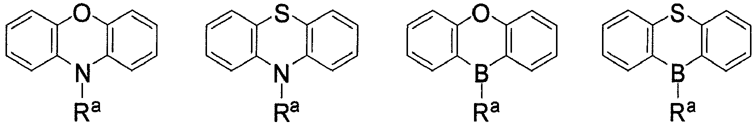

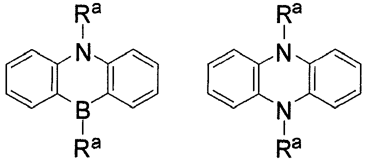

In the present specification, although the number of carbon atoms is specified as "C₁₋₂₀ alkylcarbonyl, "this number of carbon atoms only modifies the group or moiety that immediately follows. Thus, in the above-described case, since C₁₋₂₀ only modifies alkyl, "C₁ alkylcarbonyl" corresponds to acetyl.

Alkyl groups and alkyl moieties may be linear or branched.

In the present specification, an alkyl moiety not only includes respective alkyl groups of optionally substituted alkyl, C₁₋₂₀ alkylsulfonyl, C₁₋₂₀ alkylsulfonylamino, C₁₋₂₀ alkylcarbonylamino, and C₁₋₂₀ alkylcarbonyl, but also includes an alkyl group of monoalkylamino, mono- or di-alkylsulfamoyl, and mono- or di-alkylcarbamoyl.

An aryl moiety refers to an aryl group of mono- or di-aryl-substituted alkenyl, arylethynyl, aryloxy, monoarylamino, or optionally substituted aryl.

A heteroaryl moiety refers to a heteroaryl group of monoheteroarylamino, mono- or heteroaryl-substituted alkenyl, heteroarylethynyl, or optionally substituted heteroaryl.

Although "halogen atom" refers to fluorine, chlorine, bromine, or iodine, fluorine, chlorine, and bromine are preferable.

The "C₁₋₂₀ alkyl" may be linear, branched, or cyclic; and is, for example, C₁₋₂₀ alkyl such as methyl, ethyl, n-propyl, isopropyl, n-butyl, isobutyl, t-butyl, n-pentyl, isopentyl, hexyl, heptyl, octyl, nonyl, decyl, undecyl, dodecyl, tetradecyl, hexadecyl, octadecyl, and eicosyl, preferably C₁₋₁₀ alkyl, and more preferably C₁₋₆ alkyl.

Examples of the "C₃₋₈ cycloalkyl" include cyclopropyl, cyclobutyl, cyclopentyl, cyclohexyl and cycloheptyl, and cyclooctyl.

The "C₂₋₂₀ alkenyl" may be linear, branched, or cyclic; and refers to one that has at least one double bond. Examples thereof include vinyl, allyl, 1-propenyl, 2-methyl-2-propenyl, isopropenyl, 1-, 2-, or 3-butenyl, 2-, 3-, or 4-penteny, 2-methyl-2-butenyl, 3-methyl-2-butenyl, 5-hexenyl, 1-cyclopentenyl, 1-cyclohexenyl, and 3-methyl-3-butenyl, preferably a C₂₋₁₂ alkenyl, and more preferably a C₂₋₆ alkenyl.

The "C₂₋₂₀ alkynyl" may be linear, branched, or cyclic; and refers to one that has at least one triple bond. Examples thereof include ethynyl, 1- or 2-propynyl, 1-, 2-, or 3-butynyl, 1-methyl-2-propynyl, 1-pentynyl, 1-hexynyl, 1-heptynyl, 1-octynyl, 1-nonenyl, 1-decynyl, 1-undecenyl, and 1-dodecynyl, preferably a C₂₋₁₀ alkynyl, and more preferably a C₂₋₆ alkynyl.

The "hydroxy C₁₋₂₀ alkyl" may be linear or branched; and is, for example, hydroxy C₁₋₂₀ alkyl such as hydroxymethyl, hydroxyethyl, hydroxy n-propyl, hydroxyisopropyl, hydroxy n-butyl, hydroxyisobutyl, hydroxy t-butyl, hydroxy n-pentyl, hydroxyisopentyl, hydroxyhexyl, hydroxyheptyl, hydroxyoctyl, hydroxynonyl, hydroxydecyl, hydroxyundecyl, hydroxydodecyl, hydroxytetradecyl, hydroxyhexadecyl, hydroxyoctadecyl, and hydroxyeicosyl, preferably a hydroxy C₁₋₁₀ alkyl, and more preferably a hydroxy C₁₋₆ alkyl.

The "C₁₋₂₀ alkoxy" may be linear or branched; and is, for example, C₁₋₂₀ alkoxy such as methoxy, ethoxy, propoxy, isopropoxy, butoxy, isobutoxy, t-butoxy, pentyloxy, isopentyloxy, hexyloxy, heptyloxy, octyloxy, nonyloxy, decyloxy, undecyloxy, dodecyloxy, tetradecyloxy, hexadecyloxy, octadecyloxy, and eicosyloxy, preferably a C₁₋₁₀ alkoxy, and more preferably a C₁₋₆ alkoxy.

As a trifluoroethoxy, CF₃CH₂O- is preferable.

The "C₂₋₁₂ perfluoroalkyl" may be linear or branched; and is, for example, C₂₋₁₂ perfluoroalkyl such as perfluoroethyl, perfluoro n-propyl, perfluoroisopropyl, perfluoro n-butyl, perfluoroisobutyl, perfluoro t-butyl, perfluoro n-pentyl, perfluoroisopentyl, perfluorohexyl, perfluoroheptyl, perfluorooctyl, perfluorononyl, perfluorodecyl, and perfluoroundecyl, preferably a C₂₋₁₀ perfluoroalkyl, and more preferably a C₂₋₆ perfluoroalkyl.

The "C₂₋₁₂ perfluoroalkoxy" may be linear or branched; and is, for example, a C₂₋₁₂ perfluoroalkoxy such as perfluoroethoxy, perfluoro n-propyloxy, perfluoroisopropyloxy, perfluoro n-butoxy, perfluoroisobutoxy, perfluoro t-butoxy, perfluoro n-pentyloxy, perfluoroisopentyloxy, perfluorohexyloxy, perfluoroheptyloxy, perfluorooctyloxy, perfluorononyloxy, perfluorodecyloxy, and perfluoroundecyloxy, preferably a C₂₋₁₀ perfluoroalkoxy, and more preferably a C₂₋₆ perfluoroalkoxy.

In a monoalkylamino, mono- or di-alkylcarbamoyl, or mono- or di-alkylsulfamoyl, "monoalkyl" refers to one hydrogen atom bound to a nitrogen atom of an amino, carbamoyl, or sulfamoyl, being substituted with a C₁₋₂₀ alkyl; and "dialkyl" refers to two hydrogen atoms bound to a nitrogen atom of amino, carbamoyl, or sulfamoyl, being substituted with the same or different C₁₋₂₀ alkyl, or being substituted with a three- to eight-membered, preferably five- or six-membered, nitrogen-containing cyclic group. Examples of the nitrogen-containing cyclic group include morpholine, 1-pyrrolidinyl, piperidine and 4-methyl-1-piperazinyl.

Examples of the monoalkylamino include amino that is mono-substituted with C₁₋₂₀ alkyl, such as methylamino, ethylamino, n-propylamino, isopropylamino, n-butylamino, isobutylamino, t-butylamino, n-pentylamino, isopentylamino, and hexylamino, preferably C₁₋₁₀ alkyl, and more preferably C₁₋₆ alkyl.

Examples of the monoalkylcarbamoyl include carbamoyl that is mono-substituted with C₁₋₂₀ alkyl such as methylcarbamoyl, ethylcarbamoyl, n-propylcarbamoyl, isopropylcarbamoyl, n-butylcarbamoyl, isobutylcarbamoyl, t-butylcarbamoyl, n-pentylcarbamoyl, isopentylcarbamoyl, and hexylcarbamoyl, preferably C₁₋₁₀ alkyl, and more preferably C₁₋₆ alkyl.

Examples of the dialkylcarbamoyl include carbamoyl that is di-substituted with C₁₋₂₀ alkyl such as dimethylcarbamoyl, diethylcarbamoyl, di-n-propylcarbamoyl, diisopropylcarbamoyl, di-n-butylcarbamoyl, diisobutylcarbamoyl, di-t-butylcarbamoyl, di-n-pentylcarbamoyl, diisopentylcarbamoyl, and dihexylcarbamoyl, preferably C₁₋₁₀ alkyl, and more preferably C₁₋₆ alkyl.

Examples of the monoalkylsulfamoyl include sulfamoyl that is mono-substituted with C₁₋₂₀ alkyl such as methylsulfamoyl, ethylsulfamoyl, n-propylsulfamoyl, isopropylsulfamoyl, n-butylsulfamoyl, isobutylsulfamoyl, t-butylsulfamoyl, n-pentylsulfamoyl, isopentylsulfamoyl, and hexylsulfamoyl, preferably C₁₋₁₀ alkyl, and more preferably C₁₋₆ alkyl.

Examples of the dialkylsulfamoyl include sulfamoyl that is di-substituted with C₁₋₂₀ alkyl such as dimethylsulfamoyl, diethylsulfamoyl, di-n-propylsulfamoyl, diisopropylsulfamoyl, di-n-butylsulfamoyl, diisobutylsulfamoyl, di-t-butylsulfamoyl, di-n-pentylsulfamoyl, diisopentylsulfamoyl, and dihexylsulfamoyl, preferably C₁₋₁₀ alkyl, and more preferably C₁₋₆ alkyl.

The "aryl" refers to a monocyclic or polycyclic group including a five- or six-membered aromatic hydrocarbon ring, and specific examples thereof include phenyl, (1-,2-)naphthyl, fluorenyl, anthryl, (2-,3-,4-)biphenylyl, tetrahydronaphthyl, 2,3-dihydro-1,4-dioxanaphthalenyl, terphenylyl(m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, p-terphenyl-4-yl), indanyl, indenyl, indacenyl, pyrenyl, naphthacenyl, perylenyl, pyrenyl, chrysenyl, acenaphthyl, acenaphthenyl, and phenanthryl; and these are optionally substituted with 1 to 5 groups as defined above.

The "heteroaryl" refers to a monocyclic or polycyclic group including a five- or six-membered aromatic ring having 1 to 3 heteroatoms selected from N, O, S, Se, and Si; and when the "heteroaryl" is polycyclic, at least one ring thereof may be an aromatic ring. Specific examples thereof include furyl, thienyl, selenophene, pyrrolyl, imidazolyl, pyrazolyl, oxazolyl, thiazolyl, isoxazolyl, isothiazolyl, pyridyl, pyrazinyl, pyrimidinyl, pyridazinyl, indolyl, quinolyl, isoquinolyl, carbazolyl, chromanyl, silole, benzo[b]silole, benzo[b]furyl, benzo[b]thienyl, benzo[b]selenophene, benzoindolyl, benzoquinolyl, benzisoquinolyl, benzocarbazolyl, benzochromanyl, benzimidazolyl, benzopyrazolyl, benzoxazolyl, benzothiazolyl, benzisoxazolyl, benzisothiazolyl, dibenzo[b,d]furyl, dibenzo[b,d]thienyl, thieno[3,4-b]thienyl, thieno[3,2-b]thienyl, and fluoro[3,2-b]furyl; and these are optionally substituted with 1 to 5 groups as defined above.

Examples of the monoarylamino include monoarylamino whose aryl is as defined above.

Examples of the diarylamino include diarylamino whose aryl is as defined above.

Examples of the monoheteroarylamino include monoheteroarylamino whose heteroaryl is as defined above.

The "C₁₋₂₀ alkylsulfonyl" may be linear, branched, or cyclic; and is, for example, C₁₋₂₀ alkylsulfonyl such as methylsulfonyl, ethylsulfonyl, n-propylsulfonyl, isopropylsulfonyl, n-butylsulfonyl, isobutylsulfonyl, t-butylsulfonyl, n-pentylsulfonyl, isopentylsulfonyl, hexylsulfonyl, heptylsulfonyl, octylsulfonyl, nonylsulfonyl, decylsulfonyl, undecylsulfonyl, dodecylsulfonyl, tetradecylsulfonyl, hexadecylsulfonyl, octadecylsulfonyl, and eicosylsulfonyl, preferably C₁₋₁₀ alkylsulfonyl, and more preferably C₁₋₆ alkylsulfonyl.

The "C₁₋₂₀ alkylcarbonylamino" may be linear, branched, or cyclic; and is, for example, C₁₋₂₀ alkylcarbonylamino such as methylcarbonylamino, ethylcarbonylamino, n-propylcarbonylamino, isopropylcarbonylamino, n-butylcarbonylamino, isobutylcarbonylamino, t-butylcarbonylamino, n-pentylcarbonylamino, isopentylcarbonylamino, hexylcarbonylamino, heptylcarbonylamino, octylcarbonylamino, nonylcarbonylamino, decylcarbonylamino, undecylcarbonylamino, dodecylcarbonylamino, tetradecylcarbonylamino, hexadecylcarbonylamino, octadecylcarbonylamino, and eicosylcarbonylamino, preferably C₁₋₁₀ alkylcarbonylamino, and more preferably C₁₋₆ alkylcarbonylamino.

Examples of the C₁₋₂₀ alkoxycarbonylamino (e.g., C₁₋₁₂ alkoxycarbonylamino and C₁₋₆ alkoxycarbonylamino) include methoxycarbonylamino, ethoxycarbonylamino, propoxycarbonylamino, isopropoxycarbonylamino, butoxycarbonylamino, isobutoxycarbonylamino, t-butoxycarbonylamino, pentyloxycarbonylamino, isopentyloxycarbonylamino, and hexyloxycarbonylamino.

The C₁₋₂₀ alkylsulfonylamino (e.g., C₁₋₁₀ alkylsulfonylamino and C₁₋₆ alkylsulfonylamino ) is, for example, C₁₋₁₂ alkylsulfonylamino such as methylsulfonylamino, ethylsulfonylamino, n-propylsulfonylamino, isopropylsulfonylamino, n-butylsulfonylamino, isobutylsulfonylamino, t-butylsulfonylamino, n-pentylsulfonylamino, isopentylsulfonylamino, hexylsulfonylamino, octylsulfonylamino, nonylsulfonylamino, decylsulfonylamino, undecylsulfonylamino, dodecylsulfonylamino, tetradecylsulfonylamino, hexadecylsulfonylamino, octadecylsulfonylamino, and eicosylsulfonylamino, preferably C₁₋₁₀ alkylsulfonylamino, and more preferably C₁₋₆ alkylsulfonylamino.

Examples of the C₁₋₂₀ alkoxycarbonyl (e.g., C₁₋₁₀ alkoxycarbonyl and C₁₋₆ alkoxycarbonyl) include methoxycarbonyl, ethoxycarbonyl, propoxycarbonyl, isopropoxycarbonyl, butoxycarbonyl, isobutoxycarbonyl, t-butoxycarbonyl, pentyloxycarbonyl, isopentyloxycarbonyl, and hexyloxycarbonyl.

Examples of the C₁₋₂₀ alkylcarbonyl (e. g. , C₁₋₁₀ alkylcarbonyl and C₁₋₆ alkylcarbonyl) include acetyl, propionyl, butyryl, pentylcarbonyl, hexycarbonyl, heptylcarbonyl, octylcarbonyl, nonylcarbonyl, and decylcarbonyl.

Examples of the monoaryl-substituted alkenyl (e.g., monoaryl-substituted C₂₋₁₂ alkenyl and a monoaryl-substituted C₂₋₆ alkenyl) include monoaryl-substituted alkenyl whose aryl is as defined above, such as styryl.

Examples of the diaryl-substituted alkenyl (e.g., diaryl-substituted C₂₋₁₂ alkenyl, and diaryl-substituted C₂₋₆ alkenyl) include diaryl-substituted alkenyl whose aryl is as defined above, such as diphenylvinyl.

Examples of the monoheteroaryl-substituted alkenyl (e.g., monoheteroaryl-substituted C₂₋₁₂ alkenyl and monoheteroaryl-substituted C₂₋₆ alkenyl) include monoheteroaryl-substituted alkenyl whose heteroaryl is as defined above, such as thienylvinyl.

Examples of the diheteroaryl-substituted alkenyl (e.g., diheteroaryl-substituted C₂₋₁₂ alkenyl and diheteroaryl-substituted C₂₋₆ alkenyl) include diheteroaryl-substituted alkenyl whose heteroaryl is as defined above, such as dithienylvinyl.

Examples of the arylethynyl include an arylethynyl whose aryl is as defined above.

Examples of the heteroarylethynyl include heteroarylethynyl whose heteroaryl is as defined above.

Examples of the aryloxy include aryloxy whose aryl is as defined above.

R^{a} represents optionally substituted alkyl, optionally substituted aryl, or optionally substituted heteroaryl. Examples of the "alkyl" in the optionally substituted alkyl include the above-described C₁₋₂₀ alkyl, and examples of the "aryl" in the optionally substituted aryl include the above-described aryl. Examples of the "heteroaryl" in the optionally substituted heteroaryl include the above-described heteroaryl.

More specific examples of the polycyclic aromatic compound of the present invention include compounds represented by the following formulae (1) to (709):

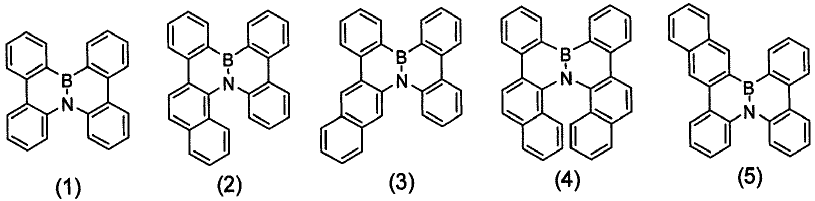

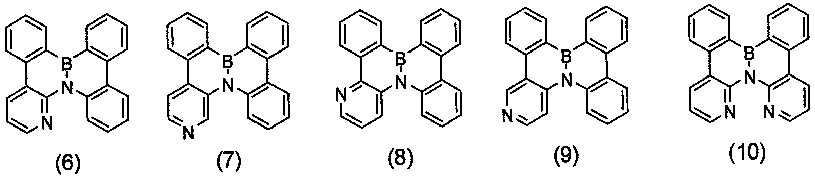

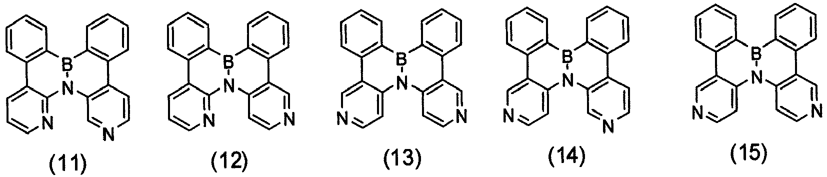

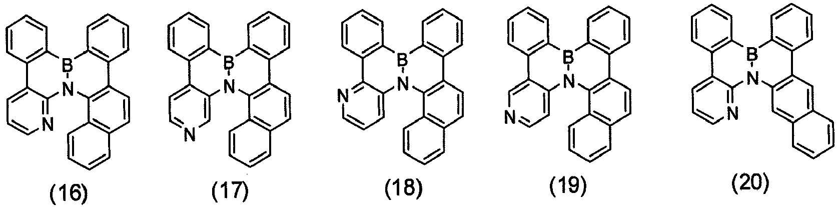

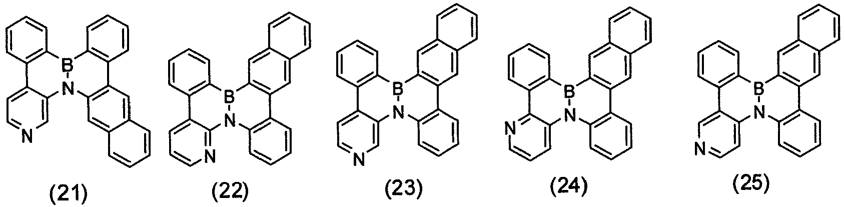

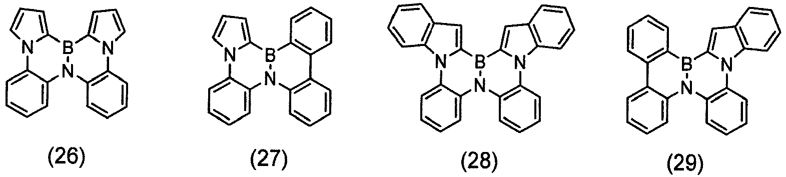

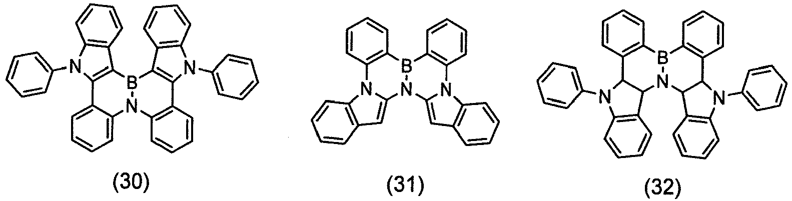

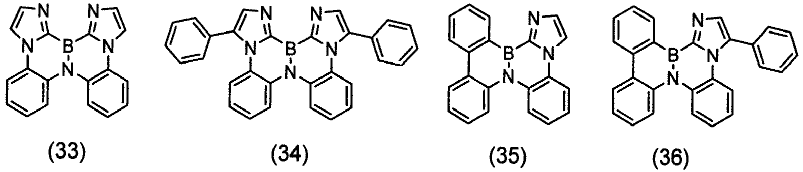

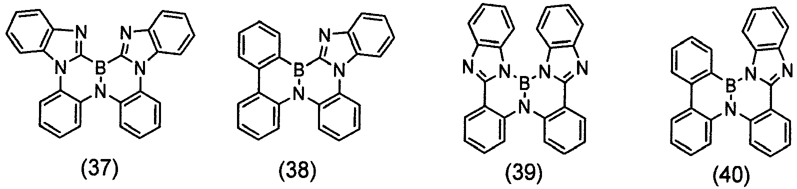

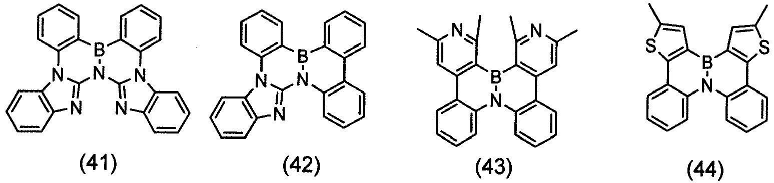

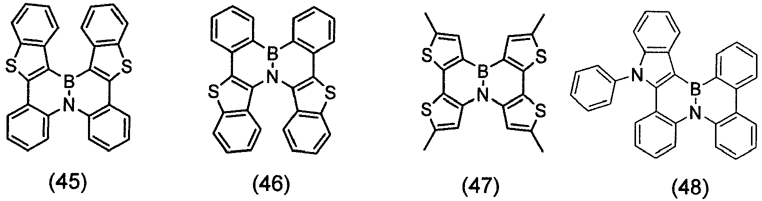

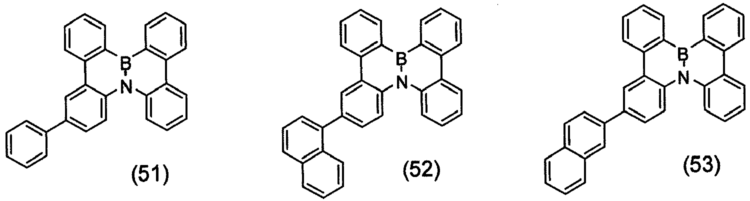

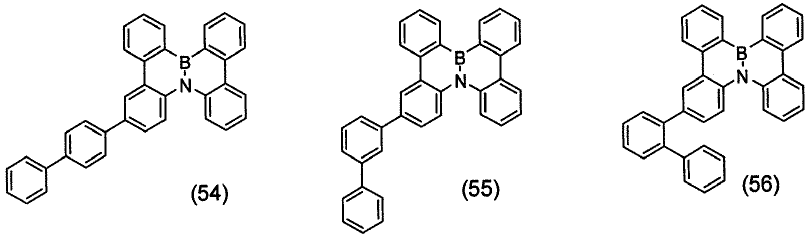

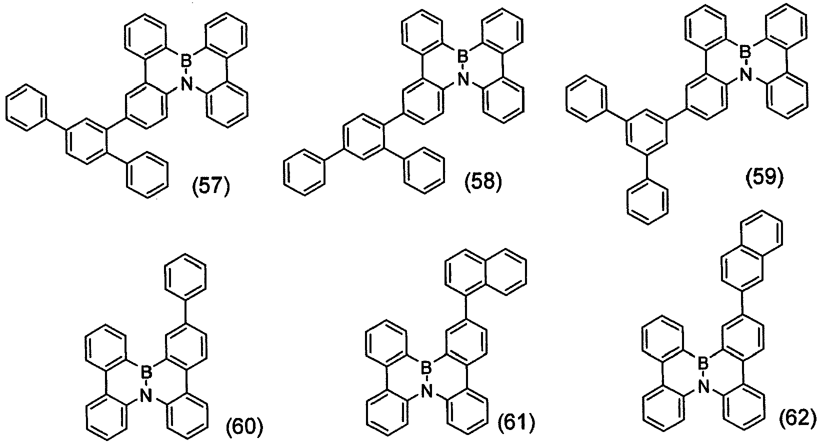

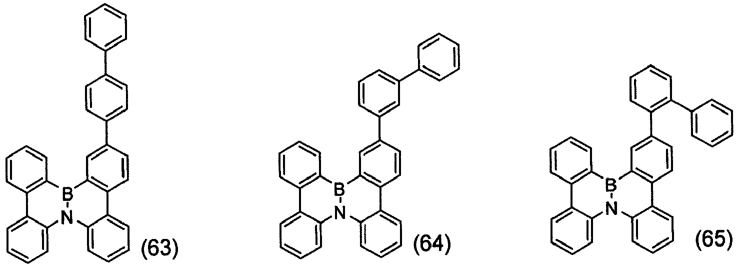

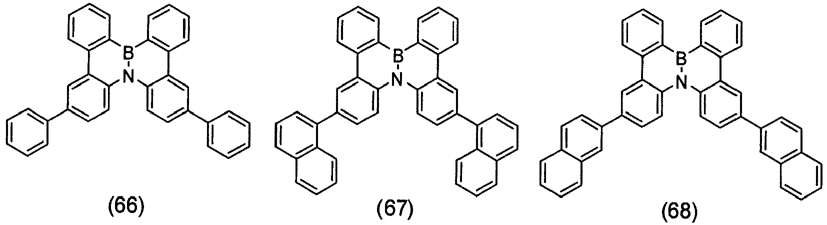

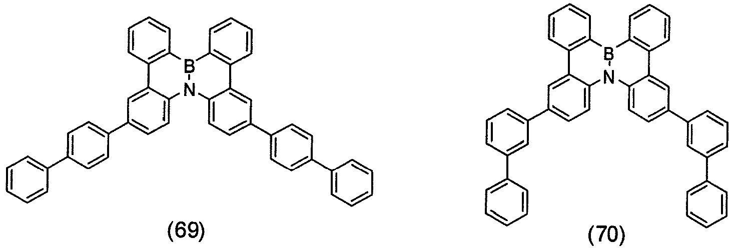

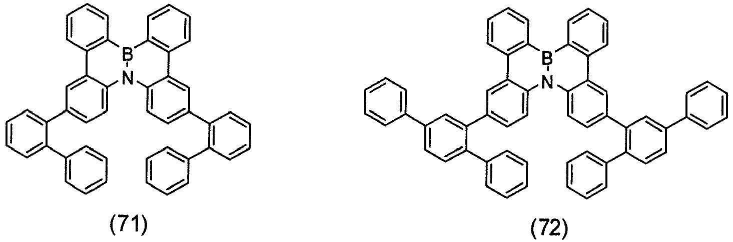

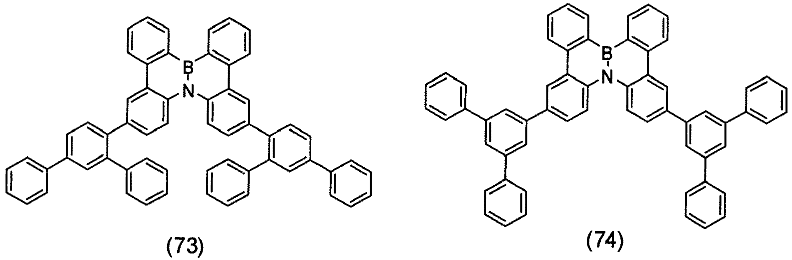

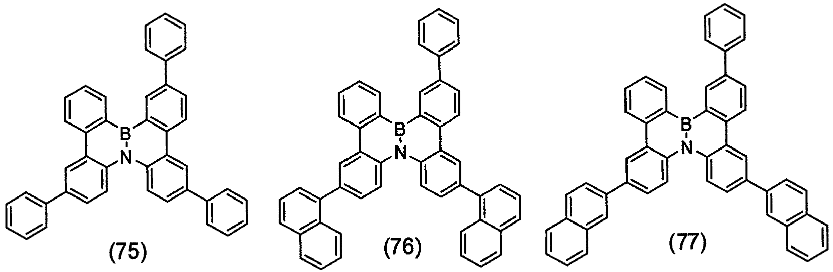

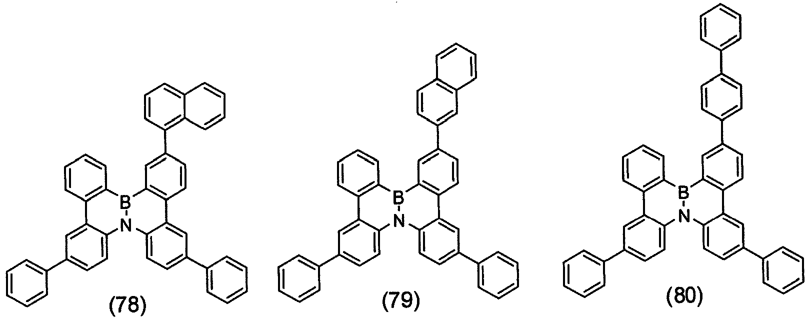

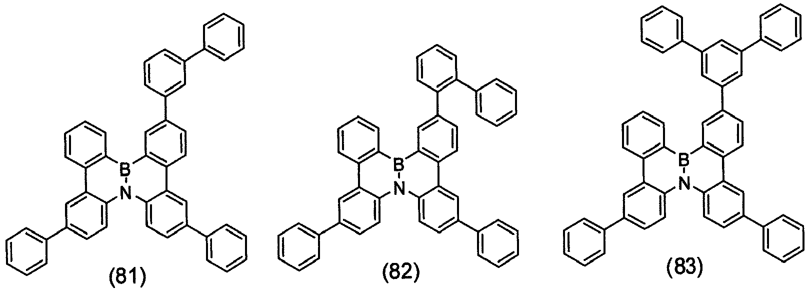

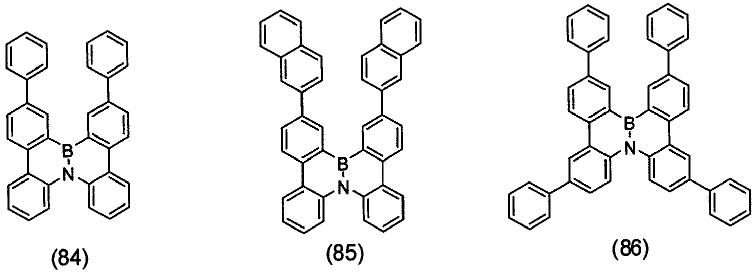

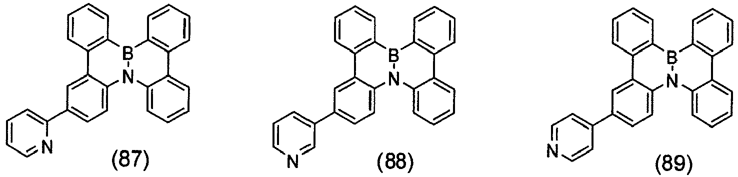

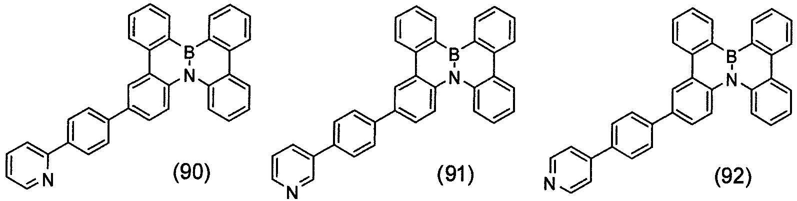

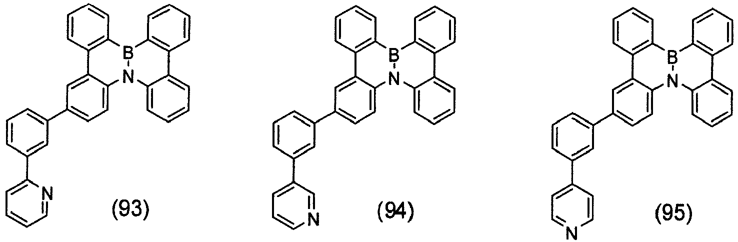

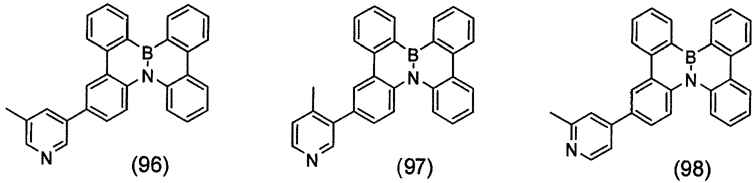

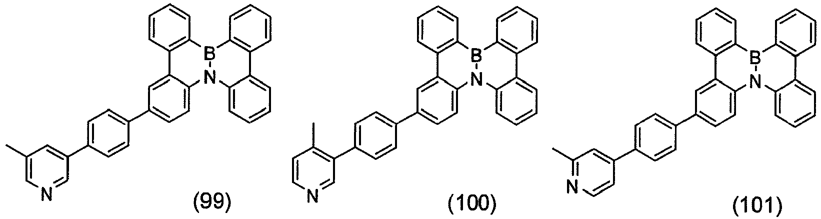

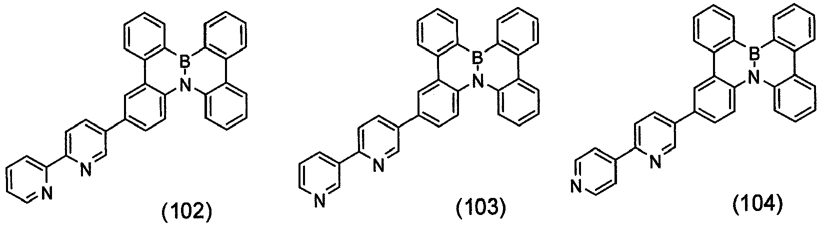

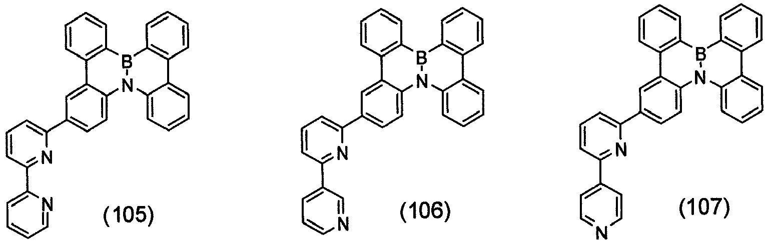

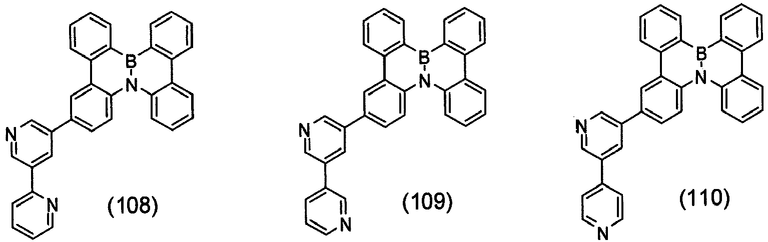

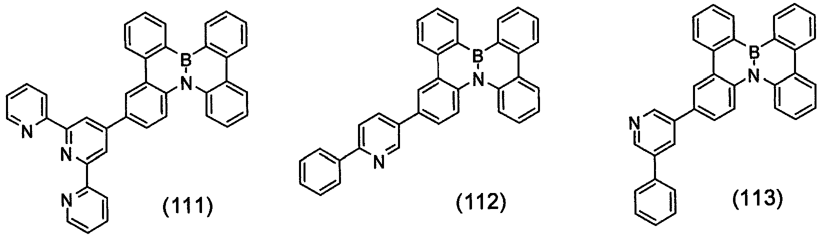

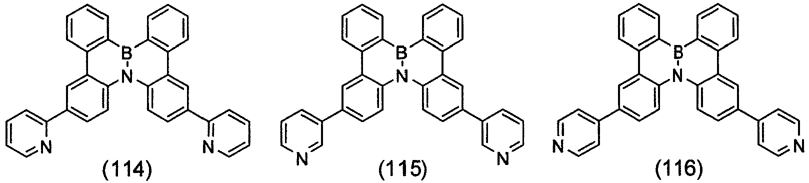

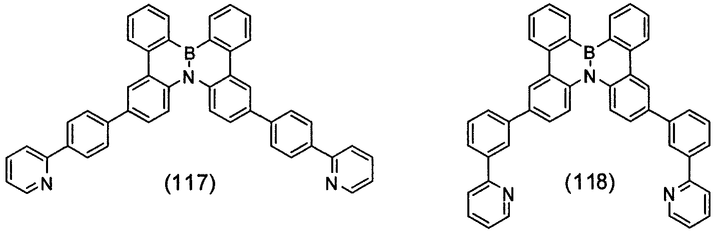

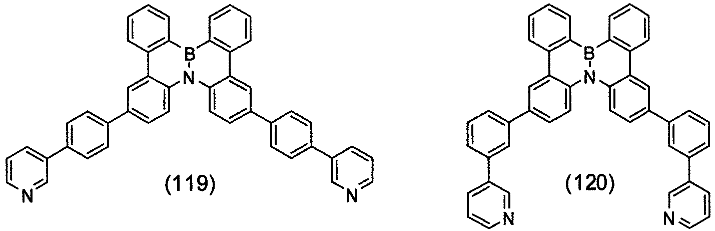

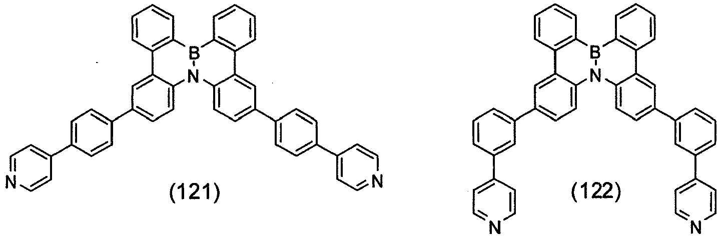

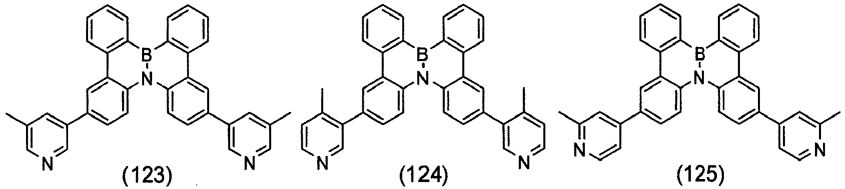

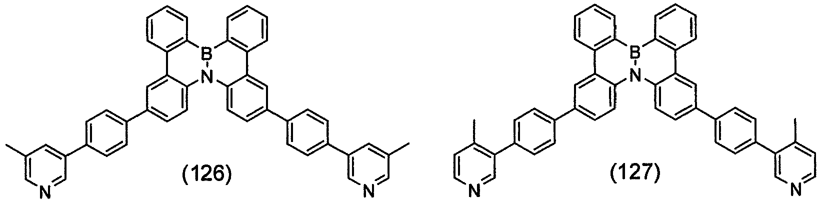

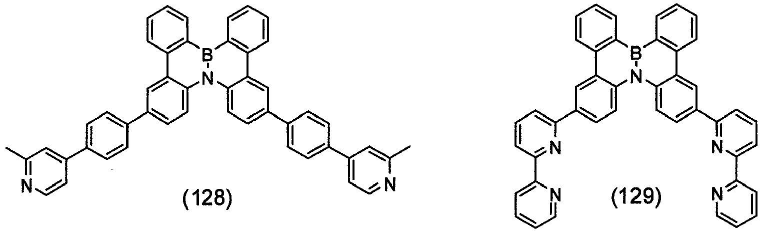

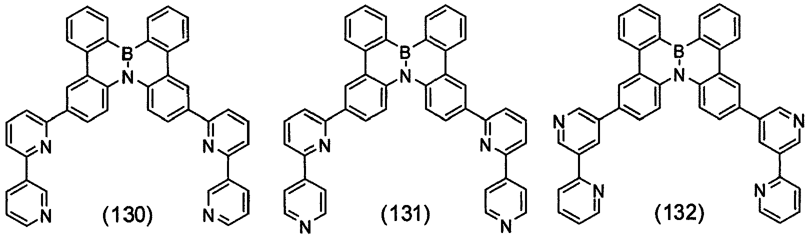

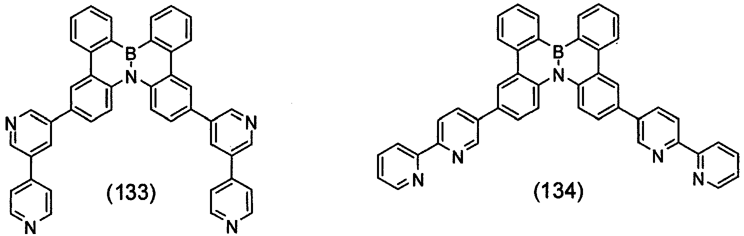

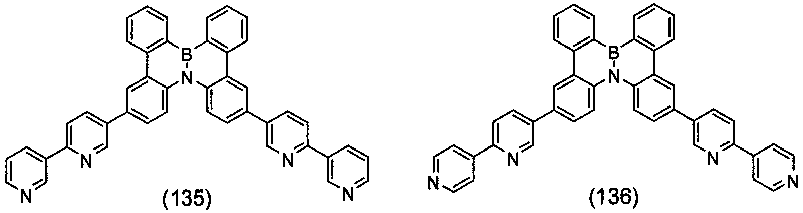

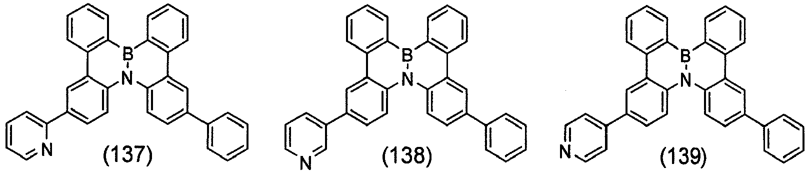

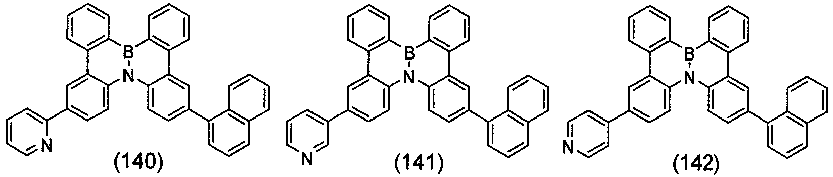

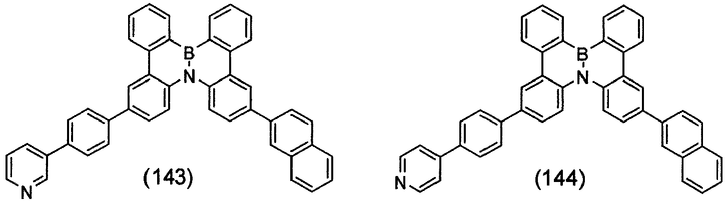

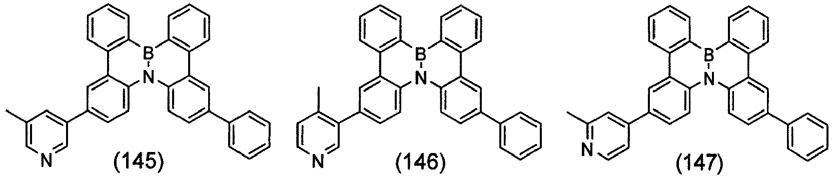

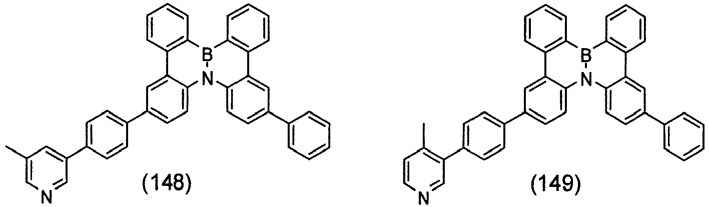

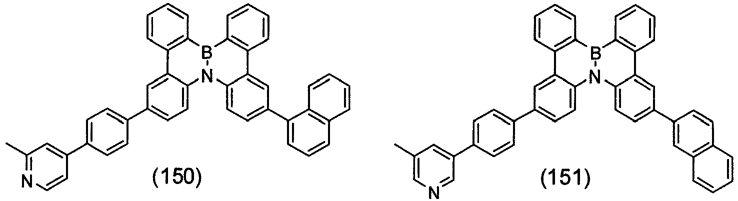

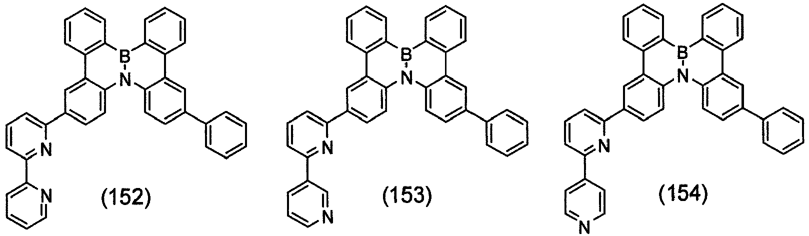

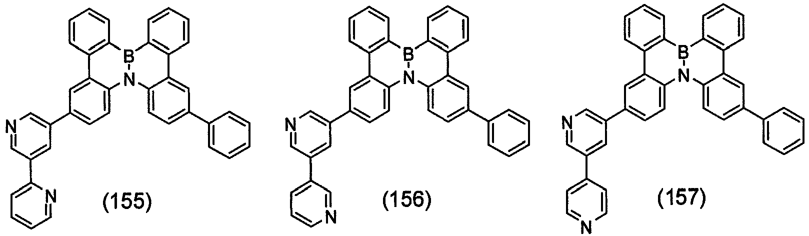

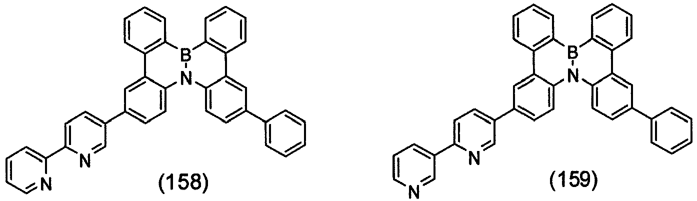

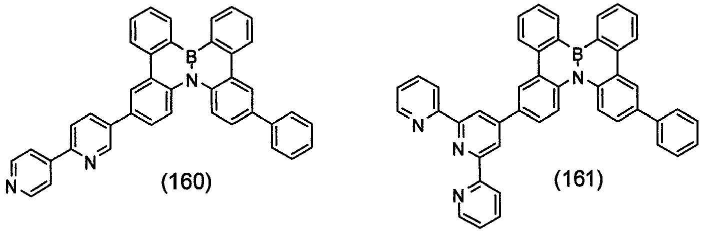

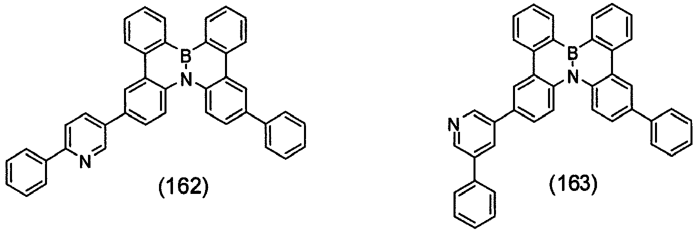

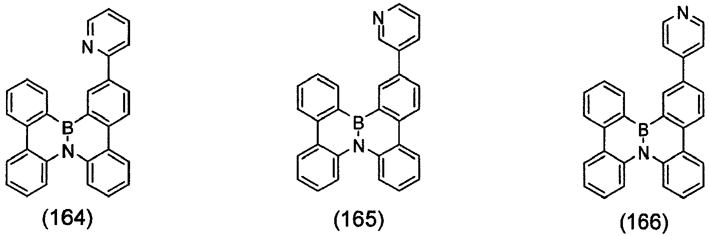

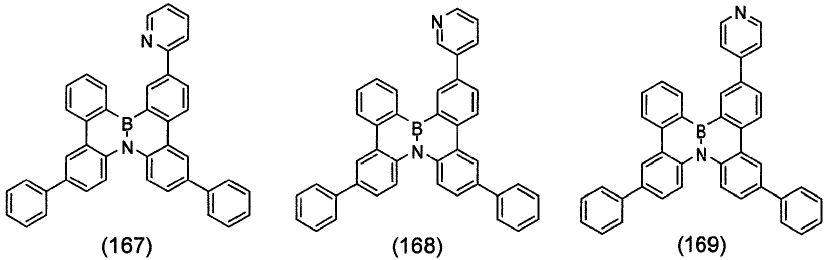

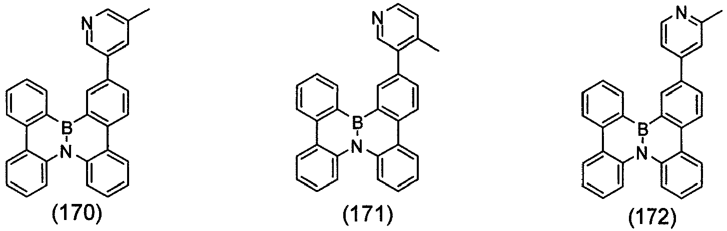

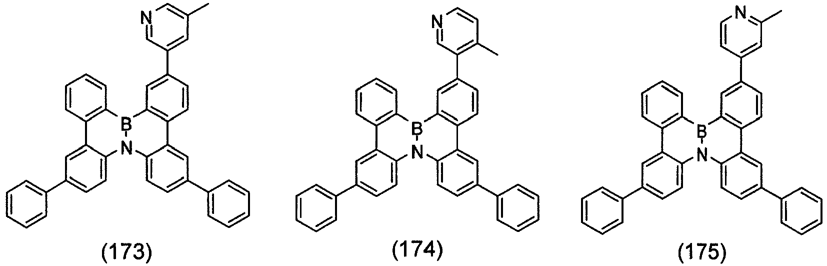

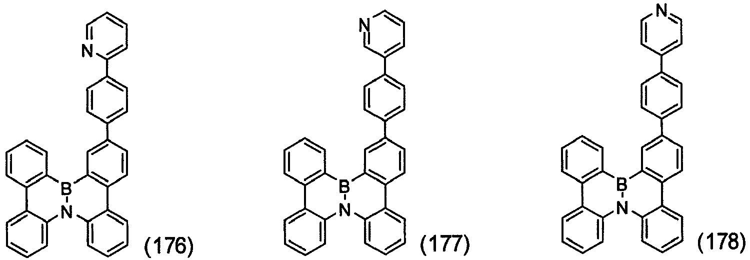

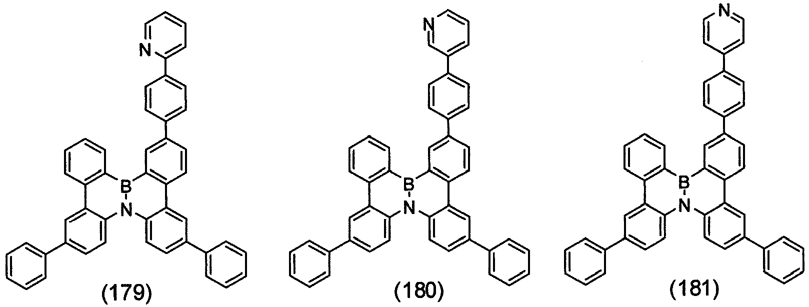

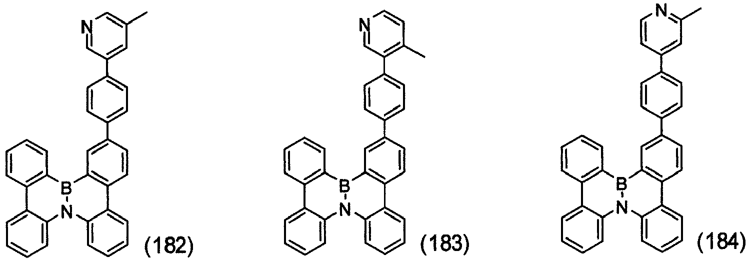

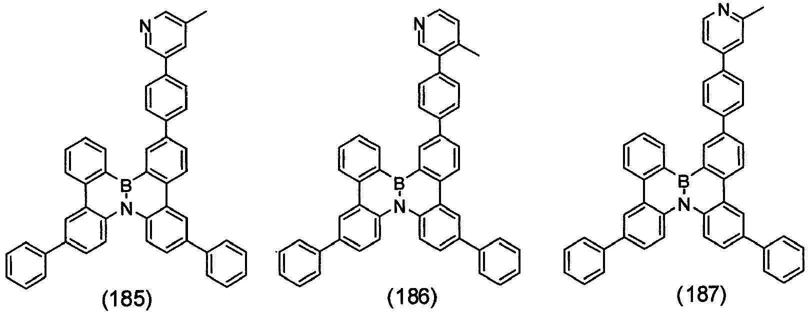

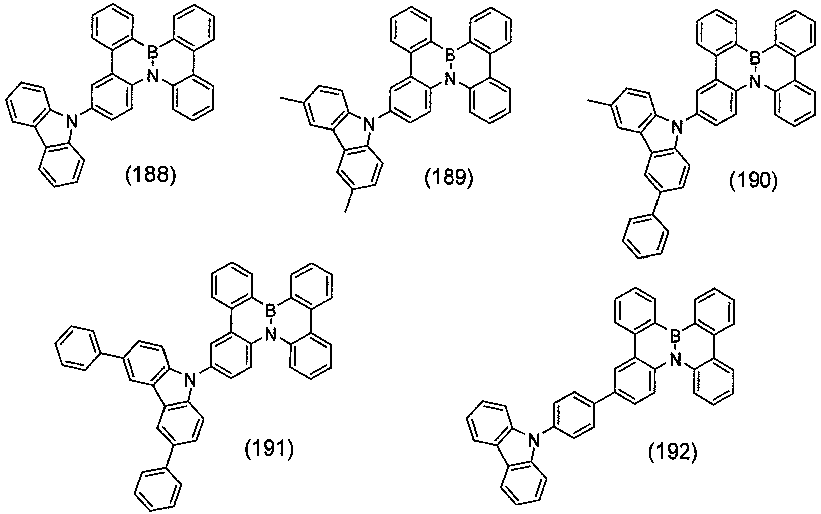

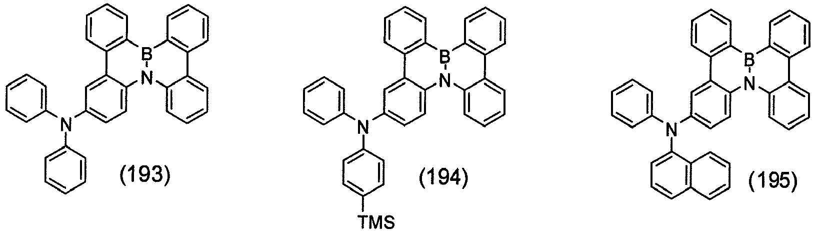

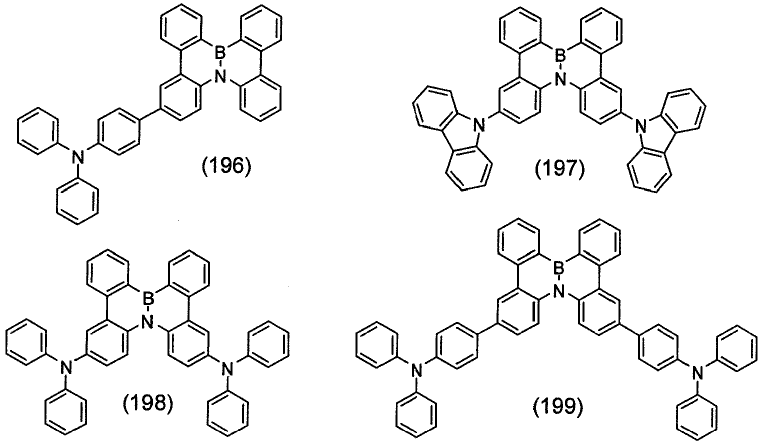

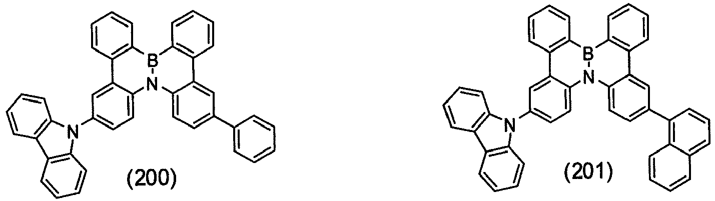

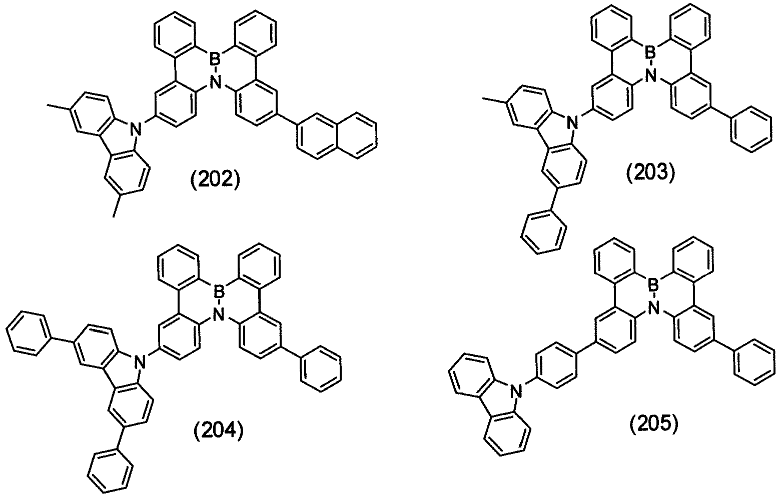

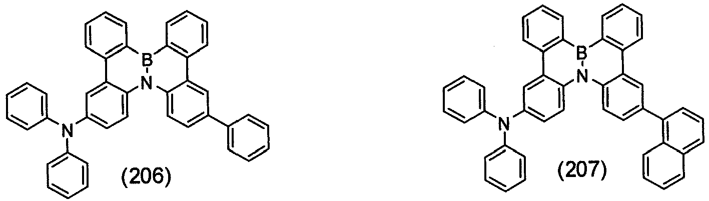

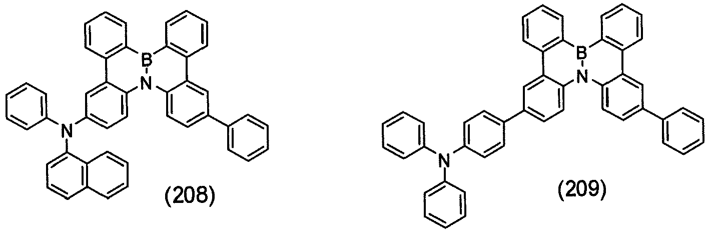

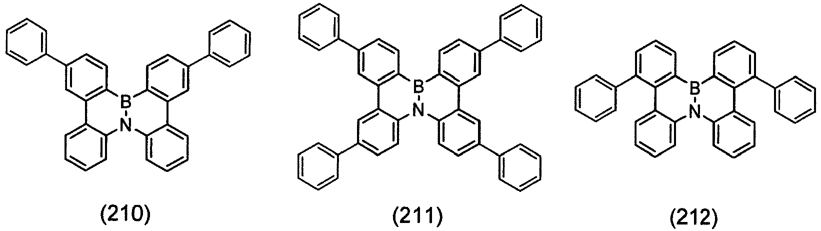

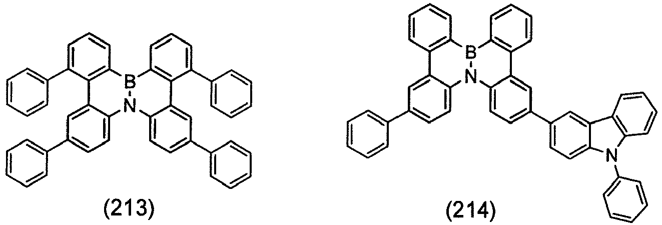

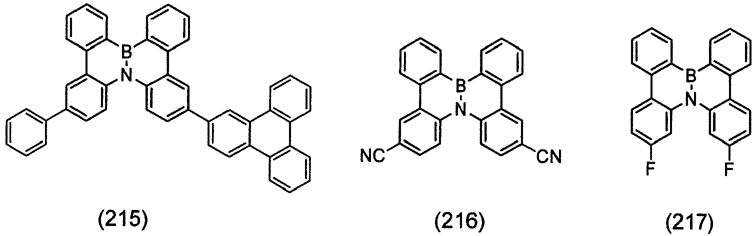

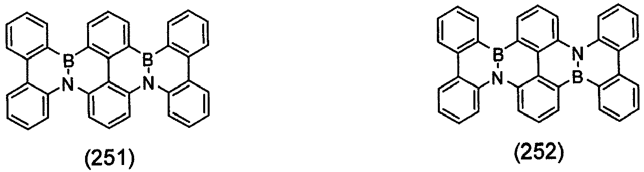

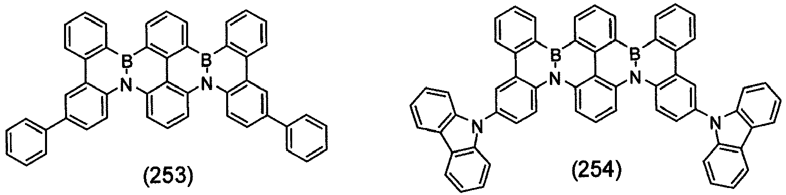

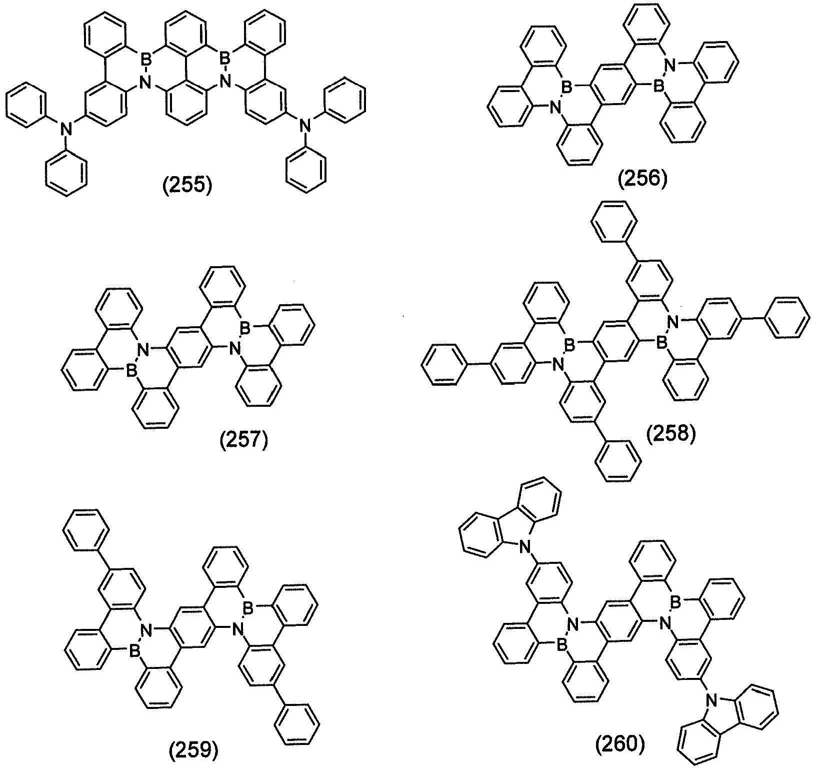

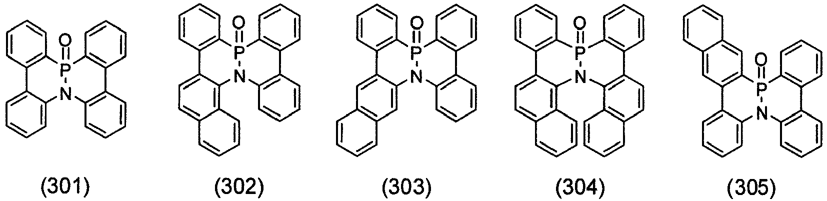

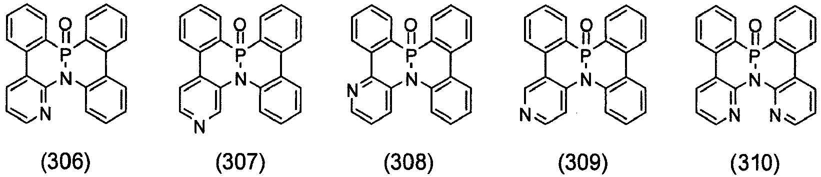

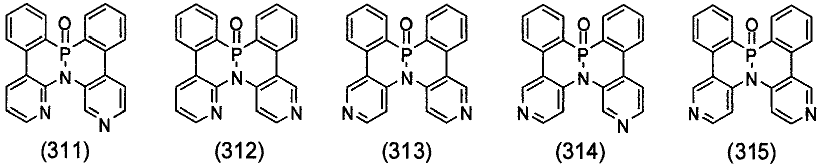

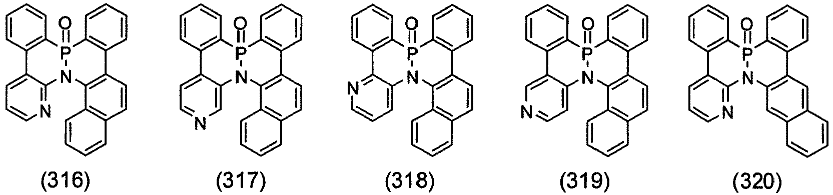

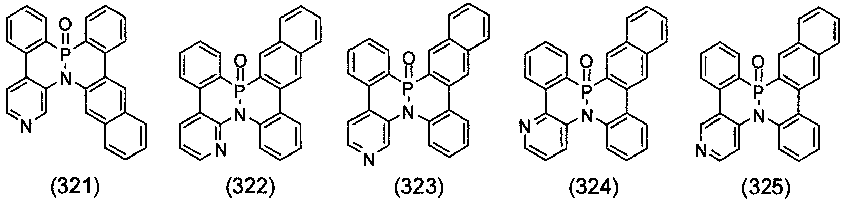

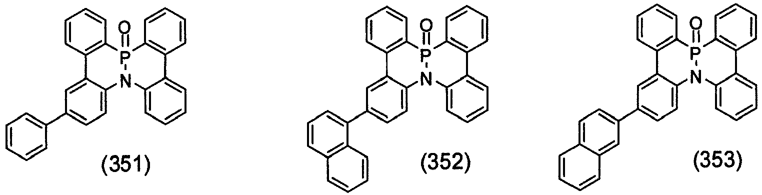

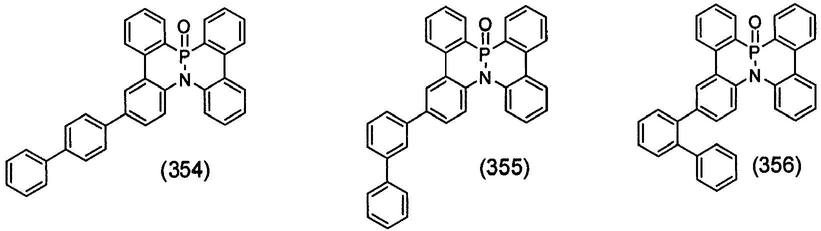

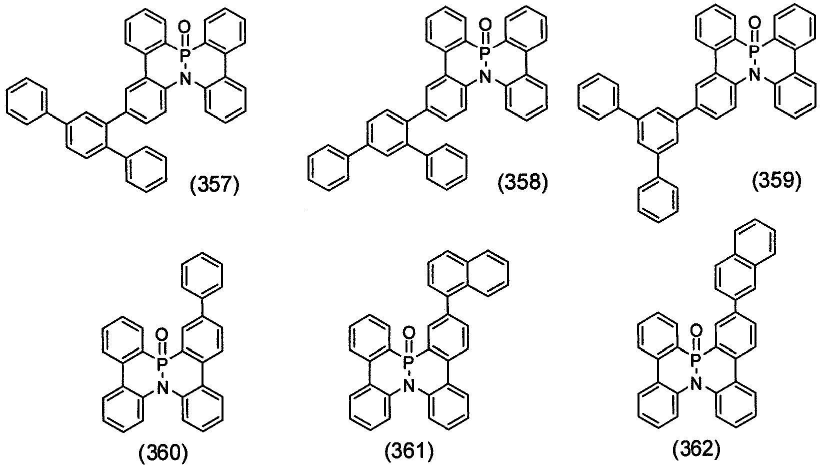

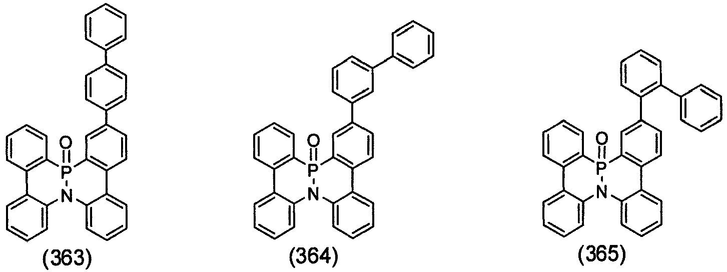

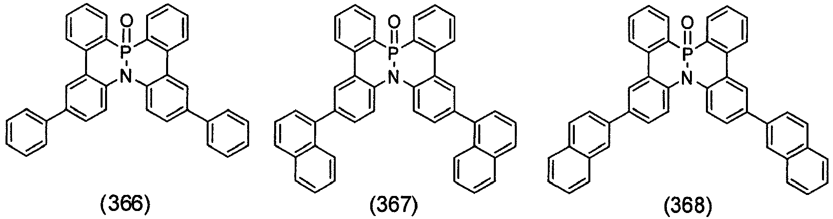

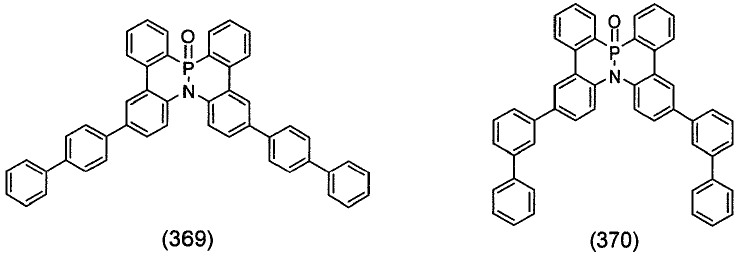

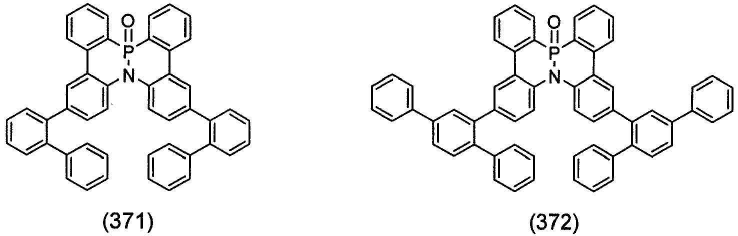

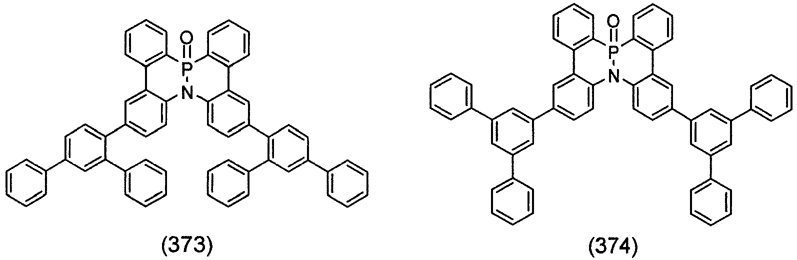

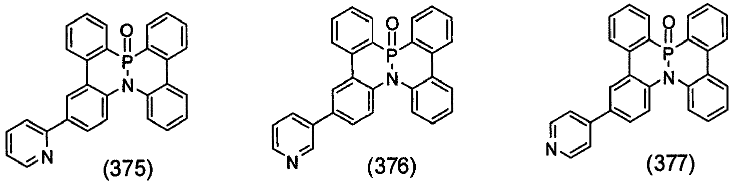

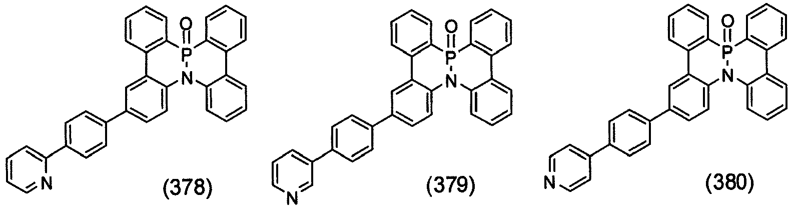

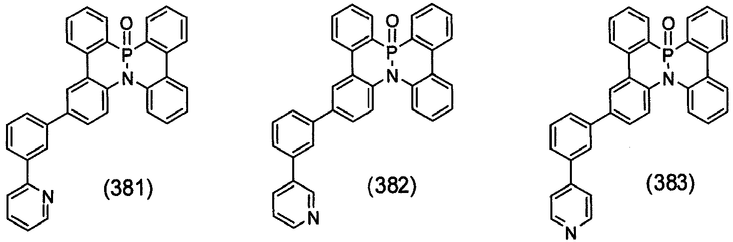

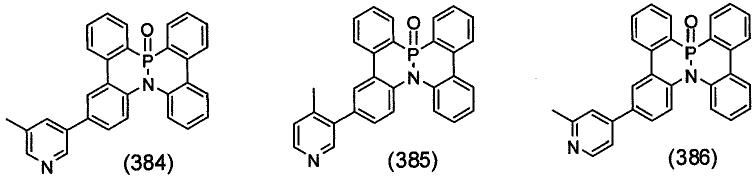

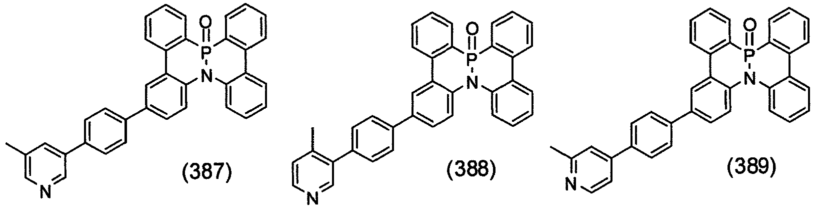

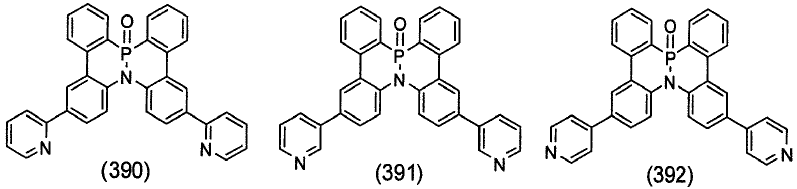

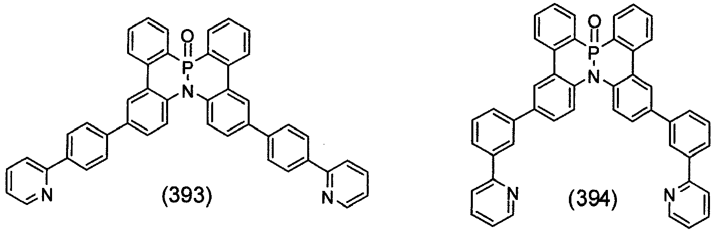

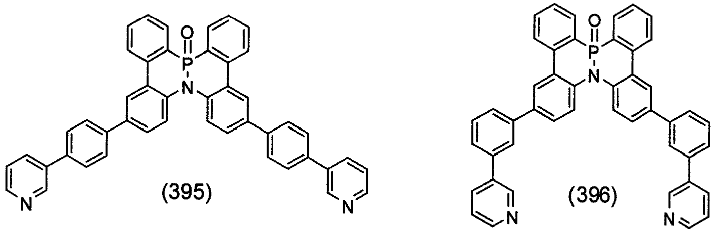

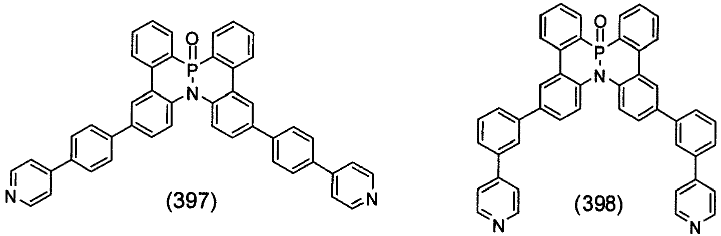

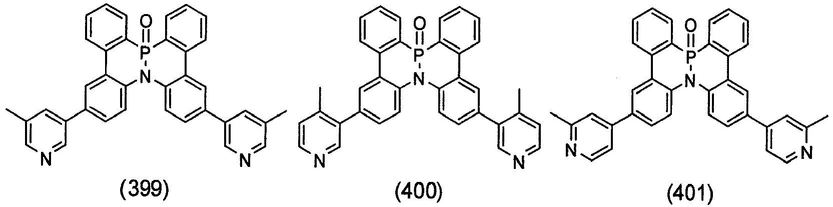

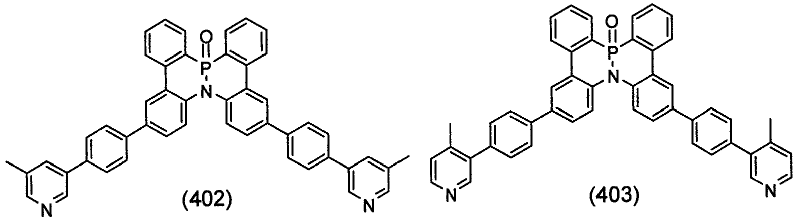

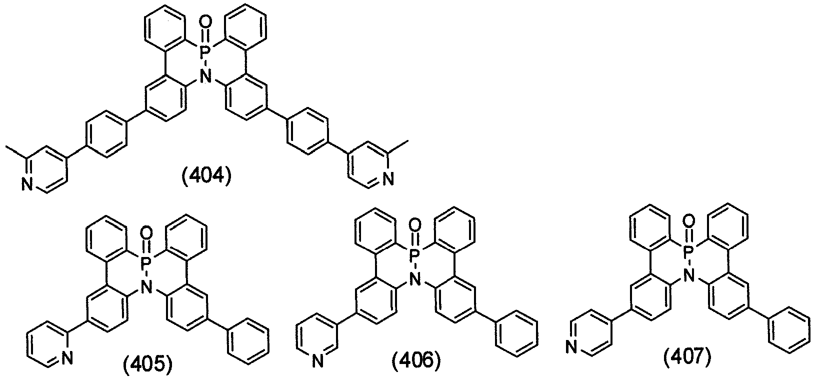

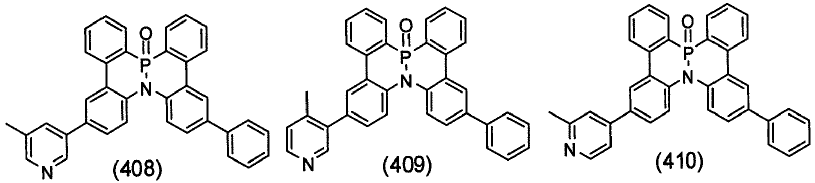

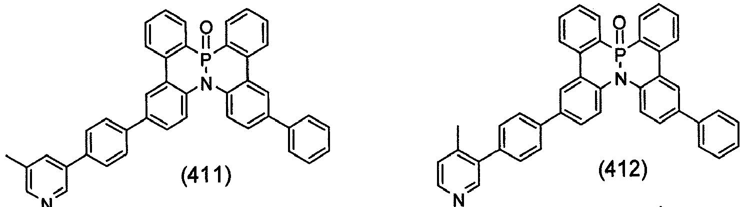

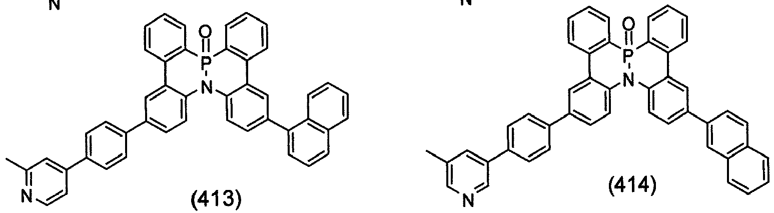

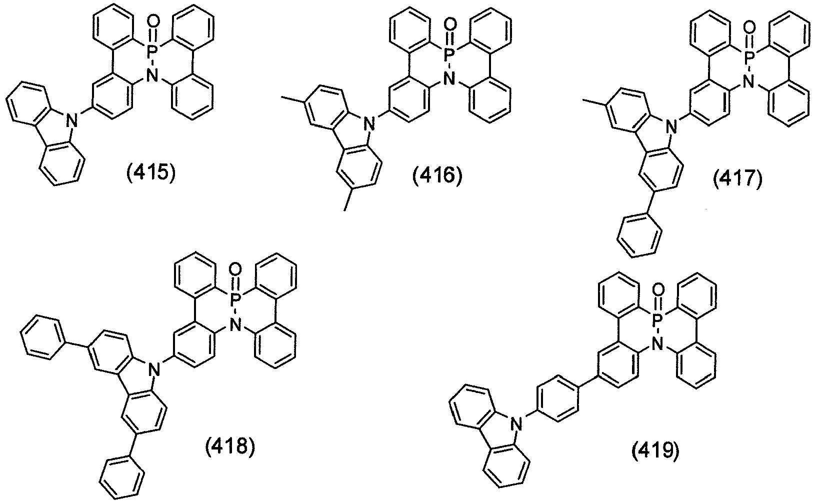

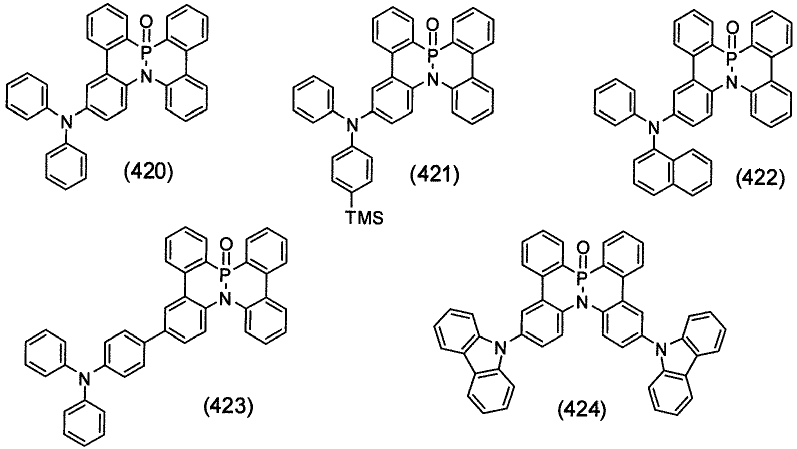

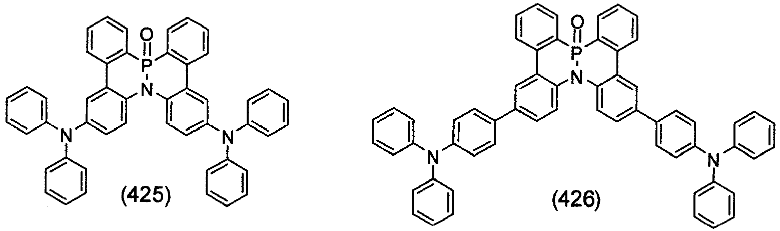

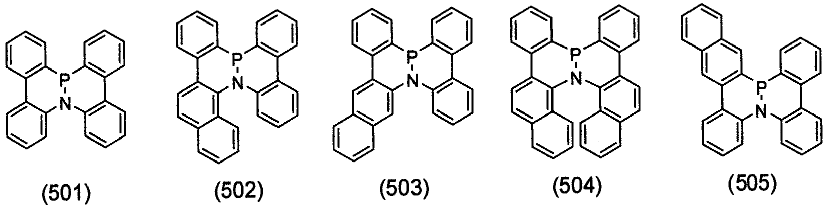

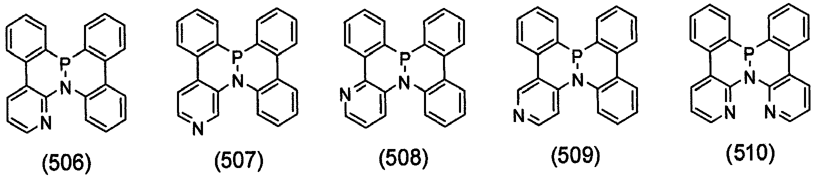

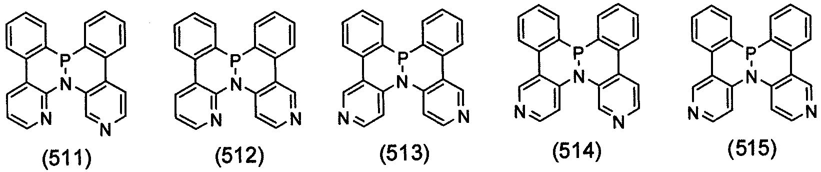

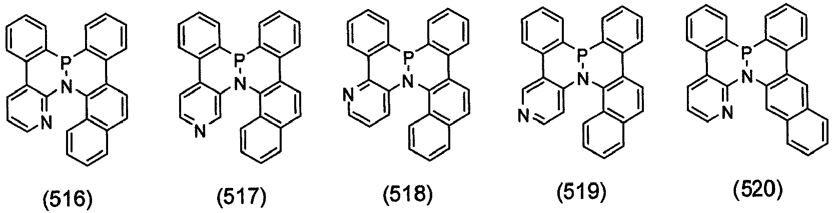

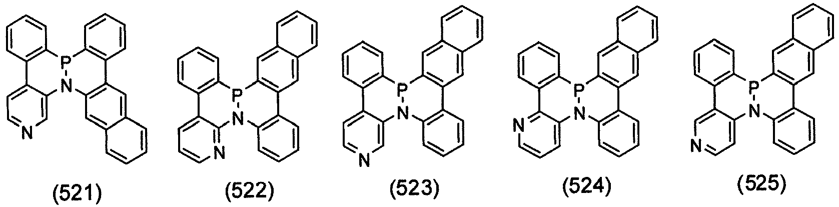

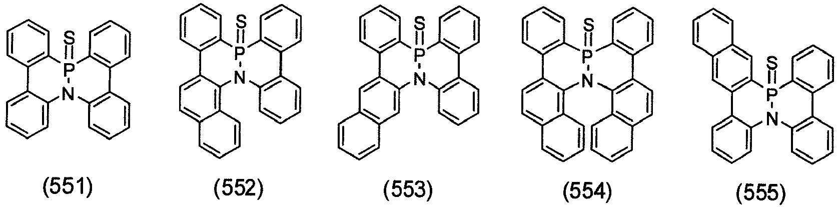

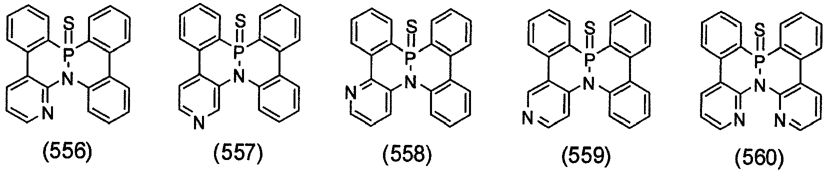

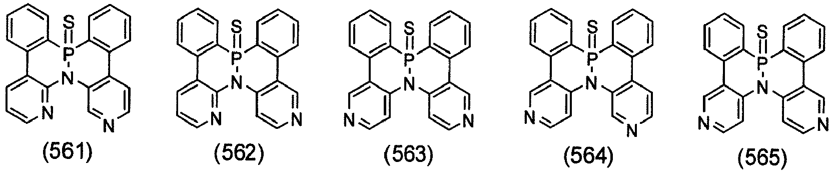

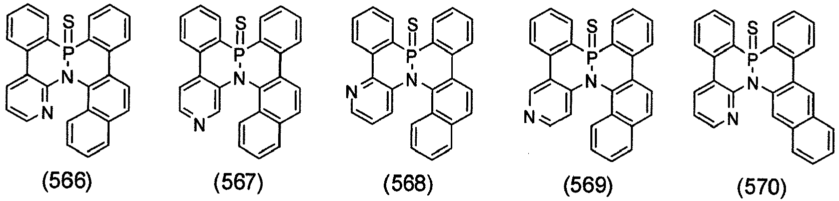

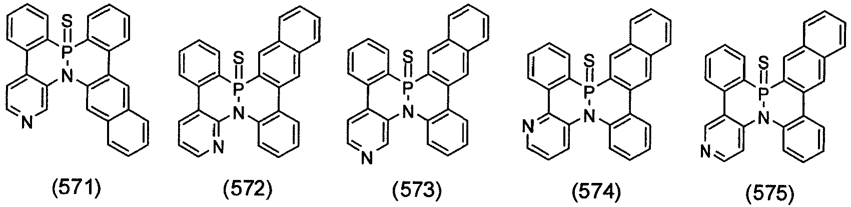

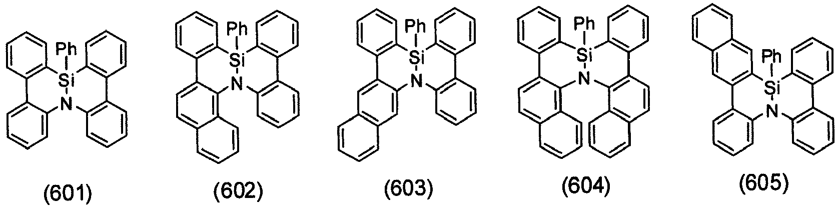

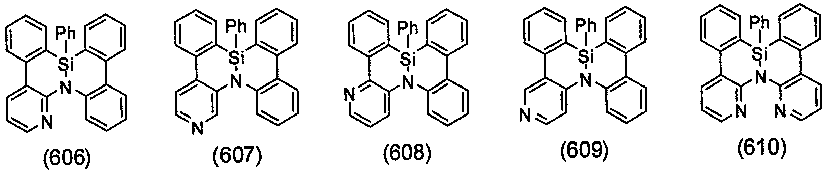

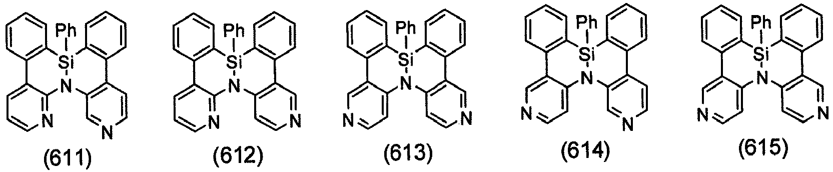

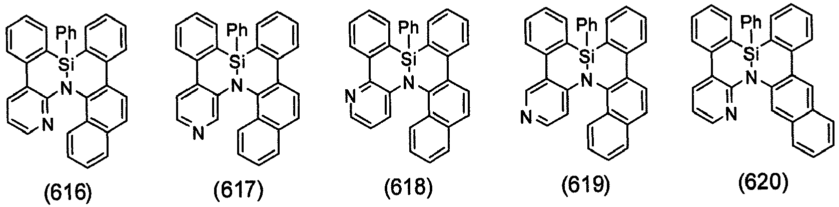

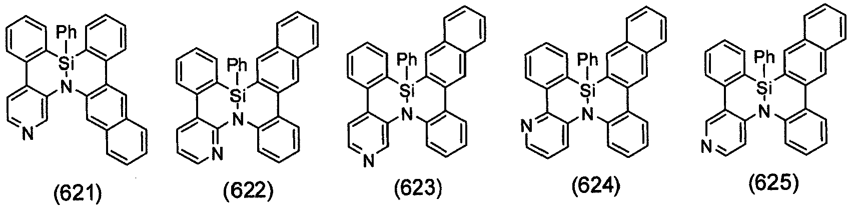

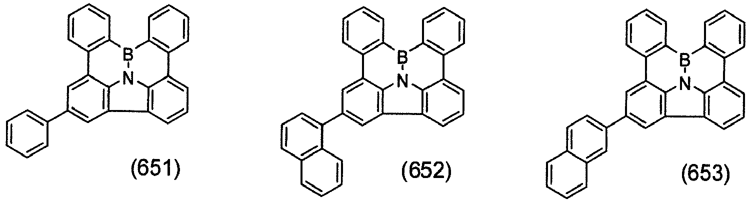

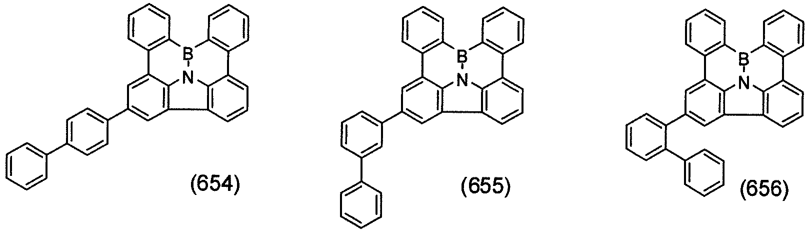

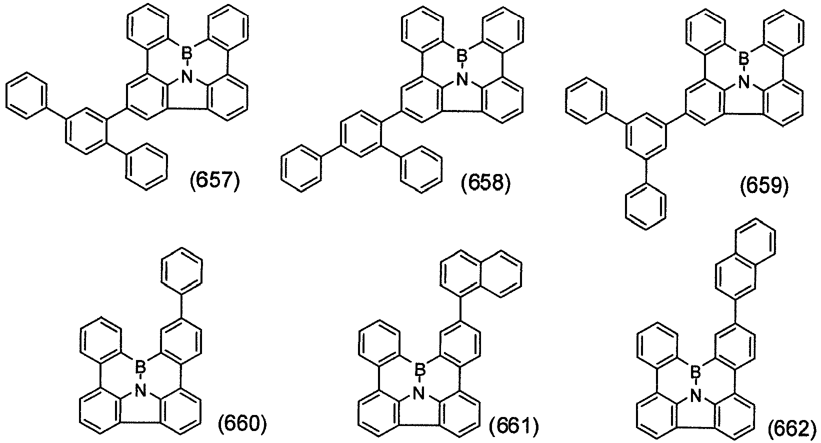

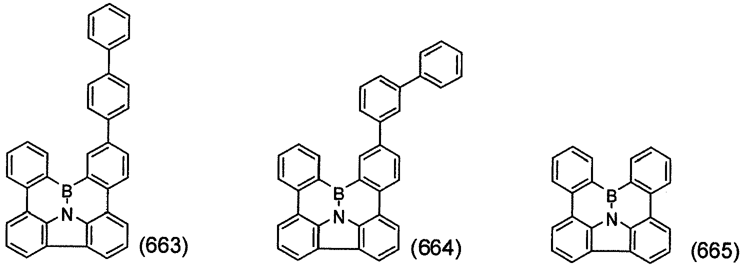

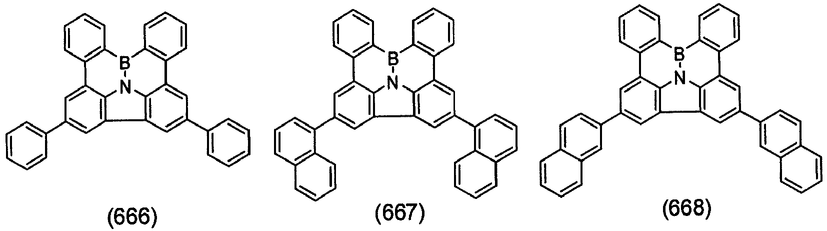

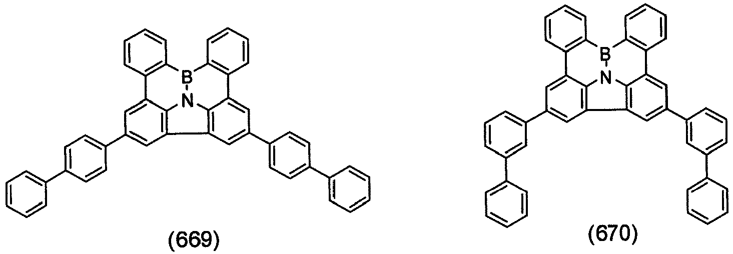

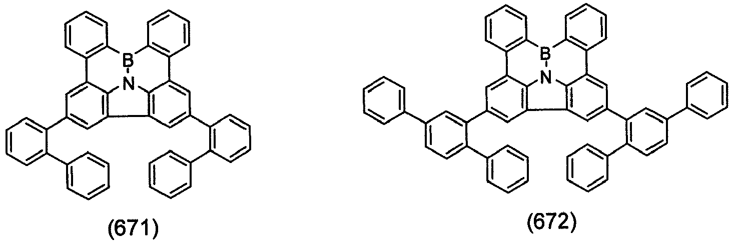

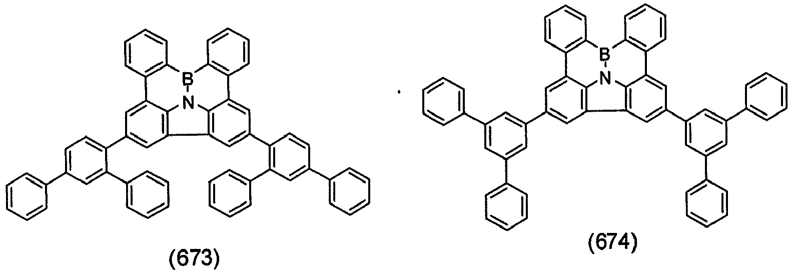

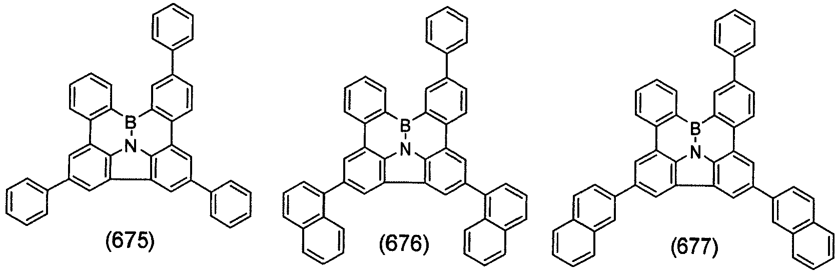

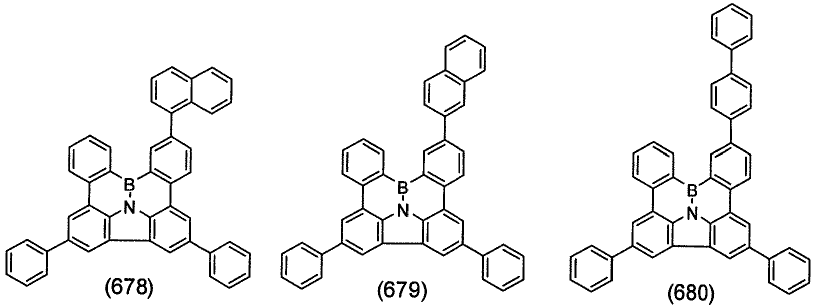

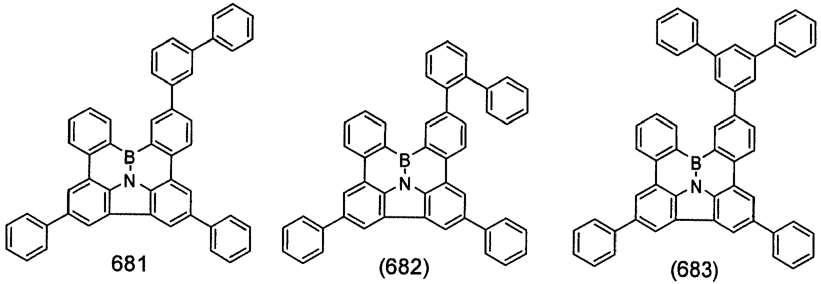

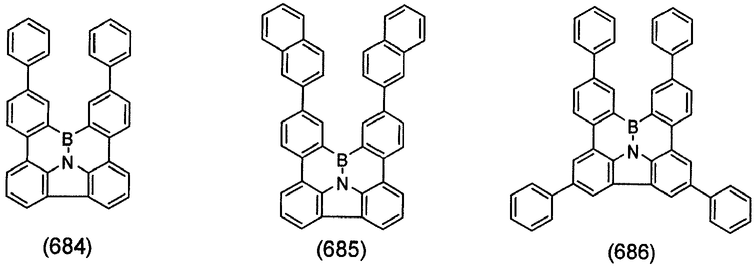

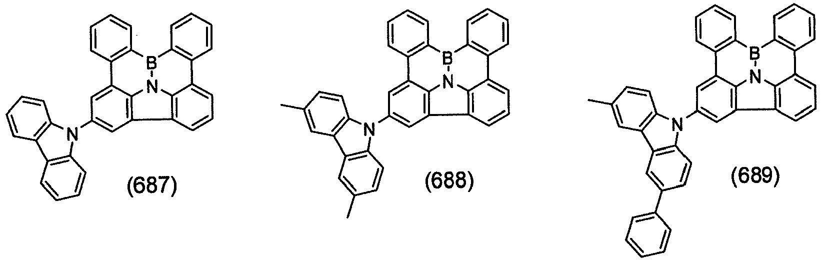

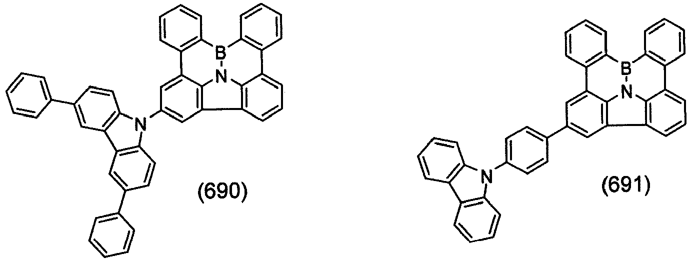

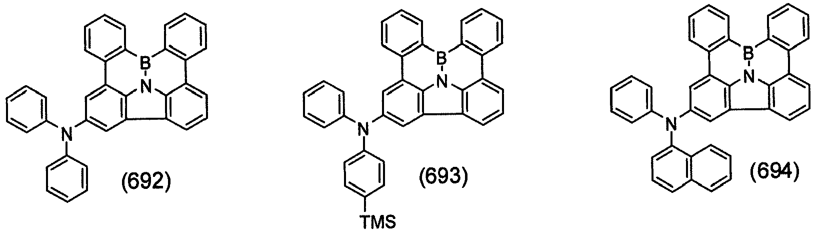

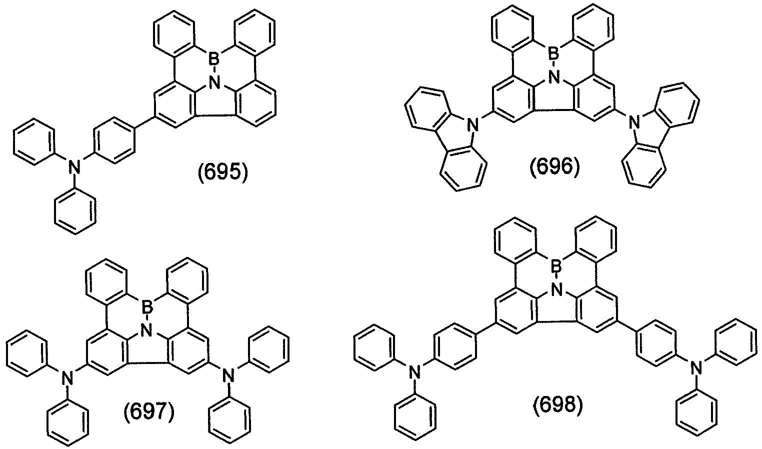

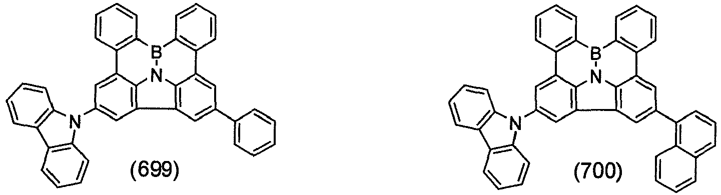

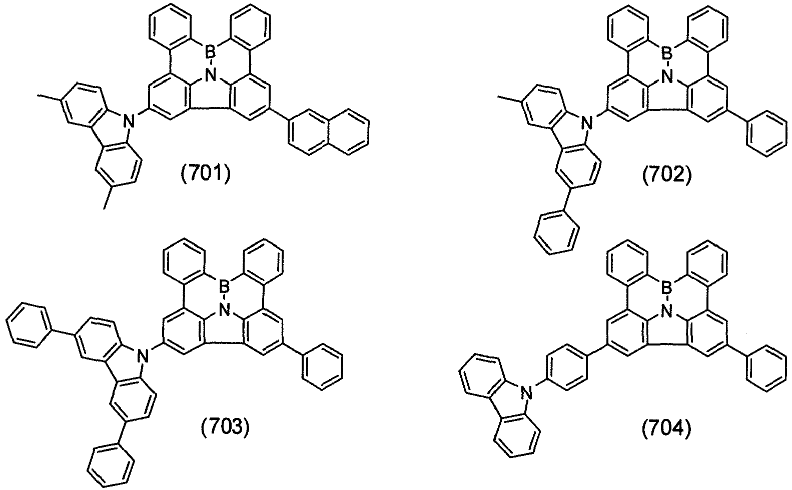

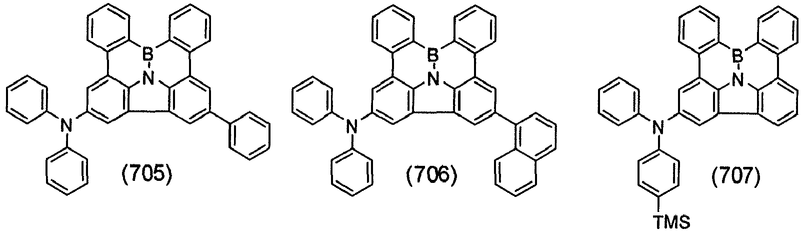

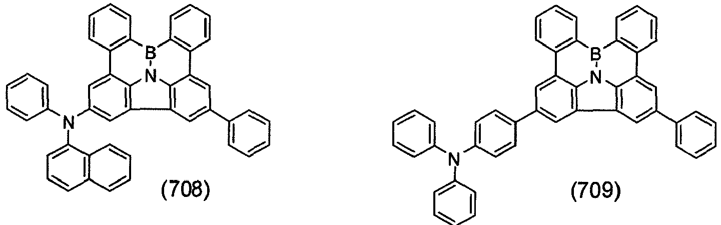

### 2. Method for producing polycyclic aromatic compound represented by the formula (I)

Next, a method for producing the compound of the present invention will be described. The compound of the present invention is a polycyclic aromatic compound (and a salt thereof), and has a partial structure represented by the above described general formula (I), and is more specifically a polycyclic aromatic compound having a partial structure represented by the above described general formula (II) or (II'), and furthermore a polycyclic aromatic compound having a partial structure represented by the above described general formulae (III-1) to (III-54), the above described general formulae (III-55) to (III-60), and the like. As the entire structure, examples include a polycyclic aromatic compound represented by the above described general formulae (IV-1) to (IV-22), more specifically a polycyclic aromatic compound represented by the above described general formulae (V-1) to (V-26) and the above described general formulae (V-27) to (V-34), a polycyclic aromatic compound represented by the above described general formulae (V-1'), (V-2') and (V-3'), a polycyclic aromatic compound represented by the above described general formula (V-27') or (V-32'), a polycyclic aromatic compound represented by the above described general formulae (VI-1) to (VI-149), and a polycyclic aromatic compound represented by the above described general formulae (1) to (709).

The basic structure constituting the polycyclic aromatic compound of the present invention, that is, a partial structure represented by a series of the above described general formula (I), (II), (II') or (III) can be synthesized in accordance with the following scheme 1. In the scheme 1, Y^{a} and X are as defined above.

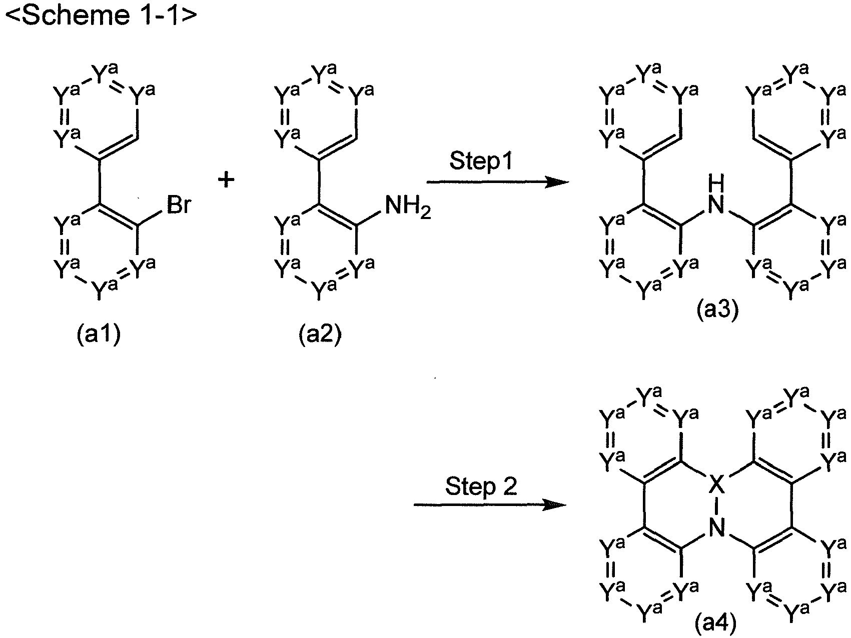

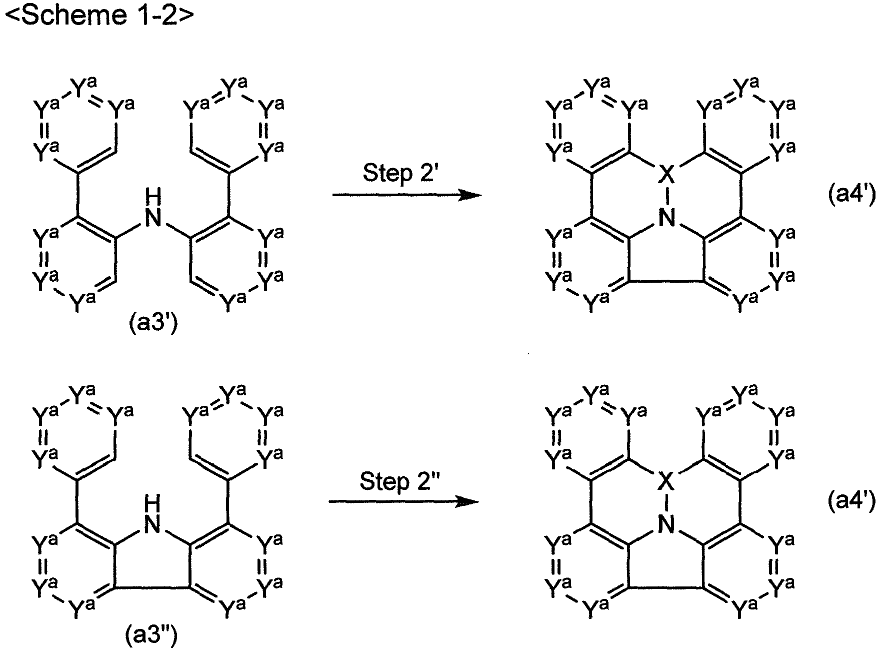

In the reaction of the step 1, with respect to 1 mol of the compound (a1), about 1 mol to an excessive amount of a base such as alkyl lithiums such as n-BuLi, Grignard reagents such as n-BuMgBr, alkali metal hydrides such as NaH and KH, alkali metal alkoxides such as NaO^{t}Bu, KO^{t}Bu, and alkali metal carbonates such as Na₂CO₃, NaHCO₃, K₂CO₃, Cs₂CO₃, and 1 mol to an excessive amount of the compound (a2) are used; and Pd(dba)₂, P^{t}Bu₃ are further used. The mixture is allowed to react by having it stirred for 30 minutes to 24 hours in a solvent at a temperature of -78°C to about room temperature to obtain compound (a3). As the solvent, an anhydrous ether solvent such as anhydrous diethyl ether, anhydrous THF, or anhydrous dibutyl ether; or an aromatic hydrocarbon solvent such as benzene, toluene, xylene, or mesitylene can be used.

Next, in the reaction of the step 2, the compound (a3) is deprotonated using a deprotonating agent such as n-BuLi; and a compound including X (a halide, an alkoxy derivative, an aryloxy derivative, an acyloxy derivative, or a haloamino derivative of X) is added thereto to introduce an X group. Then, by performing a Friedel-Crafts-type reaction in the presence of a Lewis acid such as AlCl₃ and a base such as diisopropylethylamine, the compound (a4) can be obtained.

Examples of the compound including X include, when X=P, halides such as PF₃, PCl₃, PBr₃, PI₃, alkoxy derivatives such as P(OMe)₃, P(OEt)₃, P(O-nPr)₃, P(O-iPr)₃, P(O-nBu)₃, P(O-iBu)₃, P(O-secBu)₃, P(O-t-Bu)₃, aryloxy derivatives such as P(OPh)₃, P(O-naphthyl)₃, acyloxy derivatives such as P(OAc)₃, P(O-trifluoroacetyl)₃, P(O-propionyl)₃, P(O-butyryl)₃, and P(O-benzoyl)₃, and haloamino derivatives such as PCl(NMe₂), PCl(NEt₂)₂, PCl(NPr₂)₂, PCl(NBu₂)₂, PBr(NMe₂)₂, PBr(NEt₂)₂, PBr(NPr₂)₂, and PBr(NBu₂)₂.

Even when X is other than P (specifically, when X is B, P=O, P=S, P=Se, As, As=O, As=S, As=Se, Sb, Sb=O, Sb=S, Sb=Se, a metal element in groups 3 to 11 of the periodic table, a metal element or metalloid element in group 13 or 14 of the periodic table, or the like), a halide, an alkoxy derivative, an aryloxy derivative, an acyloxy derivative, or a haloamino derivative of X can be similarly used.

In the reaction of the step 2, with respect to 1 mol of the compound of formula (a3), 1 mol to an excessive amount of a deprotonating agent such as n-BuLi, 1 mol to an excessive amount of a compound including X, a catalytic amount to an excessive amount of a Lewis acid, and 0 mole to an excessive amount of a base are used. The mixture is allowed to react by having it stirred for 30 minutes to 24 hours in a solvent at a temperature of -78 °C to about the boiling point of the solvent to, as a result, obtain the compound (a4).

As the solvent, an anhydrous ether solvent such as anhydrous diethyl ether, anhydrous THF, or anhydrous dibutyl ether; an aromatic hydrocarbon solvent such as benzene, toluene, xylene, or mesitylene; or an aromatic halide based solvent such as chlorobenzene or 1,2-dichlorobenzene can be used.

As the deprotonating agent, other than n-BuLi, an alkyl lithium such as MeLi, t-BuLi, or PhLi; a Grignard reagent such as MeMgBr, EtMgBr, or n-BuMgBr; or an alkali metal hydride such as NaH or KH can be used.

Examples of the Lewis acid that can be used include AlCl₃, AlBr₃, BF₃·OEt₂, BCl₃, BBr₃, GaCl₃, GaBr₃, InCl₃, InBr₃, In(OTf)₃, SnCl₄, SnBr₄, AgOTf, Sc(OTf)₃, ZnCl₂, ZnBr₂, Zn(OTf)₂, MgCl₂, MgBr₂, Mg(OTf)₂, and the like.

Examples of the base that can be used include diisopropylethylamine, 2,2,6,6-tetra methyl piperidine, 1,2,2,6,6-pentamethylpiperidine, 2,4,6-collidine, 2,6-lutidine, triethylamine, triisobutylamine, and the like.

When X=P, a compound in which X is P=S can be obtained directly by conducting the reaction that uses the Lewis acid and the base in the presence of sulfur (S8). A compound having bound thereto a sulfur atom can also be similarly obtained when X is other elements such as As and Sb.

In the reaction of the step 2', compound (a3') is used instead of compound (a3), and the compound (a4') can be obtained by performing a Friedel-Crafts-type reaction and a Scholl-type reaction under a condition similar to that in the reaction of the step 2.

In the reaction of the step 2", compound (a3") is used instead of compound (a3), and the compound (a4') can be obtained by performing a Friedel-Crafts-type reaction under a condition similar to that in the reaction of the step 2.

The reaction of the step 1' of the following schemes 1-3 can be used instead of the reaction of step 1 of the above described reaction scheme 1-1. That is, the reaction is a step of producing diaryl amine (a3) by reacting an aromatic halide (a1') with aromatic amine (a2) using a palladium catalyst in the presence of a base.

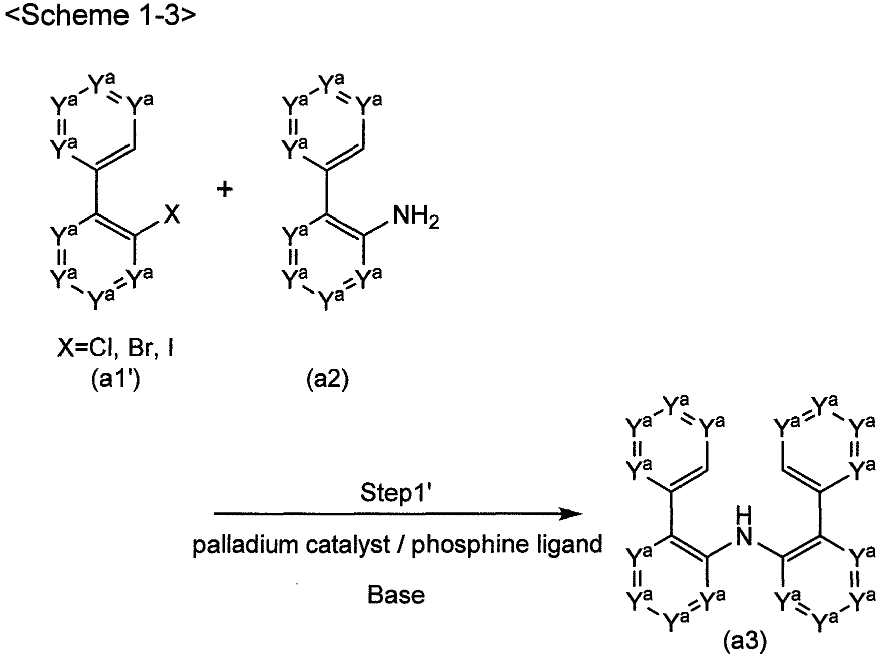

Specific examples of the palladium catalyst used in the step 1' include [1,1-bis(diphenylphosphino)ferrocene] palladium (II) dichloride: Pd(dppf)Cl₂, tetrakis(triphenylphosphine) palladium (0): Pd(PPh₃)₄, bis(triphenylphosphine) palladium (II) dichloride: PdCl₂(PPh₃)₂, palladium (II) acetate: Pd(OAc)₂, tris(dibenzylideneacetone) dipalladium (0): Pd₂(dba)₃, tris(dibenzylideneacetone) dipalladium (0) chloroform complex: Pd₂(dba)₃·CHCl₃, bis(dibenzylideneacetone) palladium (O): Pd(dba)₂, PdCl₂{P(t-Bu)₂-(p-NMe₂-Ph)}₂, bis(tri-o-tolylphosphine)-palladium (II) dichloride

(PdCl₂(o-tolyl₃)₂).

A phosphine compound may be also added to these palladium compounds in some cases in order to accelerate a reaction. Specific examples of the phosphine compound include tri(t-butyl)phosphine, tricyclohexylphosphine, 1-(N,N-dimethylaminomethyl)-2-(di-t-butylphosphino)ferrocene, 1-(N,N-dibutylaminomethyl)-2-(di-t-butylphosphino)ferrocene, 1-(methoxymethyl)-2-(di-t-butylphosphino)ferrocene, 1,1'-bis(di-t-butylphosphino)ferrocene, 2,2'-bis(di-t-butylphosphino)-1,1'-binaphthyl, 2-methoxy-2'-(di-t-butylphosphino)-1,1'-binaphthyl, 1,1'-bis(diphenylphosphino)ferrocene, bis(diphenylphosphino)binaphthyl, 4-dimethylaminophenyl dit-butylphosphine and phenyl di-t-butylphosphine.

Specific examples of a base used in the step 1' include sodium carbonate, potassium carbonate, cesium carbonate, sodium hydrogen carbonate, sodium hydroxide, potassium hydroxide, barium hydroxide, sodium ethoxide, sodium t-butoxide, sodium acetate, tripotassium phosphate and potassium fluoride.

Specific examples of a solvent used in the step 1' include benzene, 1,2,4-trimethylbenzene, toluene, xylene, N,N-dimethylformamide, tetrahydrofuran, diethyl ether, t-butylmethyl ether, 1,4-dioxane, methanol, ethanol, and isopropyl alcohol. These solvents can be appropriately selected according to a structure of an aromatic halide to be reacted. A solvent may be used solely or used as a mixed solvent.

In addition, for example, polycyclic aromatic compounds represented by the above described general formulae (IV-1) to (IV-22), more specifically, polycyclic aromatic compounds represented by the above described general formulae (V-1) to (V-26) and the above described general formulae (V-27) to (V-34), polycyclic aromatic compounds represented by the above described general formulae (V-1'), (V-2') and (V-3'), a polycyclic aromatic compound represented by the above described general formula (V-27') or (V-32'), polycyclic aromatic compounds represented by the above described general formulae (VI-1) to (VI-149), polycyclic aromatic compounds represented by the above described formulae (1) to (709) can be synthesized by the above described synthesis scheme 1 of a partial structure and schemes 2 to 8 to which the scheme 1 are applied. Note that in the schemes 2 to 8, Y^{a} and X are as defined above.

The scheme 2 can be conducted to obtain the objective compound similarly to the scheme 1, except for changing compounds used for the reaction.

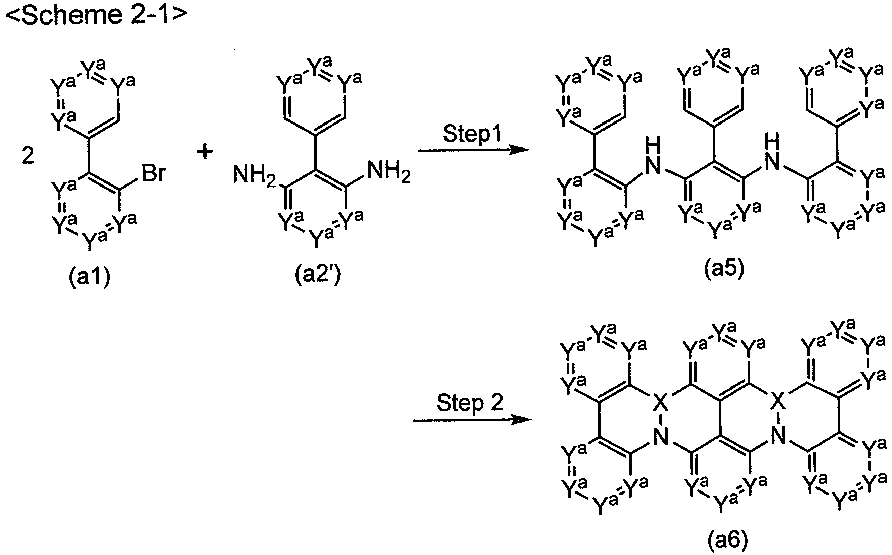

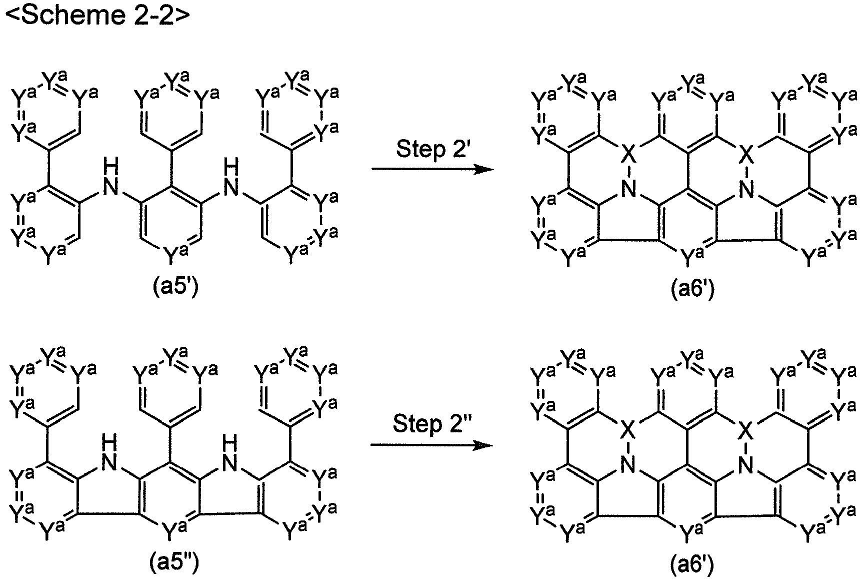

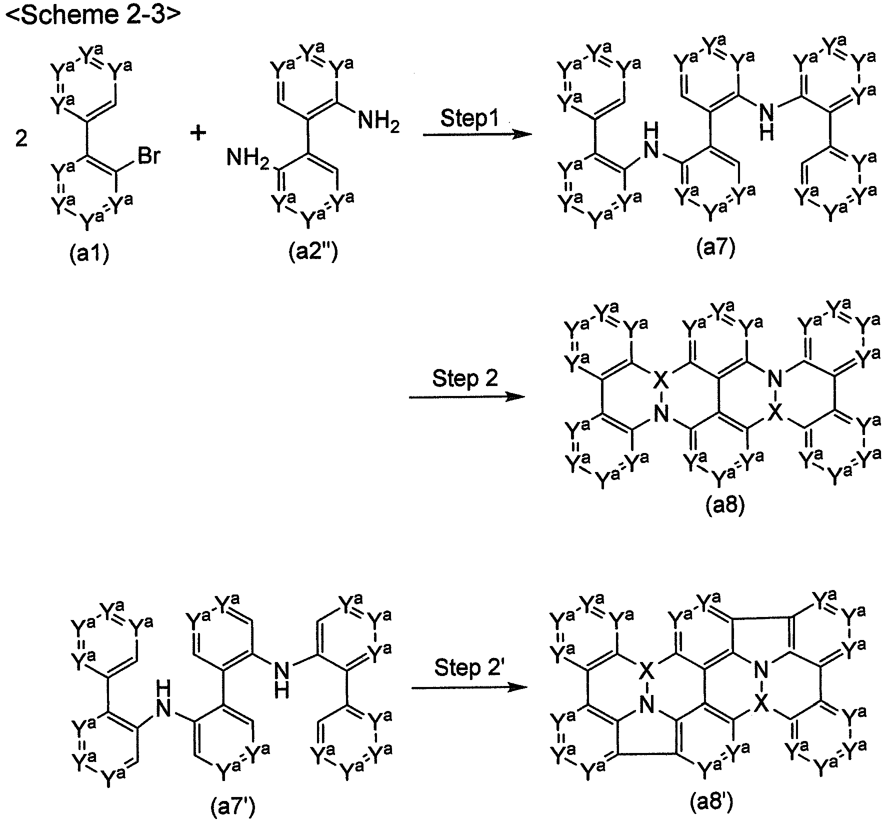

The scheme 3 can be conducted to obtain the objective compound similarly to the scheme 1, except for changing compounds used for the reaction.

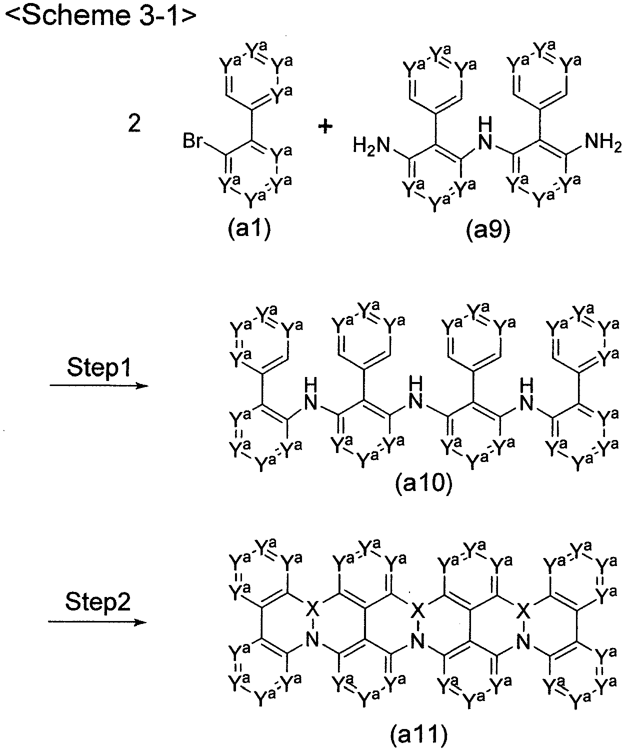

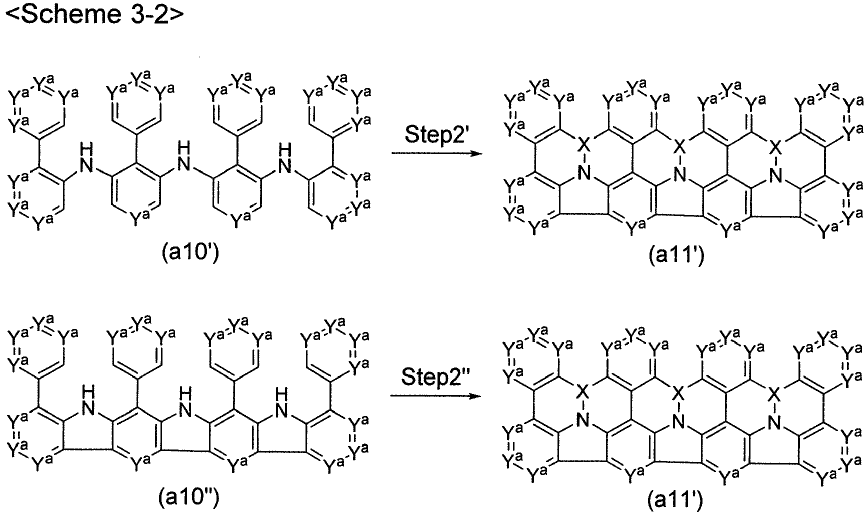

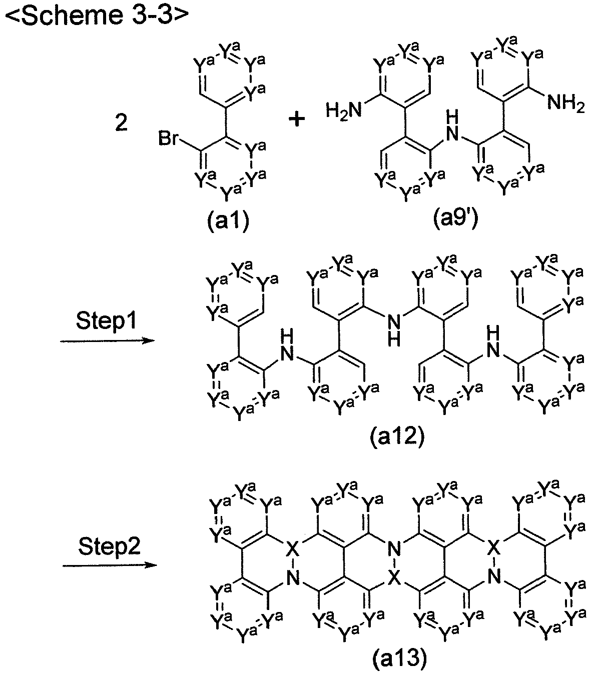

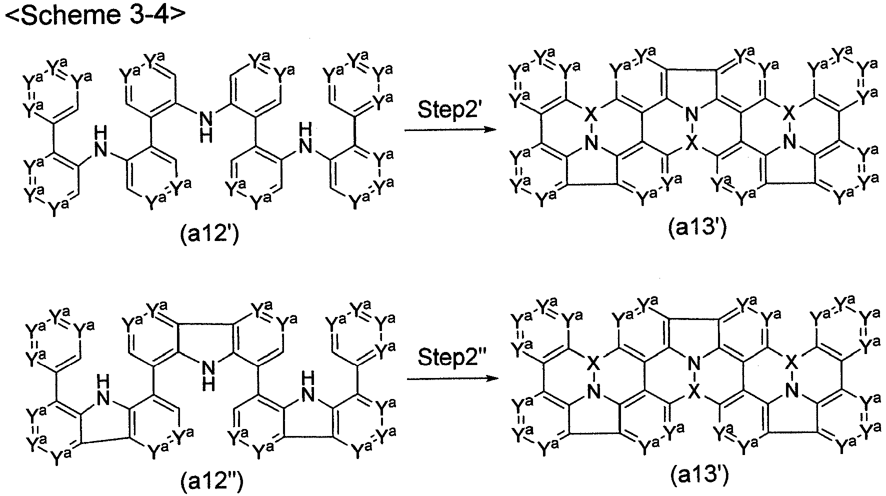

The scheme 4 can be conducted to obtain the objective compound similarly to the scheme 1, except for changing compounds used for the reaction.

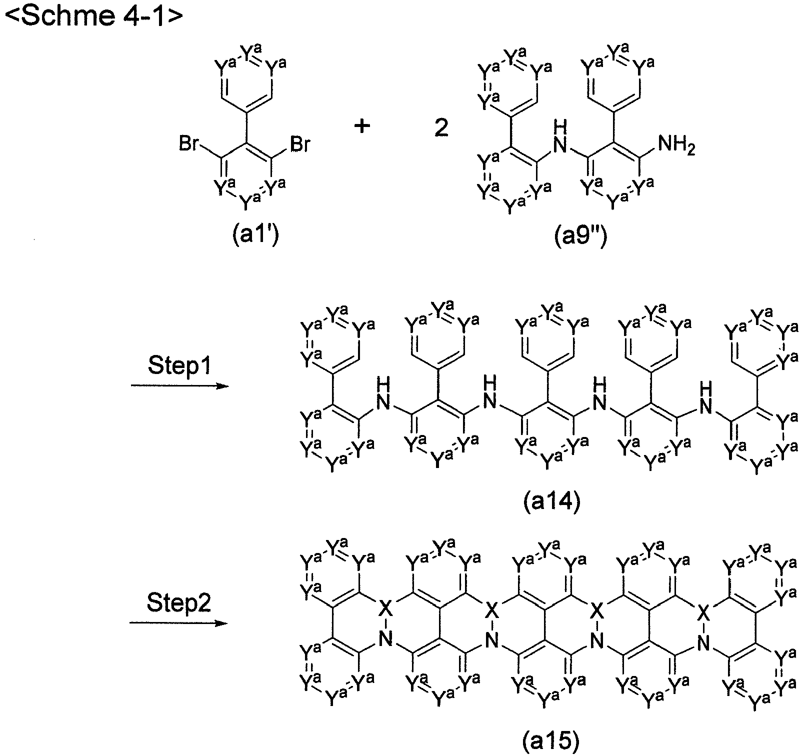

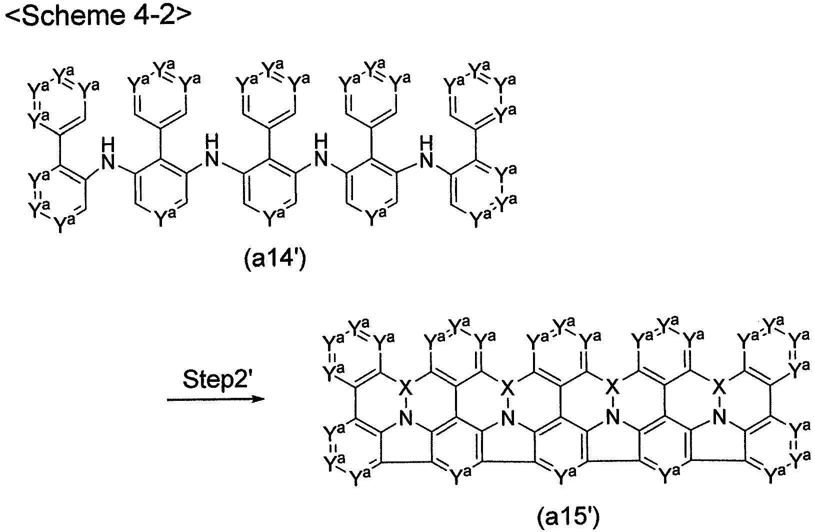

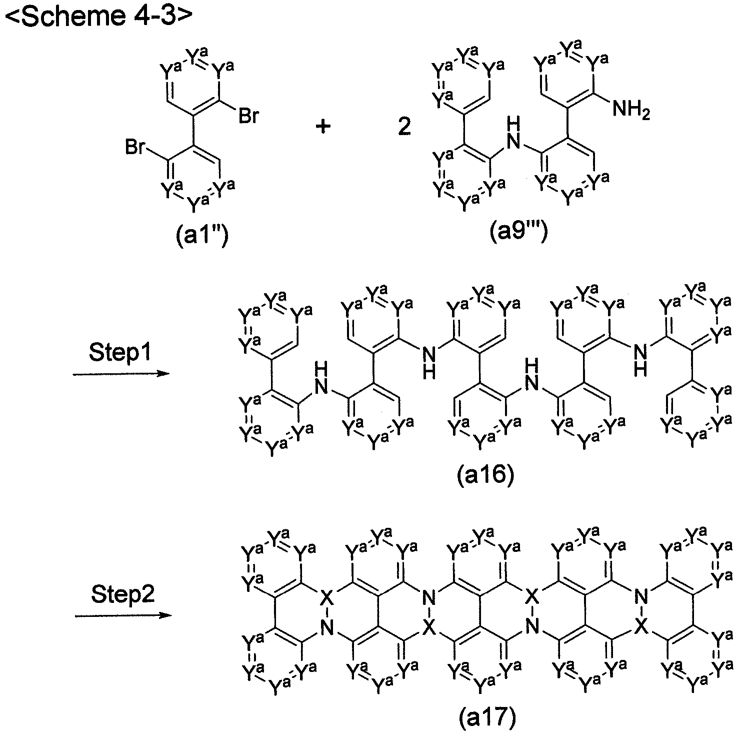

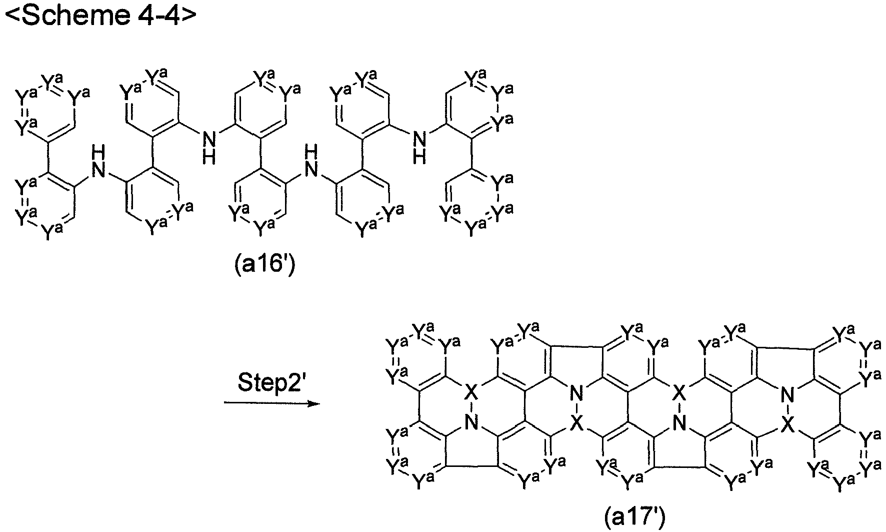

The scheme 5 can be conducted to obtain the objective compound similarly to the scheme 1, except for changing compounds used for the reaction.

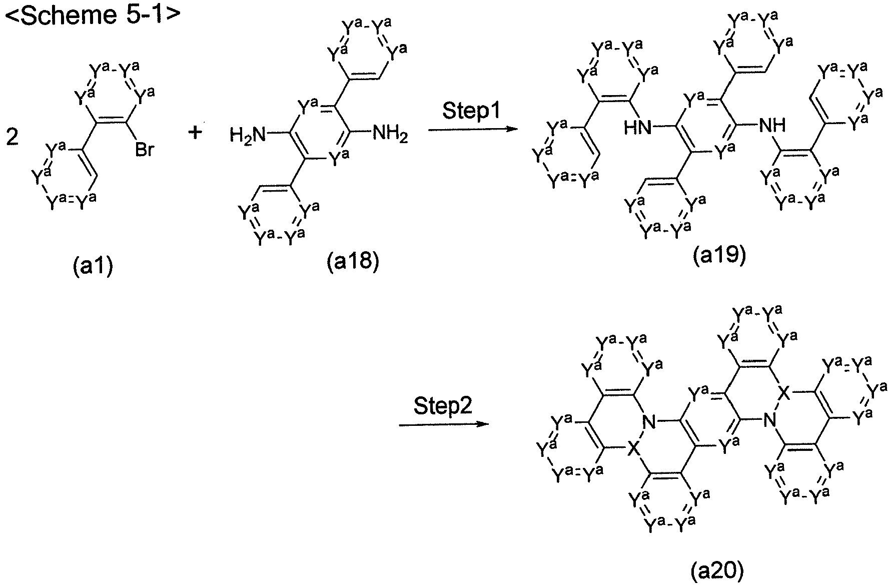

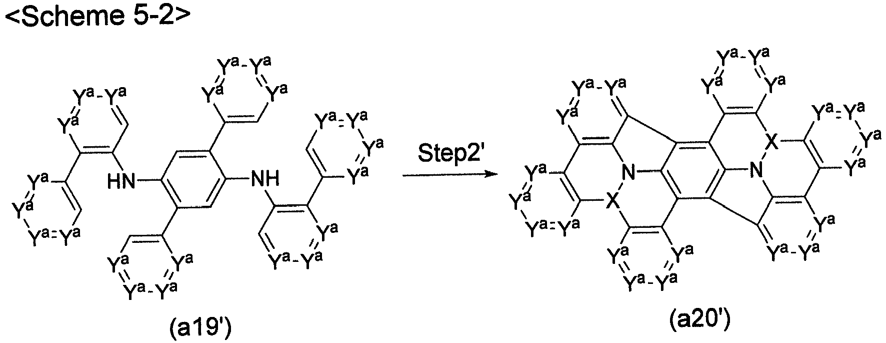

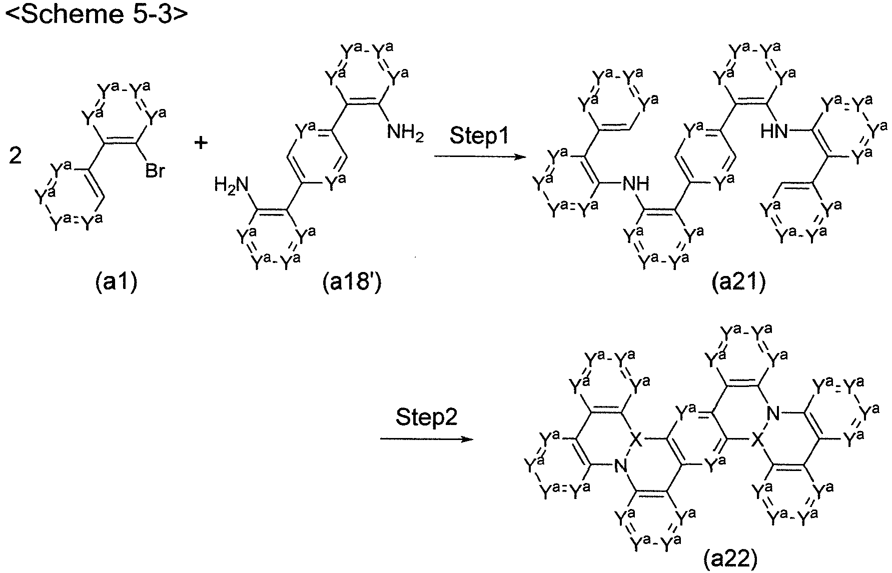

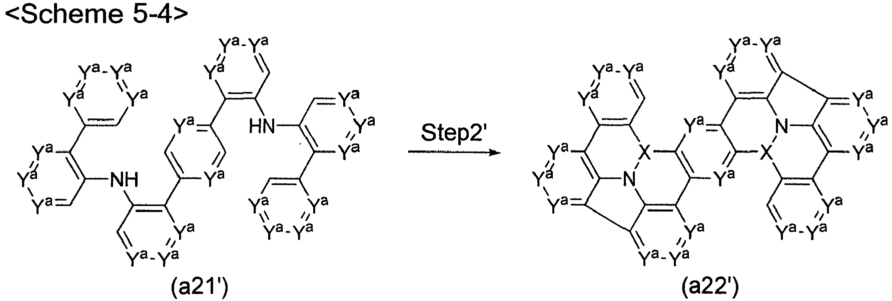

The scheme 6 can be conducted to obtain the objective compound similarly to the scheme 1, except for changing compounds used for the reaction. 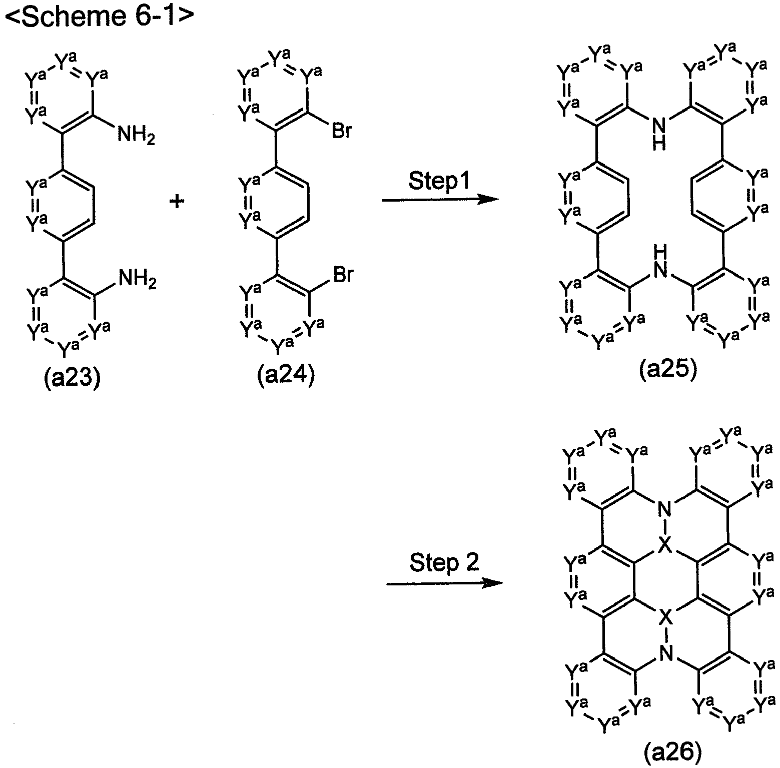 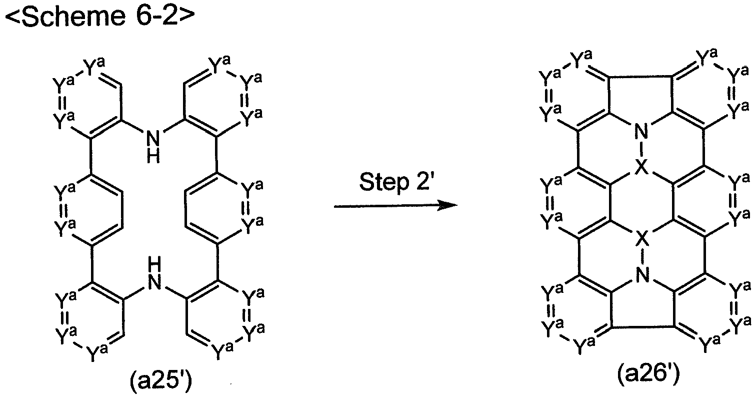 The scheme 7 can be conducted to obtain the objective compound similarly to the scheme 1, except for changing compounds used for the reaction.

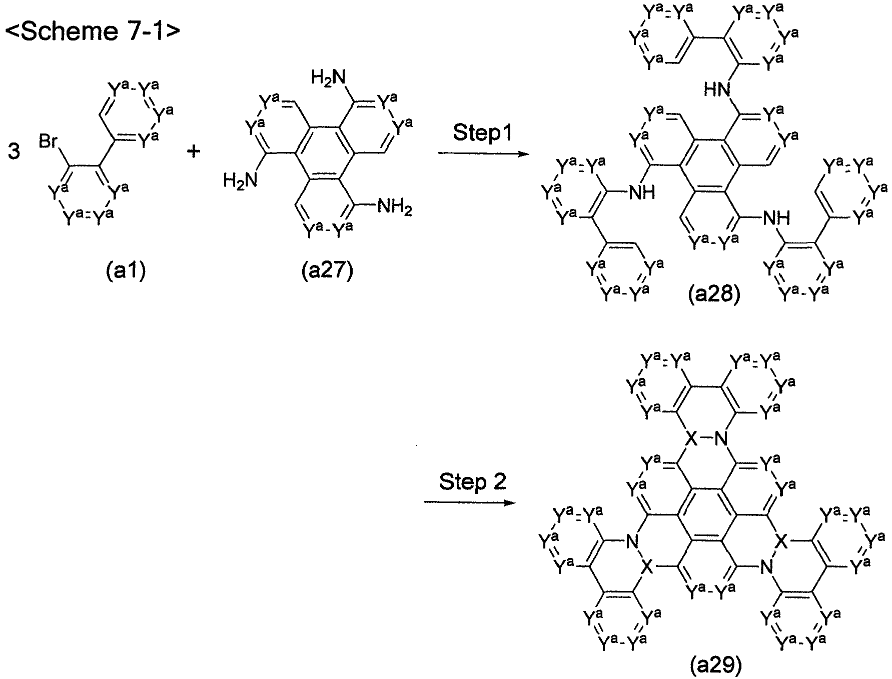

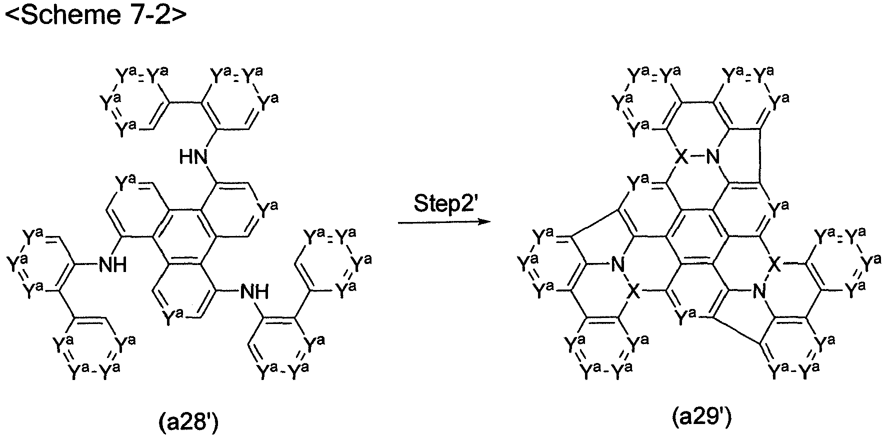

The scheme 8 can be conducted to obtain the objective compound similarly to the scheme 1, except for changing compounds used for the reaction.

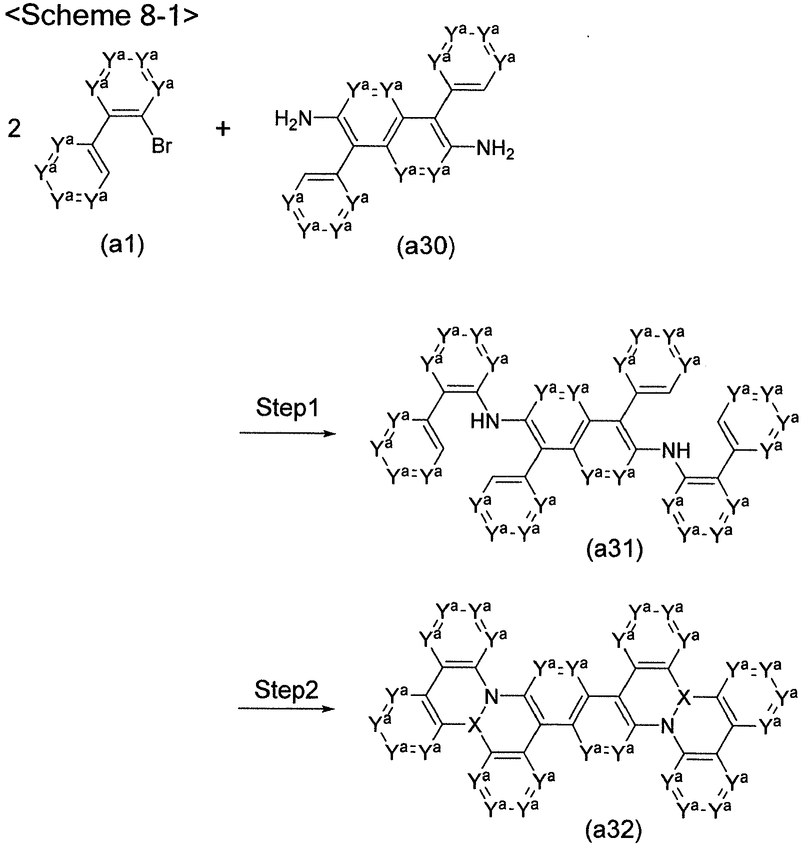

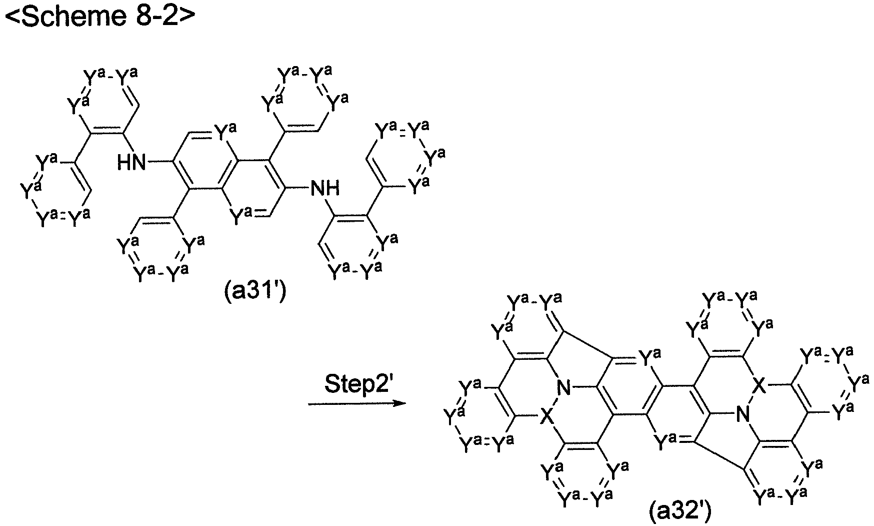

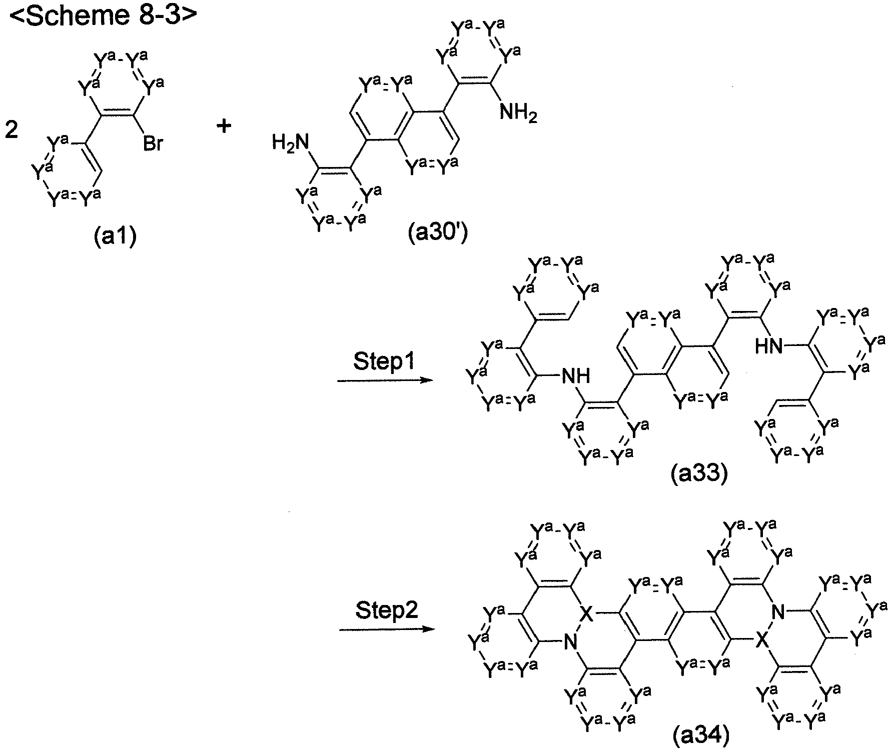

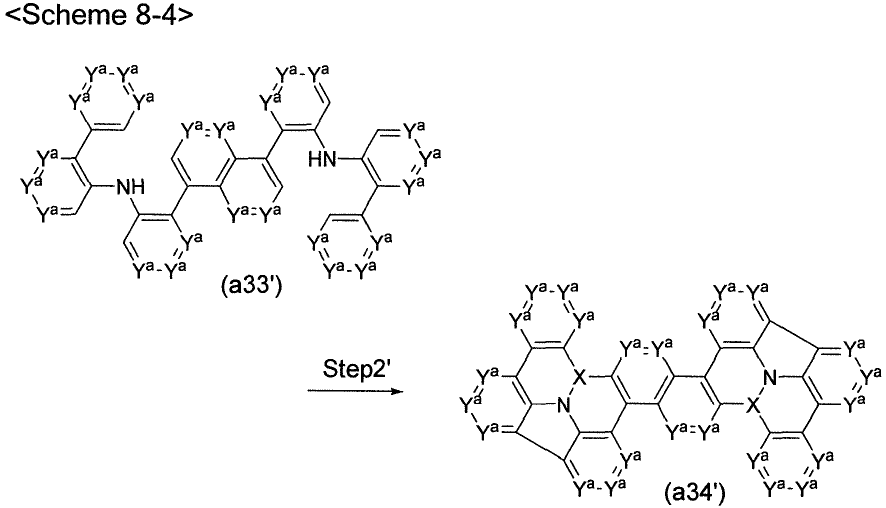

In addition, conversion of a compound in which X is P=S to a compound in which X is P or P=O can be conducted in accordance with the following scheme 9. Conversion of other compounds of the present invention can be similarly conducted.

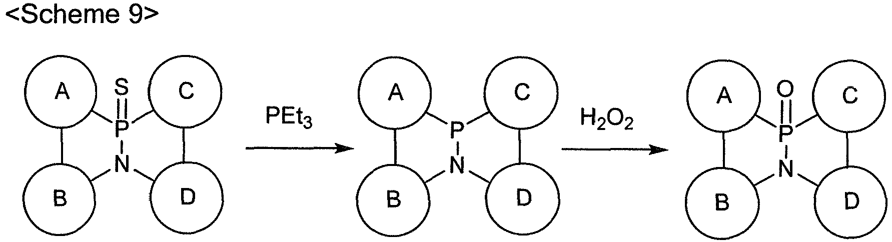

### 3. Organic electroluminescent element

The polycyclic aromatic compound according to the present invention can be used, for example, as a material for an organic electroluminescent element. Hereinafter, an organic electroluminescent element according to this exemplary embodiment will be explained in detail based on a figure. Fig. 1 is a schematic cross-sectional view showing the organic electroluminescent element according to this exemplary embodiment.

### <Structure of organic electroluminescent element>

The organic electroluminescent element 100 shown in Fig. 1 has a substrate 101, an anode 102 disposed on the substrate 101, a hole injection layer 103 disposed on the anode 102, a hole transport layer 104 disposed on the hole injection layer 103, a luminescent layer 105 disposed on the hole transport layer 104, an electron transport layer 106 disposed on the luminescent layer 105, an electron injection layer 107 disposed on the electron transport layer 106, and a cathode 108 disposed on the electron injection layer 107.

The organic electroluminescent element 100 may also have a constitution having, for example, the substrate 101, the cathode 108 disposed on the substrate 101, the electron injection layer 107 disposed on the cathode 108, the electron transport layer 106 disposed on the electron injection layer 107, the luminescent layer 105 disposed on the electron transport layer 106, the hole transport layer 104 disposed on the luminescent layer 105, the hole injection layer 103 disposed on the hole transport layer 104, and the anode 102 disposed on the hole injection layer 103, by reversing the order of preparation.

It is not necessary that all of the above-mentioned respective layers are essential, and the smallest constitutional unit is a constitution formed of the anode 102, the luminescent layer 105, the electron transport layer 106 and/or the electron injection layer 107, and the cathode 108, and the hole injection layer 103 and the hole transport layer 104 are layers that are optionally disposed. Furthermore, each of the above-mentioned respective layers may be formed of a single layer or plural layers.

Besides the above-mentioned "substrate/anode/hole injection layer/hole transport layer/luminescent layer/electron transport layer/electron injection layer/cathode", the embodiment of the layers that constitute the organic electroluminescent element may be a constitutional embodiment of "substrate/anode/hole transport layer/luminescent layer/electron transport layer/electron injection layer/cathode", "substrate/anode/hole injection layer/luminescent layer/electron transport layer/electron injection layer/cathode", "substrate/anode/hole injection layer/hole transport layer/luminescent layer/electron injection layer/cathode", "substrate/anode/hole injection layer/hole transport layer/luminescent layer/electron transport layer/cathode", "substrate/anode/luminescent layer/electron transport layer/electron injection layer/cathode", "substrate/anode/hole transport layer/luminescent layer/electron injection layer/cathode", "substrate/anode/hole transport layer/luminescent layer/electron transport layer/cathode", "substrate/anode/hole injection layer/luminescent layer/electron injection layer/cathode", "substrate/anode/hole injection layer/luminescent layer/electron transport layer/cathode", "substrate/anode/hole injection layer/hole transport layer/luminescent layer/cathode", "substrate/anode/hole injection layer/luminescent layer/cathode", "substrate/anode/hole transport layer/luminescent layer/cathode", "substrate/anode/luminescent layer/electron transport layer/cathode", "substrate/anode/luminescent layer/electron injection layer/cathode" or "substrate/anode/luminescent layer/cathode".

### <Substrate in organic electroluminescent element>

The substrate 101 forms the substrate of the organic electroluminescent element 100, and quartz, glass, metals, plastics and the like are generally used therefor. The substrate 101 is formed into a plate-shape, a film-shape or a sheet-shape according to the intended purpose, and for example, glass plates, metal plates, metal foils, plastic films or plastic sheets or the like are used. Among these, glass plates, and plates made of transparent synthetic resins such as polyesters, polymethacrylates, polycarbonates and polysulfones are preferable. As the glass substrate, soda lime glass, non-alkali glass and the like are used, and the thickness may be a thickness that is sufficient to retain mechanical strength, for example, may be 0.2 mm or more. The upper limit value of the thickness is, for example, 2 mm or less, preferably 1 mm or less. As the material for the glass, non-alkali glass is more preferable since it is preferable that the amount of eluted ion from the glass is small, and soda lime glass with a barrier coating of SiO₂ or the like is also commercially available, and thus this can be used. Furthermore, a gas barrier film of a dense silicon oxide film or the like may be disposed on at least one surface of the substrate 101 so as to enhance the gas barrier property, and especially, in the case when a plate, film or sheet made of a synthetic resin having low gas barrier property is used as the substrate 101, it is preferable to dispose a gas barrier film.

### <Anode in organic electroluminescent element>

The anode 102 plays a role in injecting holes into the luminescent layer 105. In the case when the hole injection layer 103 and/or the hole transport layer 104 is/are disposed between the anode 102 and the luminescent layer 105, holes are injected into the luminescent layer 105 through the layer(s).

As the material for forming the anode 102, inorganic compounds and organic compounds are exemplified. Examples of the inorganic compounds include metals (aluminum, gold, silver, nickel, palladium, chromium etc.), metal oxides (indium oxide, tin oxide, indium-tin oxide (ITO), indium-zinc oxide (IZO) etc.), halogenated metals (copper iodide etc.), copper sulfide, carbon black, ITO glass, NESA glass and the like. Examples of the organic compounds include electroconductive polymers such as polythiophenes such as poly(3-methylthiophene), polypyrroles and polyanilines. In addition, the material can be suitably selected from substances that are used as anodes for organic electroluminescent elements and used.

The resistance of the transparent electrode is not especially limited as long as a sufficient current for the luminescence of the luminescent device can be fed, but a low resistance is desirable in view of the consumed electrical power of the luminescent device. For example, although any ITO substrate of 300 Ω/□ or less functions as an element electrode, it is currently possible to supply a substrate of about 10 Ω/□. Therefore, it is especially desirable to use a low-resistant product of, for example, 100 to 5 Ω/□, preferably 50 to 5 Ω/□. The thickness of the ITO can be selected according to the resistance value, but the ITO is generally used between 50 to 200 nm in many cases.

### <Hole injection layer and hole transport layer in organic electroluminescent element>

The hole injection layer 103 plays a role in efficiently injecting the holes that have been transferred from the anode 102 into the luminescent layer 105 or the hole transport layer 104. The hole transport layer 104 plays a role in efficiently transporting the holes that have been injected from the anode 102 or the holes that have been injected from the anode 102 through the hole injection layer 103 to the luminescent layer 105. The hole injection layer 103 and the hole transport layer 104 are respectively formed by laminating and mixing one kind or two or more kinds of hole injection/transport material(s), or by a mixture of the hole injection/transport material(s) and a polymer binder. Alternatively, the layers may be formed by adding an inorganic salt such as iron (III) chloride to the hole injection/transport material.

The hole injection/transport substance needs to efficiently inject/transport the holes from the positive electrode between the electrodes to which an electric field has been provided, and it is desirable that the hole injection efficiency is high and the injected holes are efficiently transported. For this purpose, a substance having a small ionization potential, a high hole mobility and excellent stability, in which impurities that become traps are difficult to generate during the production and use of the substance, is preferable.

As the material for forming the hole injection layer 103 and the hole transport layer 104 (hole layer material), a polycyclic aromatic compound having a partial structure represented by the above described general formula (I) or a salt thereof can be used. The content of the polycyclic aromatic compound having a partial structure represented by the above described general formula (I) or a salt thereof in the hole injection layer 103 and the hole transport layer 104 differs depends on its kind and may be determined according to the property. The rough standard of the content of the polycyclic aromatic compound having a partial structure represented by the above described general formula (I) or a salt thereof is preferably 1 to 100% by weight, more preferably 10 to 100% by weight, further more preferably 50 to 100% by weight, and particularly preferably 80 to 100% by weight of the entirety of the hole layer material. When he polycyclic aromatic compound having a partial structure represented by the above described general formula (I) or a salt thereof is not used solely (100% by weight), other materials which are specifically described below may be mixed.

As the material for forming the hole injection layer 103 and the hole transport layer 104, optional one can be used by selecting from compounds that have been conventionally used as charge transport materials for holes in photoconductor materials, p-type semiconductor, and known compounds that are used in hole injection layers and hole transport layers of organic electroluminescent elements. Specific examples thereof are carbazole derivatives (N-phenyl carbazole, polyvinyl carbazole etc.), biscarbazole derivatives such as bis(N-arylcarbazole) or bis(N-alkyl carbazole), triarylamine derivatives (polymers having an aromatic tertiary amino in the main chain or side chain, triphenylamine derivatives such as 1,1-bis(4-di-p-tolylaminophenyl)cyclohexane, N,N'-diphenyl-N,N'-di(3-methylphenyl)-4,4'-diaminobiphenyl, N,N'-diphenyl-N,N'-dinaphthyl-4,4'-diaminobiphenyl, N,N'-diphenyl-N,N'-di(3-methylphenyl)-4,4'-diphenyl-1,1'-diamine, N,N'-dinaphthyl-N,N'-diphenyl-4,4'-diphenyl-1,1'-diamine and 4,4',4"-tris(3-methylphenyl(phenyl)amino)triphenylamine, starburst amine derivatives etc.), stilbene derivatives, phthalocyanine derivatives (metal-free, copper phthalocyanine etc.), heterocycle compounds such as pyrazoline derivatives, hydrazone-based compounds, benzofuran derivatives and thiophene derivatives, oxadiazole derivatives and porphyrin derivatives, polysilanes and the like. As polymer-based compounds, polycarbonates having the above-mentioned monomers on the side chains, styrene derivatives, polyvinyl carbazole and polysilanes and the like are preferable, but are not especially limited as long as they are compounds capable of forming a thin film required for the preparation of a luminescent device, capable of injecting holes from the anode and capable of transporting holes.

Furthermore, it is also known that the electroconductivity of an organic semiconductor is strongly affected by the doping thereof. Such organic semiconductor matrix substance is constituted by a compound having fine electron-donating property or a compound having fine electron-accepting property. For doping of an electron-donating substance, strong electron receptors such as tetracyanoquinonedimethane (TCNQ) or 2,3,5,6-tetrafluorotetracyano-1,4-benzoquinonedimethane (F4TCNQ) are known (e.g., see the document "M. Pfeiffer, A. Beyer, T. Fritz, K. Leo, Appl. Phys. Lett., 73 (22), 3202-3204 (1998)" and the document "J. Blochwitz, M. Pheiffer, T. Fritz, K. Leo, Appl. Phys. Lett., 73 (6), 729-731 (1998)"). These generate so-called holes by an electron transfer process in an electron-donating type base substance (hole transport substance). The conductivity of the base substance varies quite significantly depending on the number and mobility of the holes. As the matrix substances having hole transport property, for example, benzidine derivatives (TPD etc.) or starburst amine derivatives (TDATA etc.), or specific metal phthalocyanines (especially, zinc phthalocyanine ZnPc etc.) are known (JP 2005-167175 A).

### <Luminescent layer in organic electroluminescent element>

The luminescent layer 105 emits light by recombining the holes that have been injected from the anode 102 and the electrons that have been injected from the cathode 108 between the electrodes to which an electric field has been provided. The material for forming the luminescent layer 105 may be a compound that emits light by being excited by the recombination of holes and electrons (luminescent compound), and is preferably a compound that can form a stable thin film shape and show strong luminescence (fluorescence and/or phosphorescence) efficiency in a solid state. A luminescent material of the luminescent device according to the present embodiment may show either fluorescence or phosphorescence.

The luminescent layer may be formed of a single layer or plural layers, each of which is formed of a luminescent material (a host material, a dopant material). The host material and dopant material each may be either one kind or a combination of plural kinds. The dopant material may be contained either in the entirety or a part of the host material. As the doping process, the dopant material can be formed by a process for co-deposition with the host material, or may be mixed with the host material in advance and simultaneously deposited.

The use amount of the host material differs depends on the kind of the host material, and may be determined according to the property of the host material. The rough standard of the use amount of the host material is preferably 50 to 99.999% by weight, more preferably 80 to 99.95% by weight, and further more preferably 90 to 99.9% by weight of the entirety of the luminescent material.

The use amount of the dopant material differs depends on the kind of the dopant material, and may be determined according to the property of the dopant material (e.g., when the use amount is too large, there is possibility of a concentration quenching phenomenon). The rough standard of the use amount of the dopant is preferably 0.001 to 50% by weight, more preferably 0.05 to 20% by weight, and further preferably 0.1 to 10% by weight of the entirety of the luminescent material.

A polycyclic aromatic compound having a partial structure represented by the above described general formula (I) or a salt thereof can be also used as a host material or a dopant material. The content of the polycyclic aromatic compound having a partial structure represented by the above described general formula (I) or a salt thereof in each material differs depending on its kind and may be determined according to the property. The rough standard of the content of the polycyclic aromatic compound having a partial structure represented by the above described general formula (I) or a salt thereof is preferably 1 to 100% by weight, more preferably 10 to 100% by weight, further more preferably 50 to 100% by weight, and particularly preferably 80 to 100% by weight of the entirety of the host material (or the dopant material). When the polycyclic aromatic compound having a partial structure represented by the above described general formula (I) or a salt thereof is not used solely (100% by weight), other host materials (or dopant materials), which are specifically described below, may be mixed.

Although the host material is not especially limited, condensed ring derivatives such as anthracene and pyrene that have been known as luminescent bodies since before, metal-chelated oxinoid compounds including tris(8-quinolinolato)aluminum, bisstyryl derivatives such as bisstyrylanthracene derivatives and distyrylbenzene derivatives, tetraphenylbutadiene derivatives, coumarin derivatives, oxadiazole derivatives, pyrrolopyridine derivatives, perinone derivatives, cyclopentadiene derivatives, thiadiazolopyridine derivatives, pyrrolopyrrole derivatives, and polymer-based host materials such as polyphenylenevinylene derivatives, polyparaphenylene derivatives and polythiophene derivatives are preferably used.

In addition, other host materials can be suitably selected from the compounds described in Chemical Industry, June 2004, page 13, and the reference documents cited therein, and the like, and used.

The dopant materials are not especially limited, and already-known compounds can be used, and can be selected from various materials according to the desired color of luminescence. Specific examples include condensed ring derivatives such as phenanthrene, anthracene, pyrene, tetracene, pentacene, perylene, naphthopyrene, dibenzopyrene, rubrene and chrysen, benzoxazole derivatives, benzothiazole derivatives, benzimidazole derivatives, benzotriazole derivatives, oxazole derivatives, oxadiazole derivatives, thiazole derivatives, imidazole derivatives, thiadiazole derivatives, triazole derivatives, pyrazoline derivatives, stilbene derivatives, thiophene derivatives, tetraphenylbutadiene derivatives, cyclopentadiene derivatives, bisstyryl derivatives such as bisstyrylanthracene derivatives and bisstyrylbenzene derivatives (JP 1-245087 A), bisstyrylarylene derivatives (JP 2-247278 A), diazaindacene derivatives, furan derivatives, benzofuran derivatives, isobenzofuran derivatives such as phenylisobenzofuran, dimesitylisobenzofuran, di(2-methylphenyl)isobenzofuran, di(2-trifluoromethylphenyl)isobenzofuran and phenylisobenzofuran, dibenzofuran derivatives, coumarin derivatives such as 7-dialkylaminocoumarin derivatives, 7-piperidinocoumarin derivatives, 7-hydroxycoumarin derivatives, 7-methoxycoumarin derivatives, 7-acetoxycoumarin derivatives, 3-benzothiazolylcoumarin derivatives, 3-benzimidazolylcoumarin derivatives and 3-benzoxazolylcoumarin derivatives, dicyanomethylenepyran derivatives, dicyanomethylenethiopyran derivatives, polymethine derivatives, cyanine derivatives, oxobenzoanthracene derivatives, xanthene derivatives, rhodamine derivatives, fluorescein derivatives, pyrylium derivatives, carbostyryl derivatives, acridine derivatives, oxazin derivatives, phenyleneoxide derivatives, quinacridone derivatives, quinazoline derivatives, pyrrolopyridine derivatives, furopyridine derivatives, 1,2,5-thiadiazolopyrene derivatives, pyrromethene derivatives, perinone derivatives, pyrrolopyrrole derivatives, squarylium derivatives, violanthrone derivatives, phenazine derivatives, acridone derivatives, deazaflavin derivatives, fluorene derivatives and benzofluorene derivatives, and the like.

The dopant materials will be exemplified for every colored light. Examples of blue to blue green dopant materials include aromatic hydrocarbon compounds such as naphthalene, anthracene, phenanthrene, pyrene, triphenylene, perylene, fluorine, indene and chrysen and derivatives thereof, aromatic heterocycle compounds such as furan, pyrrole, thiophene, silole, 9-silafluorene, 9,9'-spirobisilafluorene, benzothiophene, benzofuran, indole, dibenzothiophene, dibenzofuran, imidazopyridine, phenanthroline, pyrazine, naphthylidine, quinoxaline, pyrrolopyridine and thioxanthene and derivatives thereof, distyrylbenzene derivatives, tetraphenylbutadiene derivatives, stilbene derivatives, aldazine derivatives, coumarin derivatives, azole derivatives such as imidazole, thiazole, thiadiazole, carbazole, oxazole, oxadiazole and triazole and metal complexes thereof, and aromatic amine derivatives represented by N,N'-diphenyl-N,N'-di(3-methylphenyl)-4,4'-diphenyl-1,1'-diamine, and the like.

Furthermore, examples of green to yellow dopant materials include coumarin derivatives, phthalimide derivatives, naphthalimide derivatives, perinone derivatives, pyrrolopyrrole derivatives, cyclopentadiene derivatives, acridone derivatives, quinacridone derivatives and naphthacene derivatives such as rubrene, and the like, and also include, as preferable examples, compounds obtained by introducing a substituent that enables red-shifting such as an aryl, a heteroaryl, an arylvinyl, amino and cyano into the compounds exemplified as the above-mentioned blue to blue green dopant materials.

Furthermore, examples of orange to red dopant materials include naphthalimide derivatives such as bis(diisopropylphenyl)perylene tetracarboxylic acid imide, perinone derivatives, rare earth complexes including acetylacetone or benzoylacetone and phenanthroline or the like as ligands such as Eu complex, 4-(dicyanomethylene)-2-methyl-6-(p-dimethylaminostyryl)-4H-pyran and analogues thereof, metalphthalocyanine derivatives such as magnesium phthalocyanine and aluminum chlorophthalocyanine, rhodamine compounds, deazaflavin derivatives, coumarin derivatives, quinacridone derivatives, phenoxazine derivatives, oxazin derivatives, quinazoline derivatives, pyrrolopyridine derivatives, squarylium derivatives, violanthrone derivatives, phenazine derivatives, phenoxazone derivatives and thiadiazolopyrene derivatives, and the like, and also include, as preferable examples, compounds obtained by introducing a substituent that enables red-shifting such as an aryl, a heteroaryl, an arylvinyl, amino and cyano into the compounds exemplified as the above-mentioned blue to blue green and green to yellow dopant materials. In addition, phosphorescent metal complexes containing iridium or platinum as a center metal represented by tris(2-phenylpyridine)iridium(III) are also exemplified as preferable examples.

In addition, the dopant can be suitably selected from the compounds described in Chemical Industry, June 2004, page 13, and the reference documents cited therein, and the like, and used.

Among the above described dopant materials, perylene derivatives, borane derivatives, amine-containing styryl derivatives, aromatic amine derivatives, coumarin derivatives, pyran derivatives, iridium complexes or platinum complexes are preferable.

Examples of the perylene derivatives include 3,10-bis(2,6-dimethylphenyl)perylene, 3,10-bis(2,4,6-trimethylphenyl)perylene, 3,10-diphenylperylene, 3,4-diphenylperylene, 2,5,8,11-tetra-t-butylperylene, 3,4,9,10-tetraphenylperylene, 3-(1'-pyrenyl)-8,11-di(t-butyl)perylene, 3-(9'-anthryl)-8,11-di(t-butyl)perylene, 3,3'-bis(8,11-di(t-butyl) perylenyl), and the like.

Alternatively, the perylene derivatives described in JP 11-97178 A, JP 2000-133457 A, JP 2000-26324 A, JP 2001-267079 A, JP 2001-267078 A, JP 2001-267076 A, JP 2000-34234 A, JP 2001-267075 A and JP 2001-217077 A, and the like may also be used.

Examples of the borane derivatives include 1,8-diphenyl-10-(dimesitylboryl)anthracene, 9-phenyl-10-(dimesitylboryl)anthracene, 4-(9'-anthryl)dimesitylborylnaphthalene, 4-(10'-phenyl-9'-anthryl)dimesitylborylnaphthalene, 9-(dimesitylboryl)anthracene, 9-(4'-biphenylyl)-10-(dimesitylboryl)anthracene, 9-(4'-(N-carbazolyl)phenyl)-10-(dimesitylboryl)anthracene, and the like.

Alternatively, the borane derivatives described in WO 2000/40586 A and the like may also be used.

Examples of the amine-containing styryl derivatives include N,N,N',N'-tetra(4-biphenylyl)-4,4'-diaminostilbene, N,N,N',N'-tetra(1-naphthyl)-4,4'-diaminostilbene, N,N,N',N'-tetra(2-naphthyl)-4,4'-diaminostilbene, N,N'-di(2-naphthyl)-N,N'-diphenyl-4,4'-diaminostilbene, N,N'-di(9-phenanthryl)-N,N'-diphenyl-4,4'-diaminostilbene, 4,4'-bis[4"-bis(diphenylamino)styryl]-biphenyl, 1,4-bis[4'-bis(diphenylamino)styryl]-benzene, 2,7-bis[4'-bis(diphenylamino)styryl]-9,9-dimethylfluorene, 4,4'-bis(9-ethyl-3-carbazovinylene)-biphenyl, 4,4'-bis(9-phenyl-3-carbazovinylene)-biphenyl, and the like. Alternatively, the amine-containing styryl derivatives described in JP 2003-347056 A and JP 2001-307884 A, and the like may also be used.

Examples of the aromatic amine derivatives include N,N,N,N-tetraphenylanthracene-9,10-diamine, 9,10-bis(4-diphenylamino-phenyl)anthracene, 9,10-bis(4-di(1-naphthylamino)phenyl)anthracene, 9,10-bis(4-di(2-naphthylamino)phenyl)anthracene, 10-di-p-tolylamino-9-(4-di-p-tolylamino-1-naphthyl)anthracene, 10-diphenylamino-9-(4-diphenylamino-1-naphthyl)anthracene, 10-diphenylamino-9-(6-diphenylamino-2-naphthyl)anthracene, [4-(4-diphenylamino-phenyl)naphthalen-1-yl]-diphenylamine [6-(4-diphenylamino-phenyl)naphthalen-2-yl]-diphenylamine, 4,4'-bis[4-diphenylaminonaphthalen-1-yl]biphenyl, 4,4'-bis[6-diphenylaminonaphthalen-2-yl]biphenyl, 4,4"-bis[4-diphenylaminonaphthalen-1-yl]-p-terphenyl, 4,4"-bis[6-diphenylaminonaphthalen-2-yl]-p-terphenyl, and the like.

Alternatively, the aromatic amine derivatives described in JP 2006-156888 A and the like may also be used.

Examples of the coumarin derivatives include coumarin-6, coumarin-334 and the like.

Alternatively, the coumarin derivatives described in JP 2004-43646 A, JP 2001-76876 A and JP 6-298758 A, and the like may also be used.

Examples of the pyran derivatives include DCM, DCJTB and the like mentioned below.

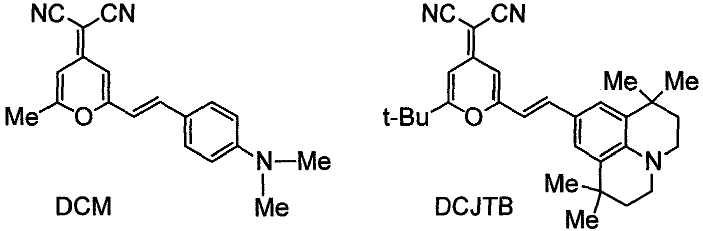

Alternatively, the pyran derivatives described in JP 2005-126399 A, JP 2005-097283 A, JP 2002-234892 A, JP 2001-220577 A, JP 2001-081090 A and JP 2001-052869 A, and the like may also be used.

Examples of the iridium complexes include Ir(ppy)₃ mentioned below, and the like.

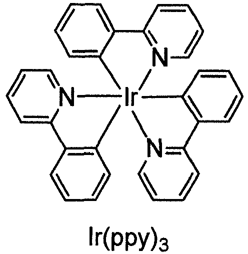

Alternatively, the iridium complexes described in JP 2006-089398 A, JP 2006-080419 A, JP 2005-298483 A, JP 2005-097263 A and JP 2004-111379 A, and the like may also be used.

Examples of the platinum complexes include PtOEP mentioned below, and the like.

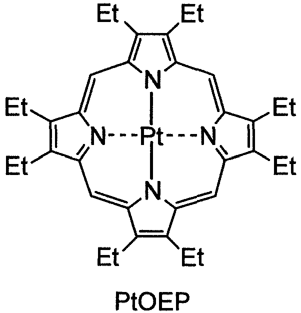

Alternatively, the platinum complexes described in JP 2006-190718 A, JP 2006-128634 A, JP 2006-093542 A, JP 2004-335122 A, and JP 2004-331508 A, and the like may also be used.

### <Electron injection layer and electron transport layer in organic electroluminescent element>

The electron injection layer 107 plays a role in efficiently injecting the electrons that have been transferred from the cathode 108 into the luminescent layer 105 or the electron transport layer 106. The electron transport layer 106 plays a role in efficiently transporting the electrons that have been injected from the cathode 108 or the electrons that have been injected from the cathode 108 through the electron injection layer 107 to the luminescent layer 105. The electron transport layer 106 and the electron injection layer 107 are respectively formed by laminating and mixing one kind or two or more kinds of electron transport/injection material(s), or by a mixture of the electron transport/injection material(s) and a polymer binder.

The electron injection/transport layer is a layer that controls the injection of electrons from the cathode and further transport of the electrons, and it is desirable that the layer has a high electron injection efficiency and efficiently transports the injected electrons. For that purposes, a substance that has high electron affinity and a high electron transfer degree and excellent stability, in which impurities that become traps are difficult to be generated during the production and use, is preferable. However, in the case when the balance of transportation of holes and electrons is taken into consideration, in the case when the substance mainly plays a role that enables efficient blocking of the flowing of the holes from the anode to the cathode side without recombination, the substance has an equivalent effect of improving luminescence efficiency to that of a material having high electron transportability, even the electron transportability is not so high. Therefore, the electron injection/transport layer in this exemplary embodiment may also include a function of a layer capable of efficiently blocking the transfer of holes.

As material for forming the electron transport layer 106 and the electron injection layer 107 (electron layer material), a polycyclic aromatic compound having a partial structure represented by the above described general formula (I) or a salt thereof can be also used as a host material or a dopant material. The content of the polycyclic aromatic compound having a partial structure represented by the above described general formula (I) or a salt thereof in each material differs depends on its kind and may be determined according to the property. The rough standard of the content of the polycyclic aromatic compound having a partial structure represented by the above described general formula (I) or a salt thereof is preferably 1 to 100% by weight, more preferably 10 to 100% by weight, further more preferably 50 to 100% by weight, and particularly preferably 80 to 100% by weight of the entirety of an electron transport layer material (or an electron injection layer material). When he polycyclic aromatic compound having a partial structure represented by the above described general formula (I) or a salt thereof is not used solely (100% by weight), other host materials, which are specifically described below, may be mixed.

Other materials used for the electron transport layer and the electron injection layer can be arbitrary selected from compounds that have been conventionally used as electron transfer compounds in photoconductor materials, and known compounds that are used in electron injection layers and electron transport layers of organic electroluminescent elements, and used.

A material used in the electron transport layer or the electron injection layer preferably contains at least one of a compound made of an aromatic ring or a heteroaromatic ring, which is constituted with one or more atoms selected from carbon, hydrogen, oxygen, sulfur, silicon and phosphorus, pyrrole derivatives and condensed ring derivatives thereof and metal complexes having electron-accepting nitrogen. Specific examples include condensed ring aromatic ring derivatives such as naphthalene and anthracene, styryl aromatic ring derivatives typically represented by 4,4'-bis(diphenylethenyl)biphenyl, perinone derivatives, coumarin derivatives, naphthalimide derivatives, quinone derivatives such as anthraquinone and diphenoquinone, phosphine oxide derivatives, carbazole derivatives and indole derivatives. Examples of metal complexes having electron-accepting nitrogen include hydroxyazole complexes such as hydroxyphenyl oxazole complexes, azomethine complexes, tropolone metal complex, flavonol metal complexes and benzoquinoline metal complexes. These materials are also used solely and may be used by mixing with different materials. Among these materials, anthracene derivatives such as 9,10-bis(2-naphthyl)anthracene, styryl aromatic ring derivatives such as 4,4'-bis(diphenylethenyl)biphenyl, carbazole derivatives such as 4,4'-bis(N-carbazolyl)biphenyl and 1,3,5-tris(N-carbazolyl)benzene are preferably used from the viewpoint of durability.

Specific examples of electron transport compounds include pyridine derivatives, naphthalene derivatives, anthracene derivatives, phenanthroline derivatives, perinone derivatives, coumarin derivatives, naphthalimide derivatives, anthraquinone derivatives, diphenoquinone derivatives, diphenylquinone derivatives, perylene derivatives, oxadiazole derivatives (1,3-bis[(4-t-butylphenyl)1,3,4-oxadiazolyl]phenylene, etc.), thiophene derivatives, triazole derivatives (N-naphthyl-2,5-diphenyl-1,3,4-triazole, etc.), thiadiazole derivatives, metal complex of oxine derivatives, quinolinol metal complex, quinoxaline derivatives, polymers of quinoxaline derivatives, benzazole compounds, gallium complex, pyrrazole derivatives, perfluorinated phenylene derivatives, triazine derivatives, pyrazine derivatives, benzoquinoline derivatives (2,2'-bis(benzo[h]quinolin-2-yl)-9,9'-spirobifluorene, etc.), imidazopyridine derivatives, boran derivatives, benzimidazole derivatives (tris(N-phenylbenzimidazol-2-yl)benzene, etc.), benzoxazole derivatives, benzothiazole derivatives, quinoline derivatives, oligopyridine derivatives such as terpyridine, bipyridine derivatives, terpyridine derivatives (1,3-bis(4'-(2,2':6'2"-terpyridinyl))benzene, etc.), naphthylidine derivatives (bis(1-naphthyl)-4-(1,8-naphthylidin-2-yl)phenylphosphine oxide, etc.), aldazine derivatives, carbazole derivatives, indole derivatives, phosphorus oxide derivatives, bisstyryl derivatives, and the like.

Alternatively, metal complexes having electron-accepting nitrogen can also be used, and examples include quinolinol-based metal complexes, hydroxyazole complexes such as hydroxyphenyloxazole complexes, azomethine complexes, tropolon metal complexes, flavonol metal complexes and benzoquinoline metal complexes, and the like.

These materials may be used alone, or may be used by mixing with different materials.

Among the above-mentioned materials, quinolinol-based metal complexes, bipyridine derivatives, phenanthroline derivatives, boran derivatives or benzimidazole derivatives are preferable.

The quinolinol-based metal complexes are compound represented by the following formula (E-1).

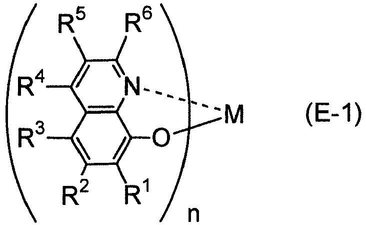

In the formula, R¹ to R⁶ are each hydrogen or a substituent, M is Li, Al, Ga, Be or Zn, and n is an integer of 1 to 3.

Specific examples of the quinolinol-based metal complexes include 8-quinolinollithium, tris(8-quinolinolate)aluminum, tris(4-methyl-8-quinolinolate)aluminum, tris(5-methyl-8-quinolinolate)aluminum, tris(3,4-dimethyl-8-quinolinolate)aluminum, tris(4,5-dimethyl-8-quinolinolate)aluminum, tris(4,6-dimethyl-8-quinolinolate)aluminum, bis(2-methyl-8-quinolinolate)(phenolate)aluminum, bis(2-methyl-8-quinolinolate)(2-methylphenolate)aluminum, bis(2-methyl-8-quinolinolate)(3-methylphenolate)aluminum, bis(2-methyl-8-quinolinolate)(4-methylphenolate)aluminum, bis(2-methyl-8-quinolinolate)(2-phenylphenolate)aluminum, bis(2-methyl-8-quinolinolate)(3-phenylphenolate)aluminum, bis(2-methyl-8-quinolinolate)(4-phenylphenolate)aluminum, bis(2-methyl-8-quinolinolate)(2,3-dimethylphenolate)aluminum, bis(2-methyl-8-quinolinolate)(2,6-dimethylphenolate)aluminum, bis(2-methyl-8-quinolinolate)(3,4-dimethylphenolate)aluminum, bis(2-methyl-8-quinolinolate)(3,5-dimethylphenolate)aluminum, bis(2-methyl-8-quinolinolate)(3,5-di-t-butylphenolate)aluminum, bis(2-methyl-8-quinolinolate)(2,6-diphenylphenolate)aluminum, bis(2-methyl-8-quinolinolate)(2,4,6-triphenylphenolate)aluminum, bis(2-methyl-8-quinolinolate)(2,4,6-trimethylphenolate)aluminum, bis(2-methyl-8-quinolinolate)(2,4,5,6-tetramethylphenolate)aluminum, bis(2-methyl-8-quinolinolate)(1-naphtholate)aluminum, bis(2-methyl-8-quinolinolate)(2-naphtholate)aluminum, bis(2,4-dimethyl-8-quinolinolate)(2-phenylphenolate)aluminum, bis(2,4-dimethyl-8-quinolinolate)(3-phenylphenolate)aluminum, bis(2,4-dimethyl-8-quinolinolate)(4-phenylphenolate)aluminum, bis(2,4-dimethyl-8-quinolinolate)(3,5-dimethylphenolate)aluminum, bis(2,4-dimethyl-8-quinolinolate)(3,5-di-t-butylphenolate)aluminum, bis(2-methyl-8-quinolinolate)aluminum-µ-oxo-bis(2-methyl-8-quinolinolate)aluminum, bis(2,4-dimethyl-8-quinolinolate)aluminum-µ-oxo-bis(2,4-dimethyl-8-quinolinolate)aluminum, bis(2-methyl-4-ethyl-8-quinolinolate)aluminum-µ-oxo-bis(2-methyl-4-ethyl-8-quinolinolate)aluminum, bis(2-methyl-4-methoxy-8-quinolinolate)aluminum-µ-oxo-bis(2-methyl-4-methoxy-8-quinolinolate)aluminum, bis(2-methyl-5-cyano-8-quinolinolate)aluminum-µ-oxo-bis(2-methyl-5-cyano-8-quinolinolate)aluminum, bis(2-methyl-5-trifluoromethyl-8-quinolinolate)aluminum-µ-oxo-bis(2-methyl-5-trifluoromethyl-8-quinolinolate)aluminum, bis(10-hydroxybenzo[h]quinoline)beryllium and the like.

The bipyridine derivatives are compounds represented by the following formula (E-2).

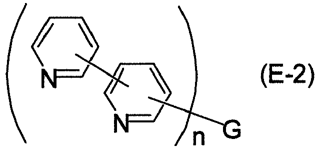

In the formula, G represents a simple bond or a linking group with a valency of n, and n is an integer of 2 to 8. Furthermore, the carbon atoms that are not used for the bonding of pyridine-pyridine or pyridine-G may be substituted.

Examples of G in the formula (E-2) include those having the following structural formulas. The Rs in the following structural formulas are each independently hydrogen, methyl, ethyl, isopropyl, cyclohexyl, phenyl, 1-naphthyl, 2-naphthyl, biphenylyl or terphenylyl.

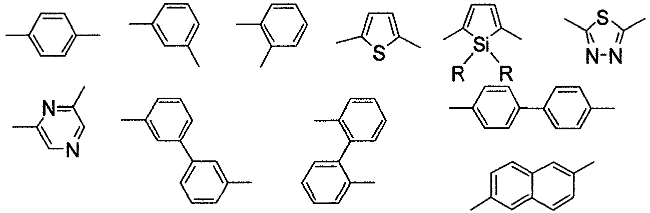

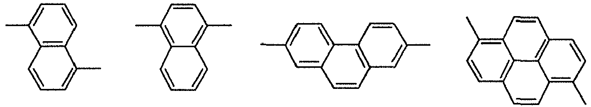

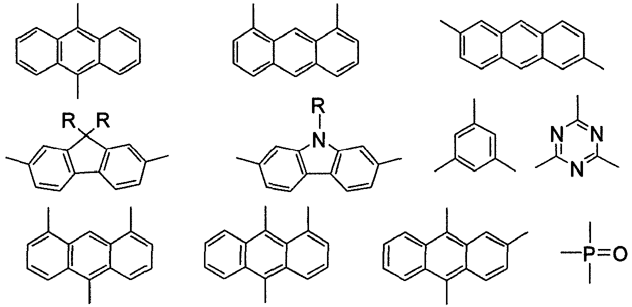

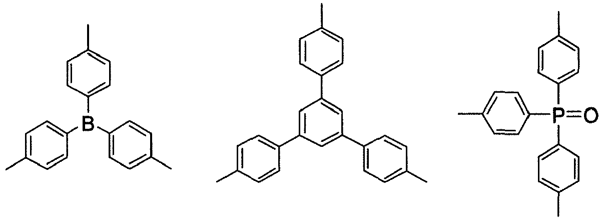

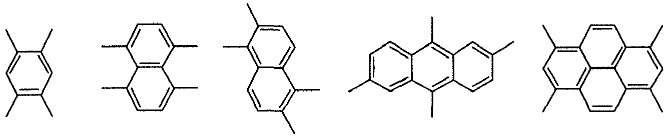

Specific examples of the pyridine derivatives are 2,5-bis(2,2'-bipyridin-6-yl)-1,1-dimethyl-3,4-diphenylsilole, 2,5-bis(2,2'-bipyridin-6-yl)-1,1-dimethyl-3,4-dimesitylsilole, 2,5-bis(2,2'-bipyridin-5-yl)-1,1-dimethyl-3,4-diphenylsilole, 2,5-bis(2,2'-bipyridin-5-yl)-1,1-dimethyl-3,4-dimesitylsilole, 9,10-di(2,2'-bipyridin-6-yl)anthracene, 9,10-di(2,2'-bipyridin-5-yl)anthracene, 9,10-di(2,3'-bipyridin-6-yl)anthracene, 9,10-di(2,3'-bipyridin-5-yl)anthracene, 9,10-di(2,3'-bipyridin-6-yl)-2-phenylanthracene, 9,10-di(2,3'-bipyridin-5-yl)-2-phenylanthracene, 9,10-di(2,2'-bipyridin-6-yl)-2-phenylanthracene, 9,10-di(2,2'-bipyridin-5-yl)-2-phenylanthracene, 9,10-di(2,4'-bipyridin-6-yl)-2-phenylanthracene, 9,10-di(2,4'-bipyridin-5-yl)-2-phenylanthracene, 9,10-di(3,4'-bipyridin-6-yl)-2-phenylanthracene, 9,10-di(3,4'-bipyridin-5-yl)-2-phenylanthracene, 3,4-diphenyl-2,5-di(2,2'-bipyridin-6-yl)thiophene, 3,4-diphenyl-2,5-di(2,3'-bipyridin-5-yl)thiophene, 6'6"-di(2-pyridyl)2,2' : 4',4" : 2",2"'-quaterpyridine and the like.

The phenanthroline derivatives are compounds represented by the following formula (E-3-1) or (E-3-2).

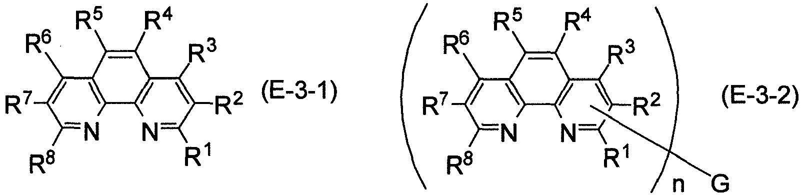

In the formulas, R¹ to R⁸ are each hydrogen or a substituent, where in the adjacent groups may bind to each other to form a condensed ring, G represents a simple bond or a linking group with a valency of n, and n is an integer of 2 to 8. Furthermore, examples of G in the formula (E-3-2) include those similar to those explained in the column of the bipyridine derivatives.

Specific examples of the phenanthroline derivatives include 4,7-diphenyl-1,10-phenanthroline, 2,9-dimethyl-4,7-diphenyl-1,10-phenanthroline, 9,10-di(1,10-phenanthrolin-2-yl)anthracene, 2,6-di(1,10-phenanthrolin-5-yl)pyridine, 1,3,5-tri(1,10-phenanthrolin-5-yl)benzene, 9,9'-difluoro-bis(1,10-phenanthrolin-5-yl), bathocuproine, 1,3-bis(2-phenyl-1,10-phenanthrolin-9-yl)benzene, and the like.

Especially, the case when a phenanthroline derivative is used in the electron transport layer and the electron injection layer will be explained. In order to obtain stable luminescent over a long time, a material that is excellent in thermal stability and thin film formability is desired, and among phenanthroline derivatives, those having substituents in which the substituents themselves have three-dimensional steric structures or those having three-dimensional steric structures by the steric repulsion with the phenanthroline backbone or the adjacent substituents, or those formed by linking plural phenanthroline backbones are preferable. Furthermore, in the case when plural phenanthroline backbones are connected, compounds containing conjugate bonds, substituted or unsubstituted aromatic hydrocarbons or substituted or unsubstituted aromatic heterocycles in the linked units are more preferable.

The borane derivatives are compounds represented by the following formula (E-4), and the details thereof are disclosed in JP 2007-27587 A.

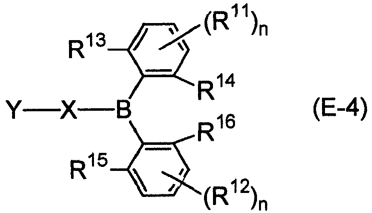

In the formula, R¹¹ and R¹² are each independently at least one of hydrogen, an alkyl, an optionally substituted aryl, a substituted silyl, an optionally substituted nitrogen-containing heterocycle or cyano, R¹³ to R¹⁶ are each independently an optionally substituted alkyl or an optionally substituted aryl, X is an optionally substituted arylene, Y is an optionally substituted aryl, substituted boryl or optionally substituted carbazole with a carbon number of 16 or less, and ns are each independently an integer of 0 to 3.

Among the compounds represented by the above-mentioned formula (E-4), compounds represented by the following formula (E-4-1) and compounds represented by the following formulae (E-4-1-1) to (E-4-1-4) are preferable. Specific examples include 9-[4-(4-dimesitylborylnaphthalen-1-yl)phenyl]carbazole, 9-[4-(4-dimesitylborylnaphthalen-1-yl)naphthalen-1-yl]carbazole and the like.

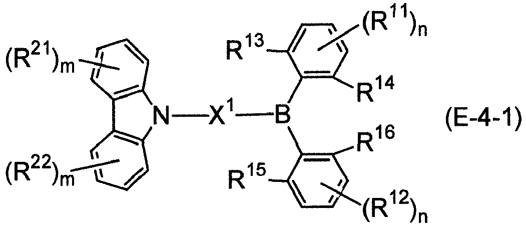

In the formula, R¹¹ and R¹² are each independently at least one of hydrogen, an alkyl, an optionally substituted aryl, a substituted silyl, an optionally substituted nitrogen-containing heterocycle or cyano, R¹³ to R¹⁶ are each independently an optionally substituted alkyl or an optionally substituted aryl, R²¹ and R²² are each independently at least one of hydrogen, an alkyl, an optionally substituted aryl, a substituted silyl, an optionally substituted nitrogen-containing heterocycle or cyano, X¹ is an optionally substituted arylene with a carbon number of 20 or less, ns are each independently an integer of 0 to 3, and ms are each independently an integer of 0 to 4. 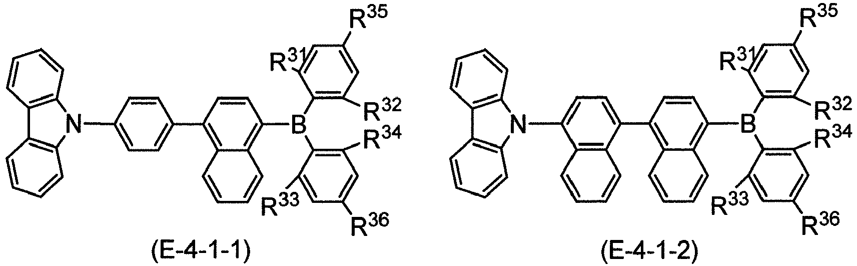 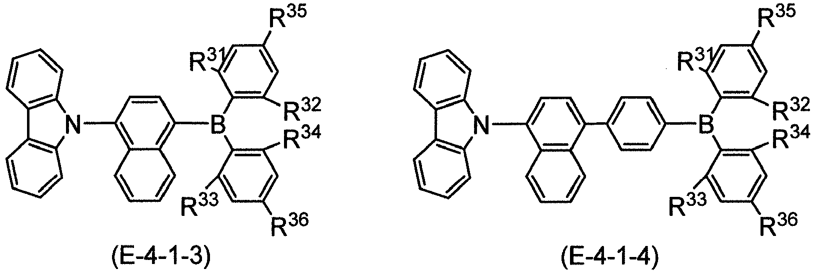 In each formula, R³¹ to R³⁴ are each independently any of methyl, isopropyl or phenyl, and R³⁵ and R³⁶ are each independently any of hydrogen, methyl, isopropyl or phenyl.

Among the compounds represented by the above-mentioned formula (E-4), the compounds represented by the following formula (E-4-2) and the compounds represented by the following formula (E-4-2-1) are preferable.

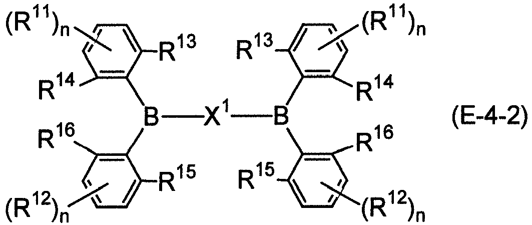

In the formula, R¹¹ and R¹² are each independently at least one of hydrogen, an alkyl, an optionally substituted aryl, a substituted silyl, an optionally substituted nitrogen-containing heterocycle or cyano, R¹³ to R¹⁶ are each independently an optionally substituted alkyl or an optionally substituted aryl, X¹ is an optionally substituted arylene with a carbon number of 20 or less, and ns are each independently an integer of 0 to 3. 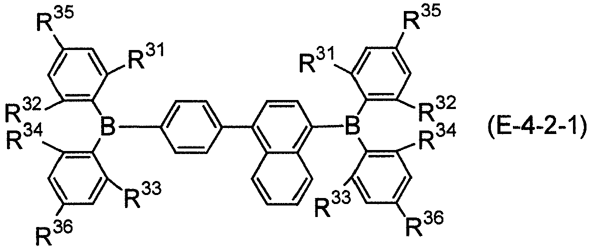 In the formula, R³¹ to R³⁴ are each independently any of methyl, isopropyl or phenyl, and R³⁵ and R³⁶ are each independently any of hydrogen, methyl, isopropyl or phenyl.

Among the compounds represented by the above-mentioned formula (E-4), the compounds represented by the following formula (E-4-3), the compounds represented by the following formula (E-4-3-1) or the compounds represented by the following formula (E-4-3-2) are preferable.

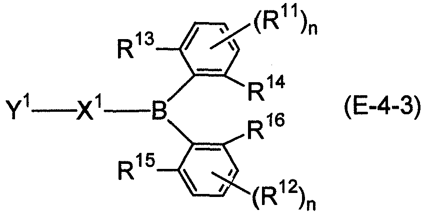

In the formula, R¹¹ and R¹² are each independently at least one of hydrogen, an alkyl, an optionally substituted aryl, a substituted silyl, an optionally substituted nitrogen-containing heterocycle or cyano, R¹³ to R¹⁶ are each independently an optionally substituted alkyl or an optionally substituted aryl, X¹ is an optionally substituted arylene with a carbon number of 10 or less, Y¹ is an optionally substituted aryl with a carbon number of 14 or less, and ns are each independently an integer of 0 to 3. 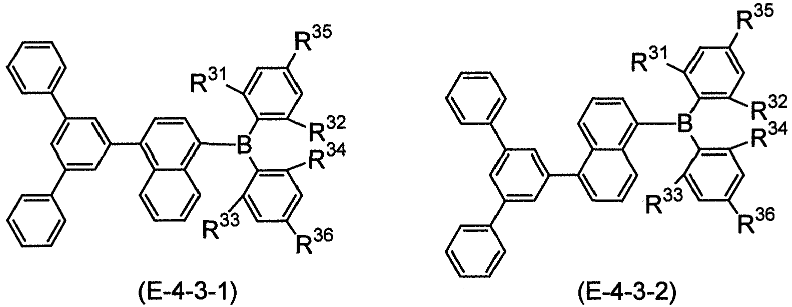 In each formula, R³¹ to R³⁴ are each independently any of methyl, isopropyl or phenyl, and R³⁵ and R³⁶ are each independently any of hydrogen, methyl, isopropyl or phenyl.

The benzimidazole derivatives are compounds represented by the following formula (E-5).

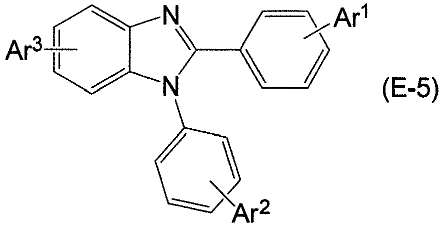

In the formula, Ar¹ to Ar³ are each independently hydrogen or an optionally substituted aryl with a carbon number of 6 to 30. Especially, the benzimidazole derivatives wherein Ar¹ is an optionally substituted anthryl are preferable.

Specific examples of the aryl with a carbon number of 6 to 30 include phenyl, 1-naphthyl, 2-naphthyl, acenaphthylen-1-yl, acenaphthylen-3-yl, acenaphthylen-4-yl, acenaphthylen-5-yl, fluoren-1-yl, fluoren-2-yl, fluoren-3-yl, fluoren-4-yl, fluoren-9-yl, phenalen-1-yl, phenalen-2-yl, 1-phenanthryl, 2-phenanthryl, 3-phenanthryl, 4-phenanthryl, 9-phenanthryl, 1-anthryl, 2-anthryl, 9-anthryl, fluoranthen-1-yl, fluoranthen-2-yl, fluoranthen-3-yl, fluoranthen-7-yl, fluoranthen-8-yl, triphenylen-1-yl, triphenylen-2-yl, pyren-1-yl, pyren-2-yl, pyren-4-yl, chrysen-1-yl, chrysen-2-yl, chrysen-3-yl, chrysen-4-yl, chrysen-5-yl, chrysen-6-yl, naphthacen-1-yl, naphthacen-2-yl, naphthacen-5-yl, perylen-1-yl, perylen-2-yl, perylen-3-yl, pentacen-1-yl, pentacen-2-yl, pentacen-5-yl and pentacen-6-yl.

Specific examples of the benzimidazole derivatives include 1-phenyl-2-(4-(10-phenylanthracen-9-yl)phenyl)-1H-benzo[d]imidazole, 2-(4-(10-(naphthalen-2-yl)anthracen-9-yl)phenyl)-1-phenyl-1H-benzo[d]imidazole, 2-(3-(10-(naphthalen-2-yl)anthracen-9-yl)phenyl)-1-phenyl-1H-benzo[d]imidazole, 5-(10-(naphthalen-2-yl)anthracen-9-yl)-1,2-diphenyl-1H-benzo[d]imidazole, 1-(4-(10-(naphthalen-2-yl)anthracen-9-yl)phenyl)-2-phenyl-1H-benzo[d]imidazole, 2-(4-(9,10-di(naphthalen-2-yl)anthracen-2-yl)phenyl)-1-phenyl-1H-benzo[d]imidazole, 1-(4-(9,10-di(naphthalen-2-yl)anthracen-2-yl)phenyl)-2-phenyl-1H-benzo[d]imidazole, and 5-(9,10-di(naphthalen-2-yl)anthracen-2-yl)-1,2-diphenyl-1H-benzo[d]imidazole.

The electron transport layer or the electron injection layer may further contain a substance that can reduce the material that forms the electron transport layer or electron injection layer. As this reductive substance, various substances are used as long as they have certain reductivity, and at least one selected from, for example, alkali metals, alkaline earth metals, rare earth metals, oxides of alkali metals, halides of alkali metals, oxides of alkaline earth metals, halides of alkaline earth metals, oxides of rare earth metals, halides of rare earth metals, organic complexes of alkali metals, organic complexes of alkaline earth metals and organic complexes of rare earth metals can be preferably used.

Preferable reductive substances include alkali metals such as Na (work function: 2.36 eV), K (work function: 2.28 eV), Rb (work function: 2.16 eV) or Cs (work function: 1.95 eV), alkaline earth metals such as Ca (work function: 2.9 eV), Sr (work function: 2.0 to 2.5 eV) or Ba (work function: 2.52 eV), and those having a work function of 2.9 eV or less are especially preferable. Among these, more preferable reductive substances are alkali metals K, Rb or Cs, and Rb or Cs is further preferable, and Cs is the most preferable. These alkali metals especially have high reductivity, and by adding these to the material that forms the electron transport layer or electron injection layer in a relatively small amount, the luminance of the luminescent in an organic EL element is improved and the lifetime is extended. Furthermore, as the reductive substance having a work function of 2.9 eV or less, a combination of two or more kinds of these alkali metals is also preferable, and especially, combinations containing Cs such as a combination of Cs and Na, Cs and K, Cs and Rb or Cs and Na and K are preferable. Since the reductive substance contains Cs, the reducibility can be efficiently exerted, and the luminance of the luminescence in an organic EL element is improved and the lifetime is extended by adding to the material that forms the electron transport layer or the electron injection layer.

### <Cathode in organic electroluminescent element>

The cathode 108 plays a role in injecting electrons to the luminescent layer 105 through the electron injection layer 107 and the electron transport layer 106.

The material for forming the cathode 108 is not especially limited as long as it is a substance that can efficiently inject the electrons into the organic layer, similar materials to the material that forms the anode 102 can be used. Among these, metals such as tin, indium, calcium, aluminum, silver, copper, nickel, chromium, gold, platinum, iron, zinc, lithium, sodium, potassium, cesium and magnesium or alloys thereof (magnesium-silver alloys, magnesium-indium alloys, aluminum-lithium alloys such as lithium fluoride/aluminum, etc.) and the like are preferable. In order to increase the electron injection efficiency to improve the element property, lithium, sodium, potassium, cesium, calcium, magnesium or alloys containing these metals having a low work function are effective. However, in many cases, these low work function metals are generally unstable in the air. In order to improve this point, for example, a process using an electrode having high stability by doping an organic layer with a trace amount of lithium, cesium or magnesium is known. As other dopants, inorganic salts such as lithium fluoride, cesium fluoride, lithium oxide and cesium oxide can also be used. However the dopants are not limited to these.

Furthermore, in order to protect the electrodes, preferable examples include laminating metals such as platinum, gold, silver, copper, iron, tin, aluminum and indium or alloys using these metals, inorganic substances such as silica, titania and silicon nitride, polyvinyl alcohol, vinyl chloride, hydrocarbon-based polymer compounds and the like. The processes for preparing these electrodes are not especially limited as long as conduction can be obtained, and include resistance heating, electron ray beam, sputtering, ion plating and coating, and the like.

### <Binder that may be used in respective layers>

The above-mentioned materials that are used for the hole injection layer, hole transport layer, luminescent layer, electron transport layer and electron injection layer can form the respective layers by themselves, but can also be used by dispersing in a polymer binder, including solvent-soluble resins such as polyvinyl chloride, polycarbonate, polystyrene, poly(N-vinyl carbazole), polymethyl methacrylate, polybutyl methacrylate, polyester, polysulfone, polyphenylene oxide, polybutadiene, hydrocarbon resins, ketone resins, phenoxy resins, polyamide, ethyl cellulose, vinyl acetate resins, ABS resins and polyurethane resins, curable resins such as phenolic resins, xylene resins, petroleum resins, urea resins, melamine resins, unsaturated polyester resins, alkid resins, epoxy resins and silicone resins.

### <Method for preparing organic electroluminescent element>

The respective layers that constitute the organic electroluminescent element can be formed by forming the materials that should constitute the respective layers into thin films by a process such as a deposition process, resistance heating deposition, electron beam deposition, sputtering, a molecular lamination process, a printing process, a spin coating process or a casting process, a coating process, and the like. The film thickness of each layer formed by this way is not especially limited and can be suitably preset according to the property of the material, but is generally in the range of 2 nm to 5000 nm. The film thickness can be generally measured by a quartz crystal oscillator film thickness meter or the like. In the case when a thin film is formed by using a deposition process, the deposition conditions thereof differ depending on the kind of the material, the intended crystal structure and associated structure of the film, and the like. It is preferable that the deposition conditions are suitably preset generally in the ranges of a boat heating temperature of 50 to 400°C, a vacuum degree of 10⁻⁶ to 10⁻³ Pa, a deposition velocity of 0.01 to 50 nm/sec, a substrate temperature of -150 to +300°C, a film thickness of 2 nm to 5 µm.

Next, as an example of the process for preparing the organic electroluminescent element, a process for preparing an organic electroluminescent element formed of an anode/a hole injection layer/a hole transport layer/a luminescent layer formed of a host material and a dopant material/an electron transport layer/an electron injection layer/a cathode will be explained. A thin film of an anode material is formed on a suitable substrate by a deposition process or the like to thereby form an anode, and thin films of a hole injection layer and a hole transport layer are formed on this anode. A host material and a dopant material are co-deposited thereon to form a thin film to thereby give a luminescent layer, and an electron transport layer and an electron injection layer are formed on this luminescent layer, and a thin film formed of a substance for a cathode is further formed by a deposition process or the like to give a cathode, thereby the intended organic electroluminescent element can be obtained. In the preparation of the above-mentioned organic electroluminescent element, it is also possible to reverse the order of preparation to prepare the cathode, electron injection layer, electron transport layer, luminescent layer, hole transport layer, hole injection layer and anode in this order.

In the case when a direct current voltage is applied to the organic electroluminescent element obtained in such way, it is sufficient to apply so that the anode has polarity of + and the cathode has polarity of -, and when a voltage of about 2 to 40 V is applied, luminescence can be observed from the side of the transparent or translucent electrode (the anode or cathode, and both). Furthermore, this organic electroluminescent element emits light also in the case when a pulse electrical current or an alternate current is applied. The wave form of the applied current may be arbitrary.

### <Example of application of organic electroluminescent element>

Furthermore, the present invention can also be applied to a display device equipped with an organic electroluminescent element or a lighting device equipped with an organic electroluminescent element.

The display device or the lighting device equipped with the organic electroluminescent element can be produced by a known process such as connecting the organic electroluminescent element according to this exemplary embodiment to a known driving apparatus, and can be driven by suitably using a known driving process such as direct current driving, pulse driving and alternate current driving.

Examples of the display device include panel displays such as color flat panel displays, flexible displays such as flexible color organic electroluminescent (EL) displays, and the like (e.g., see JP 10-335066 A, JP 2003-321546 A, JP 2004-281086 A etc.). Furthermore, examples of the display formats of the displays may include matrix and/or segment system(s), and the like. Matrix display and segment display may be present in a same panel.

A matrix refers to pixels for display that are two-dimensionally disposed in a grid form, a mosaic form or the like, and letters and images are displayed by an assembly of pixels. The shape and size of the pixels are determined depending on the intended use. For example, square pixels wherein each side is 300 µm or less are generally used for displaying images and letters on personal computers, monitors and television sets, and pixels wherein each side is in the order of millimeters are used in the cases of large-sized displays such as display panels. In the case of monochrome display, it is sufficient to align pixels of a same color, whereas in the case of color display, the display is conducted by aligning pixels of red, green and blue. In this case, a delta type and a stripe type are typically exemplified. Furthermore, the process for driving this matrix may be a line sequential driving process or an active matrix. The line sequential driving process has an advantage that the structure is easy, but in the case when the operation property is taken into consideration, the active matrix is more excellent in some cases. Therefore, it is necessary to use the process depending on the intended use.

In a segment format (type), a pattern is formed so that information that has been determined in advance is displayed, and fixed regions are allowed to emit light. Examples include display of time and temperature in digital clocks and thermometers, display of the operation state on audio devices, electromagnetic cookers and the like, and display on panels of automobiles, and the like.

Examples of the lighting device include lighting devices such as indoor lighting devices, backlights for liquid crystal display devices, and the like (e.g., see JP 2003-257621 A, JP 2003-277741 A, JP 2004-119211 A etc.). Backlights are mainly used for the purpose of improving the visibility of display devices that do not emit light by themselves, and are used in liquid crystal display devices, clocks, audio apparatuses, automobile panels, display plates and signs, and the like. Especially, as a backlight for use in a liquid crystal display device, especially a personal computer for which thinning is a problem, a backlight using the luminescent device according to this exemplary embodiment is characterized by its thin shape and light weight, considering that a backlight of a conventional system is difficult to be formed into a thin shape since it includes a fluorescent light and a light guiding plate.

### Examples

The present invention is explained in further detail by Examples hereinbelow; however, the present invention is not limited thereto. Firstly, examples of synthesis of polycyclic aromatic compounds used in the examples are explained in the following.

### Synthesis Example (1):

### Synthesis of 4b-aza-12b-thiophosphadibenzo[g,p]chrysene

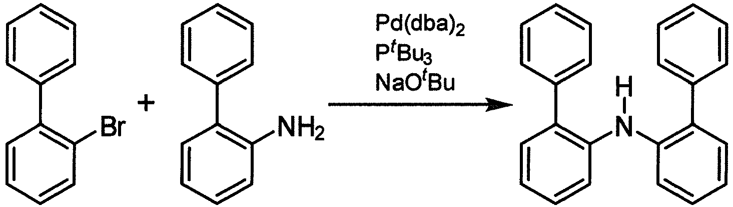

Firstly, 2-bromobiphenyl (23.1 g, 0.10 mol) was added to 2-aminobiphenyl (16.9 g, 0.10 mol), bis(dibenzylideneacetone)palladium (0.575 g, 1.0 mmol), sodium t-butoxide (14.4 g, 0.15 mol) and toluene (100 mL) at 0°C under an argon atmosphere, followed by stirring at room temperature for 7 hours, the mixture was then subjected to filtration with florisil, and a brown oily substance obtained by distilling off the solvent under reduced pressure was triturated using hexane to thus obtain bis(biphenyl-2-yl)amine as white powder (32.1 g, yield 98%).

¹H NMR (δppm in CDCl₃) ; 5.79 (s, 1H), 6.92 (t, J = 7.2 Hz, 2H), 7.17-7.27 (m, 14H), 7.40 (d, 2H, J = 8.1 Hz)
¹³C NMR (δppm in CDCl₃) 117.0, 120.8, 127.2, 128.1, 128.7, 129.0, 130.6, 132.0, 138.9, 140.1.

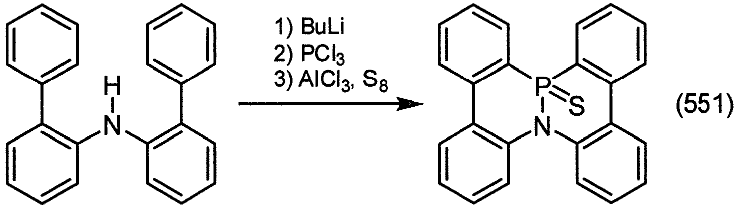

Next, a hexane solution (6.13 mL, 1.63 M, 10.0 mmol) of butyllithium was added to bis(biphenyl-2-yl)amine (3.21 g, 10.0 mmol) and THF (50 mL) at -78°C under an argon atmosphere, followed by stirring. One hour later, phosphorus trichloride (1.37 g, 10.0 mmol) was added thereto, and the mixture was stirred for one hour, the temperature of the mixture was then increased to 0°C and the reaction solution was further stirred for one hour. After distilling off the solvent under reduced pressure, 1,2-dichlorobenzene (80 mL) was added thereto. Thereafter aluminum trichloride (4.00 g, 30.0 mmol) and sulfur (0.481 g, 15.0 mmol) were added thereto, and the mixture was stirred at 120°C for 18 hours. 1,4-Diazabicyclo[2.2.2.]octane (3.36 g, 30.0 mmol) was added thereto, the mixture was subjected to filtration, and the crude product obtained by distilling off the solvent under reduced pressure was then isolated by HPLC and GPC to thus obtain the compound represented by the formula (551) as a white powder (0.725 g, yield: 19%).

HRMS(EI) m/z; calcd. 381.0741[M]⁺; found 381.0746.
¹H NMR (δppm in CD₂Cl₂ at -40°C) ; 6.65(d, 1H, J = 8.4 Hz), 7.01(t, 1H, J = 7.2 Hz), 7.09(t, 1H, J = 7.8 Hz), 7.19 (dd, 1H, J = 7.8, 13.8 Hz), 7.31 (td, 1H, J = 3.0, 7.8 Hz), 7.54 (t, 1H, J = 7.8 Hz), 7.62 (d, 1H, J = 7.2 Hz), 7.65-7.69 (m, 2H), 7.75 (td, 1H, J = 3.0, 7.8 Hz), 7.84-7.91 (m, 3H), 8.05 (d, 2H, J = 7.2 Hz), 8.09 (t, 1H, J = 7.2 Hz), 8.58 (dd, 1H, J = 7.8, 15.6 Hz)
¹³C NMR (δppm in CD₂Cl₂ at -40°C); 118.1, 120.8, 121.2, 122.3, 124.4, 126.5, 128.1, 128.5, 128.6, 128.7, 128.9, 129.3, 130.2 (2C), 131.6, 132.1, 132.8, 132.9, 134.4, 134.5, 135.2, 135.3, 136.2, 141.5

### Synthesis Example (2):

### Synthesis of 4b-aza-12b-phenyl-12b-siladibenzo[g,p]chrysene

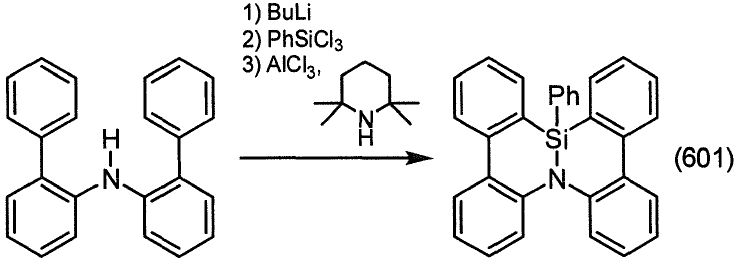

A hexane solution (0.62 mL, 1.60 M, 1.00 mmol) of butyllithium was added to bis(biphenyl-2-yl)amine (0.321 g, 1.00 mmol) and tetrahydrofuran (5 mL) at -78°C under an argon atmosphere, followed by stirring. After one hour of stirring, phenyl trichlorosilane (0.212 g, 1.00 mmol) was added thereto at -78°C, and stirred at room temperature for 12 hours. After distilling off the solvent under reduced pressure, 1,2-dichlorobenzene was added thereto. Thereafter, aluminum trichloride (0.533 g, 4.00 mmol) and 2,2,6,6-tetramethylpiperidine (0.233 g, 1.50 mmol) were added thereto, and the mixture was stirred at 150°C for 18 hours. 1,4-Diazabicyclo[2.2.2.]octane (0.449 g, 4.00 mmol) was added thereto, the mixture was subjected to filtration, and the crude product obtained by distilling off the solvent under reduced pressure was then isolated by HPLC and GPC to thus obtain the compound represented by the formula (601) as a white powder (0.064 g, yield: 15%). The compound represented by the formula (601) was recrystallized from hexane to obtain a colorless needle crystal, and the structure was determined by X-ray crystal structure analysis.

HRMS(FAB) m/z; calcd. 423.1443[M]⁺; found 423.1426.
X-ray crystal structure

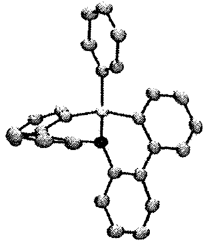

| | | | |
|---|---|---|---|
| Formula | C₃₀H₂₁NSi | Abs. Coefficient. cm⁻¹ | 0.127 |
| Formula Weight | 423.57 | F(000) | 888.00 |
| Temperature. K | 100(2) | Crystal Size. mm³ | 0.05, 0.02, 0.01 |
| Wavelength, A | 0.71069 | 2θₘᵢₙ, 2θₘₐₓ deg | 3.78, 51.0 |
| Crystal System | Monoclinic | Index Ranges | -10 h 11 |
| Space Group | P 2₁/n (No. 14) | | -18 k 19 |
| *a,* Å | 9.2321(2) | | -17 1 17 |
| *b,* Å | 16.4740(4) | Reflections (unique) | 3878 |
| *c,* Å | 14.2878(3) | Reflections (*I*>2.0σ(*I*)) | 3371 |
| *α*, deg | 90 | Parameters | 289 |
| *β*, deg | 96.1539(8) | GOF on F² | 1.087 |
| *γ,* deg | 90 | *R*₁ (*I*>2.0σ(*I*)) | 0.0538 |
| Volume. Å | 2160.50(8) | R. w*R*₂ (all data) | 0.0632.0.1387 |
| *Z* | 4 | Largest diff peak and hole. e. Å⁻³ | 0.560.-0.494 |
| Density_{calcd·} g·cm⁻³ | 1.302 | | |

### Synthesis Example (3):

### Synthesis of 4b-aza-12b-germa-12b-phenyldibenzo[g,p] chrysene

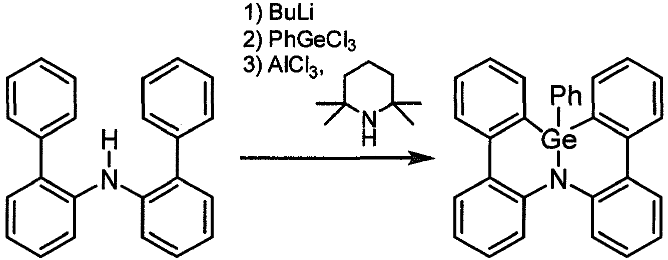

A hexane solution (1.25 mL, 1.60 M, 2.00 mmol) of butyllithium was added to bis(biphenyl-2-yl)amine (0.643 g, 2.00 mmol) and toluene (80 mL) at -78°C under an argon atmosphere, followed by stirring. One hour later, the temperature of the mixture was increased to 0°C, and the reaction solution was further stirred for one hour. Phenyl trichlorogermanium (0.512 g, 2.00 mmol) was then added at-78°C and stirred at room temperature for 12 hours. After distilling off the solvent under reduced pressure, 1,2-dichlorobenzene was added thereto. Thereafter, aluminum trichloride (1.07 g, 8.00 mmol) and 2,2,6,6-tetramethylpiperidine (0.466 g, 3.00 mmol) were added thereto, and the mixture was stirred at 150°C for 24 hours. 1,4-Diazabicyclo[2.2.2.]octane (1.12 g, 10.0 mmol) was added thereto, the mixture was subjected to filtration, and the crude product obtained by distilling off the solvent under reduced pressure was then isolated by HPLC and GPC to thus obtain the title compound as a white powder (0.389 g, yield: 42%).

The title compound was recrystallized from hexane to thus obtain a colorless column crystal, and the structure was determined by X-ray crystal structure analysis.

HRMS(MALDI) m/z; calcd. 470.0964[M+H]⁺; found 470.0980.
X-ray crystal structure

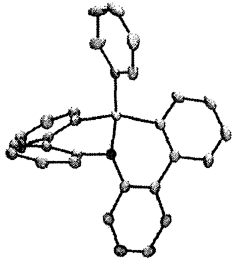

| | | | |
|---|---|---|---|
| Formula | C₃₀H₂₁NGe | Abs. Coefficient. cm⁻¹ | 1.416 |
| Formula Weight | 468.09 | F(000) | 480.00 |
| Temperature. K | 173 | Crystal Size, mm³ | 0.2, 0.2, 0.2 |
| Wavelength, A | 0.71070 | 2θ_{min·} 2θₘₐₓ deg | 6.3, 54.9 |
| Crystal System | Triclinic | Index Ranges | -11 h 11 |
| Space Group | P-1 (No. 2) | | -12 k 12 |
| *a*, Å | 9.655(3) | | -15 1 15 |
| *b*, Å | 10.225(2) | Reflections (unique) | 4293 |
| *c*, Å | 12.886(3) | Reflections (*I*>2.0σ(*I*)) | 3856 |
| *α*, deg | 67.894(11) | Parameters | 289 |
| *β*, deg | 71.624(11) | GOF on F² | 1.046 |
| *γ*, deg | 72.722(13) | *R*₁ (*I*>2.0σ(*I*)) | 0.0300 |
| Volmue. Å | 1095.4(5) | R. W*R*₂ (all data) | 0.0347, 0.0705 |
| *Z* | 2 | Largest diff peak and hole, e, Å⁻³ | 0.440, -0.290 |
| Density_{calcd·} g·cm⁻³ | 1.419 | | |

### Synthesis Example (4): Synthesis of 4b-aza-12b-boradibenzo[g,p]chrysene

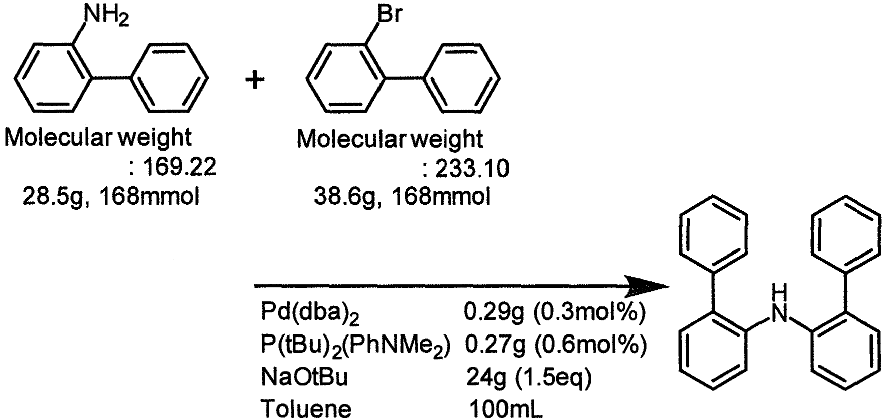

Firstly, a flask containing [1,1'-biphenyl]-2-amine (28.5 g), 2-bromo-1,1'-biphenyl (38.6 g), sodium-t-butoxide (24.0 g), Pd(dba)₂ (0.29 g), 4-(di-t-butylphosphino)-N,N-dimethylaniline (0.27 g) and toluene (100 ml) was stirred at 70°C for one hour under a nitrogen atmosphere. After cooling the reaction solution to room temperature, water and toluene were added to separate the reaction solution. Subsequently, the solvent was distilled off under reduced pressure and the reaction solution was then purified by active alumina column chromatography (developing solution: toluene) to thus obtain di([1,1'-biphenyl]-2-yl)amine (54.0 g).

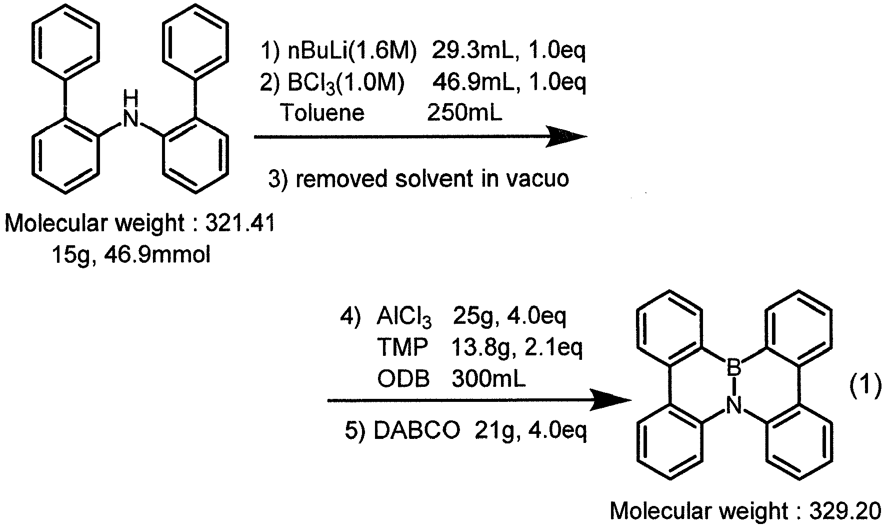

Next, a flask containing di([1,1'-biphenyl]-2-yl)amine (15.0 g) and toluene (250 ml) was cooled to -75°C, a 1.6 M-hexane solution of n-butyllithium (29.3 ml) was dropped thereto. After completion of dropping, the temperature of the reaction solution was once increased to 0°C, followed by stirring for one hour. Thereafter, the mixture was cooled to -75°C again, and a 1.0 M-heptane solution containing boron trichloride (46.9 ml) was dropped. Then, after increasing the temperature of the reaction solution to room temperature, the solvent was distilled off under reduced pressure once. Thereto were added orthodichlorobenzene (300 ml), 2,2,6,6-tetramethylpiperidine (13.8 g) and aluminum trichloride (25.0 g), followed by stirring at 150°C for 18 hours. After adding 1,4-diazabicyclo[2.2.2.]octane "DABCO" (21.0 g) and stirring the mixture, toluene (500 ml) and celite were added thereto, and the mixture was stirred and then stood still for about one hour. Subsequently, the deposited precipitate was removed by suction filtration using a hirsch funnel in which celite was bedded, thereafter distilling off the solvent under reduced pressure. Furthermore, the reaction solution was purified by active alumina column chromatography (developing solution: toluene/ethyl acetate/triethylamine = 90/10/1 (volume ratio)) and then reprecipitated with an ethyl acetate/heptane mixed solvent to thus obtain the compound represented by the formula (1) (8.2 g).

### Synthesis Example (5):

### Synthesis of 2,7-dibromo-4b-aza-12b-boradibenzo[g,p] chrysene

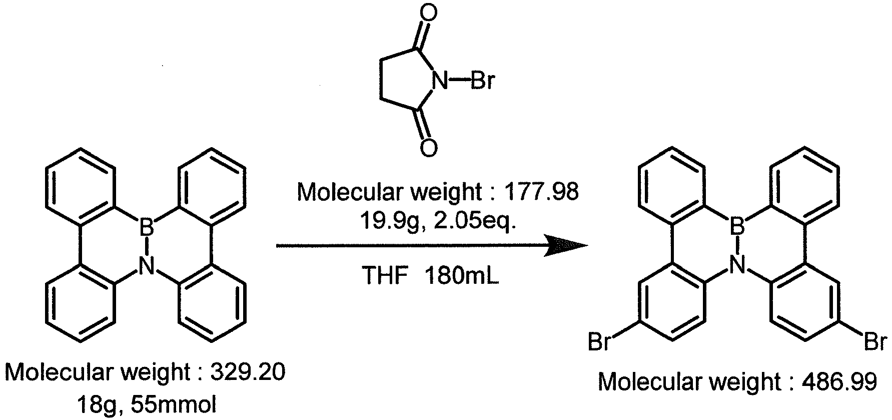

Under a nitrogen atmosphere, N-bromosuccinimide (NBS) (19.9g) was added to a THF (180 ml) solution of 4b-aza-12b-boradibenzo[g,p]chrysene (18.0 g) and the mixture was stirred at room temperature for one hour. After completion of the reaction, an aqueous sodium sulfite solution was added thereto, followed by distilling off THF under reduced pressure, and toluene was then added to separate the reaction solution. Subsequently, the reaction solution was purified by active alumina column chromatography (developing solution: toluene/ethyl acetate/triethylamine = 95/5/1 (volume ratio)) to thus obtain the title compound (24.7 g).

### Synthesis Example (6):

### Synthesis of 2,7-dimethyl-4b-aza-12b-boradibenzo[g,p] chrysene

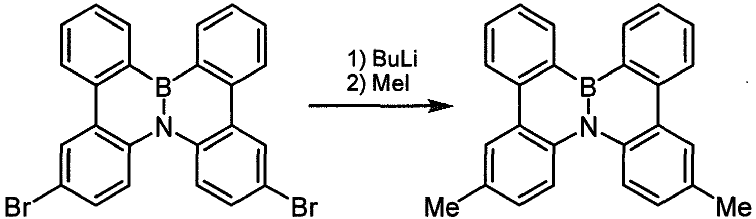

A hexane solution (0.63 mL, 1.60 M, 1.00 mmol) of butyllithium was added to 2,7-dibromo-4b-aza-12b-boradibenzo[g,p]chrysene (0.243 g, 0.50 mmol) and toluene (5.0 mL) at -78°C under an argon atmosphere, followed by stirring at 40°C for 24 hours. Thereafter, methyl iodide (0.178 g, 1.00 mmol) was added thereto, and the mixture was stirred for one hour. The crude product obtained by distilling off the solvent under reduced pressure was isolated by GPC to thus obtain the title compound as a whitish yellow powder (0.228 g, yield: 20%).

HRMS(EI) m/z; calcd. 357.1689[M]⁺; found 357.1692.
¹¹B NMR (δppm in C₆D₆) 34.0.

### Synthesis Example (7):

### Synthesis of 14b¹-aza-14b-borabenzo[p]indeno[1,2,3,4-defg]chrysene

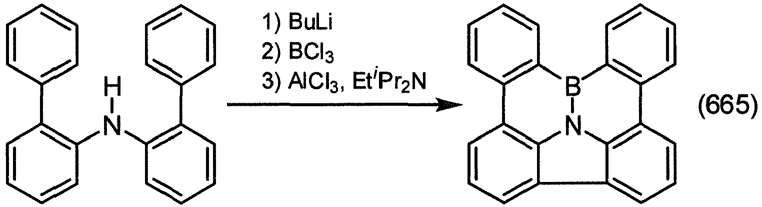

A hexane solution (1.23 mL, 1.60 M, 2.00 mmol) of butyllithium was added to bis(biphenyl-2-yl)amine (0.643 g, 2.00 mmol) and toluene (10 mL) at -78°C under an argon atmosphere, followed by stirring. One hour later, the temperature of the mixture was increased to 0°C and the reaction solution was further stirred for one hour. A heptane solution (2.00 mL, 1.00 M, 2.00 mmol) of boron trichloride was added at -78°C and stirred at room temperature for 12 hours. After distilling off the solvent under reduced pressure, 1,2-dichlorobenzene (20 mL) was added thereto. Thereafter, aluminum trichloride (1.07 g, 8.00 mmol), and ethyldiisopropyl amine (0.258 g, 2.00 mmol) were added thereto, and the mixture was stirred at 180°C for 12 hours. 1,4-Diazabicyclo[2.2.2.]octane (0.896 g, 8.00 mmol) was added thereto, the mixture was subjected to filtration, and the crude product obtained by distilling off the solvent under reduced pressure was then isolated by HPLC and GPC to thus obtain the compound represented by the formule (665) as a whitish yellow powder (0.255 g, yield: 39%).

HRMS(EI) m/z; calcd. 327.1219[M]⁺; found 327.1215.
¹H NMR (δppm in CDCl₃); 7.66-7.72 (m, 4H), 7.84 (td, 2H, J = 1.4, 8.2 Hz), 8.21 (d, 2H, J = 7.8 Hz), 8.43 (d, 2H, J = 7.8 Hz), 8.67 (d, 2H, J = 7.8 Hz), 9.18 (d, 2H, J = 7.8 Hz).

### Synthesis Example (8):

### Synthesis of 6,9-dichloro-14b¹-aza-14b-borabenzo[p]indeno [1,2,3,4-defg]chrysene

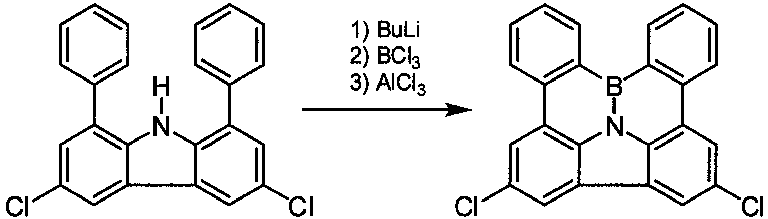

A hexane solution (1.56 mL, 1.60 M, 2.50 mmol) of butyllithium was added to 3,6-dichloro-1,8-diphenyl carbazole (0.971 g, 2.50 mmol) and toluene (10 mL) at -78°C under an argon atmosphere, followed by stirring. One hour later, the temperature of the mixture was increased to 0°C and the reaction solution was further stirred for one hour. A heptane solution (2.50 mL, 1.00 M, 2.50 mmol) of boron trichloride was added at -78°C and stirred at room temperature for 12 hours. After distilling off the solvent under reduced pressure, 1,2-dichlorobenzene (50 mL) was added thereto. Thereafter, aluminum trichloride (1.33 g, 10.0 mmol) was added thereto, and the mixture was stirred at 160°C for 14 hours. 1,4-Diazabicyclo[2.2.2.]octane (1.12 g, 10.0 mmol) was added thereto, the mixture was subjected to filtration, and the crude product obtained by distilling off the solvent under reduced pressure was then isolated by HPLC and GPC to thus obtain the title compound as a yellowish brown powder (0.297 g, yield: 30%).

HRMS(EI) m/z; calcd. 395.0440[M]⁺; found 395.0426.

### Synthesis Example (9):

### Synthesis of 4b-aza-12b-phosphadibenzo[g,p]chrysene

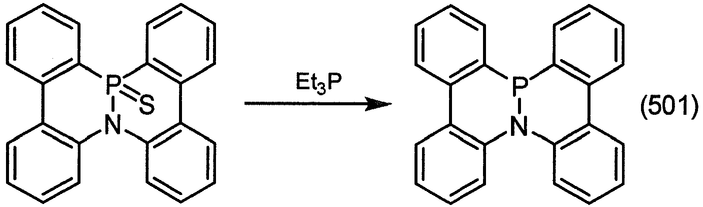

Chlorobenzene (3.0 mL) was added to 4b-aza-12b-thiophosphadibenzo[g,p]chrysene (0.114 g, 0.30 mmol) and triethylphosphine (0.039 g, 0.33 mmol) at 0°C under an argon atmosphere, followed by stirring at 120°C for 18 hours. The substance obtained by distilling off the solvent under reduced pressure was subjected to trituration by adding hexane to thus obtain the compound represented by the formula (501) as a white powder (0.073 g, yield: 70%).

HRMS(EI) m/z; calcd. 349.1020[M]⁺; found 349.1013.
³¹P NMR (δppm in C₆D₆) 12.7.

### Synthesis Example (10):

### Synthesis of 4b-aza-12b-oxaphospha-dibenzo[g,p]chrysene

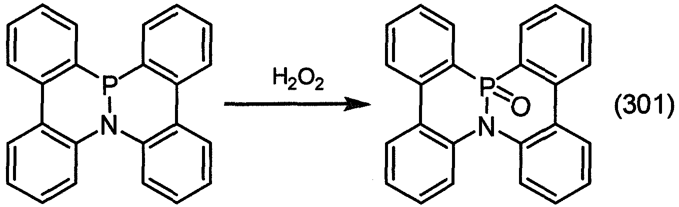

A 30% hydrogen peroxide solution (2.0 mL) was added to 4b-aza-12b-phosphadibenzo[g,p]chrysene (0.070 g, 0.20 mmol) and dichloromethane (2.0 mL), followed by stirring at room temperature for 6 hours. The crude product obtained by distilling off the solvent of the extracted organic layer under reduced pressure was isolated by HPLC and GPC to thus obtain the compound represented by the formula (301) as a whitish yellow powder (0.066 g, yield: 90%).

HRMS(ESI) m/z; calcd. 366.1042[M+H]⁺; found 366.1032.
³¹P NMR (δppm in C₆D₆) 6.6.

### Synthesis Example (11):

### Synthesis of 8b,19b-diaza-11b,22b-dithiophosphahexabenzo [a,c,fg,j,l,op]tetracene

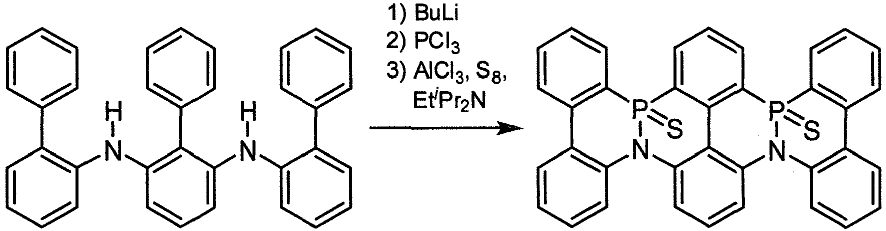

A hexane solution (2.45 mL, 1.63 M, 4.0 mmol) of butyllithium was added to N,N'-bis(biphenyl-2-yl)-2,6-diaminobiphenyl (0.977 g, 2.00 mmol) and toluene (20 mL) at -78°C under an argon atmosphere, followed by stirring. One hour later, phosphorus trichloride (0.549 g, 4.0 mmol) was added thereto, the mixture was stirred for one hour, the temperature of the mixture was then increased to 0°C and the reaction solution was further stirred for one hour. After distilling off the solvent under reduced pressure, 1,2-dichlorobenzene (40 mL) was added thereto. Thereafter, aluminum trichloride (2.13 g, 16.0 mmol) and sulfur (0.192 g, 6.0 mmol) were added thereto, and the mixture was stirred at 120°C for 18 hours. 1,4-Diazabicyclo[2.2.2.]octane (1.79 g, 16.0 mmol) was added thereto, the mixture was subjected to filtration, and the crude product obtained by distilling off the solvent under reduced pressure was then isolated by HPLC and GPC to thus obtain the title compound as a whitish yellow powder (0.122 g, yield: 10%).

HRMS(FAB) m/z; calcd. 609.0778[M+H]⁺; found 609.0762.

### Synthesis Example (12):

### Synthesis of 8b,19b-diaza-11b,22b-diborahexabenzo [a,c,fg,j,l,op]tetracene

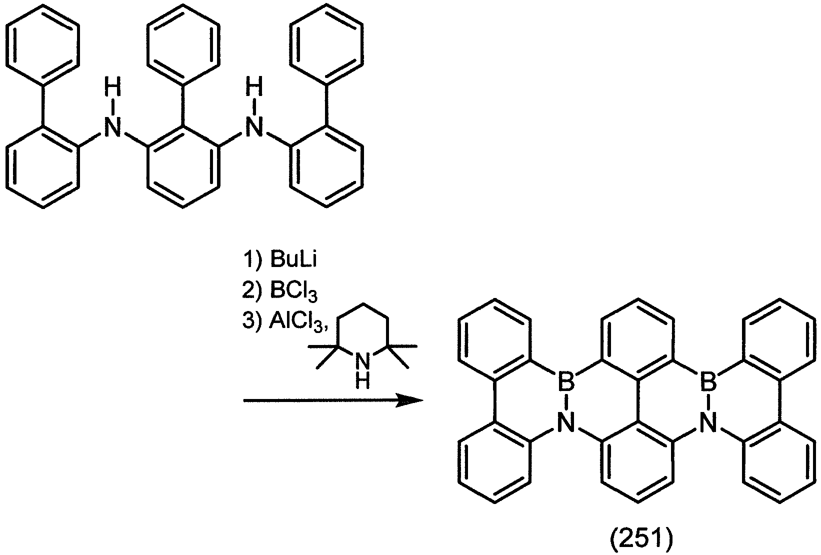

A hexane solution (2.45 mL, 1.63 M, 4.0 mmol) of butyllithium was added to N,N'-bis(biphenyl-2-yl)-2,6-diaminobiphenyl (0.977 g, 2.00 mmol) and toluene (20 mL) at -78°C under an argon atmosphere, followed by stirring. One hour later, the temperature of the mixture was increased to 0°C and the reaction solution was further stirred for one hour. Thereafter, a heptane solution (4.00 mL, 1.00 M, 4.0 mmol) of boron trichloride was added at -78°C and stirred for one hour. The temperature of the mixture was increased to room temperature and the reaction solution was further stirred for 12 hours. After distilling off the solvent under reduced pressure, 1,2-dichlorobenzene (40 mL) was added thereto. Thereafter, aluminum trichloride (2.13 g, 16.0 mmol) and 2,2,6,6-tetramethylpiperidine (0.192 g, 6.0 mmol) were added thereto, and the mixture was stirred at 150°C for 24 hours. 1,4-Diazabicyclo[2.2.2.]octane (1.79 g, 16.0 mmol) was added thereto, the mixture was subjected to filtration, and the crude product obtained by distilling off the solvent under reduced pressure was then isolated by HPLC and GPC to thus obtain the compound represented by the formula (251) as a whitish yellow powder (0.122 g, yield: 40%).

Anal. calcd for C₃₆H₂₂N₂B₂C, 85.76; H, 4.40; N, 5.56. found C, 85.85; H, 4.24; N, 5.66.
¹H NMR (δppm in CS₂/CD₂Cl₂=2/1, 600 MHz) 7.31-7.34 (m, 4H, NCCCHCH), 7.55 (t, J = 8.4 Hz, 1H, NCCHCHCHCN), 7.61 (td, J = 1.2, 7.2 Hz, 2H, BCCHCHCHCH), 7.78 (td, J = 1.2, 7.2 Hz, 2H, BCCHCHCHCH), 7.91 (t, J = 7.2 Hz, 1H, BCCHCHCHCB), 8.05 (d, J = 8.4 Hz, 2H, NCCHCHCHCN), 8.11-8.13 (m, 2H, NCCHCHCHCH), 8.32-8.35 (m, 2H, NCCCH), 8.40 (d, J = 7.2 Hz, 2H, BCCCH), 8.71 (d, J = 7.2 Hz, 2H, BCCHCHCHCH), 8.96 (d, J = 7.2 Hz, 2H, BCCHCHCHCB)
¹³C NMR (δppm in CS₂/CD₂Cl₂=2/1, 151 MHz) 114.3 (2C), 119.2, 121.8 (2C), 123.1 (2C), 123.4 (2C), 125.7, 125.8 (2C), 126.2, 126.7 (2C), 127.1 (2C), 128.1 (2C), 130.5 (br, 2C, CBCCCBC), 131.4 (2C), 133.0 (br, 2C, CBCCCBC), 135.8 (2C), 137.5 (4C), 137.6 (2C), 138.9, 139.0 (2C)
¹¹B NMR (δppm in CS₂/CD₂Cl₂=2/1, 193 MHz) 36.5.

### Synthesis Example (13):

### Synthesis of 4b,17b-diaza-9b,22b-diboratetrabenzo[a,c,f,m] phenanthro[9,10-k]tetraphene

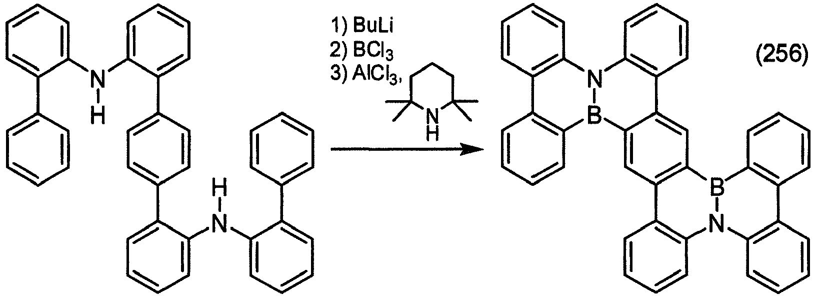

A hexane solution (0.62 mL, 1.63 M, 1.0 mmol) of butyllithium was added to N,N"-bis(biphenyl-2-yl)-2,2"-diamino terphenyl (0.565 g, 1.00 mmol) and toluene (10 mL) at -78C° under an argon atmosphere, followed by stirring. One hour later, the temperature of the mixture was increased to 0°C and the reaction solution was further stirred for one hour. A heptane solution (1.00 mL, 1.00 M, 1.0 mmol) of boron trichloride was then added thereto at-78°C and the mixture was stirred for one hour. The temperature of the reaction solution was then increased to room temperature and the reaction solution was further stirred for 12 hours. After distilling off the solvent under reduced pressure, 1,2-dichlorobenzene (20 mL) was added thereto. Thereafter, aluminum trichloride (2.13 g, 16.0 mmol) and 2,2,6,6-tetramethylpiperidine (0.192 g, 6.0 mmol) were added thereto, and the mixture was stirred at 150°C for 24 hours. 1,4-Diazabicyclo[2.2.2.]octane (1.79 g, 16.0 mmol) was added thereto, the mixture was subjected to filtration, and the crude product obtained by distilling off the solvent under reduced pressure was then isolated by HPLC and GPC to thus obtain the compound represented by the formula (256) as a whitish yellow powder (0.133 g, yield: 23%).

HRMS(FAB) m/z; calcd. 580.2282[M]⁺; found 580.2296.
¹¹B NMR (δppm in CS₂/C₆D₆=2/1, 126 MHz) 35.7.

### Synthesis Example (14):

### Synthesis of 11b-aza-3b-borabenzo[11,12]chryseno[6,5-b]thiophene

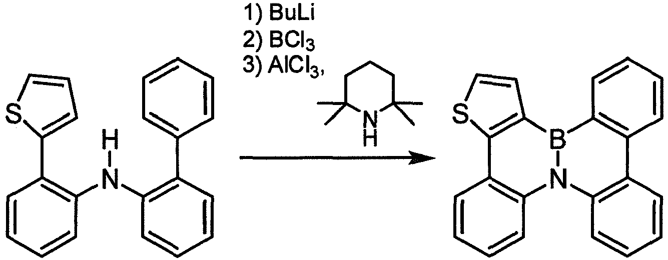

A hexane solution (1.25 mL, 1.60 M, 2.00 mmol) of butyllithium was added to N-[(2-thienyl)phenyl]-N-(biphenyl-2-yl)amine (0.655 g, 2.00 mmol) and toluene (10 mL) at -78°C under an argon atmosphere, followed by stirring. One hour later, the temperature of the mixture was increased to 0°C and the reaction solution was further stirred for one hour. A heptane solution (2.00 mL, 1.00 M, 2.00 mmol) of boron trichloride was then added at -78°C and stirred at room temperature for 12 hours. After distilling off the solvent under reduced pressure, 1,2-dichlorobenzene (10 mL) was added thereto. Thereafter, aluminum trichloride (1.07 g, 8.00 mmol) and 2,2,6,6-tetramethylpiperidine (0.621 g, 4.00 mmol) were added thereto, and the mixture was stirred at 150°C for 24 hours. 1,4-Diazabicyclo[2.2.2.]octane (0.897 g, 8.00 mmol) was added thereto, the mixture was subjected to filtration, and the crude product obtained by distilling off the solvent under reduced pressure was then isolated by HPLC and GPC to thus obtain the title compound as a whitish yellow powder (0.054 g, yield: 8%).

HRMS(EI) m/z; calcd. 335.0940[M]⁺; found 335.0926.
¹H NMR (δppm in C₆D₆, 392 MHz) 6.92-7.11 (m, 5H), 7.39 (td, J = 0.9, 7.6 Hz, 1H), 7.50 (td, J = 1.8, 7.2 Hz, 1H), 7.91-8.00 (m, 4H), 8.11-8.16 (m, 2H), 8.63 (dd, J = 0.9, 7.6 Hz, 1H) .

### Synthesis Example (15):

### Synthesis of 11b-aza-3b-borabenzo[11,12]chryseno[5,6-b]thiophene

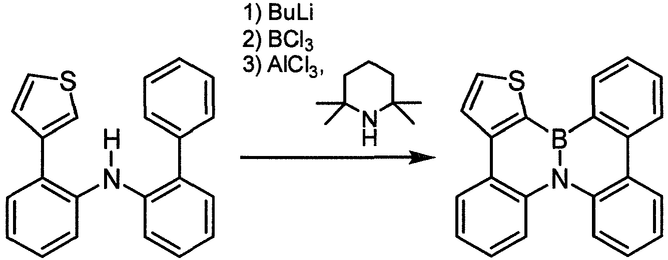

A hexane solution (1.25 mL, 1.60 M, 2.00 mmol) of butyllithium was added to N-[(3-thienyl)phenyl]-N-(biphenyl-2-yl)amine (0.655 g, 2.00 mmol) and toluene (10 mL) at -78°C under an argon atmosphere, followed by stirring. One hour later, the temperature of the mixture was increased to 0°C and the reaction solution was further stirred for one hour. A heptane solution (2.00 mL, 1.00 M, 2.00 mmol) of boron trichloride was added at -78°C and stirred at room temperature for 12 hours. After distilling off the solvent under reduced pressure, 1,2-dichlorobenzene (10 mL) was added thereto. Thereafter, aluminum trichloride (1.07 g, 8.00 mmol) and 2,2,6,6-tetramethylpiperidine (0.621 g, 4.00 mmol) were added thereto, and the mixture was stirred at 150°C for 24 hours. 1,4-Diazabicyclo[2.2.2.]octane (0.897 g, 8.00 mmol) was added thereto, the mixture was subjected to filtration, and the crude product obtained by distilling off the solvent under reduced pressure was then isolated by HPLC and GPC to thus obtain the title compound as a whitish yellow powder (0.020 g, yield: 3%).

HRMS(EI) m/z; calcd. 335.0940[M]⁺; found 335.0943.
¹H NMR (δppm in C₆D₆, 392 MHz) 7.00-7.05 (m, 2H), 7.07-7.12 (m, 2H), 7.40-7.50 (m, 3H), 7.63 (d, J = 4.9 Hz, 1H), 7.94 (dd, J = 1.8, 8.1 Hz, 1H), 8.03 (dd, J = 1.3, 8.5 Hz, 1H), 8.08-8.15 (m, 3H), 8.95 (dd, J = 1.4, 7.6 Hz, 1H).

### Synthesis Example (16):

### Synthesis of 1-methyl-11b-aza-3b-borabenzo[11,12]chryseno [5,6-c]thiophene

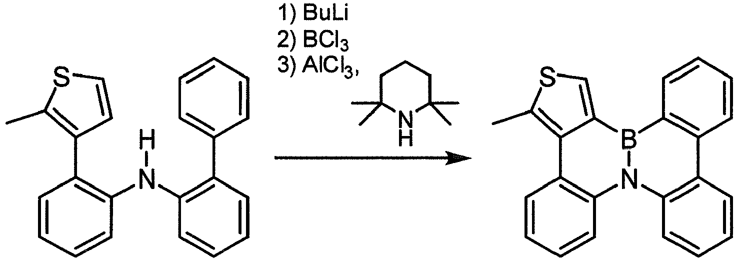

A hexane solution (1.25 mL, 1.60 M, 2.00 mmol) of butyllithium was added to N-[(3-(2-methyl)thienyl)phenyl]-N-(biphenyl-2-yl)amine (0.683 g, 2.00 mmol) and toluene (10 mL) at -78°C under an argon atmosphere, followed by stirring. One hour later, the temperature of the mixture was increased to 0°C and the reaction solution was further stirred for one hour. A heptane solution (2.00 mL, 1.00 M, 2.00 mmol) of boron trichloride was added at -78°C and stirred at room temperature for 12 hours. After distilling off the solvent under a reduced pressure, 1,2-dichlorobenzene (10 mL) was added thereto. Thereafter, aluminum trichloride (1.07 g, 8.00 mmol) and 2,2,6,6-tetramethylpiperidine (0.621 g, 4.00 mmol) were added thereto, and the mixture was stirred at 150°C for 18 hours. 1,4-Diazabicyclo[2.2.2.]octane (0.897 g, 8.00 mmol) was added thereto, the mixture was subjected to filtration, and the crude product obtained by distilling off the solvent under reduced pressure was then isolated by HPLC and GPC to thus obtain the title compound as a brown powder (0.035 g, yield: 5%).

HRMS(MALDI) m/z; calcd. 349.1091[M]⁺; found 349.1088. ¹¹B NMR (δppm in C₆D₆, 126 MHz) 32.5.

### Synthesis Example (17):

### Synthesis of 3b-aza-11b-borabenzo[11,12]chryseno[6,5-b]thiophene

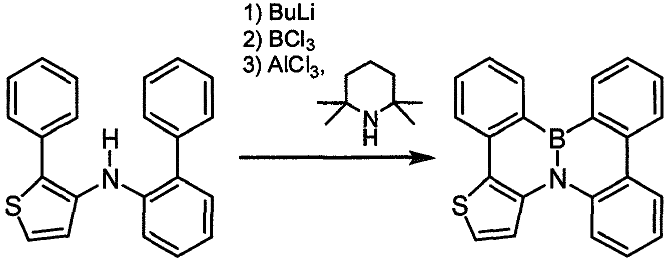

A hexane solution (1.25 mL, 1.60 M, 2.00 mmol) of butyllithium was added to N-([1,1'-biphenyl]-2-yl)-2-phenylthiophene-3-amine (0.655 g, 2.00 mmol) and toluene (10 mL) at -78°C under an argon atmosphere, followed by stirring. One hour later, the temperature of the mixture was increased to 0°C and the mixture was further stirred for another hour. A heptane solution (2.00 mL, 1.00 M, 2.00 mmol) of boron trichloride was added at -78°C, and stirred at room temperature for 12 hours. After distilling off the solvent under a reduced pressure, 1,2-dichlorobenzene (10 mL) was added thereto. Thereafter, aluminum trichloride (1.07 g, 8.00 mmol) and 2,2,6,6-tetramethylpiperidine (0.621 g, 4.00 mmol) were added thereto, and the mixture was stirred at 150°C for 24 hours. 1,4-Diazabicyclo[2.2.2.]octane (0.897 g, 8.0 mmol) was added thereto, the mixture was subjected to filtration, and the crude product obtained by distilling off the solvent under reduced pressure was then isolated by HPLC and GPC to thus obtain the title compound as a whitish yellow powder (0.030 g, yield: 4%).

HRMS(EI) m/z; calcd. 335.0940[M]⁺; found 335.0929.
¹¹B NMR (δppm in C₆D₆, 126 MHz) 34.5.

### Synthesis Example (18):

### Synthesis of 12b-aza-4b-boradibenzo[1,k]pyrrolo[1,2-f]phenanthridine

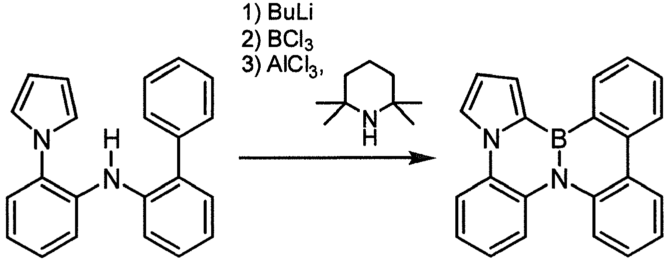

A hexane solution (1.25 mL, 1.60 M, 2.00 mmol) of butyllithium was added to N-(2-(1H-pyrrol-1-yl)phenyl)-[1,1'-biphenyl]-2-amine (0.621 g, 2.00 mmol) and toluene (10 mL) at -78°C under an argon atmosphere, followed by stirring. One hour later, the temperature of the mixture was increased to 0°C and the reaction solution was further stirred for one hour. A heptane solution (2.00 mL, 1.00 M, 2.00 mmol) of boron trichloride was added at -78°C and stirred at room temperature for 12 hours. After distilling off the solvent under a reduced pressure, 1,2-dichlorobenzene (10 mL) was added thereto. Thereafter, aluminum trichloride (1.07 g, 8.00 mmol) and 2,2,6,6-tetramethylpiperidine (0.466 g, 3.00 mmol) were added and stirred at 150°C for 24 hours. 1,4-Diazabicyclo[2.2.2.]octane (1.12 g, 10.0 mmol) was added thereto, the mixture was subjected to filtration, and the crude product obtained by distilling off the solvent under reduced pressure was then isolated by HPLC and GPC to thus obtain the title compound as a white powder (0.023 g, yield: 4%).

HRMS(EI) m/z; calcd. 318.1328[M]⁺; found 318.1324.
¹H NMR (δppm in C₆D₆, 392 MHz) 6.72-6.73 (m, 1H), 6.76-6.80 (m, 1H), 6.85-6.89 (m, 1H), 7.01-7.09 (m, 2H), 7.28 (dd, J = 1.3, 8.5 Hz, 1H), 7.35-7.39 (m, 1H), 7.46-7.51 (m, 2H), 7.55 (dd, J = 1.3, 3.6 Hz, 1H), 7.80 (dd, J = 1.3, 8.5 Hz, 1H), 7.86-7.89 (m, 1H), 8.09-8.13 (m, 2H), 8.71 (dd, J = 1.3, 7.6 Hz, 1H).

### Synthesis Example (19):

### Synthesis of 4b-aza-12b-borabenzo[f]phenanthro[9,10-h]quinoline

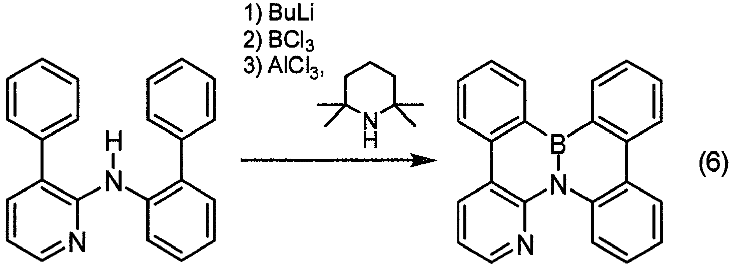

A hexane solution (1.25 mL, 1.60 M, 2.00 mmol) of butyllithium was added to N-([1,1'-biphenyl]-2-yl)-3-phenylpyridin-2-amine (0.645 g, 2.00 mmol) and toluene (10 mL) at -78°C under an argon atmosphere, followed by stirring. One hour later, the temperature of the mixture was increased to 0°C and the reaction solution was further stirred for one hour. A heptane solution (2.00 mL, 1.00 M, 2.00 mmol) of boron trichloride was then added at -78°C, and stirred at room temperature for 12 hours. After distilling off the solvent under a reduced pressure, 1,2-dichlorobenzene (10 mL) was added thereto. Thereafter, aluminum trichloride (1.07 g, 8.00 mmol) and 2,2,6,6-tetramethylpiperidine (0.621 g, 4.00 mmol) were added thereto and stirred at 150°C for 24 hours. 1,4-Diazabicyclo[2.2.2.]octane (0.897 g, 8.0 mmol) was added thereto, the mixture was subjected to filtration, and the crude product obtained by distilling off the solvent under reduced pressure was then isolated by HPLC and GPC to thus obtain the compound represented by the formula (6).

### Synthesis Example (20):

### Synthesis of 4b-aza-12b-phenyl-12b-stannadibenzo[g,p] chrysene

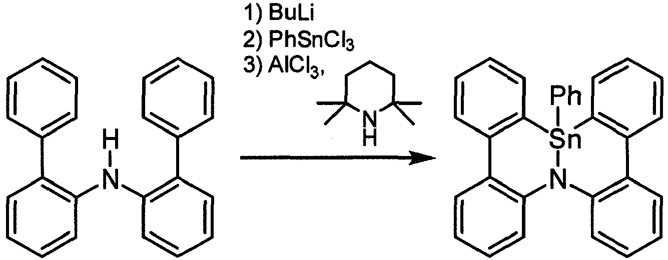

A hexane solution (0.63 mL, 1.60 M, 1.00 mmol) of butyllithium was added to bis(biphenyl-2-yl)amine (0.321 g, 1.00 mmol) and THF (10 mL) at -78°C under an argon atmosphere, followed by stirring. One hour later, phenyltrichlorostannane (0.302 g, 1.00 mmol) was added at-78°C and the mixture was stirred for one hour. The reaction solution was then further stirred at room temperature for 12 hours. After distilling off the solvent under a reduced pressure, 1,2-dichlorobenzene was added thereto. Thereafter, aluminum trichloride (0.533 g, 4.00 mmol) and 2,2,6,6-tetramethylpiperidine (0.232 g, 1.50 mmol) were added thereto, and the mixture was stirred at 150°C for 12 hours. 1,4-Diazabicyclo[2.2.2.]octane (0.448 g, 4.00 mmol) was added thereto, the mixture was subjected to filtration, and the crude product obtained by distilling off the solvent under reduced pressure was then isolated by HPLC and GPC to thus obtain the title compound.

### Synthesis Example (21):

### Synthesis of 6c-aza-16b-boradibenzo[c,p]naphtho[1,2-g]chrysene

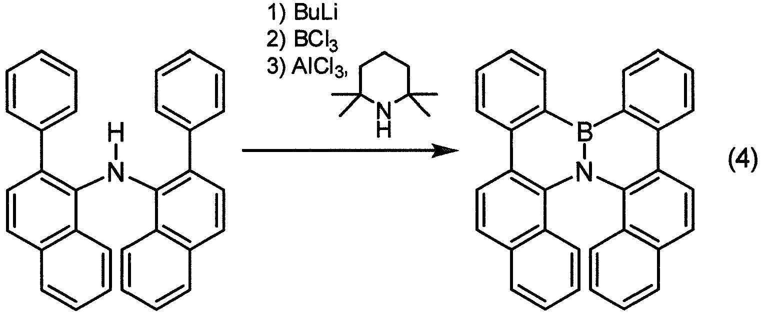

A hexane solution (8.75 mL, 1.60 M, 14.0 mmol) of butyllithium was added to bis(2-phenylnaphthalen-1-yl)amine (5.91 g, 14.0 mmol) and toluene (70 mL) at -78°C under an argon atmosphere, followed by stirring. Five minutes later, the temperature of the mixture was increased to 0°C and the reaction solution was further stirred for 2 and a half hours. Thereafter, a heptane solution (14.0 mL, 1.00 M, 14.0 mmol) of boron trichloride was added at -78°C and the mixture was stirred at room temperature for 12 hours. After distilling off the solvent under a reduced pressure, 1,2-dichlorobenzene was added thereto. Thereafter, aluminum trichloride (14.9 g, 112 mmol) and 2,2,6,6-tetramethylpiperidine (9.53 mL, 56.0 mmol) were added thereto and the mixture was stirred at 150°C for 12 hours. 1,4-Diazabicyclo[2.2.2.]octane (12.6 g, 112 mmol) was added thereto, the mixture was subjected to filtration, and the crude product obtained by distilling off the solvent under reduced pressure was then isolated by washing with hexane to thus obtain the compound represented by the formula (4) as a brown powder (4.27 g, yield: 68%).

HRMS(EI) m/z; calcd. 429.1694[M]⁺; found 429.1698.
¹H NMR (δppm in CDCl₃); 6.65-6.69 (m, 2H), 7.11 (t, 2H, J = 7.4 Hz), 7.16 (d, 2H, J = 8.9 Hz), 7.64-7.70 (m, 4H), 7.79 (d, 2H, J = 8.9 Hz), 7.86 (dd, 2H, J = 0.9, 7.6 Hz), 8.48 (d, 2H, J = 8.9 Hz), 8.60 (d, 2H, J = 8.1 Hz), 8.84 (d, 2H, J = 7.1 Hz).

### Synthesis Example (22):

### Synthesis of 6c-aza-14b-boratribenzo[c,g,p]chrysene

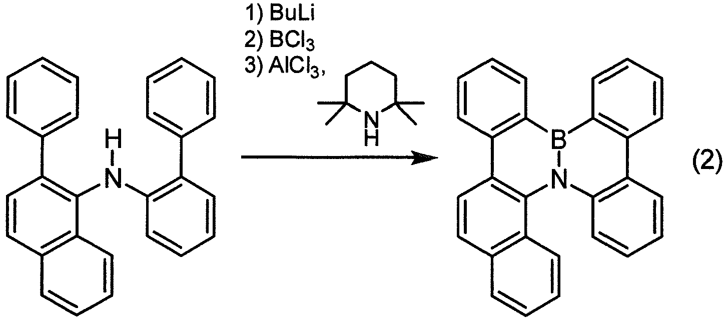

A hexane solution (0.940 mL, 1.60 M, 1.50 mmol) of butyllithium was added to N-([1,1'-biphenyl]-2-yl)-2-phenylnaphthalen-1-amine (0.559 g, 1.51 mmol) and toluene (7.5 mL) at -78°C under an argon atmosphere, followed by stirring. Ten minutes later, the temperature of the mixture was increased to 0°C and the reaction solution was further stirred for one and a half hours. A heptane solution (1.50 mL, 1.00 M, 1.50 mmol) of boron trichloride was then added at -78°C and the mixture was stirred at room temperature for 12 hours. After distilling off the solvent under a reduced pressure, 1,2-dichlorobenzene was added. Thereafter, aluminum trichloride (0.800 g, 6.00 mmol) and 2,2,6,6-tetramethylpiperidine (0.510 mL, 3.00 mmol) were added and the mixture was stirred at 150°C for 12 hours. 1,4-Diazabicyclo[2.2.2.]octane (0.675 g, 6.01 mmol) was added thereto, the mixture was subjected to filtration, and the crude product obtained by distilling off the solvent under reduced pressure was then isolated by GPC to thus obtain the title compound represented by the formula (2) as a brown powder (0.132 g, yield: 23%).

HRMS(EI) m/z; calcd. 379.1532[M]⁺; found 379.1521.
¹H NMR (δppm in CDCl₃); 7.04-7.06 (m, 2H), 7.10-7.15 (m, 1H), 7.18-7.22 (m, 1H), 7.37-7.41 (m, 1H), 7.58-7.62 (m, 2H), 7.63-7.67 (m, 1H), 7.77-7.89 (m, 4H), 8.30 (d, 1H, J = 7.6 Hz), 8.44 (d, 1H, J = 8.5 Hz), 8.46 (d, 1H, J = 8.0 Hz), 8.51 (d, 1H, J = 8.0 Hz), 8.74-8.77 (m, 2H).

### Synthesis Example (23):

### Synthesis of 4b-aza-14b-boratribenzo[a,c,f]tetraphene

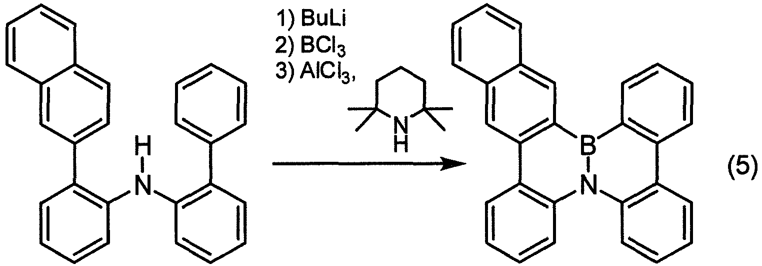

A hexane solution (0.625 mL, 1.60 M, 1.00 mmol) of butyllithium was added to N-(2-(naphthalen-2-yl)phenyl)-[1,1'-biphenyl]-2-amine (0.370 g, 0.996 mmol) and toluene (5.0 mL) at -78°C under an argon atmosphere, followed by stirring. Fifteen minutes later, the temperature of the mixture was increased to 0°C and the reaction solution was further stirred for one and a half hours. A heptane solution (1.00 mL, 1.00 M, 1.00 mmol) of boron trichloride was then added at -78°C, and the mixture was stirred at room temperature for 12 hours. After distilling off the solvent under a reduced pressure, 1,2-dichlorobenzene was added thereto. Thereafter, aluminum trichloride (1.07 g, 8.00 mmol) and 2,2,6,6-tetramethylpiperidine (0.680 mL, 4.00 mmol) were added thereto, and the mixture was stirred at 150°C for 12 hours. 1,4-Diazabicyclo[2.2.2.]octane (0.897 g, 8.00 mmol) was added thereto, the mixture was subjected to filtration, and the crude product obtained by distilling off the solvent under reduced pressure was then isolated by GPC to thus obtain the compound represented by the formula (5) as a brown powder (0.219 g, yield: 55%).

HRMS(EI) m/z; calcd. 379.1532[M]⁺; found 379.1538.
¹H NMR (δppm in CDCl₃); 7.26-7.38 (m, 4H), 7.49-7.53 (m, 1H), 7.54-7.60 (m, 1H), 7.61-7.65 (m, 1H), 7.75-7.79 (m, 1H), 7.97-8.07 (m, 4H), 8.32 (dd, 1H, J = 1.6, 7.8 Hz), 8.38-8.43 (m, 2H), 8.73 (s, 1H), 8.78 (dd, 1H, J = 1.4, 7.6 Hz), 9.10 (s, 1H).

### Synthesis Example (24):

### Synthesis of 2,11-dibromo-6c-aza-16b-boradibenzo[c,p] naphtha[1,2-g]chrysene

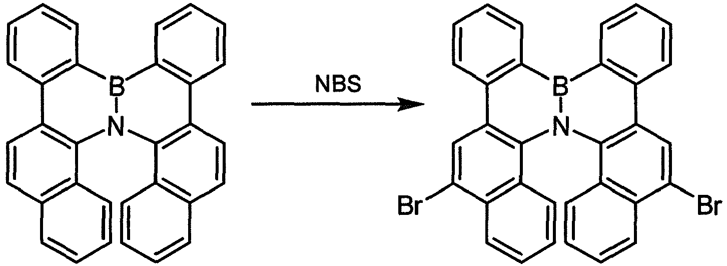

N-Bromosuccinimide (0.0444 g, 0.249 mmol) was added to 6c-aza-16b-boradibenzo[c,p]naphtho[1,2-g]chrysene (0.0427 g, 0.996 mmol) and methylene chloride (1.0 mL) at room temperature, followed by stirring for 6 hours. The crude product obtained by distilling off the solvent under reduced pressure was isolated by GPC to thus obtain the title compound as a brown powder (0.0222 g, yield: 38%).

HRMS(EI) m/z; calcd. 586.9887[M]⁺; found 586.9885.
¹H NMR (δppm in CDCl₃); 6.79 (dt, 2H, J = 1.4, 7.7 Hz), 7.19-7.24 (m, 4H), 7.70 (t, 2H, J = 6.7 Hz), 7.90 (dt, 2H, J = 1.3, 7.4 Hz), 8.12 (d, 2H, J = 8.5 Hz), 8.55 (d, 2H, J = 8.1 Hz), 8.80 (s, 2H), 8.84 (d, 2H, J = 6.7 Hz).

### Synthesis Example (25):

### Synthesis of 8b,11b,14b-triaza-22b,25b,28b-triboraoctabenzo [a, c, fg, j k, n, p, st, wx] hexacene

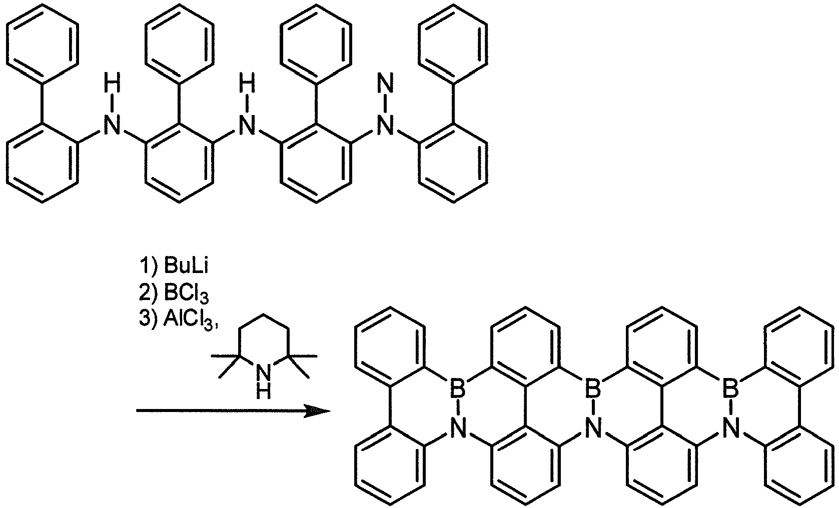

A hexane solution (3.68 mL, 1.63 M, 6.00 mmol) of butyllithium was added to N²-([1,1'-biphenyl]-2-yl)- N⁶-(6-([1,1'-biphenyl]-2-ylamino)-[1,1'-biphenyl]-2-yl)-[1,1'-biphenyl]-2,6-diamine (1.31 g, 2.00 mmol) and toluene (20 mL) at -78°C under an argon atmosphere, followed by stirring. One hour later, the temperature of the mixture was increased to 0°C and the reaction solution was further stirred for one hour. A heptane solution (6.00 mL, 1.00 M, 6.00 mmol) of boron trichloride was added at -78°C and the mixture was stirred at room temperature for 12 hours. After distilling off the solvent under a reduced pressure, 1,2-dichlorobenzene (40 mL) was added thereto. Thereafter, aluminum trichloride (4.01 g, 30.0 mmol) and 2,2,6,6-tetramethylpiperidine (1.74 g, 11.3 mmol) were added thereto and the mixture was stirred at 150°C for 12 hours. 1,4-Diazabicyclo[2.2.2.]octane (3.36 g, 30.0 mmol) was added thereto, the mixture was subjected to filtration, and the crude product obtained by distilling off the solvent under reduced pressure was then isolated by HPLC and GPC to thus obtain the title compound.

### Synthesis Example (26):

### Synthesis of 9b,22b-diaza-4b,17b-diboratetrabenzo[a,c,f,m] phenanthro[9,10-k]tetraphene

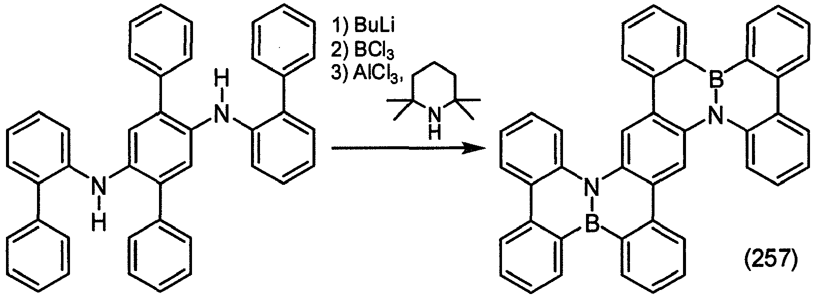

A hexane solution (2.45 mL, 1.63 M, 4.00 mmol) of butyllithium was added to N^{2'}, N^{5'}-di([1,1'-biphenyl]-2-yl)-[1,1':4',1"-terphenyl]-2',5'-diamine (1.13 g, 2.00 mmol) and toluene (20 mL) at -78°C under an argon atmosphere, followed by stirring. One hour later, the temperature of the mixture was increased to 0°C and the reaction solution was further stirred for one hour. Thereafter, a heptane solution (4.00 mL, 1.00 M, 4.00 mmol) of boron trichloride was added at -78°C and the mixture was stirred at room temperature for 12 hours. The solvent was distilled off under a reduced pressure and 1,2-dichlorobenzene (40 mL) was added thereto. Thereafter, aluminum trichloride (2.67 g, 20.0 mmol) and 2,2,6,6-tetramethylpiperidine (1.16 g, 7.50 mmol) were added thereto and the mixture was stirred at 150°C for 12 hours. 1,4-Diazabicyclo[2.2.2.]octane (2.24 g, 20.0 mmol) was added thereto, the mixture was subjected to filtration, and the crude product obtained by distilling off the solvent under reduced pressure was then isolated by HPLC and GPC to thus obtain the compound represented by the formula (257).

### Synthesis Example (27):

### Synthesis of 2,7-diphenyl-4b-aza-12b-boradibenzo[g,p] chrysene

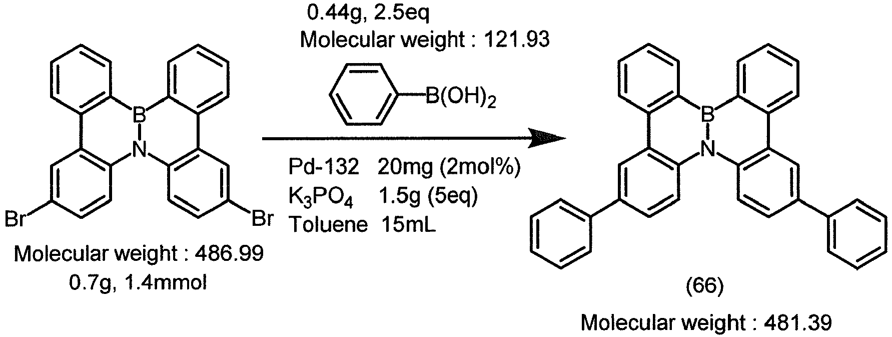

Under a nitrogen atmosphere, a flask containing 2,7-dibromo-4b-aza-12b-boradibenzo[g,p]chrysene (0.70 g), phenylboronic acid (0.44 g), potassium phosphate (1.5 g), Pd-132 (Johnson Matthey) (0.02 g) and toluene (15 mL) was stirred at 70°C for one hour. After cooling the reaction solution to room temperature, thereto were added water and toluene to separate the reaction solution. Subsequently, after distilling off the solvent under reduced pressure, the reaction solution was purified by active alumina column chromatography (developing solution: toluene/ triethylamine = 99/1 (volume ratio)). After distilling off the solvents under reduced pressure, the obtained solid was washed with heptane and ethyl acetate in this order, and further recrystallized from a chlorobenzene/heptane mixed solution to thus obtain the compound represented by the formula (66) (0.51 g).

The structure of the obtained compound was confirmed by an NMR measurement.
¹H-NMR (CDCl₃) : δ = 8.73 (d, 2H), 8.60 (m, 2H), 8.51 (d, 2H), 8.23 (d, 2H), 7.82 (t, 2H), 7.75 (d, 4H), 7.64 (m, 4H), 7.51 (t, 4H), 7.40 (t, 2H).

### Synthesis Example (28):

### Synthesis of N²,N²,N⁷,N⁷-tetraphenyl-4b-aza-12b-boradibenzo [g,p]chrysene-2,7-diamine

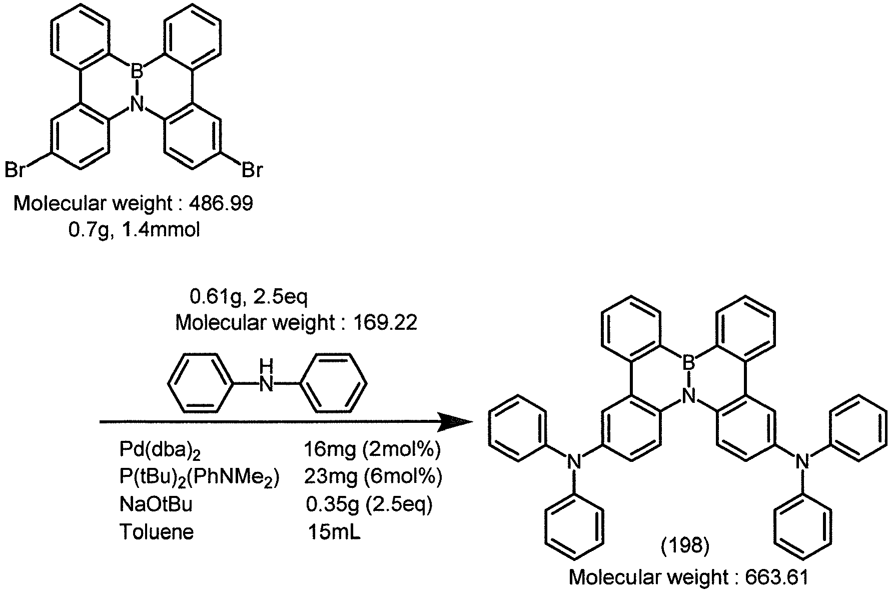

A flask containing 2,7-dibromo-4b-aza-12b-boradibenzo[g,p]chrysene (0.70 g), diphenylamine (0.61g), sodium-t-butoxide (0.35 g), Pd(dba)₂ (0.02 g), 4-(di-t-butylphosphino)-N,N-dimethylaniline (0.02 g) and toluene (15 mL) was stirred at 70°C for one hour under a nitrogen atmosphere. After cooling the reaction solution to room temperature, thereto were added water and toluene to separate the reaction solution. Subsequently, after distilling off the solvent under reduced pressure, the reaction solution was purified by active alumina column chromatography (developing solution: toluene/heptane/triethylamine = 10/10/1 (volume ratio)). After distilling off the solvent under reduced pressure, the obtained solid was washed with heptane to thus obtain the compound represented by the formula (198) (0.22 g).

The structure of the obtained compound was confirmed by an NMR measurement.
¹H-NMR (CDCl₃): δ = 8.67 (d, 2H), 8.12 (m, 4H), 8.03 (d, 2H), 7.67 (t, 2H), 7.57 (t, 2H), 7.26 (m, 8H), 7.16 (m, 8H), 7.13 (dd, 2H), 7.02 (t, 4H).

### Synthesis Example (29):

### Synthesis of 2,7-dicarbazolyl-4b-aza-12b-boradibenzo[g,p] chrysene

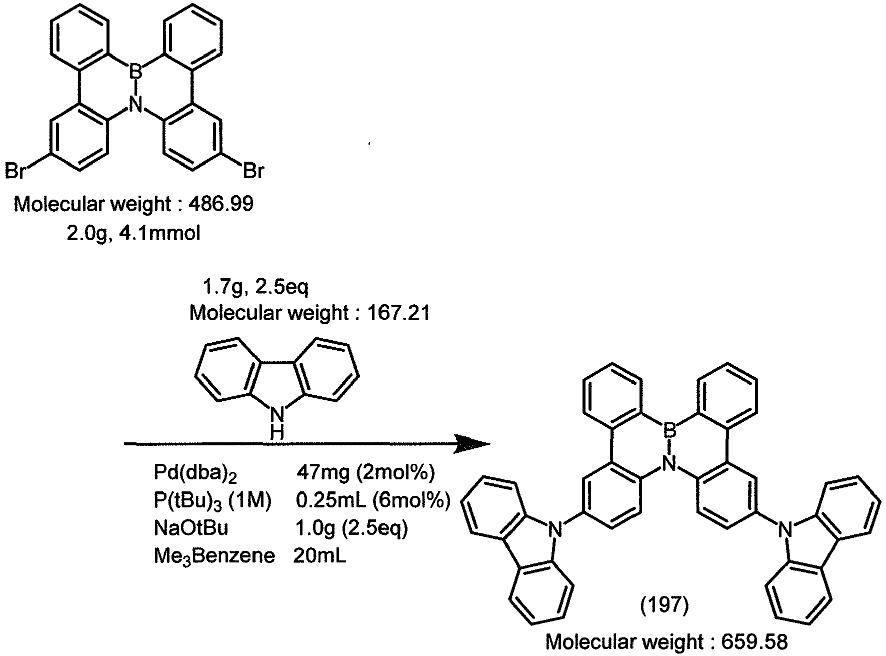

A flask containing 2,7-dibromo-4b-aza-12b-boradibenzo[g,p]chrysene (2.00 g), carbazole (1.70 g), sodium-t-butoxide (1.00 g), Pd(dba)₂ (0.05 g), a 1 M-toluene solution of tri-t-butylphosphine (0.25 ml) and 1,2,4-trimethylbenzene (20 ml) was stirred at 150°C for one hour under a nitrogen atmosphere. After cooling the reaction solution to room temperature, the deposited solid was collected by suction filtration and washed with methanol, water and methanol in this order. Subsequently, the solid was dissolved into heated chlorobenzene and passed through an active alumina short column. In this process, the solid was eluted from the column using a developing solution (toluene/ethyl acetate/triethylamine = 95/5/1 (volume ratio)) from the column. After distilling off the solvents under reduced pressure, the obtained solid was washed with ethyl acetate to thus obtain the compound represented by the formula (197) (1.50 g).

The structure of the obtained compound was confirmed by an NMR measurement.
¹H-NMR (CDCl₃): δ = 8.80 (d, 2H), 8.60 (m, 2H), 8.48 (d, 2H), 8.37 (d, 2H), 8.20 (d, 4H), 7.81 (t, 2H), 7.70 (t, 2H), 7.65 (dd, 2H), 7.40-7.60 (m, 8H), 7.33 (t, 4H).

### Synthesis Example (30):

### Synthesis of 2,7,11,14-tetraphenyl-4b-aza-12b-boradibenzo [g,p]chrysene

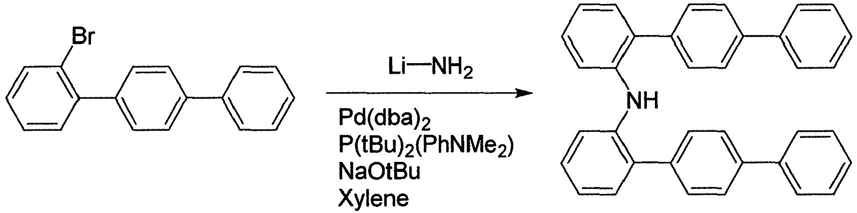

Firstly, a flask containing 2-bromo-1,1':4',1"-terphenyl (35.0 g), sodium-t-butoxide (10.9 g), Pd(dba)₂ (0.65 g), 4-(di-t-butylphosphino)-N,N-dimethylaniline (0.60 g), xylene (100 ml) and lithium amide (1.3 g) was stirred at 90°C for 2 hours under a nitrogen atmosphere. After cooling the reaction solution to room temperature, thereto were added water and ethyl acetate to separate the reaction solution. Subsequently, after distilling off the solvent under reduced pressure, the reaction product was purified by active alumina column chromatography (developing solution: toluene). After distilling off the solvent under reduced pressure, thereto was added heptane to deposit a precipitate, and the obtained precipitate was washed with heptane to thus obtain di([1,1':4',1"-terphenyl]-2-yl)amine (22.2 g).

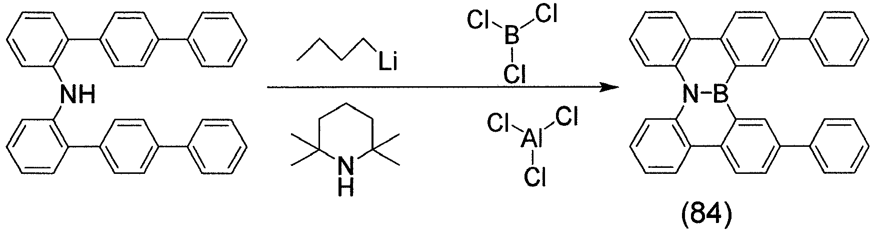

Next, a flask containing di([1,1':4',1"-terphenyl]-2-yl)amine (22.2 g) and toluene (250 ml) was cooled to -70°C, a 2.6 M-hexane solution containing n-butyllithium (18.0 ml) was dropped. After completion of dropping, the temperature of the reaction solution was once increased to 0°C, followed by stirring at 0°C for 5 minutes. Thereafter, the mixture was cooled to -70°C again, and a 1.0 M-heptane solution of boron trichloride (46.9 ml) was dropped. Subsequently, after increasing the temperature of the reaction solution to room temperature, the solvent was distilled off under reduced pressure once. Thereto were added orthodichlorobenzene (300 ml), 2,2,6,6-tetramethylpiperidine (13.9 g) and aluminum trichloride (25.0 g), followed by stirring at 160°C for 12 hours. The reaction solution was cooled to room temperature, thereto were added toluene (500 ml) and celite, and the mixture was stirred and then stood still for about one hour. Subsequently, the deposited precipitate was removed by suction filtration using a hirsch funnel in which celite was bedded, thereafter distilling off the solvent under reduced pressure. Furthermore, the reaction product was purified by active alumina column chromatography (developing solution: toluene/ethyl acetate/triethylamine = 90/10/1 (volume ratio)) and then reprecipitated with an ethyl acetate/heptane mixed solvent to thus obtain the compound represented by the formula (84) (16.2 g).

The structure of the obtained compound was confirmed by an NMR measurement.
¹H-NMR (CDCl₃): δ = 9.00 (m, 2H), 8.50 (d, 2H), 8.41 (d, 2H), 8.15 (d, 2H), 8.04 (d, 2H), 7.77 (d, 4H), 7.50 (t, 4H), 7.40 (m, 6H).

### Synthesis Example (31):

### Synthesis of 2,7-dibromo-11,14-diphenyl-4b-aza-12b-boradibenzo [g,p]chrysene

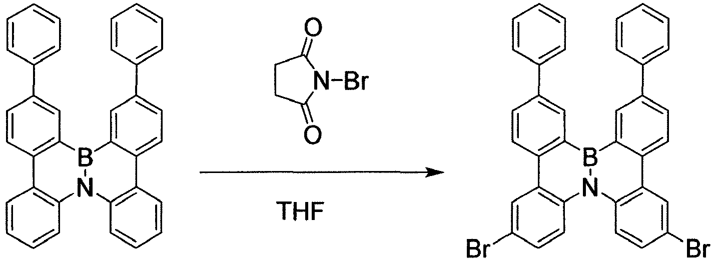

Firstly, under a nitrogen atmosphere, N-Bromosuccinimide (NBS) (3.7 g) was added to a THF (50 ml) solution containing 2,7,11,14-tetraphenyl-4b-aza-12b-boradibenzo[g,p]chrysene (4.8 g) and the mixture was stirred at room temperature for one hour. After completion of the reaction, an aqueous sodium sulfite solution was added and a deposited precipitate was collected by suction filtration. Furthermore, the obtained solid was purified by active alumina column chromatography (developing solution: toluene/triethylamine = 99/1 (volume ratio)) to thus obtain 2,7-dibromo-11,14-diphenyl-4b-aza-12b-boradibenzo [g,p]chrysene (5.2 g).

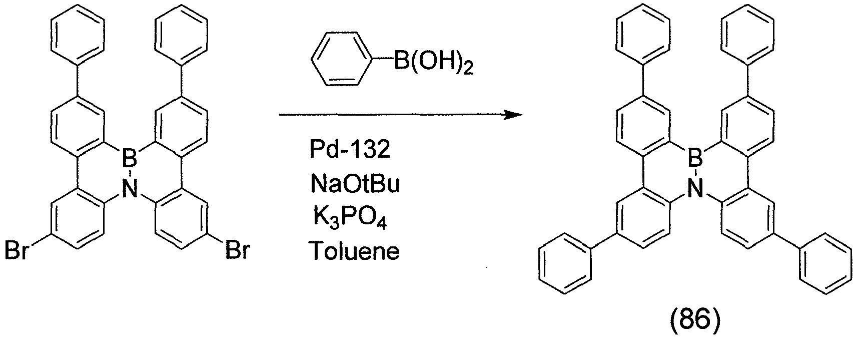

Next, a flask containing 2,7-dibromo-11,14-diphenyl-4b-aza-12b-boradibenzo[g,p]chrysene (2.0 g), phenylboronic acid (1.0 g), potassium phosphate (1.3 g), sodium-t-butoxide (0.6 g), Pd-132 (Johnson Matthey) (0.04 g) and toluene (40 mL) was stirred at 100°C for one hour under a nitrogen atmosphere. After cooling the reaction solution to room temperature, thereto were added water and toluene to separate the reaction solution. Subsequently, after distilling off the solvent under reduced pressure, the reaction product was purified by active alumina column chromatography (developing solution: toluene/ triethylamine = 99/1 (volume ratio)). After distilling off the solvents under reduced pressure, the reaction product was reprecipitated by adding heptane to thus obtain the compound represented by the formula (86) (1.8 g).

The structure of the obtained compound was confirmed by an NMR measurement.
¹H-NMR (CDCl₃) : δ = 9.03 (s, 2H), 8.64 (s, 2H), 8.59 (d, 2H), 8.26 (d, 2H), 8.06 (d, 2H), 7.79 (m, 8H), 7.67 (d, 2H), 7.52 (m, 8H), 7.40 (m, 4H).

### Synthesis Example (32):

### Synthesis of 10,15-diphenyl-4b-aza-12b-boradibenzo[g,p] chrysene

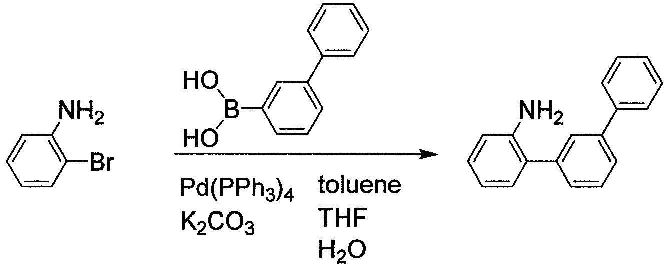

Firstly, a flask containing 2-bromoaniline (25.0 g), [1,1'-biphenyl]-3-yl boronic acid (28.8 g), potassium phosphate (50.2 g), Pd(PPh₃)₄ (5.0 g), toluene (200 ml), THF (70 ml) and water (30 ml) was stirred at a reducing temperature for 8 hours. After cooling the reaction solution to room temperature, thereto was added water to separate the reaction solution and the solvent was distilled off under reduced pressure. The obtained oily substance was purified by silica gel short column (developing solution: toluene) and the oily substance obtained by distilling off the solvent under reduced pressure was reprecipitated by adding heptane to thus obtain [1,1':3',1"-terphenyl]-2-amine (33.0 g).

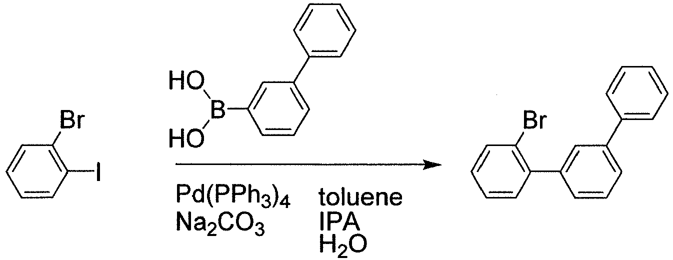

Next, a flask containing 1-bromo-2-iodobenzene (35.0 g), [1,1'-biphenyl]-3-yl boronic acid (24.5 g),sodium carbonate (32.8 g), Pd(PPh₃)₄ (4.3 g), toluene (200 ml), isopropyl alcohol (50 ml) and water (20 ml) was stirred at a reducing temperature for 8 hours. After cooling the reaction solution to room temperature, thereto was added water to separate the reaction solution and the solvent was distilled off under reduced pressure. The obtained oily substance was purified by silica gel short column (developing solution: toluene) and the oily substance obtained by distilling off the solvent under reduced pressure was further purified to thus obtain 2-bromo-1,1':3',1"-terphenyl (34.4 g).

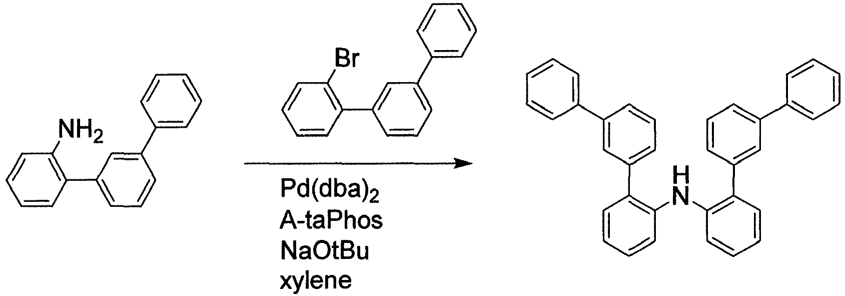

Furthermore, a flask containing [1,1':3',1"-terphenyl]-2-amine (20.0 g), 2-bromo-1,1':3',1"-terphenyl (25.2 g), sodium-t-butoxide (11.8 g), Pd(dba)₂ (0.11 g), 4-(di-t-butylphosphino)-N,N-dimethylaniline "A-taPhos" (0.11 g) and xylene (150 ml) was stirred at 110°C for 2 hours under a nitrogen atmosphere. After cooling the reaction solution to room temperature, thereto was added water to separate the reaction solution and the solvent was distilled off under reduced pressure. The obtained oily substance was purified by silica gel short column (developing solution: toluene/heptane = 2/8 (volume ratio)) to thus obtain di([1,1':3',1"-terphenyl]-2-yl)amine (32.6 g).

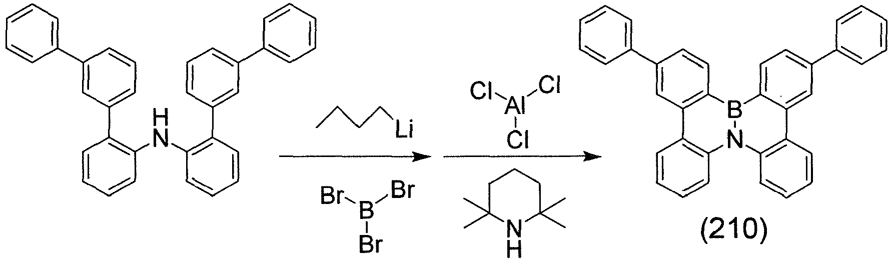

A flask containing di([1,1':3',1"-terphenyl]-2-yl)amine (22.2 g) and toluene (250 ml) was cooled to -70°C, a 2.6 M-hexane solution of n-butyllithium (18.0 ml) was dropped. After completion of dropping, the temperature of the reaction solution was once increased to 0°C, followed by stirring at 0°C for 5 minutes. Thereafter, the mixture was cooled to -70°C again, and a solution obtained by dissolving boron trichloride (11.7 g) into heptane was dropped. Subsequently, after increasing the temperature of the reaction solution to room temperature, the solvent was distilled off under reduced pressure once. Thereto were added orthodichlorobenzene (300 ml), 2,2,6,6-tetramethylpiperidine (13.9 g) and aluminum trichloride (25.0 g), followed by stirring at 160°C for 12 hours. The reaction solution was cooled to room temperature, thereto were added toluene (500 ml) and celite, and the mixture was stirred and then stood still for about one hour. Subsequently, the deposited precipitate was removed by suction filtration using a hirsch funnel in which celite was bedded, thereafter distilling off the solvent under reduced pressure. Furthermore, the reaction product was purified by active alumina column chromatography (developing solution: toluene/heptane/triethylamine = 50/50/1 (volume ratio)) and then reprecipitated with an ethyl acetate/ethanol mixed solvent to thus obtain the compound represented by the formula (210) (17.0 g).

The structure of the obtained compound was confirmed by an NMR measurement.
¹H-NMR (CDCl₃): δ = 8.80 (d, 2H), 8.64 (m, 2H), 8.47 (d, 2H), 8.16 (d, 2H), 7.87 (d, 2H), 7.82 (d, 4H), 7.55 (t, 4H), 7.34-7.50 (m, 6H).

### Synthesis Example (33):

### Synthesis of 2,7,10,15-tetraphenyl-4b-aza-12b-boradibenzo [g,p]chrysene

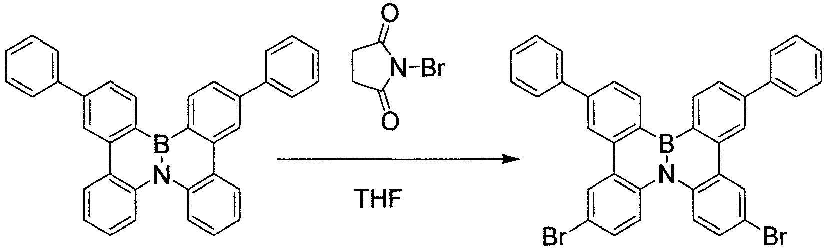

Firstly, under a nitrogen atmosphere, N-bromosuccinimide (NBS) (3.7 g) was added to a THF (40 ml) solution containing 10,15-diphenyl-4b-aza-12b-boradibenzo[g,p]chrysene (4.8 g) and the mixture was stirred at room temperature for one hour. After completion of the reaction, a precipitate deposited by adding an aqueous sodium sulfite solution was obtained by suction filtration. The obtained solid was further purified by active alumina column chromatography (developing solution: toluene/triethylamine = 99/1 (volume ratio)) to thus obtain 2,7-dibromo-10,15-diphenyl-4b-aza-12b-boradibenzo[g,p]chrysene (5.9 g).

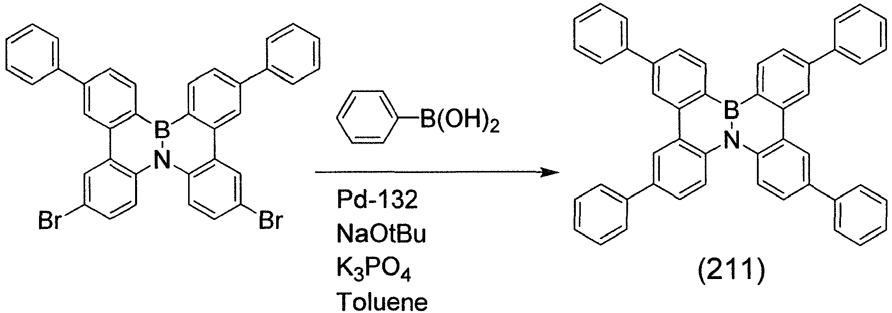

Next, a flask containing 2,7-dibromo-10,15-diphenyl-4b-aza-12b-boradibenzo[g,p]chrysene (2.0 g), phenylboronic acid (1.0 g), potassium phosphate (2.0 g), sodium-t-butoxide (0.3 g), Pd-132 (Johnson Matthey) (0.05 g) and toluene (40 mL) was stirred at 100°C for one hour under a nitrogen atmosphere. After cooling the reaction solution to room temperature, thereto were added water and toluene to separate the reaction solution. Subsequently, after distilling off the solvent under reduced pressure, the reaction solution was purified by active alumina column chromatography (developing solution: toluene/triethylamine = 99/1 (volume ratio)). After distilling off the solvents under reduced pressure, the purified product was recrystallized from toluene to thus obtain the compound represented by the formula (211) (1.8 g).

The structure of the obtained compound was confirmed by an NMR measurement.
¹H-NMR (CDCl₃): δ = 8.82 (d, 2H), 8.69 (m, 2H), 8.65 (m, 2H), 8.25 (d, 2H), 7.88 (dd, 2H), 7.82 (d, 4H), 7.76 (d, 4H), 7.66 (dd, 2H), 7.49-7.59 (m, 8H), 7.46 (t, 2H), 7.40 (t, 2H).

### Synthesis Example (34):

### Synthesis of 9,16-diphenyl-4b-aza-12b-boradibenzo[g,p] chrysene compound

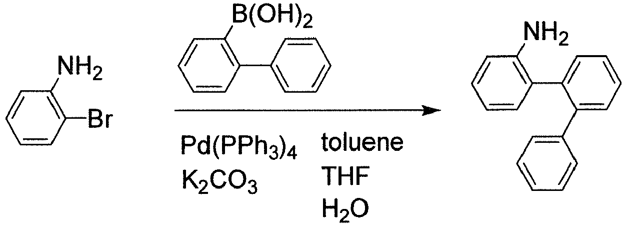

Firstly, a flask containing 2-bromoaniline (21.7 g), [1,1'-biphenyl]-2-yl boronic acid (25.0 g), potassium phosphate (44.0 g), Pd(PPh₃)₄ (4.4 g), toluene (175 ml), THF (60 ml) and water (20 ml) was stirred at a reducing temperature for 8 hours. After cooling the reaction solution to room temperature, thereto was added water to separate the reaction solution and the solvent was distilled off under reduced pressure. The obtained oily substance was purified by silica gel short column (developing solution: toluene /heptane =1/1 (volume ratio)). The oily substance obtained by distilling off the solvent under reduced pressure was further purified by distilling under reduced pressure to thus obtain [1,1':2',1"-terphenyl]-2-amine (25.6 g).

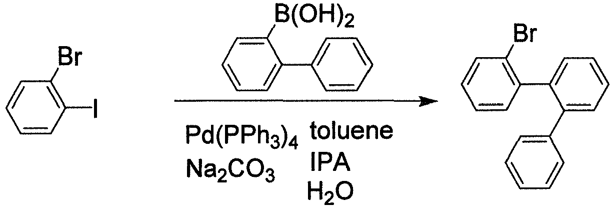

Next, a flask containing 1-bromo-2-iodobenzene (35.0 g), [1,1'-biphenyl]-2-yl boronic acid (24.5 g),sodium carbonate (32.8 g), Pd(PPh₃)₄ (4.3 g), toluene (200 ml), isopropyl alcohol (50 ml) and water (20 ml) was stirred at a reducing temperature for 8 hours. After cooling the reaction solution to room temperature, thereto was added water to separate the reaction solution and the solvent was distilled off under reduced pressure. The obtained oily substance was purified by silica gel short column (developing solution: toluene/heptane = 1/1). The oily substance obtained by distilling off the solvent under reduced pressure was further purified by distilling under reduced pressure to thus obtain 2-bromo-1,1':2',1"-terphenyl (22.0 g).

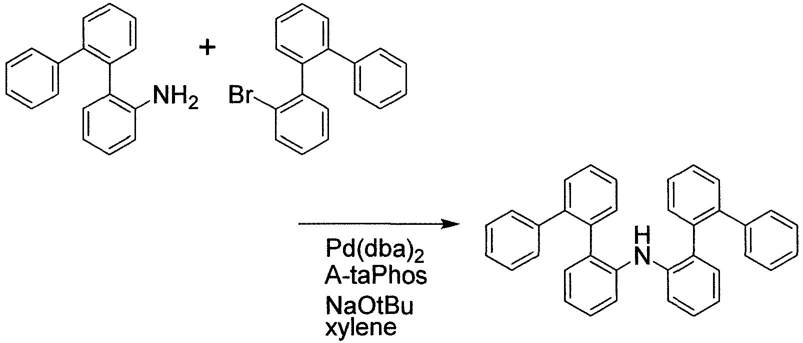

Furthermore, a flask containing [1,1':2',1"-terphenyl]-2-amine (17.5 g), 2-bromo-1,1':2',1"-terphenyl (22.0 g), sodium-t-butoxide (10.3 g), Pd(dba)₂ (0.10 g), 4-(di-t-butylphosphino)-N,N-dimethylaniline (0.09 g) and xylene (100 ml) was stirred at 110°C for 2 hours under a nitrogen atmosphere. After cooling the reaction solution to room temperature, thereto was added water to separate the reaction solution and the solvent was distilled off under reduced pressure. The obtained oily substance was purified by silica gel column chromatography (developing solution: toluene/heptane mixed solution) to thus obtain di([1,1':2',1"-terphenyl]-2-yl)amine (32.6 g). In this process, the objective product was eluted by gradually increasing a ratio of toluene in the developing solution by reference to the method described in "Procedure of Organic Chemistry Experiments (1) - Method of Handling Substances and Method of Separation and Purification" published by Kagaku-Dojin Publishing Company, INC, p. 94. Di([1,1':2',1"-terphenyl]-2-yl)amine (20.1 g) was obtained.

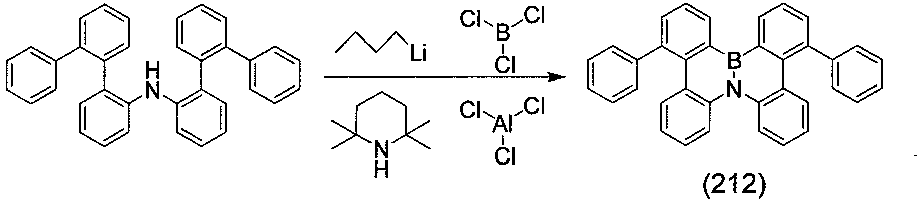

A flask containing di([1,1':2',1"-terphenyl]-2-yl)amine (19.0 g) and toluene (250 ml) was cooled to -70°C, a 2.6 M-hexane solution containing n-butyllithium (15.4 ml) was dropped. After completion of dropping, the temperature of the reaction solution was once increased to 0°C, followed by stirring at 0°C for 5 minutes. Thereafter, the solution was dropped into a toluene solution containing boron trichloride (29.7 g), which was cooled to -70°C. Subsequently, the solvent was distilled off under reduced pressure once, thereto were added orthodichlorobenzene (300 ml), 2,2,6,6-tetramethylpiperidine (11.9 g) and aluminum trichloride (21.4 g), followed by stirring at 160°C for 12 hours. The reaction solution was cooled to room temperature, thereto were added toluene (500 ml) and celite, and the mixture was stirred and then stood still for about one hour. Subsequently, the deposited precipitate was removed by suction filtration using a hirsch funnel in which celite was bedded, thereafter distilling off the solvent under reduced pressure. Furthermore, the reaction product was purified by active alumina column chromatography (developing solution: toluene/heptane/triethylamine = 90/10/1 (volume ratio)) and then reprecipitated with an ethyl acetate/ethanol mixed solvent to thus obtain the compound represented by the formula (212) (2.3 g).

The structure of the obtained compound was confirmed by an NMR measurement.
¹H-NMR (CDCl₃): δ = 8.74 (d, 2H), 8.70 (m, 1H), 8.06 (d, 2H), 7.26-7.70 (m, 16H), 7.21 (t, 2H), 6.77 (t, 2H).

### Synthesis Example (35):

### Synthesis of 2-phenyl-4b-aza-12b-boradibenzo[g,p]chrysene compound

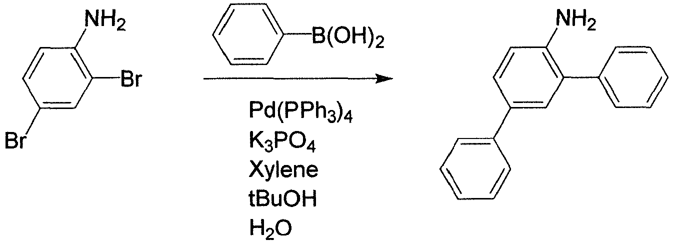

Firstly, a flask containing 2,4-dibromoaniline (25.0 g), phenylboronic acid (30.0 g), Pd(PPh₃)₄ (5.8 g), tripotassium phosphate (106.0 g), xylene (300 ml), t-butyl alcohol (50 ml) and water (50 ml) was stirred at 120°C for 30 minutes. After cooling the reaction solution to room temperature, thereto were added water and ethyl acetate to separate the reaction solution. The organic layer was passed through a silica gel short column to remove a high polar sub-product, thereafter distilling off the solvent under reduced pressure. The reaction product was further purified by silica gel column chromatography (developing solution: toluene /heptane =8/2 (volume ratio)) and then reprecipitated with heptane to thus obtain [1,1':3',1"-terphenyl]- 4'-amine (13.1 g).

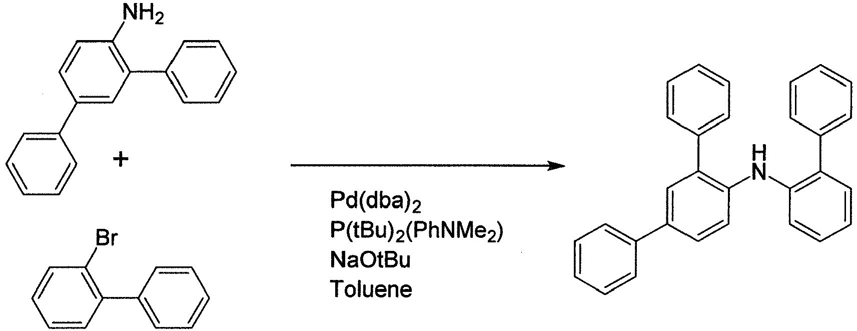

Next, a flask containing [1,1':3',1"-terphenyl]-4'-amine (13.0 g), 2-bromobiphenyl (12.4 g), sodium-t-butoxide (7.6 g), Pd(dba)₂ (0.08 g), 4-(di-t-butylphosphino)-N,N-dimethylaniline (0.07 g) and toluene (100 ml) was stirred at 80°C for 30 minutes under a nitrogen atmosphere. After cooling the reaction solution to room temperature, thereto were added water and ethyl acetate to separate the reaction solution. After the solvent was distilled off under reduced pressure, the reaction product was purified by silica gel column chromatography (developing solution: toluene/heptane = 2/8 (volume ratio)) to thus obtain N-([1,1'-biphenyl]-2-yl)-[l,l':3',1"-terphenyl]-4'-amine (20.0 g).

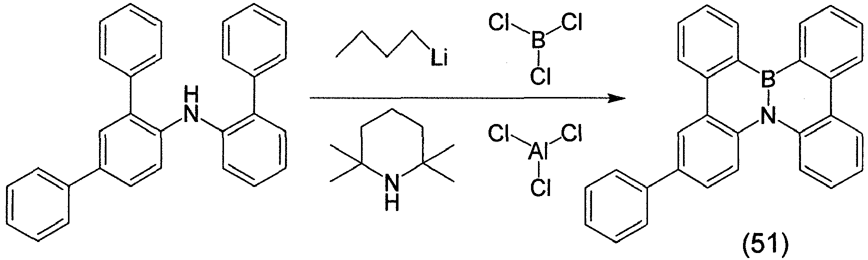

A flask containing N-([1,1'-biphenyl]-2-yl)-[1,1':3',1"-terphenyl]-4'-amine (18.6 g) which was obtained as described above, and toluene (250 ml) was cooled to-70°C, and a 1.6 M-hexane solution of n-butyllithium (29.3 ml) was dropped. After completion of dropping, a suspension obtained by increasing the temperature to 0°C once was dropped into a solution obtained by diluting a 1.0 M-heptane solution (46.9 ml) of boron trichloride with toluene. Subsequently, the temperature of the reaction solution was increased to room temperature once, thereafter distilling off the solvent under reduced pressure once. Thereto were added orthodichlorobenzene (300 ml), 2,2,6,6-tetramethylpiperidine (13.9 g) and aluminum trichloride (25.0 g), followed by stirring at 170°C for 20 hours. The reaction solution was cooled to 60°C and added to ice water (suspension solution) obtained by adding sodium carbonate (10.0 g) and sodium acetate (31.0 g). After separating the organic layer, the reaction product was subjected to suction filtration using a hirsch funnel in which celite was bedded, thereafter distilling off the solvent under reduced pressure. Subsequently, the reaction product was purified by active alumina column chromatography (developing solution: toluene/triethylamine = 100/1 (volume ratio)) and then reprecipitated with an ethyl acetate/heptane mixed solvent to thus obtain the compound represented by the formula (51) (14.0 g).

The structure of the obtained compound was confirmed by an NMR measurement.
¹H-NMR (CDCl₃): δ = 8.71 (m, 2H), 8.58 (m, 1H), 8.50 (d, 1H), 8.43 (d, 1H), 8.38 (d, 1H), 8.19 (d, 1H), 8.16 (d, 1H), 7.80 (m, 2H), 7.74 (d, 2H), 7.63 (m, 3H), 7.50 (t, 2H), 7.33-7.43 (m, 3H).

### Synthesis Example (36):

### Synthesis of 9-(4-(7-phenyl-4b-aza-12b-boradibenzo[g,p] chrysene-2-yl)phenyl)-9H-carbazole

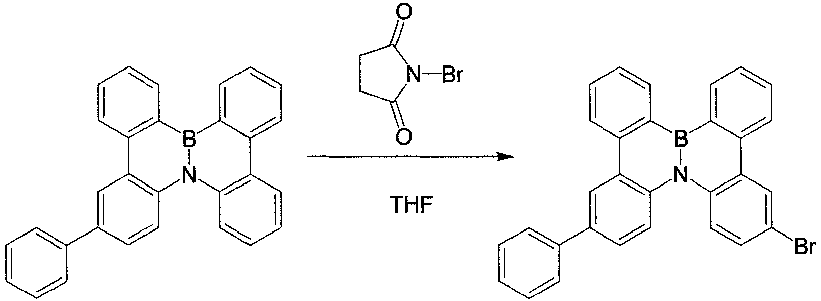

Firstly, under a nitrogen atmosphere, N-bromosuccinimide (NBS) (2.8 g) was added to a THF (40 ml) solution containing 2-phenyl-4b-aza-12b-boradibenzo [g,p]chrysene (6.0 g) and the mixture was stirred at room temperature all night. After completion of the reaction, thereto were added an aqueous sodium nitrite solution and toluene to separate the reaction solution and the solvent was distilled off under reduced pressure. The obtained solid was dissolved into chlorobenzene and passed through an active alumina short column (developing solution: toluene/triethylamine = 100/1 (volume ratio)). The solid obtained by distilling off the solvent under reduced pressure was washed with heptane to thus obtain 2-bromo-7-phenyl-4b-aza-12b-boradibenzo [g,p]chrysene (6.1 g).

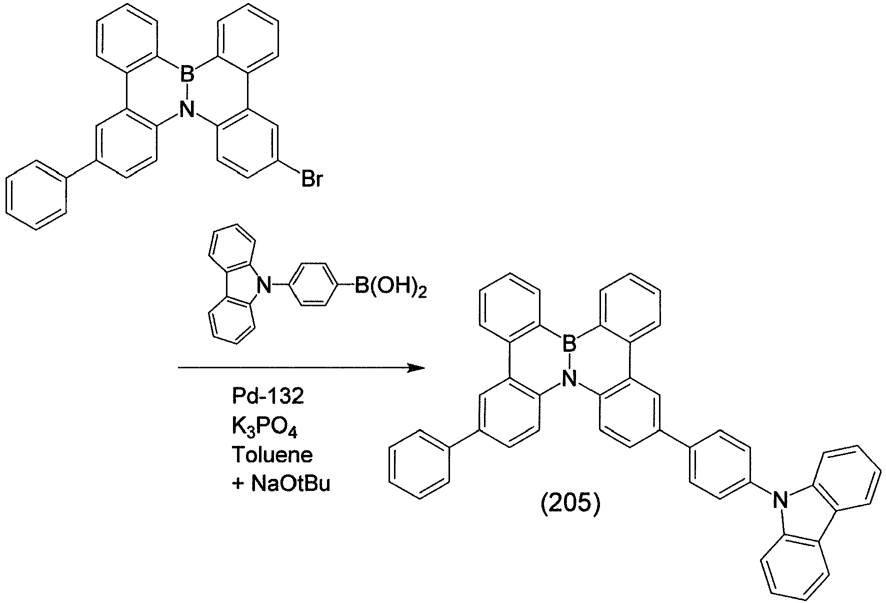

Next, a flask containing 2-bromo-7-phenyl-4b-aza-12b-boradibenzo[g,p]chrysene (2.0 g), (4-(9H-carbazole-9-yl)phenyl) boronic acid (1.4 g), Pd-132 (0.06 g), tripotassium phosphate (1.75 g), sodium-t-butoxide (1.0 g) and toluene (40 ml) was stirred at 80°C for one hour under a nitrogen atmosphere. After cooling the reaction solution to room temperature, thereto were added water and ethyl acetate to separate the reaction solution. Subsequently, after distilling off the solvent under reduced pressure, the reaction product was passed through an active alumina short column (developing solution: orthodichlorobenzene). After distilling off the solvents under reduced pressure, the reaction product was dissolved into heated chlorobenzene and recrystallized by adding heptane to thus obtain the compound represented by the formula (205) (1.0 g).

The structure of the obtained compound was confirmed by an NMR measurement.
¹H-NMR (CDCl₃) : δ = 8.76 (m, 2H), 8.70 (m, 1H), 8.62 (m, 1H), 8.58 (d, 1H), 8.54 (d, 1H), 8.30 (d, 1H), 8.26 (d, 1H), 8.18 (d, 2H), 7.99 (d, 2H), 7.84 (m, 2H), 7.64-7.79 (m, 8H), 7.53 (m, 4H), 7.45 (t, 2H), 7.40 (t, 1H), 7.32 (t, 2H).

### Synthesis Example (37):

### Synthesis of N,N-diphenyl-4-(7-phenyl-4b-aza-12b-boradibenzo[g,p]chrysene-2-yl)aniline

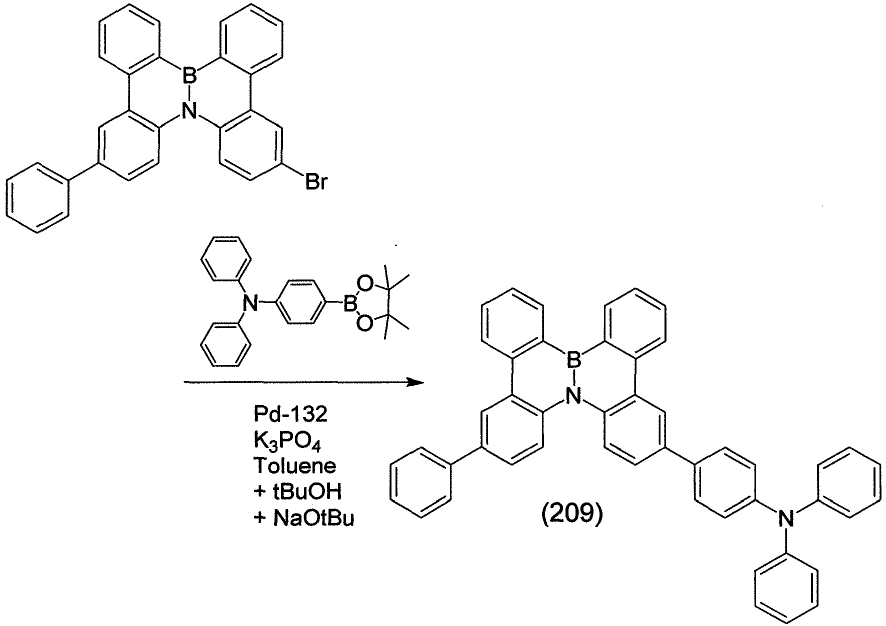

A flask containing 2-bromo-7-phenyl-4b-aza-12b-boradibenzo[g,p]chrysene (2.0 g), N,N-diphenyl-4-(4,4,5,5-tetramethyl-1,3,2-dioxaborolane-2-yl)aniline (1.7 g), Pd-132 (0.06 g), tripotassium phosphate (1.75 g), sodium-t-butoxide (1.0 g), t-butyl alcohol (0.4 ml) and toluene (40 ml) was stirred at 90°C for one hour under a nitrogen atmosphere. After cooling the reaction solution to room temperature, thereto were added water and ethyl acetate to separate the reaction solution. Subsequently, after distilling off the solvent under reduced pressure, the reaction product was passed through an active alumina short column (developing solution: toluene /triethylamine = 100/1 (volume ratio)). After distilling off the solvent under reduced pressure, the reaction product was reprecipitated by adding heptane to thus obtain the compound represented by the formula (209) (0.9 g).

The structure of the obtained compound was confirmed by an NMR measurement.
¹H-NMR (CDCl₃) : δ = 8.73 (d, 2H), 8.60 (m, 1H), 8.57 (m, 1H), 8.51 (m, 2H), 8.22 (m, 2H), 7.81 (m, 2H), 7.75 (d, 2H) 7.63 (m, 6H), 7.52 (t, 2H), 7.40 (t, 1H), 7.29 (m, 4H), 7.20 (d, 2H), 7.18 (m, 4H), 7.05 (t, 2H).

### Synthesis Example (38):

### Synthesis of 9-phenyl-3-(7-phenyl-4b-aza-12b-boradibenzo [g,p]chrysene-2-yl)-2-yl)-9H-carbazole

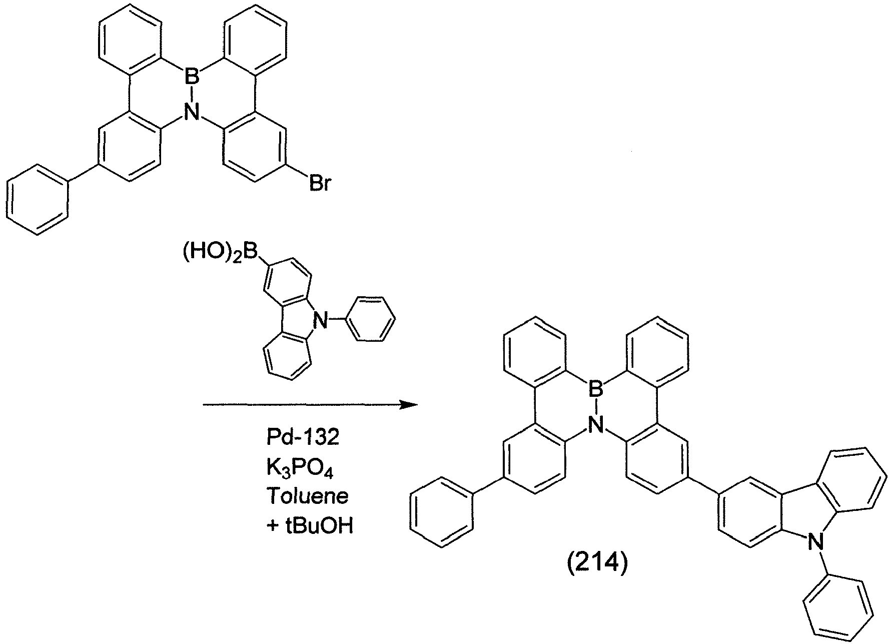

A flask containing 2-bromo-7-phenyl-4b-aza-12b-boradibenzo[g,p]chrysene (2.0 g), (9-phenyl-9H-carbazole-3-yl)boronic acid (1.4 g), Pd-132 (0.06 g), tripotassium phosphate (1.75 g), toluene (40 ml) and t-butyl alcohol (10 ml) was stirred at 120°C for 2 hours. After cooling the reaction solution to room temperature, thereto were added water and ethyl acetate to separate the reaction solution. Subsequently, after distilling off the solvent under reduced pressure, the reaction product was passed through an active alumina short column (developing solution: toluene /triethylamine = 100/1 (volume ratio)). After distilling off the solvent under reduced pressure, the reaction product was reprecipitated by adding heptane to thus obtain the compound represented by the formula (214) (1.6 g).

The structure of the obtained compound was confirmed by an NMR measurement.
¹H-NMR (CDCl₃) : δ = 8.75 (d, 2H), 8.71 (m, 1H), 8.61 (m, 1H), 8.59 (d, 1H), 8.51 (d, 1H), 8.50 (m, 1H), 8.26 (m, 3H), 7.79-7.87 (m, 3H), 7.77 (m, 3H), 7.60-7.70 (m, 7H), 7.47-7.57 (m, 4H), 7.45 (m, 2H), 7.40 (t, 1H), 7.33 (m, 1H).

### Synthesis Example (39):

### Synthesis of 2,7-diphenyl-4b-aza-12b-oxaphospha-dibenzo [g,p]chrysene

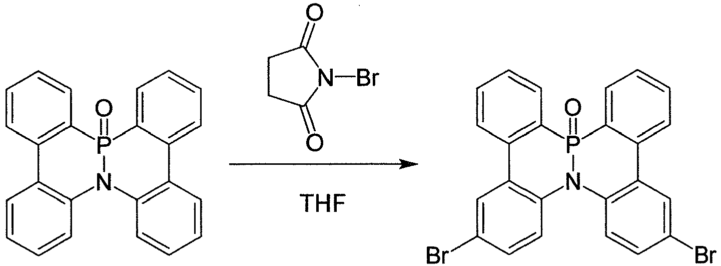

Firstly, N-bromosuccinimide (NBS) (13.6 g) was added to a THF solution (150 ml) of 4b-aza-12b-oxaphospha-dibenzo[g,p]chrysene (3.5 g) and the mixture was stirred at a reducing temperature for 2 hours under a nitrogen atmosphere. After completion of the reaction solution, thereto were added an aqueous sodium nitrite solution and toluene to separate the reaction solution and the solvent was distilled off under reduced pressure. The obtained oily substance was reprecipitated by adding ethanol to thus obtain 2,7-dibromo-4b-aza-12b-oxaphospha-dibenzo[g,p]chrysene (4.5 g).

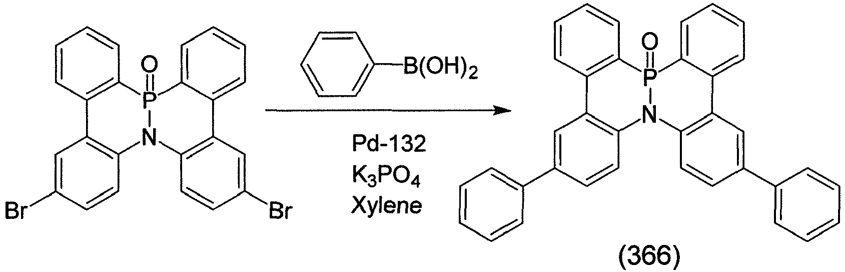

Next, a flask containing 2,7-dibromo-4b-aza-12b-oxaphospha-dibenzo[g,p]chrysene (1.5 g), phenylboronic acid (0.9 g), potassium phosphate (3.0 g), Pd-132 (Johnson Matthey) (0.04 g) and xylene (30 mL) was stirred at 70°C for one hour under a nitrogen atmosphere. After cooling the reaction solution to room temperature, a precipitate generated by adding heptane was collected by suction filtration. The obtained solid was washed with heated water and purified by silica gel column chromatography (developing solution: toluene/ethyl acetate mixed solution). In this process, the objective product was eluted by gradually increasing a ratio of ethyl acetate in the developing solution. In addition, when a sample was charged on silica gel, a solution obtained by dissolving the sample into chlorobenzene was used. Furthermore, the solid was recrystallized from ethyl acetate to thus obtain the compound represented by the formula (366) (1.3 g).

### Synthesis Example (40):

### Synthesis of 2,7-di(pyridine-3-yl)-4b-aza-12b-oxaphospha-dibenzo[g,p]chrysene

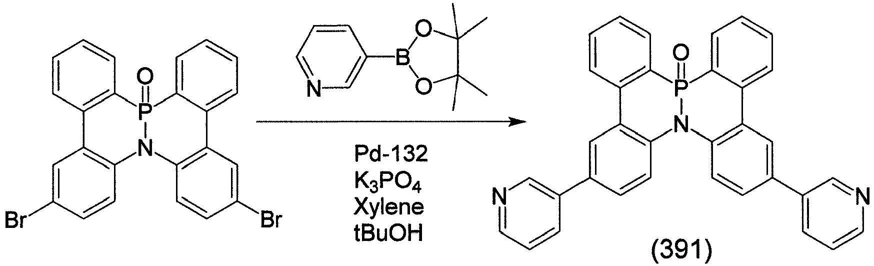

A flask containing 2,7-dibromo-4b-aza-12b-oxaphospha-dibenzo[g,p]chrysene (2.0 g), 3-(4,4,5,-tetramethyl-1,3,2-dioxaborolane-2-yl)pyridine (2.0 g), potassium phosphate (4.0 g), Pd-132 (Johnson Matthey) (0.05 g), xylene (40 mL) and t-butyl alcohol (4 ml) was stirred at 100°C for one hour under a nitrogen atmosphere. After cooling the reaction solution to room temperature, thereto were added ethyl acetate and water. Diluted hydrochloric acid was further added and the aqueous layer was neutralized, thereafter separating the reaction solution. After distilling off the solvents under reduced pressure, the obtained solid was purified by NH-modified silica gel (DM1020: manufactured by FUJI SILYSIA CHEMICAL LTD.) column chromatography (developing solution: chlorobenzene/ethyl acetate = 9/1 (volume ratio)), and heptane was added to a concentrated solution obtained by distilling off the solvent to be reprecipitated to thus obtain the compound represented by the formula (391) (1.0 g).

### Synthesis Example (41):

### Synthesis of 2,7-di(pyridine-4-yl)-4b-aza-12b-oxaphospha-dibenzo[g,p]chrysene

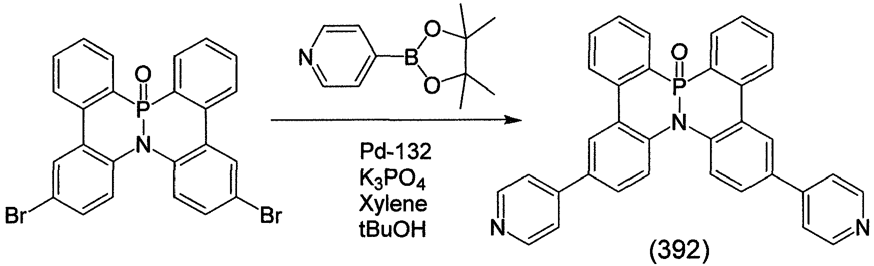

A flask containing 2,7-dibromo-4b-aza-12b-oxaphospha-dibenzo[g,p]chrysene (1.5 g), 4-(4,4,5,-tetramethyl-1,3,2-dioxaborolane-2-yl)pyridine (1.5 g), potassium phosphate (4.0 g), Pd-132 (Johnson Matthey) (0.05 g), xylene (40 mL) and t-butyl alcohol (4 ml) was stirred at 120°C for 2 hours under a nitrogen atmosphere. After cooling the reaction solution to room temperature, thereto was added heptane and the generated precipitate was collected by suction filtration. After washing the obtained solid with heated water, the solid was purified by an NH-modified silica gel (DM1020: manufactured by FUJI SILYSIA CHEMICAL LTD.) short column (developing solution: heated chlorobenzene). After distilling off the solvent under reduced pressure, heptane was added to be reprecipitated to thus obtain the compound represented by the formula (392) (0.4 g).

### Synthesis Example (42):

### Synthesis of 2,7-bis(3-(pyridine-2-yl)phenyl)-4b-aza-12b-oxaphospha-dibenzo[g,p]chrysene

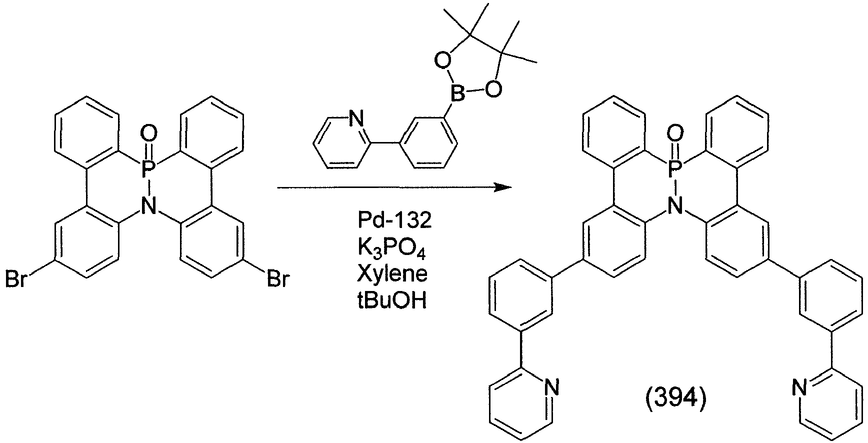

A flask containing 2,7-dibromo-4b-aza-12b-oxaphospha-dibenzo[g,p]chrysene (2.0 g), 2-(3-(4,4,5,-tetramethyl-1,3,2-dioxaborolane-2-yl)phenyl)pyridine (2.7 g), potassium phosphate (4.0 g), Pd-132 (Johnson Matthey) (0.05 g), xylene (40 mL) and t-butyl alcohol (4 ml) was stirred at 120°C for 3 hours under a nitrogen atmosphere. After cooling the reaction solution to room temperature, thereto were added toluene and diluted hydrochloric acid to separate the reaction solution. After distilling off the solvent under reduced pressure, the obtained solid was purified by an NH-modified silica gel (DM1020: manufactured by FUJI SILYSIA CHEMICAL LTD.) short column (developing solution: toluene/ethyl acetate = 9/1 (volume ratio)). The solid was reprecipitated with a toluene/heptane mixed solution to thus obtain the compound represented by the formula (394) (1.6 g).

### Synthesis Example (43):

### Synthesis of 2,7-di(carbazole-9-yl)-4b-aza-12b-oxaphospha-dibenzo[g,p]chrysene

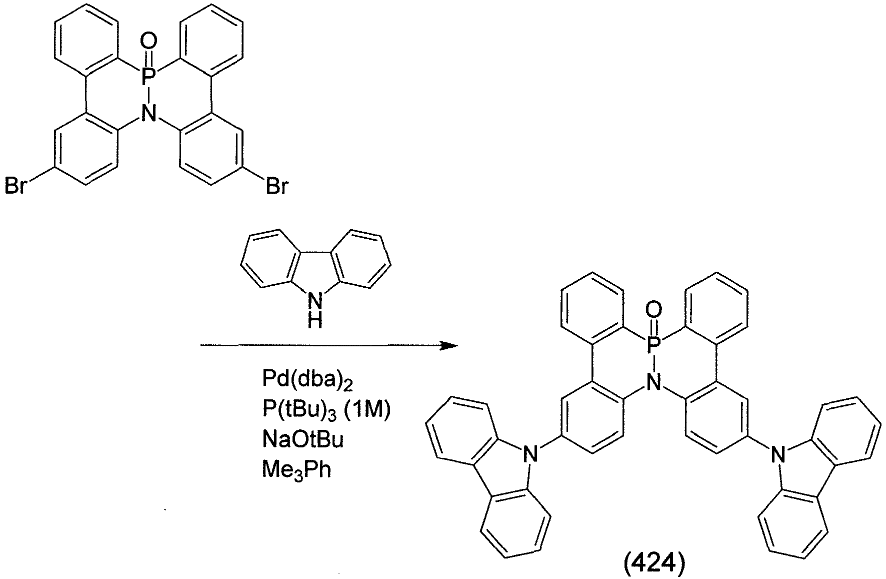

A flask containing 2,7-dibromo-4b-aza-12b-oxaphospha-dibenzo[g,p]chrysene (2.0 g), carbazole (1.6 g), sodium-t-butoxide (0.64 g), Pd(dba)₂ (0.07 g), a tri-t-butylphosphine 1 M-toluene solution (0.34 ml) and 1,2,4-trimethylbenzene "Me₃Ph" (40 mL) was stirred at 150°C for 16 hour under a nitrogen atmosphere. After cooling the reaction solution to room temperature, thereto were added water and toluene to separate the reaction solution. After distilling off the solvent under reduced pressure, the reaction product was purified by silica gel column chromatography (developing solution: toluene/ethyl acetate mixed solution). In this process, the objective product was eluted by gradually increasing a ratio of ethyl acetate in the developing solution. After distilling off the solvent under reduced pressure, the reaction product was washed with ethyl acetate and reprecipitated with a chlorobenzene/ethyl acetate mixed solvent to thus obtain the compound represented by the formula (424) (0.9 g).

### Synthesis Example (44):

### Synthesis of 2-phenyl-14b¹-aza-14b-borabenzo[p]indeno [1,2,3,4-defg]chrysene

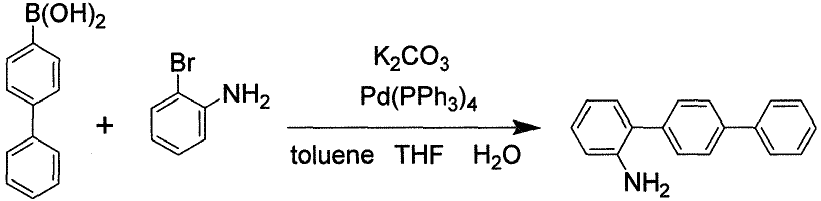

Firstly, a flask containing 4-biphenyl boronic acid (13.5 g), 2-bromoaniline (12.9 g), potassium phosphate (18.8 g), Pd(PPh₃)₄ (1.6 g), toluene (135 ml), THF (65 ml) and water (30 ml) was stirred at a reducing temperature for 7 hours under a nitrogen atmosphere. After cooling the reaction solution to room temperature, thereto were added water and toluene to separate the reaction solution. After distilling off the solvent under reduced pressure, the reaction product was purified by silica gel column chromatography (developing solution: toluene/heptane mixed solution) to thus obtain [1,1':4',1"-terphenyl]-2-amine (11.1 g). In this process, the objective product was eluted by gradually increasing a ratio of toluene in the developing solution. In addition, when the sample was charged on silica gel, a solution obtained by dissolving the sample into chlorobenzene was used.

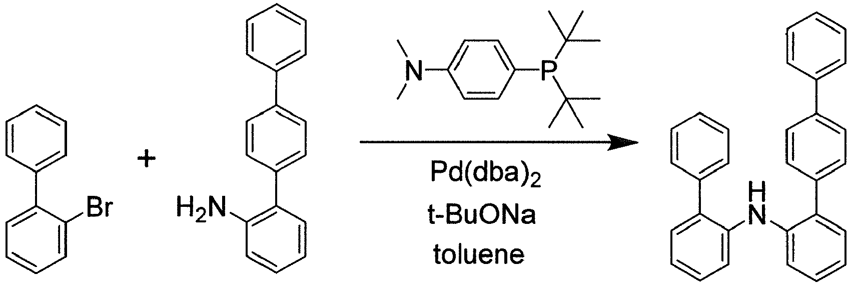

Next, a flask containing [1,1':4',1"-terphenyl]-2-amine (11.0 g), 2-bromobiphenyl (10.5 g), sodium-t-butoxide (5.2 g), Pd(dba)₂ (0.06 g), 4-(di-t-butylphosphino)-N,N-dimethylaniline (0.06 g) and toluene was stirred at a reducing temperature for 3 hours under a nitrogen atmosphere. After cooling the reaction solution to room temperature, thereto were added water and toluene to analyze the reaction solution. After distilling off the solvent under reduced pressure, the reaction product was purified by silica gel column chromatography (developing solution: toluene/heptane mixed solution) to thus obtain N-([1,1'-biphenyl]-2-yl)-[1,1':4',1"-terphenyl]-2-amine (17.5 g). In this process, the objective product was eluted by gradually increasing a ratio of toluene in the developing solution.

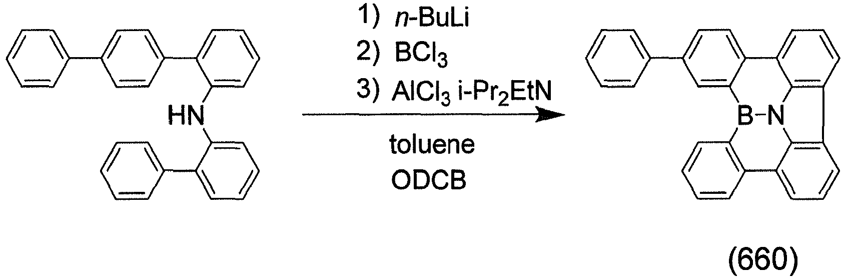

A flask containing N-([1,1'-biphenyl]-2-yl)-[1,1':4',1"-terphenyl]-2-amine (7.5 g) obtained as described above and toluene (100 ml) was cooled to -70°C and a 1.6 M-hexane solution of n-butyl lithium (11.7 ml) was dropped. After completion of dropping, the temperature of the mixture was increased to 0°C once, followed by stirring at 0°C for 5 minutes. Then, the reaction solution was cooled to -70°C again and a 1.0 M-heptane solution of boron trichloride (18.8 ml) was dropped. Subsequently, after increasing the temperature of the reaction solution to room temperature, the solvent was distilled off under reduced pressure once. Thereto were added orthodichlorobenzene "ODCB" (100 ml), diisopropylethylamine (3.2 ml) and aluminum trichloride (10.0 g) and the mixture was stirred at 170°C for 13 hours. After cooling the reaction solution to room temperature, the reaction solution was neutralized with an aqueous sodium hydrogen carbonate solution and thereto were added chlorobenzene and water to separate the reaction solution. Subsequently, the reaction product was purified by an active alumina short column (developing solution: toluene) and further recrystallized from chlorobenzene to thus obtain the compound represented by the formula (660) (0.2 g).

The structure of the obtained compound was confirmed by an NMR measurement.
¹H-NMR (CDCl₃): δ = 9.42 (m, 1H), 9.27 (d, 1H), 8.77 (d, 1H), 8.73 (d, 1H), 8.50 (dd, 2H), 8.27 (dd, 2H), 8.10 (dd, 1H), 7.88 (m, 3H), 7.73 (m, 3H), 7.60 (t, 2H), 7.47 (t, 1H).

### Synthesis Example (45):

### Synthesis of 2-(14b¹-aza-14b-borabenzo[p]indeno [1,2,3,4-defg]chrysene-6-yl)-9H-carbazole

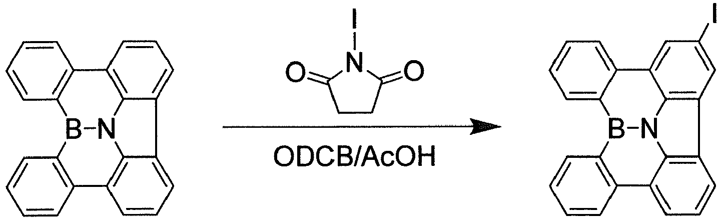

Firstly, N-iodosuccinimide (NIS) (2.8 g) was added to a mixed solution of orthodichlorobenzene (10 ml) and acetic acid (1 ml) containing 14b¹-aza-14b-borabenzo[p]indeno [1,2,3,4-defg]chrysene (1.0 g) and the mixture was stirred at room temperature for 26 hours under a nitrogen atmosphere. Thereto was added an aqueous sodium thiosulfate solution to terminate the reaction, and the deposited solid was collected by suction filtration. The obtained solid was washed with water and methanol and then recrystallized from chlorobenzene to thus obtain 6-iodo-14b¹-aza-14b-borabenzo[p]indeno[1,2,3,4-defg]chrysene (0.4 g).

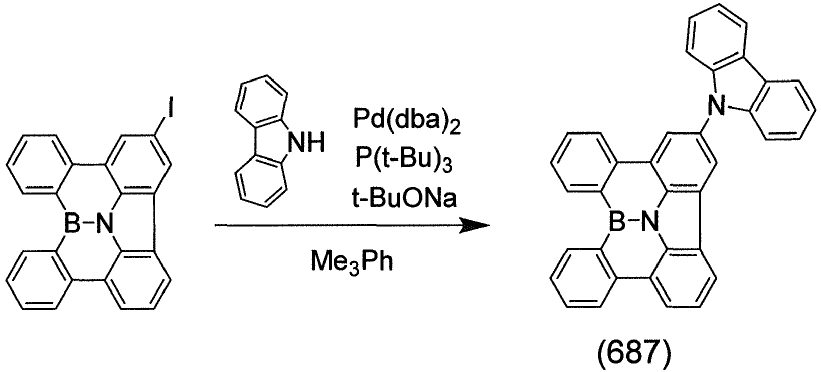

Next, a flask containing 6-iodo-14b¹-aza-14b-borabenzo[p]indeno[1,2,3,4-defg]chrysene (0.4 g), carbazole (0.2 g), sodium-t-butoxide (0.1 g), Pd(dba)₂ (0.03 g), a 1 M-tri-t-butylphosphinetoluene solution (0.13 ml) and 1,2,4-trimethylbenzene "Me₃Ph" (10 ml) was stirred at a reducing temperature for 3 hours under a nitrogen atmosphere. After cooling the reaction solution to room temperature, the deposited solid obtained by adding water was collected by suction filtration. The obtained solid was washed with water and methanol and passed through an active alumina short column (developing solution: toluene). The solid was further recrystallized from chlorobenzene to thus obtain the compound represented by (687) (0.2 g).

The structure of the obtained compound was confirmed by an NMR measurement.
¹H-NMR (CDCl₃): δ = 9.27 (m, 2H), 8.74 (d, 1H), 8.61 (m, 2H), 8.53 (d, 1H), 8.40 (m, 1H), 8.24 (m, 3H), 7.91 (t, 1H), 7.85 (t, 1H), 7.72-7.80 (m, 3H), 7.42-7.51 (m, 4H), 7.35 (t, 2H).

### Synthesis Example (46):

### Synthesis of 2,5,8,11-tetramethyl-3b-aza-9b-bora-naphtho[2,1-b:3,-b':6,5-b":7,8-b"']tetrathiophene

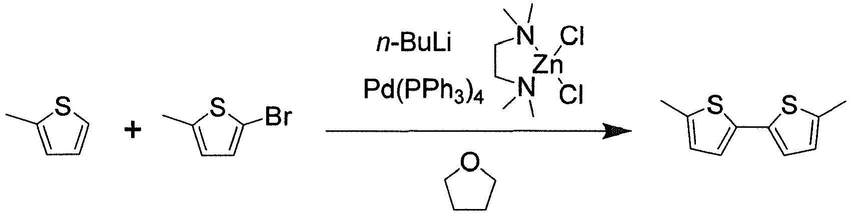

2-methylthiophene (5.0 g) was dissolved into THF (50 ml) and the mixture was cooled to -78°C. Thereto was gradually dropped a 1.6 M-n-butyl lithium hexane solution (35.0 ml). When 30 minutes passed after completion of dropping, the temperature of the reaction solution was increased to 0°C and the mixture was stirred for 3 hours and then added with a zinc chloride tetramethylethylenediamine complex (14.2 g), followed by further stirring for 30 minutes. Subsequently, after the reaction solution was increased to room temperature, thereto were added 2-bromo-5-methylthiophene (6.8 g) and Pd(PPh₃)₄, and the temperature of the reaction solution was further increased to a reducing temperature and the mixture was stirred for 3 hours. After cooling the reaction solution to room temperature, a solution obtained by dissolving ethylenediamine tetraacetic acid tetrasodium salt dihydrate into an appropriate amount of water (hereinafter, abbreviated as an aqueous EDTA·4Na solution) and thereto was added toluene to separate the reaction solution. After distilling off the solvent under reduced pressure, the reaction product was purified by silica gel column chromatography (developing solution: heptane) to thus obtain 5,5'-dimethyl-2,2'-bithiophene (20.3 g).

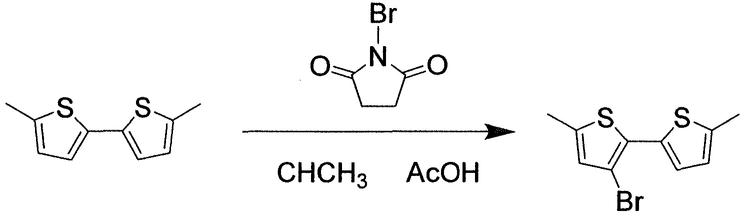

5,5'-dimethyl-2,2'-bithiophene (7.5 g) was dissolved into a chloroform (75 ml)/acetic acid (37.5 ml) mixed solution and cooled to 0°C. Thereto was gradually dropped N-bromosuccinimide "NBS" (6.9 g) and the temperature of the mixture was increased to room temperature. After completion of the reaction, water was added to separate the reaction solution, and the organic later was further washed with an aqueous sodium carbonate solution. The solvent was distilled off under reduced pressure and the reaction product was purified by silica gel column chromatography (developing solution: heptane) to thus obtain 3-bromo-5,5'-dimethyl-2,2'-bithiophene (10.0 g).

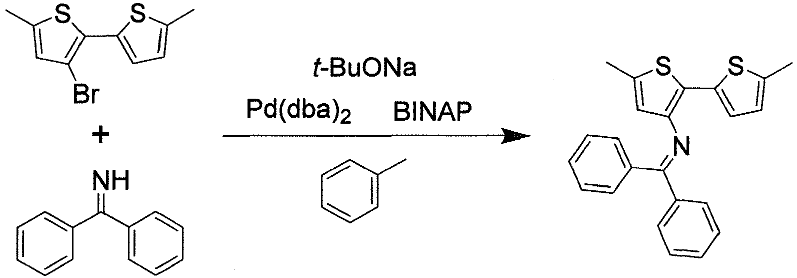

A flask containing 3-bromo-5,5'-dimethyl-2,2'-bithiophene (8.3 g), diphenylmethaneimine (11.0 g), Pd(dba)₂ (0.5 g), 2,2'-bis(diphenylphosphino)-1,1'-binaphthyl "BINAP" (1.1 g), sodium-t-butoxide (10.2 g) and toluene (100 ml) was stirred at reducing temperature for 20 hours under a nitrogen atmosphere. The reaction solution was cooled to room temperature, and the solid content was filtered off by suction filtration. Subsequently, after distilling off the solvent under reduced pressure, the reaction product was purified by silica gel column chromatography (developing solution: heptane/toluene = 1/1 (volume ratio)) to thus obtain N-(diphenylmethylene)-5,5'-dimethyl-[2,2'-bithiophene]-3-amine (11.4 g).

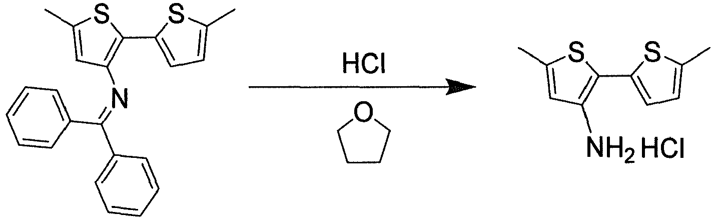

N-(diphenylmethylene)-5,5'-dimethyl-[2,2'-bithiophene]-3-amine (11.4 g) was dissolved into THF (165 ml). Thereto was added 6M hydrochloric acid (98 ml) and the mixture was stirred at room temperature for 10 minutes. The solvent was distilled off under reduced pressure and the deposited solid was collected by suction filtration and washed with heptane to thus obtain 5,5'-dimethyl-[2,2'-bithiophene]-3-amine hydrochloride (10.0 g).

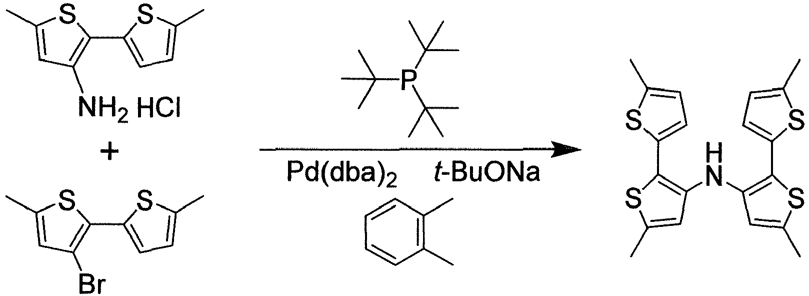

Under a nitrogen atmosphere, a flask containing 5,5'-dimethyl-[2,2'-bithiophene]-3-amine hydrochloride (10.0 g), 3-bromo-5,5'-dimethyl-2,2'-bithiophene (13.0 g), Pd(dba)₂ (0.5 g), a 1 M-tri-t-butyl phosphinetoluene solution (4.3 ml), sodium-t-butoxide (11.4 g) and xylene (130 ml) was stirred at 120°C for 12 hours. The reaction solution was cooled to room temperature and thereto were added water and toluene to separate the reaction solution. The solvent was distilled off under reduced pressure and the reaction product was purified by silica gel column chromatography (developing solution: heptane/toluene = 10/1 (volume ratio)) and then recrystallized from heptane to thus obtain bis(5,5'-dimethyl-[2,2'-bithiophene]-3-yl)amine (10.7 g).

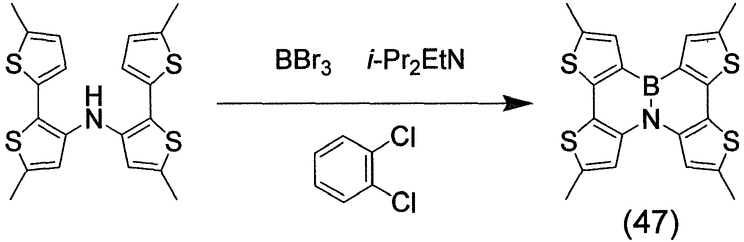

Under a nitrogen atmosphere, boron tribromide (1.8 ml) was added to a flask containing bis(5,5'-dimethyl-[2,2'-bithiophene]-3-yl)amine (5.0 g), diisopropylethylamine (4.4 ml) and orthodichlorobenzene (50 ml) and the mixture was stirred at 180°C for 8 hours. The solvent was distilled off under reduced pressure and the reaction product was purified by active alumina column chromatography (developing solution: chlorobenzene). The solvent was distilled off under reduced pressure, and the obtained solid was washed with heated heptane to thus obtain the compound represented by the formula (47) (0.7 g).

The structure of the obtained compound was confirmed by an NMR measurement.
¹H-NMR (CDCl₃) : δ = 7.73 (s, 2H), 7.71 (s, 2H), 2.69 (s, 6H), 2. 66 (s, 6H).

### Synthesis Example (47):

### Synthesis of 11b-aza-3b-boradibenzo[c,f]dipyrrolo[2,1-a: 1' , 2' -h] [2, 7] naphthyridine

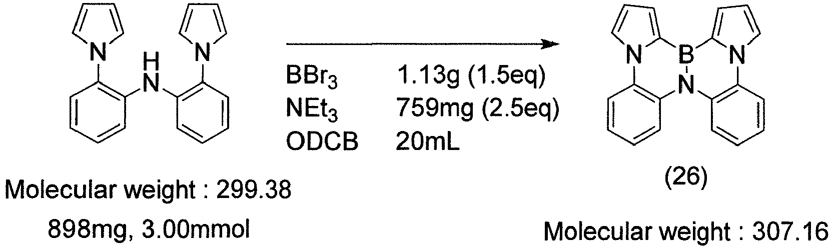

A flask containing bis(2-(1H-pyrrole-1-yl)phenylamine (0.898 g), boron tribromide (1.13 g), triethylamine "NEt₃" (0.759 g) and 1,2-dichlorobenzene "ODCB" (20 ml) was stirred at 120°C for 2 hours under an argon atmosphere. After cooling the reaction solution to room temperature, thereto was added 1,4-diazabicyclo[2.2.2]octane (2.02 g) and the mixture was passed through an active alumina short column. During this process, the reaction product was eluted from the column using toluene. After distilling off the solvent under reduced pressure, the obtained solid was washed with hexane to thus obtain the compound represented by the formula (26) (0.789 g).

The structure of the obtained compound was confirmed by an NMR measurement.
¹H-NMR (CDCl₃) : δ = 8.01 (dd, 2H), 7.84 (dd, 2H), 7.74 (dd, 2H), 7.31 (dd, 2H), 7.16-7.23 (m, 4H), 6.73 (dd, 2H).

### Synthesis Example (48):

### Synthesis of 2,7-dicyano-4b-aza-12b-boradibenzo[g,p] chrysene

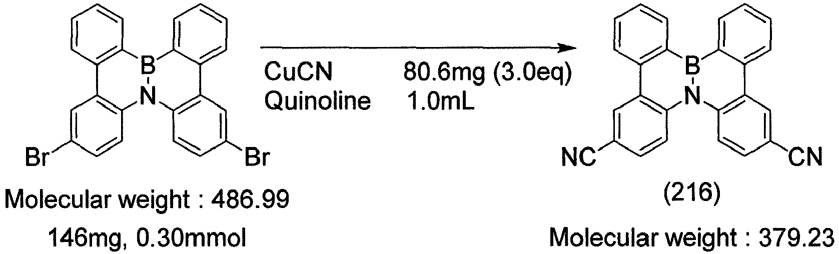

A flask containing 2,7-dibromo-4b-aza-12b-boradibenzo[g,p]chrysene (0.146 g), copper cyanide (80.6 mg) and quinoline (1.0 mL) was stirred at 200°C for 40 hours under an argon atmosphere. After cooling the reaction solution to room temperature, the mixture was passed through an active alumina short column. During this process, the reaction product was eluted from the column using toluene. After distilling off the solvent under reduced pressure, the obtained crude product was isolated by GPC to thus obtain the compound represented by the formula (216) (58.0 mg) as a light yellow powder.

The structure of the obtained compound was confirmed by an NMR measurement.
¹H-NMR (CDCl₃) : δ = 8.66-8.70 (m, 4H), 8.38 (d, 2H), 8.05 (d, 2H), 7.89 (d, 2H), 7.73 (d, 2H), 7.65 (dd, 2H).

### Synthesis Example (49):

### Synthesis of 3,6-difluoro-4b-aza-12b-boradibenzo[g,p] chrysene

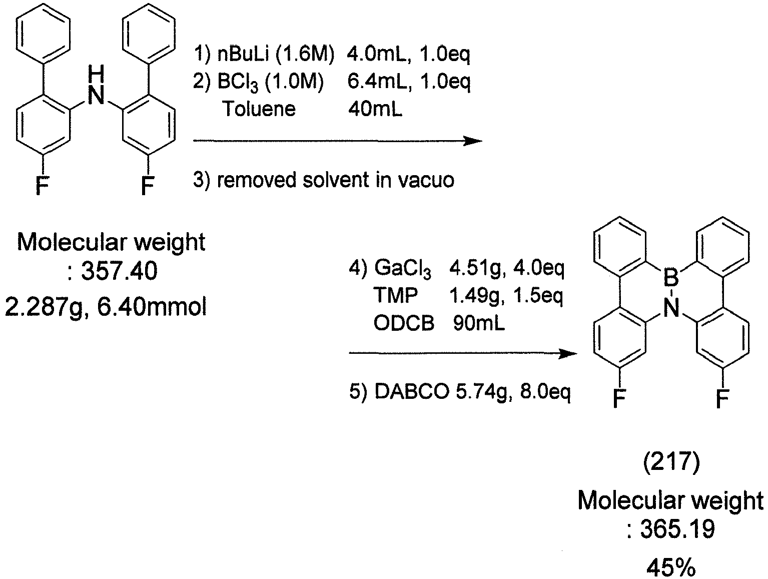

A flask containing di([4-fluoro-1,1'-biphenyl]-2-yl)amine (2.29 g) and toluene (40 ml) was cooled to -78°C and a 1.6 M hexane solution of n-butyl lithium (4.0 ml) was dropped thereto. After completion of dropping, the temperature of the mixture was increased to 0°C once and the reaction solution was stirred at 0°C for one hour. Thereafter, the reaction solution was cooled to -78°C again, and thereto was dropped a 1.0 M-toluene solution containing boron trichloride (6.4 ml). Subsequently, after increasing the temperature of the reaction solution to room temperature, the solvent was distilled off under reduced pressure once. Thereto were added orthodichlorobenzene (90 ml), 2,2,6,6-tetramethylpiperidine "TMP" (1.49 g) and gallium trichloride (4.51 g), and the mixture was stirred at 135°C for 24 hours and subsequently stirred at 150°C for 15 hours. Thereto were added 1,4-diazabicyclo[2.2.2]octane (5.74 g) and toluene (100 ml) and the mixture was stirred. Subsequently, the deposited precipitate was removed by suction filtration using a glass filter in which celite was bedded, thereafter distilling off the solvent under reduced pressure. Toluene (36 ml) was added thereto and a precipitate was removed by filtration using filter paper. Furthermore, a metallic salt was removed by a short column using Alumina Neutral (developing solution: toluene/dichloromethane = 1/1 (volume ratio)), and the obtained crude product was isolated by GPC to thus obtain the compound represented by the formula (217) (1.05 g) as a white powder.

The structure of the obtained compound was confirmed by an NMR measurement.
¹H-NMR (CDCl₃) : δ = 8.63 (dd, 2H), 8.30 (d, 2H), 8.29 (d, 2H), 7.78 (dd, 2H), 7.76 (dd, 2H), 7.59 (dd, 2H), 7.08 (dd, 2H), 7.06 (dd, 2H).

### Synthesis Example (50):

### Synthesis of 2,7,9,16-tetraphenyl-4b-aza-12b-boradibenzo [g,p]chrysene

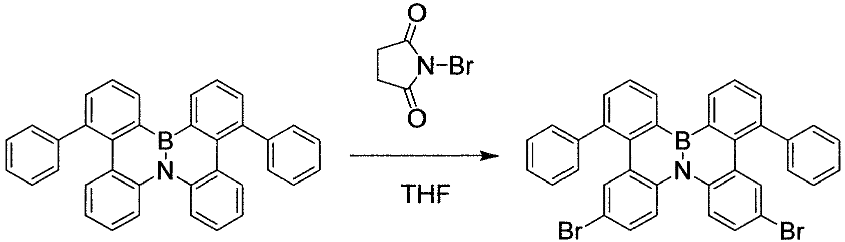

Firstly, under a nitrogen atmosphere, N-bromosuccinimide (NBS) (1.8 g) was added to a THF solution of 9,16-diphenyl-4b-aza-12b-boradibenzo[g,p]chrysene (2.3 g) (20 ml) and the mixture was stirred at room temperature for one hour. After completion of the reaction, thereto was added an aqueous sodium nitrite solution and the deposited precipitate was collected by suction filtration. The obtained solid was further purified by active alumina column chromatography (developing solution: toluene /triethylamine = 99/1 (volume ratio)). The solvent was distilled off under reduced pressure and the obtained solid was washed with ethyl acetate to thus obtain 2,7-dibromo-9,16-diphenyl-4b-aza-12b-boradibenzo[g,p]chrysene (2.6 g).

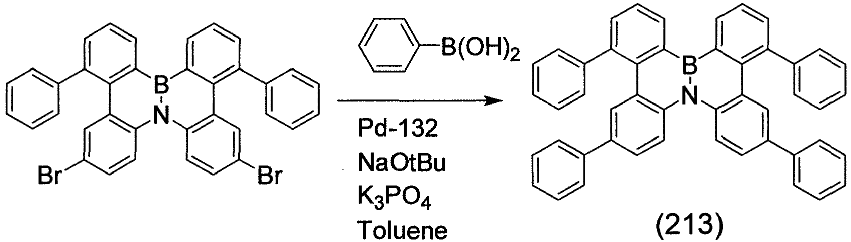

Next, a flask containing 2,7-dibromo-9,16-diphenyl-4b-aza-12b-boradibenzo[g,p]chrysene (1.8 g), phenylboronic acid (0.9 g), potassium phosphate (1.8 g), sodium-t-butoxide (0.3 g), Pd-132 (Johnson Matthey) (0.04 g) and toluene (30 mL) was stirred at 80°C for one hour under a nitrogen atmosphere. After cooling the reaction solution to room temperature, thereto were added water and toluene to separate the reaction solution. Subsequently, after distilling off the solvent under reduced pressure, the reaction product was purified by active alumina column chromatography (developing solution: toluene/triethylamine = 99/1 (volume ratio)). The reaction product was further dissolved into toluene and then added to heptane to be re precipitated, thereby obtaining the compound represented by the formula (213) (1.2 g).

The structure of the obtained compound was confirmed by an NMR measurement.
¹H-NMR (CDCl₃) : δ = 8.77 (d, 2H), 8.16 (d, 2H), 7.81 (m, 2H), 7.66-7.74 (m, 4H), 7.46-7.55 (m, 4H), 7.20-7.30 (m, 14H), 7.01 (m, 4H).

### Synthesis Example (51):

### Synthesis of 2-phenyl-7-(triphenylene-2-yl)-4b-aza-12b-boradibenzo[g,p]chrysene

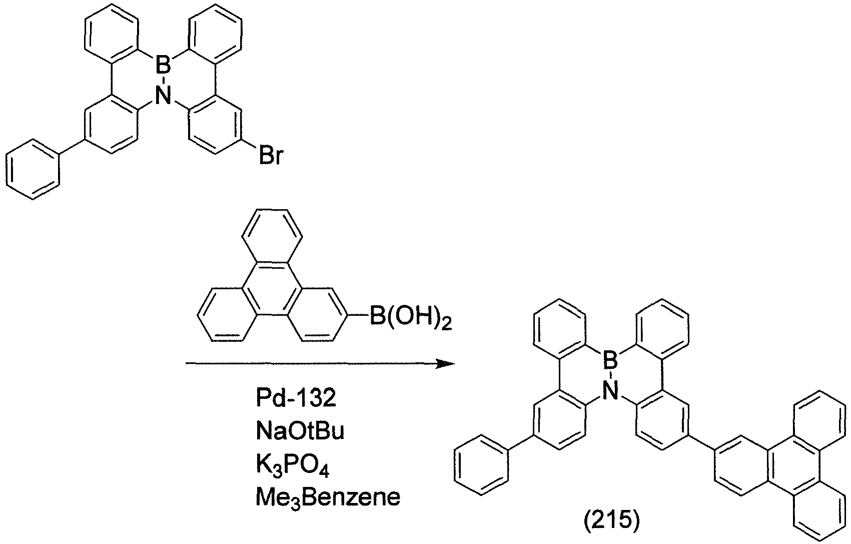

A flask containing 2-bromo-7-phenyl-4b-aza-12b-boradibenzo[g,p]chrysene (2.0 g), 2-triphenylene boronic acid (1.2 g), Pd-132 (0.06 g), tripotassium phosphate (0.9 g), sodium-t-butoxide (0.4 g) and 1,2,4-trimethylbenzene (50 ml) was stirred at 115°C for one hour. The reaction solution was cooled to room temperature, thereto were added water and heptane, and the deposited solid was collected by suction filtration. Subsequently, the solid was dissolved into heated chlorobenzene and passed through an active alumina short column (developing solution: toluene /triethylamine = 99/1 (volume ratio)). The solvent was distilled off under reduced pressure, and the obtained solid was washed with ethyl acetate and recrystallized from chlorobenzene to thus obtain the compound represented by the formula (215) (0.6 g).

The structure of the obtained compound was confirmed by an NMR measurement.
¹H-NMR (CDCl₃): δ = 9.00 (m, 1H), 8.83 (m, 1H), 8.75-8.80 (m, 4H), 8.68-8.74 (m, 3H), 8.61 (m, 2H), 8.53 (d, 1H), 8.31 (d, 1H), 8.27 (d, 1H), 8.05 (d, 1H), 7.81-7.89 (m, 3H), 7.77 (m, 2H), 7.64-7.75 (m, 7H), 7.52 (t, 2H), 7.40 (t, 1H).

### Synthesis Example (52):

### Synthesis of 13c-aza-4b-bora-9-phenyl-9,13c-dihydro-4bH-benzo[a]phenanthro[9,10-c]carbazole

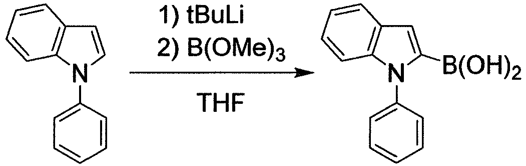

Firstly, a solution obtained by dissolving 1-phenyl-1H-indole (31.0 g) into THF (500 ml) was cooled to -78°C. After dropping t-butyl lithium (99.7 ml) to the solution, the temperature of the mixture was gradually increased to room temperature and the reaction solution was stirred for one hour. The reaction solution was cooled to -78°C again and thereto was dropped trimethoxyborane (23.3 g). Thereafter, the temperature of the mixture was increased to room temperature, the solution was stirred all night, an appropriate amount of THF was distilled off under reduced pressure, thereto was added an aqueous ammonium chloride solution, followed by stirring the reaction solution for one hour. Thereto was added ethyl acetate to separate the reaction solution, the solvent in the organic layer was distilled off under reduced pressure, and toluene was added to conduct azeotropic dehydration to thus obtain (1-phenyl-1H-indolo-2-yl) boronic acid (31.0 g).

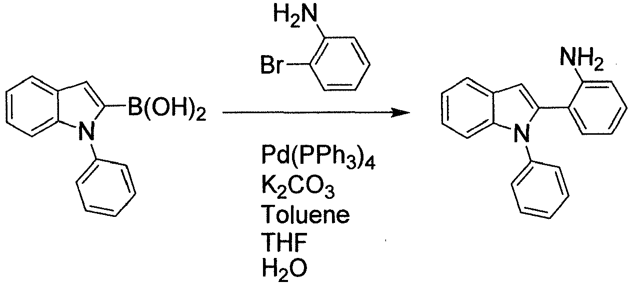

Next, a flask containing (1-phenyl-1H-indolo-2-yl) boronic acid (30.0 g), 2-bromoaniline (20.0 g), Pd(PPh₃)₄ (5.0 g), potassium carbonate (50.0 g), toluene (200 ml), THF (70 ml) and water (30 ml) was stirred at 80°C for 4 hours under a nitrogen atmosphere. After cooling the reaction solution to room temperature, thereto were added water and ethyl acetate to separate the reaction solution, and the solvent was distilled off under reduced pressure. The obtained oily substance was purified by silica gel column chromatography (developing solution: toluene/heptane = 1 (volume ratio)), and a low-boiling component was distilled off under reduced pressure to thus obtain 2-(1-phenyl-1H-indolo-2-yl)aniline (26.8 g).

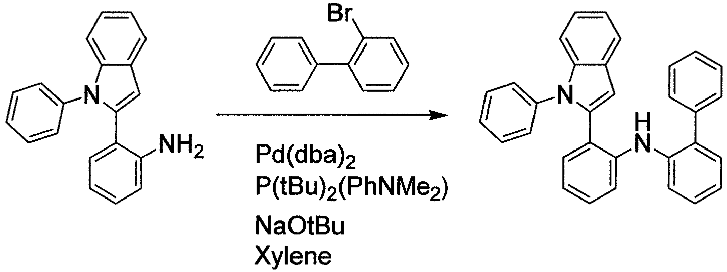

Furthermore, a flask containing 2-(1-phenyl-1H-indolo-2-yl)aniline (25.0 g), 2-bromobiphenyl (20.5 g), sodium-t-butoxide (13.0 g), Pd(dba)₂ (0.13 g), 4-(di-t-butylphosphino)-N,N-dimethylaniline (0.12 g) and xylene (120 ml) was stirred at 90°C for one hour under a nitrogen atmosphere. After cooling the reaction solution to room temperature, thereto were added water and chlorobenzene to analyze the reaction solution, and the reaction product was purified by an active alumina short column (developing solution: chlorobenzene). The solvent was distilled off under reduced pressure, and the obtained oily substance was reprecipitated by adding heptane and a small amount of ethyl acetate to thus obtain N-(2-(1-phenyl-1H-indolo-2-yl)phenyl)-[1,1'-biphenyl]-2-amine (36.2 g).

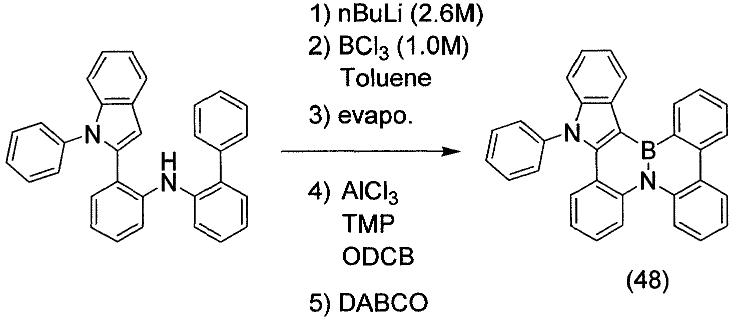

A flask containing N-(2-(1-phenyl-1H-indolo-2-yl)phenyl)-[1,1'-biphenyl]-2-amine (16.3 g) obtained as described above and toluene (150 ml) was cooled to -70°C, and a 2.6 M-hexane solution of n-butyllithium (14.4 ml) was dropped thereto. After completion of dropping, the temperature of the reaction solution was increased to 0°C once and the reaction solution was stirred at 0°C for 5 minutes. Thereafter, this solution was cooled to -70°C, and thereto was dropped a 1 M-boron trichloride toluene solution (37.3 ml). Subsequently, the solvent was distilled off under reduced pressure once, thereto were added orthodichlorobenzene (150 ml), 2,2,6,6-tetramethylpiperidine (11.1 g) and aluminum trichloride (25.0 g) and the mixture was stirred at 160°C for 8 hours. After cooling to the reaction solution to room temperature, a solution obtained by suspending 1,4-diazabicyclo[2.2.2]octane "DABCO" (21.0 g) into toluene was added, and the deposited solid was filtered off by filtration under reduced pressure using a funnel in which celite was bedded. The solid was further purified by active alumina column chromatography (toluene/heptane/triethylamine = 30/70/2 (volume ratio)), then washed with heptane to thus obtain the compound represented by the formula (48) (12.0 g).

The structure of the obtained compound was confirmed by an NMR measurement.
¹H-NMR (CDCl₃) : δ = 8.97 (d, 1H), 8.55 (m, 1H), 8.40 (d, 1H), 8.38 (d, 1H), 8.23 (d, 1H), 8.11 (d, 1H), 7.73-7.90 (m, 3H), 7.54-7.68 (m, 3H), 7.21-7.39 (m, 8H), 6.92 (t, 1H).

The other polycyclic aromatic compounds of the present invention can be synthesized by methods according to the above described synthesis examples by appropriately changing raw material compounds.

Hereinbelow, respective examples were shown in order to more specifically explain the present invention, however, the present invention is not limited to these examples.

The electroluminescent elements of Examples 1 to 4 and Comparative Example 1 were prepared, the driving initial voltage (V) and the current efficiency (cd/A) when driven under a constant current at a current density at which a luminance of 1000 cd/m² is obtained were respectively measured. Hereinbelow, examples and comparative examples are specifically explained.

The material constitutions of the respective layers in the organic electroluminescent elements according to Examples 1 to 4 and Comparative Example 1 are shown in the following Table 1.

**[Table 1]**

| | Hole injection layer (40nm) | Hole transport layer (10nm) | Luminescent layer (35nm) | | Hole inhibition layer (5nm) | Electron transport layer (15nm) | Cathode (1nm/100nm) |
|---|---|---|---|---|---|---|---|
| | | | Host | Dopant | | | |
| Example 1 | HI | NPD | Compound (1) | Ir(PPy)₃ | BCP | ET1 | LiF/Al |
| Example 2 | HI | NPD | Compound (66) | Ir(PPy)₃ | BCP | ET1 | LiF/Al |
| Example 3 | HI | NPD | Compound (197) | Ir(PPy)₃ | BCP | ET1 | LiF/Al |
| Example 4 | HI | Compound (198) | CBP | Ir(PPy)₃ | BCP | ET1 | LiF/Al |
| Comparative Example 1 | HI | NPD | CBP | Ir(PPy)₃ | BCP | ET1 | LiF/Al |

In Table 1, "HI" is N⁴,N^{4'}-diphenyl-N⁴,N^{4'}-bis (9-phenyl-9H-carbazol-3-yl)-[1,1'-biphenyl]-4,4'-diamine, "NPD" is N⁴, N^{4'} -di (naphthalen-1-yl)-N⁴,N^{4'}-diphenyl- [1,1'-biphenyl]-4,4'-diamine, "CBP" is 4,4'-di(9H-carbazolyl-9-yl)-1,1'-biphenyl, "Ir(PPy)₃" is tris(2-phenylpyridine)iridium(III), "BCP" is 2,9-dimethyl-4,7-diphenyl-1,10-phenanthroline, and "ET1" is 2,5-bis-(2',2"-bipyridine-6'-yl)-1,1-dimethyl-3,4-bis(2,4,6-trimethylphenyl)silacyclopentadiene (these are the same in tables shown below). The chemical structures are shown below.

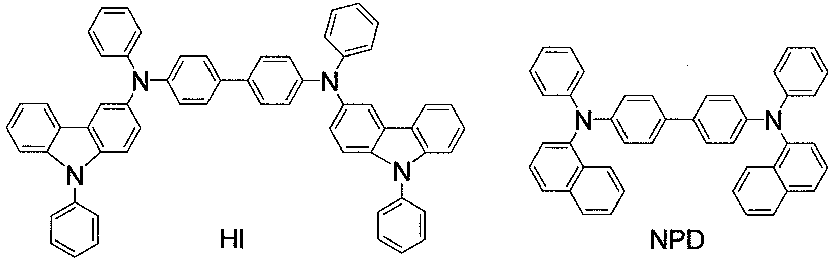

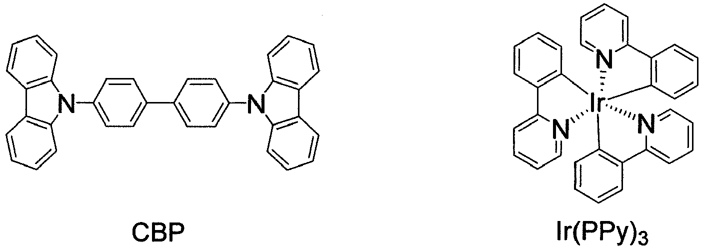

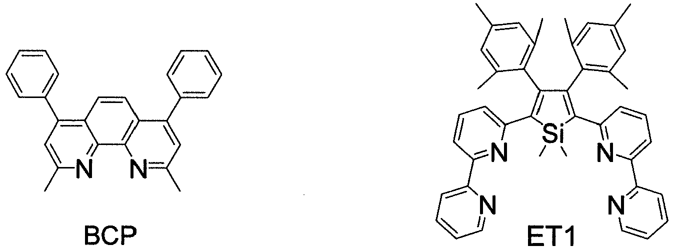

### <Example 1>

### <Element using compound (1) in host material of luminescent layer>

A glass substrate of 26 mm x 28 mm x 0.7 mm (manufactured by OPTO SCIENCE, INC.), which was obtained by grinding ITO formed into a film at a thickness of 180 nm to have a thickness of 150 nm by sputtering, was used as a transparent support substrate. This transparent support substrate was fixed on a substrate holder of a commercially available deposition apparatus (manufactured by Showa Shinku Co., Ltd.), and a molybdenum deposition boat containing HI, a molybdenum deposition boat containing NPD, a molybdenum deposition boat containing the compound (1) of the present invention, a molybdenum deposition boat containing Ir(PPy)₃, a molybdenum deposition boat containing BCP, a molybdenum deposition boat containing ET1, a molybdenum deposition boat containing LiF and a tungsten deposition boat containing aluminum were attached thereto.

The following respective layers were successively formed on the ITO film of the transparent support substrate. The pressure in a vacuum bath was reduced to 5 x 10⁻⁴ Pa, the deposition boat containing HI was first heated to conduct deposition so as to give a film thickness of 40 nm to thereby form a hole injection layer, and the deposition boat containing NPD was then heated to conduct deposition so as to give a film thickness of 10 nm to thereby form a hole transport layer. Subsequently, the deposition boat containing the compound (1) and the deposition boat containing Ir(PPy)₃ were simultaneously heated to conduct deposition so as to give a film thickness of 35 nm to thereby form a luminescent layer. The deposition velocity was controlled so that the weight ratio of compound (1) to Ir(PPy)₃ became approximately 95 to 5. Subsequently, the deposition boat containing BCP was heated to conduct deposition so as to give a film thickness of 5 nm to thereby form a hole inhibition layer. Subsequently, the deposition boat containing ET1 was heated to conduct deposition so as to give a film thickness of 15 nm to thereby form an electron transport layer. The above-mentioned deposition velocities were 0.01 to 1 nm/sec.

Thereafter, the deposition boat containing LiF was heated to conduct deposition so as to give a film thickness of 1 nm at a deposition velocity of 0.01 to 0.1 nm/sec. Subsequently, the deposition boat containing aluminum was heated to conduct deposition so as to give a film thickness of 100 nm at a deposition velocity of 0.01 to 2 nm/sec to thereby form a cathode and an organic EL element was obtained.

When a direct-current voltage was applied by using the ITO electrode as an anode and the LiF/aluminum electrode as a cathode, green light emission at a wavelength of 515 nm was obtained. In addition, a driving voltage for obtaining an initial luminance of 1000 cd/m² was 6.0 V and the current efficiency at that time was 34.2 cd/A.

### <Example 2>

### <Element using compound (66) in host material of luminescent layer>

An organic EL element was obtained by a process according to Example 1, except that the compound (1) that was the host material of the luminescent layer in Example 1 was changed to the compound (66). When a direct-current voltage was applied to the both electrodes, green light emission at a wavelength of 515 nm was obtained. In addition, a driving voltage for obtaining an initial luminance of 1000 cd/m² was 5.7 V and the current efficiency at that time was 36.4 cd/A.

### <Example 3>

### <Element using compound (197) in host material of luminescent layer>

An organic EL element was obtained by a process according to Example 1, except that the compound (1) that was the host material of the luminescent layer in Example 1 was changed to the compound (197). When a direct-current voltage was applied to the both electrodes, green light emission at a wavelength of 515 nm was obtained. In addition, a driving voltage for obtaining an initial luminance of 1000 cd/m² was 5.6 V and the current efficiency at that time was 28.1 cd/A.

### <Example 4>

### <Element using compound (198) in host material of luminescent layer>

An organic EL element was obtained by a process according to Example 1, except that NPD that was the hole transport material was changed to the compound (198) and the compound (1) that was the host material of the luminescent layer in Example 1 was changed to CBP. When a direct-current voltage was applied to the both electrodes, green light emission at a wavelength of 515 nm was obtained. In addition, a driving voltage for obtaining an initial luminance of 1000 cd/m² was 5.9 V and the current efficiency at that time was 26.4 cd/A.

### <Comparative Example 1>

An organic EL element was obtained by a process according to Example 1, except that the compound (1) that was the host material of the luminescent layer in Example 1 was changed to CBP. When a direct-current voltage was applied to the both electrodes, green light emission at a wavelength of 515 nm was obtained. In addition, a driving voltage for obtaining an initial luminance of 1000 cd/m² was 6.7 V and the current efficiency at that time was 24.6 cd/A.

The above-mentioned results are summarized in Table 2.

**[Table 2]**

| | Hole transport layer material | Host material | Driving voltage (V) | Current efficiency (cd/A) |
|---|---|---|---|---|
| Example 1 | NPD | Compound (1) | 6.0 | 34.2 |
| Example 2 | NPD | Compound (66) | 5.7 | 36.4 |
| Example 3 | NPD | Compound (197) | 5.6 | 28.1 |
| Example 4 | Compound (198) | CBP | 5.9 | 26.4 |
| Comparative Example 1 | NPD | CBP | 6.7 | 24.6 |

Next, the electroluminescent elements according to Example 5 and Comparative Example 2 were prepared, the drive initial voltage (V) and the current efficiency (cd/A) when driven under a constant current at a current density at which a luminance of 1000 cd/m² is obtained were respectively measured. Hereinbelow, examples and comparative examples are specifically explained.

The material constitutions of the respective layers in the prepared electroluminescent elements according to Example 5 and Comparative Example 2 are shown in the following Table 3.

**[Table 3]**

| | Hole injection layer (30nm) | Hole transport layer (20nm) | Luminescent layer (35nm) | | Hole inhibition layer (5nm) | Electron transport layer (15nm) | Cathode (1nm/100nm) |
|---|---|---|---|---|---|---|---|
| | | | Host | Dopant | | | |
| Example 5 | HI | HT | Compound (251) | Ir(PPy)₃ | BCP | ET1 | LiF/Al |
| Comparative Example 2 | HI | HT | CBP | Ir(PPy)₃ | BCP | ET1 | LiF/Al |

In Table 3, "HT" is N-([1,1'-biphenyl]-4-yl)-9,9-dimethyl-N-(4-(9-phenyl-9H-carbazole-3-yl)phenyl)-9H-fluorene-2-amine (these are the same in tables shown below). The chemical structures are shown below.

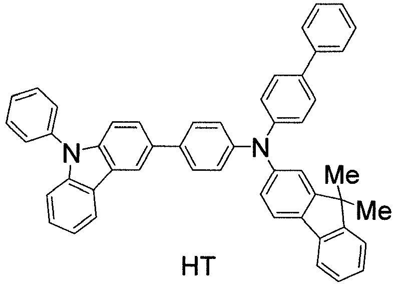

### <Example 5>

### <Element using compound (251) in host material of luminescent layer>

A glass substrate of 26 mm x 28 mm x 0.7 mm (manufactured by OPTO SCIENCE, INC.), which was obtained by grinding ITO formed into a film at a thickness of 180 nm to have a thickness of 150 nm by sputtering, was used as a transparent support substrate. This transparent support substrate was fixed on a substrate holder of a commercially available deposition apparatus (manufactured by Showa Shinku Co., Ltd.), and a molybdenum deposition boat containing HI, a molybdenum deposition boat containing HT, a molybdenum deposition boat containing the compound (251) of the present invention, a molybdenum deposition boat containing Ir(PPy)₃, a molybdenum deposition boat containing BCP, a molybdenum deposition boat containing ET1, a molybdenum deposition boat containing LiF and a tungsten deposition boat containing aluminum were attached thereto.

The following respective layers were successively formed on the ITO film of the transparent support substrate. The pressure in a vacuum bath was reduced to 5 x 10⁻⁴ Pa, the deposition boat containing HI was first heated to conduct deposition so as to give a film thickness of 30 nm to thereby form a hole injection layer, and the deposition boat containing HT was then heated to conduct deposition so as to give a film thickness of 20 nm to thereby form a hole transport layer. Subsequently, the deposition boat containing the compound (251) and the deposition boat containing Ir(PPy)₃ were simultaneously heated to conduct deposition so as to give a film thickness of 35 nm to thereby form a luminescent layer. The deposition velocity was controlled so that the weight ratio of compound (251) to Ir(PPy)₃ became approximately 95 to 5. Subsequently, the deposition boat containing BCP was heated to conduct deposition so as to give a film thickness of 5 nm to thereby form a hole inhibition layer. Subsequently, the deposition boat containing ET1 was heated to conduct deposition so as to give a film thickness of 15 nm to thereby form an electron transport layer. The above-mentioned deposition velocities were 0.01 to 1 nm/sec.

Thereafter, the deposition boat containing LiF was heated to conduct deposition so as to give a film thickness of 1 nm at a deposition velocity of 0.01 to 0.1 nm/sec. Subsequently, the deposition boat containing aluminum was heated to conduct deposition so as to give a film thickness of 100 nm at a deposition velocity of 0.01 to 2 nm/sec to thereby form a cathode and an organic EL element was obtained.

When a direct-current voltage was applied by using the ITO electrode as an anode and the LiF/aluminum electrode as a cathode, green light emission at a wavelength of 515 nm was obtained. In addition, a driving voltage for obtaining an initial luminance of 1000 cd/m² was 5.0 V and the current efficiency at that time was 33.7 cd/A.

### <Comparative Example 2>

An organic EL element was obtained by a process according to Example 5, except that the compound (251) that was the host material of the luminescent layer in Example 5 was changed to CBP. When a direct-current voltage was applied to the both electrodes, green light emission at a wavelength of 515 nm was obtained. In addition, a driving voltage for obtaining an initial luminance of 1000 cd/m² was 5.9 V and the current efficiency at that time was 31.8 cd/A.

The above-mentioned results are summarized in Table 4.

**[Table 4]**

| | Hole transport layer material | Host material | Driving voltage (V) | Current efficiency (cd/A) |
|---|---|---|---|---|
| Example 5 | HT | Compound (251) | 5.0 | 33.7 |
| Comparative Example 2 | HT | CBP | 5.9 | 31.8 |

Next, the electroluminescent elements according to Examples 6 to 14 and Comparative Examples 3 and 4 were prepared, the drive initial voltage (V) and the current efficiency (cd/A) when driven under a constant current at a current density at which a luminance of 1000 cd/m² is obtained were respectively measured. Hereinbelow, examples and comparative examples are specifically explained.

The material constitutions of the respective layers in the organic electroluminescent elements according to Examples 6 to 14 and Comparative Examples 3 and 4 are shown in the following Table 5.

**[Table 5]**

| | Hole injection layer (30nm) | Hole transport layer (10nm) | Luminescent layer (30nm) | | Hole inhibition layer (10nm) | Electron transport layer (20nm) | Cathode (1nm/100nm) |
|---|---|---|---|---|---|---|---|
| | | | Host | Dopant | | | |
| Example 6 | HI | HT | Compound (1) | Ir(PPy)₃ | HB1 | ET2 | LiF/Al |
| Example 7 | HI | HT | Compound (501) | Ir(PPy)₃ | HB1 | ET2 | LiF/Al |
| Example 8 | HI | HT | Compound (551) | Ir(PPy)₃ | HB1 | ET2 | LiF/Al |
| Example 9 | HI | HT | Compound (687) | Ir(PPy)₃ | HB1 | ET2 | LiF/Al |
| Comparative Example 3 | HI | HT | CBP | Ir(PPy)₃ | HB1 | ET2 | LiF/Al |
| Example 10 | HI | HT | CBP | Ir(PPy)₃ | Compound (301) | Compound (301) | LiF/Al |
| Example 11 | HI | HT | CBP | Ir(PPy)₃ | Compound (391) | Compound (391) | LiF/Al |
| Example 12 | HI | HT | CBP | Ir(PPy)₃ | Compound (392) | Compound (392) | LiF/Al |
| Example 13 | HI | HT | CBP | Ir(PPy)₃ | Compound (391) | ET2 | LiF/Al |
| Example 14 | HI | HT | CBP | Ir(PPy)₃ | Compound (392) | ET2 | LiF/Al |
| Comparative Example 4 | HI | HT | CBP | Ir(PPy)₃ | BCP | ET2 | LiF/Al |

In Table 5, "HB1" is 9-(4'-(dimesitylboryl)-[1,1'-binaphthalene]-4-yl)-9H-carbazole, and "ET2" is 5,5"-(2-phenylanthracene 9,10-diyl)di-2,2'-bipyridine (these are the same in tables shown below). The chemical structures are shown below.

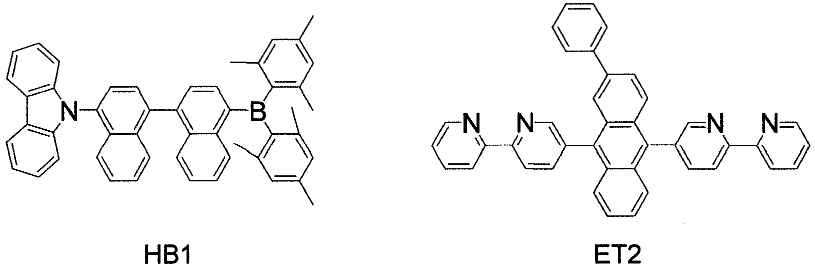

### <Example 6>

### <Element using compound (1) in host material of luminescent layer 2>

A glass substrate of 26 mm × 28 mm × 0.7 mm (manufactured by OPTO SCIENCE, INC.), which was obtained by grinding ITO formed into a film at a thickness of 180 nm to have a thickness of 150 nm by sputtering, was used as a transparent support substrate. This transparent support substrate was fixed on a substrate holder of a commercially available deposition apparatus (manufactured by Showa Shinku Co., Ltd.), and a molybdenum deposition boat containing HI, a molybdenum deposition boat containing HT, a molybdenum deposition boat containing the compound (1) of the present invention, a molybdenum deposition boat containing Ir(PPy)₃, a molybdenum deposition boat containing HB1, a molybdenum deposition boat containing ET2, a molybdenum deposition boat containing LiF and a tungsten deposition boat containing aluminum were attached thereto.

The following respective layers were successively formed on the ITO film of the transparent support substrate. The pressure in a vacuum bath was reduced to 5 x 10⁻⁴ Pa, the deposition boat containing HI was first heated to conduct deposition so as to give a film thickness of 30 nm to thereby form a hole injection layer, and the deposition boat containing HT was then heated to conduct deposition so as to give a film thickness of 10 nm to thereby form a hole transport layer. Subsequently, the deposition boat containing the compound (1) and the deposition boat containing Ir(PPy)₃ were simultaneously heated to conduct deposition so as to give a film thickness of 30 nm to thereby form a luminescent layer. The deposition velocity was controlled so that the weight ratio of compound (1) to Ir(PPy)₃ became approximately 95 to 5. Subsequently, the deposition boat containing HB1 was heated to conduct deposition so as to give a film thickness of 10 nm to thereby form a hole inhibition layer. Subsequently, the deposition boat containing ET2 was heated to conduct deposition so as to give a film thickness of 20 nm to thereby form an electron transport layer. The above-mentioned deposition velocities were 0.01 to 1 nm/sec.

Thereafter, the deposition boat containing LiF was heated to conduct deposition so as to give a film thickness of 1 nm at a deposition velocity of 0.01 to 0.1 nm/sec. Subsequently, the deposition boat containing aluminum was heated to conduct deposition so as to give a film thickness of 100 nm at a deposition velocity of 0.01 to 2 nm/sec to thereby form a cathode and an organic EL element was obtained.

When a direct-current voltage was applied by using the ITO electrode as an anode and the LiF/aluminum electrode as a cathode, green light emission at a wavelength of 515 nm was obtained. In addition, a driving voltage for obtaining an initial luminance of 1000 cd/m² was 5.2 V and the current efficiency at that time was 43.7 cd/A.

### <Example 7>

### <Element using compound (501) in host material of luminescent layer>

An organic EL element was obtained by a process according to Example 6, except that the compound (1) that was the host material of the luminescent layer in Example 6 was changed to the compound (501). When a direct-current voltage was applied to the both electrodes, green light emission at a wavelength of 515 nm was obtained. In addition, a driving voltage for obtaining an initial luminance of 1000 cd/m² was 6.2 V and the current efficiency at that time was 29.0 cd/A.

### <Example 8>

### <Element using compound (551) in host material of luminescent layer>

An organic EL element was obtained by a process according to Example 6, except that the compound (1) that was the host material of the luminescent layer in Example 6 was changed to the compound (551). When a direct-current voltage was applied to the both electrodes, green light emission at a wavelength of 515 nm was obtained. In addition, a driving voltage for obtaining an initial luminance of 1000 cd/m² was 4.8 V and the current efficiency at that time was 31.7 cd/A.

### <Example 9>

### <Element using compound (687) in host material of luminescent layer>

An organic EL element was obtained by a process according to Example 6, except that the compound (1) that was the host material of the luminescent layer in Example 6 was changed to the compound (687). When a direct-current voltage was applied to the both electrodes, green light emission at a wavelength of 515 nm was obtained. In addition, a driving voltage for obtaining an initial luminance of 1000 cd/m² was 4.0 V and the current efficiency at that time was 28.3 cd/A.

### <Comparative Example 3>

### <Element using CBP in host material of luminescent layer>

An organic EL element was obtained by a process according to Example 6, except that the compound (1) that was the host material of the luminescent layer in Example 6 was changed to CBP. When a direct-current voltage was applied to the both electrodes, green light emission at a wavelength of 515 nm was obtained. In addition, a driving voltage for obtaining an initial luminance of 1000 cd/m² was 5.4 V and the current efficiency at that time was 24.2 cd/A.

### <Example 10>

### <Element using compound (301) in hole inhibition layer doubled as electron transport layer (using in one layer)>

A glass substrate of 26 mm × 28 mm × 0.7 mm (manufactured by OPTO SCIENCE, INC.), which was obtained by grinding ITO formed into a film at a thickness of 180 nm to have a thickness of 150 nm by sputtering, was used as a transparent support substrate. This transparent support substrate was fixed on a substrate holder of a commercially available deposition apparatus (manufactured by Showa Shinku Co., Ltd.), and a molybdenum deposition boat containing HI, a molybdenum deposition boat containing HT, a molybdenum deposition boat containing CBP of the present invention, a molybdenum deposition boat containing Ir(PPy)₃, a molybdenum deposition boat containing the compound (301), a molybdenum deposition boat containing LiF and a tungsten deposition boat containing aluminum were attached thereto.

The following respective layers were successively formed on the ITO film of the transparent support substrate. The pressure in a vacuum bath was reduced to 5 x 10⁻⁴ Pa, the deposition boat containing HI was first heated to conduct deposition so as to give a film thickness of 30 nm to thereby form a hole injection layer, and the deposition boat containing HT was then heated to conduct deposition so as to give a film thickness of 10 nm to thereby form a hole transport layer. Subsequently, the deposition boat containing CBP and the deposition boat containing Ir(PP_{y})₃ were simultaneously heated to conduct deposition so as to give a film thickness of 30 nm to thereby form a luminescent layer. The deposition velocity was controlled so that the weight ratio of CBP to Ir(PPy)₃ became approximately 95 to 5. Subsequently, the deposition boat containing the compound (301) was heated to conduct deposition so as to give a film thickness of 30 nm to thereby form a hole inhibition layer doubled as an electron transport layer. The above-mentioned deposition velocities were 0.01 to 1 nm/sec.

Thereafter, the deposition boat containing LiF was heated to conduct deposition so as to give a film thickness of 1 nm at a deposition velocity of 0.01 to 0.1 nm/sec. Subsequently, the deposition boat containing aluminum was heated to conduct deposition so as to give a film thickness of 100 nm at a deposition velocity of 0.01 to 2 nm/sec to thereby form a cathode and an organic EL element was obtained.

When a direct-current voltage was applied by using the ITO electrode as an anode and the LiF/aluminum electrode as a cathode, green light emission at a wavelength of 515 nm was obtained. In addition, a driving voltage for obtaining an initial luminance of 1000 cd/m² was 5.6 V and the current efficiency at that time was 32.2 cd/A.

### <Example 11>

### <Element using compound (391) in hole inhibition layer doubled as electron transport layer (using in one layer)>

An organic EL element was obtained by a process according to Example 10, except that the compound (301) that was the hole inhibition layer doubled as the electron transport layer in Example 10 was changed to the compound (391). When a direct-current voltage was applied to the both electrodes, green light emission at a wavelength of 515 nm was obtained. In addition, a driving voltage for obtaining an initial luminance of 1000 cd/m² was 6.0 V and the current efficiency at that time was 28.0 cd/A.

### <Example 12>

### <Element using compound (392) in hole inhibition layer doubled as electron transport layer (using in one layer)>

An organic EL element was obtained by a process according to Example 10, except that the compound (301) that was the hole inhibition layer doubled as the electron transport layer in Example 10 was changed to the compound (392). When a direct-current voltage was applied to the both electrodes, green light emission at a wavelength of 515 nm was obtained. In addition, a driving voltage for obtaining an initial luminance of 1000 cd/m² was 6.2 V and the current efficiency at that time was 26.2 cd/A.

### <Example 13>

### <Element using compound (391) in hole inhibition layer>

A glass substrate of 26 mm × 28 mm × 0.7 mm (manufactured by OPTO SCIENCE, INC.), which was obtained by grinding ITO formed into a film at a thickness of 180 nm to have a thickness of 150 nm by sputtering, was used as a transparent support substrate. This transparent support substrate was fixed on a substrate holder of a commercially available deposition apparatus (manufactured by Showa Shinku Co., Ltd.), and a molybdenum deposition boat containing HI, a molybdenum deposition boat containing HT, a molybdenum deposition boat containing CBP of the present invention, a molybdenum deposition boat containing Ir(PPy)₃, a molybdenum deposition boat containing the compound (391), a molybdenum deposition boat containing ET2, a molybdenum deposition boat containing LiF and a tungsten deposition boat containing aluminum were attached thereto.

The following respective layers were successively formed on the ITO film of the transparent support substrate. The pressure in a vacuum bath was reduced to 5 x 10⁻⁴ Pa, the deposition boat containing HI was first heated to conduct deposition so as to give a film thickness of 30 nm to thereby form a hole injection layer, and the deposition boat containing HT was then heated to conduct deposition so as to give a film thickness of 10 nm to thereby form a hole transport layer. Subsequently, the deposition boat containing CBP and the deposition boat containing Ir(PPy)₃ were simultaneously heated to conduct deposition so as to give a film thickness of 30 nm to thereby form a luminescent layer. The deposition velocity was controlled so that the weight ratio of CBP to Ir(PPy)₃ became approximately 95 to 5. Subsequently, the deposition boat containing the compound (391) was heated to conduct deposition so as to give a film thickness of 10 nm to thereby form a hole inhibition layer. Subsequently, the deposition boat containing ET2 was heated to conduct deposition so as to give a film thickness of 20 nm to thereby form an electron transport layer. The above-mentioned deposition velocities were 0.01 to 1 nm/sec.

Thereafter, the deposition boat containing LiF was heated to conduct deposition so as to give a film thickness of 1 nm at a deposition velocity of 0.01 to 0.1 nm/sec. Subsequently, the deposition boat containing aluminum was heated to conduct deposition so as to give a film thickness of 100 nm at a deposition velocity of 0.01 to 2 nm/sec to thereby form a cathode and an organic EL element was obtained.

When a direct-current voltage was applied by using the ITO electrode as an anode and the LiF/aluminum electrode as a cathode, green light emission at a wavelength of 515 nm was obtained. In addition, a driving voltage for obtaining an initial luminance of 1000 cd/m² was 3.6 V and the current efficiency at that time was 28.0 cd/A.

### <Example 14>

### <Element using compound (392) in hole inhibition layer >

An organic EL element was obtained by a process according to Example 13, except that the compound (391) that was the hole inhibition layer in Example 13 was changed to the compound (392). When a direct-current voltage was applied to the both electrodes, green light emission at a wavelength of 515 nm was obtained. In addition, a driving voltage for obtaining an initial luminance of 1000 cd/m² was 4.9 V and the current efficiency at that time was 32.7 cd/A.

### <Comparative Example 4>

### <Element using BCP in hole inhibition layer>

An organic EL element was obtained by a process according to Example 13, except that the compound (391) that was the hole inhibition layer in Example 13 was changed to BCP. When a direct-current voltage was applied to the both electrodes, green light emission at a wavelength of 515 nm was obtained. In addition, a driving voltage for obtaining an initial luminance of 1000 cd/m² was 5.7 V and the current efficiency at that time was 28.7 cd/A.

The above-mentioned results are summarized in Tables 6 and 7.

**[Table 6]**

| | Hole transport layer material | Host material | Driving voltage (V) | Current efficiency (cd/A) |
|---|---|---|---|---|
| Example 6 | HT | Compound (1) | 5.2 | 43.7 |
| Example 7 | HT | Compound (501) | 6.2 | 29.0 |
| Example 8 | HT | Compound (551) | 4.8 | 31.7 |
| Example 9 | HT | Compound (687) | 4.0 | 28.3 |
| Comparative Example 3 | HT | CBP | 5.4 | 24.2 |

**[Table 7]**

| | Hole inhibition layer material | Electron transport layer material | Driving voltage (V) | Current efficiency (cd/A) |
|---|---|---|---|---|
| Example 10 | Compound (301) | Compound (301) | 5.6 | 32.2 |
| Example 11 | Compound (391) | Compound (391) | 6.0 | 28.0 |
| Example 12 | Compound (392) | Compound (392) | 6.2 | 26.2 |
| Example 13 | Compound (391) | ET2 | 3.6 | 28.0 |
| Example 14 | Compound (392) | ET2 | 4.9 | 32.7 |
| Comparative Example 4 | BCP | ET2 | 5.7 | 28.7 |

Furthermore, the electroluminescent elements according to Examples 15 to 29 and Comparative Example 5 were prepared, the drive initial voltage (V) and the current efficiency (cd/A) when driven under a constant current at a current density at which a luminance of 1000 cd/m² is obtained were respectively measured. Hereinbelow, examples and comparative examples are specifically explained.

The material constitutions of the respective layers in the organic electroluminescent elements according to Examples 15 to 29 and Comparative Example 5 are shown in the following Table 8.

**[Table 8]**

| | Hole injection layer (10nm) | Hole transport layer (30nm) | Luminescent layer (30nm) | | Electron transport layer (50nm) | Cathode (1nm/100nm) |
|---|---|---|---|---|---|---|
| | | | Host | Dopant | | |
| Example 15 | HAT-CN | TBB | Compound (1) | Ir(PPy)₃ | TPBi | LiF/Al |
| Example 16 | HAT-CN | TBB | Compound (66) | Ir(PPy)₃ | TPBi | LiF/Al |
| Example 17 | HAT-CN | TBB | Compound (84) | Ir(PPy)₃ | TPBi | LiF/Al |
| Example 18 | HAT-CN | TBB | Compound (86) | Ir(PPy)₃ | TPBi | LiF/Al |
| Example 19 | HAT-CN | TBB | Compound (197) | Ir(PPy)₃ | TPBi | LiF/Al |
| Example 20 | HAT-CN | TBB | Compound (51) | Ir(PPy)₃ | TPBi | LiF/Al |
| Example 21 | HAT-CN | TBB | Compound (214) | Ir(PPy)₃ | TPBi | LiF/Al |
| Example 22 | HAT-CN | TBB | Compound (26) | Ir(PPy)₃ | TPBi | LiF/Al |
| Example 23 | HAT-CN | TBB | Compound (210) | Ir(PPy)₃ | TPBi | LiF/Al |
| Example 24 | HAT-CN | TBB | Compound (212) | Ir(PPy)₃ | TPBi | LiF/Al |
| Example 25 | HAT-CN | TBB | Compound (215) | Ir(PPy)₃ | TPBi | LiF/Al |
| Example 26 | HAT-CN | TBB | Compound (48) | Ir(PPy)₃ | TPBi | LiF/Al |
| Example 27 | HAT-CN | Compound (209) | CBP | Ir(PPy)₃ | TPBi | LiF/Al |
| Example 28 | HAT-CN | TBB | CBP | Ir(PPy)₃ | Compound (366) | LiF/Al |
| Example 29 | HAT-CN | TBB | CBP | Ir(PPy)₃ | Compound (424) | LiF/Al |
| Comparative Example 5 | HAT-CN | TBB | CBP | Ir(PPy)₃ | TPBi | LiF/Al |

In Table 8, "HAT-CN" is 1,4,5,8,9,12-hexaazatriphenylenehexacarbonitrile, "TBB" is N⁴,N⁹,N^{4'},N^{4'}-tetra([1,1'-biphenyl]-4-yl)-[1,1'-biphenyl]-4,4'-diamine, and "TPBi" is 1,3,5-tris(1-phenyl-1H-benzo[d]imidazole-2-yl)benzene (these are the same in tables shown below). The chemical structures are shown below.

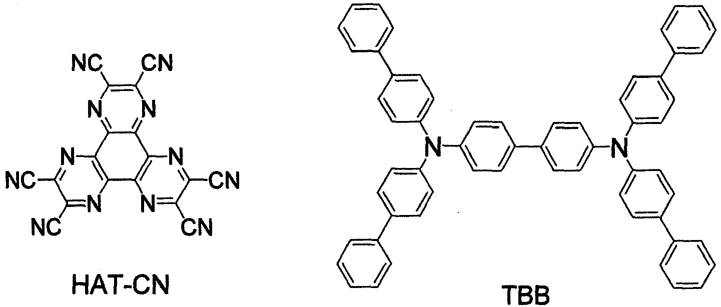

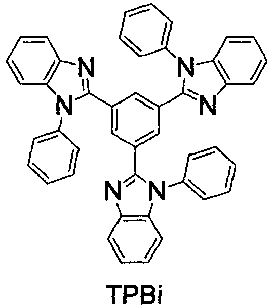

### <Example 15>

### <Element using compound (1) in host material of luminescent layer 3>

A glass substrate of 26 mm × 28 mm × 0.7 mm (manufactured by OPTO SCIENCE, INC.), which was obtained by grinding ITO formed into a film at a thickness of 180 nm to have a thickness of 150 nm by sputtering, was used as a transparent support substrate. This transparent support substrate was fixed on a substrate holder of a commercially available deposition apparatus (manufactured by Showa Shinku Co., Ltd.), and a molybdenum deposition boat containing HAT-CN, a molybdenum deposition boat containing TBB, a molybdenum deposition boat containing the compound (1) of the present invention, a molybdenum deposition boat containing Ir(PPy)₃, a molybdenum deposition boat containing TPBi, a molybdenum deposition boat containing LiF and a tungsten deposition boat containing aluminum were attached thereto.

The following respective layers were successively formed on the ITO film of the transparent support substrate. The pressure in a vacuum bath was reduced to 5 x 10⁻⁴ Pa, the deposition boat containing HAT-CN was first heated to conduct deposition so as to give a film thickness of 10 nm to thereby form a hole injection layer, and the deposition boat containing TBB was then heated to conduct deposition so as to give a film thickness of 30 nm to thereby form a hole transport layer. Subsequently, the deposition boat containing the compound (1) and the deposition boat containing Ir(PPy)₃ were simultaneously heated to conduct deposition so as to give a film thickness of 30 nm to thereby form a luminescent layer. The deposition velocity was controlled so that the weight ratio of the compound (1) to Ir(PPy)₃ became approximately 95 to 5. Subsequently, the deposition boat containing TPBi was heated to conduct deposition so as to give a film thickness of 50 nm to thereby form an electron transport layer. The above-mentioned deposition velocities were 0.01 to 1 nm/sec.

Thereafter, the deposition boat containing LiF was heated to conduct deposition so as to give a film thickness of 1 nm at a deposition velocity of 0.01 to 0.1 nm/sec. Subsequently, the deposition boat containing aluminum was heated to conduct deposition so as to give a film thickness of 100 nm at a deposition velocity of 0.01 to 2 nm/sec to thereby form a cathode and an organic EL element was obtained.

When a direct-current voltage was applied by using the ITO electrode as an anode and the LiF/aluminum electrode as a cathode, green light emission at a wavelength of 515 nm was obtained. In addition, a driving voltage for obtaining an initial luminance of 1000 cd/m² was 5.2 V and the current efficiency at that time was 28.9 cd/A.

### <Example 16>

### <Element using compound (66) in host material of luminescent layer>

An organic EL element was obtained by a process according to Example 15, except that the compound (1) that was the host material of the luminescent layer in Example 15 was changed to the compound (66). When a direct-current voltage was applied to the both electrodes, green light emission at a wavelength of 515 nm was obtained. In addition, a driving voltage for obtaining an initial luminance of 1000 cd/m² was 4.8 V and the current efficiency at that time was 37.0 cd/A.

### <Example 17>

### <Element using compound (84) in host material of luminescent layer>

An organic EL element was obtained by a process according to Example 15, except that the compound (1) that was the host material of the luminescent layer in Example 15 was changed to the compound (84). When a direct-current voltage was applied to the both electrodes, green light emission at a wavelength of 515 nm was obtained. In addition, a driving voltage for obtaining an initial luminance of 1000 cd/m² was 5.6 V and the current efficiency at that time was 35.9 cd/A.

### <Example 18>

### <Element using compound (86) in host material of luminescent layer>

An organic EL element was obtained by a process according to Example 15, except that the compound (1) that was the host material of the luminescent layer in Example 15 was changed to the compound (86). When a direct-current voltage was applied to the both electrodes, green light emission at a wavelength of 515 nm was obtained. In addition, a driving voltage for obtaining an initial luminance of 1000 cd/m² was 5.0 V and the current efficiency at that time was 29.0 cd/A.

### <Example 19>

### <Element using compound (197) in host material of luminescent layer>

An organic EL element was obtained by a process according to Example 15, except that the compound (1) that was the host material of the luminescent layer in Example 15 was changed to the compound (197). When a direct-current voltage was applied to the both electrodes, green light emission at a wavelength of 515 nm was obtained. In addition, a driving voltage for obtaining an initial luminance of 1000 cd/m² was 4.9 V and the current efficiency at that time was 32.4 cd/A.

### <Example 20>

### <Element using compound (51) in host material of luminescent layer>

An organic EL element was obtained by a process according to Example 15, except that the compound (1) that was the host material of the luminescent layer in Example 15 was changed to the compound (51). When a direct-current voltage was applied to the both electrodes, green light emission at a wavelength of 515 nm was obtained. In addition, a driving voltage for obtaining an initial luminance of 1000 cd/m² was 5.1 V and the current efficiency at that time was 39.2 cd/A.

### <Example 21>

### <Element using compound (214) in host material of luminescent layer>

An organic EL element was obtained by a process according to Example 15, except that the compound (1) that was the host material of the luminescent layer in Example 15 was changed to the compound (214). When a direct-current voltage was applied to the both electrodes, green light emission at a wavelength of 515 nm was obtained. In addition, a driving voltage for obtaining an initial luminance of 1000 cd/m² was 4.2 V and the current efficiency at that time was 35.2 cd/A.

### <Example 22>

### <Element using compound (26) in host material of luminescent layer>

An organic EL element was obtained by a process according to Example 15, except that the compound (1) that was the host material of the luminescent layer in Example 15 was changed to the compound (26). When a direct-current voltage was applied to the both electrodes, green light emission at a wavelength of 515 nm was obtained. In addition, a driving voltage for obtaining an initial luminance of 1000 cd/m² was 4.7 V and the current efficiency at that time was 42.2 cd/A.

### <Example 23>

### <Element using compound (210) in host material of luminescent layer>

An organic EL element was obtained by a process according to Example 15, except that the compound (1) that was the host material of the luminescent layer in Example 15 was changed to the compound (210). When a direct-current voltage was applied to the both electrodes, green light emission at a wavelength of 515 nm was obtained. In addition, a driving voltage for obtaining an initial luminance of 1000 cd/m² was 5.1 V and the current efficiency at that time was 32.7 cd/A.

### <Example 24>

### <Element using compound (212) in host material of luminescent layer>

An organic EL element was obtained by a process according to Example 15, except that the compound (1) that was the host material of the luminescent layer in Example 15 was changed to the compound (212). When a direct-current voltage was applied to the both electrodes, green light emission at a wavelength of 515 nm was obtained. In addition, a driving voltage for obtaining an initial luminance of 1000 cd/m² was 5.3 V and the current efficiency at that time was 27.0 cd/A.

### <Example 25>

### <Element using compound (215) in host material of luminescent layer>

An organic EL element was obtained by a process according to Example 15, except that the compound (1) that was the host material of the luminescent layer in Example 15 was changed to the compound (215). When a direct-current voltage was applied to the both electrodes, green light emission at a wavelength of 515 nm was obtained. In addition, a driving voltage for obtaining an initial luminance of 1000 cd/m² was 5.5 V and the current efficiency at that time was 27.7 cd/A.

### <Example 26>

### <Element using compound (48) in host material of luminescent layer>

An organic EL element was obtained by a process according to Example 15, except that the compound (1) that was the host material of the luminescent layer in Example 15 was changed to the compound (48). When a direct-current voltage was applied to the both electrodes, green light emission at a wavelength of 515 nm was obtained. In addition, a driving voltage for obtaining an initial luminance of 1000 cd/m² was 5.5 V and the current efficiency at that time was 29.2 cd/A.

### <Example 27>

### <Element using compound (209) in hole transport layer>

A glass substrate of 26 mm × 28 mm × 0.7 mm (manufactured by OPTO SCIENCE, INC.), which was obtained by grinding ITO formed into a film at a thickness of 180 nm to have a thickness of 150 nm by sputtering, was used as a transparent support substrate. This transparent support substrate was fixed on a substrate holder of a commercially available deposition apparatus (manufactured by Showa Shinku Co., Ltd.), and a molybdenum deposition boat containing HAT-CN, a molybdenum deposition boat containing the compound (209) of the present invention, a molybdenum deposition boat containing CBP, a molybdenum deposition boat containing Ir(PPy)₃, a molybdenum deposition boat containing TPBi, a molybdenum deposition boat containing LiF and a tungsten deposition boat containing aluminum were attached thereto.

The following respective layers were successively formed on the ITO film of the transparent support substrate. The pressure in a vacuum bath was reduced to 5 x 10⁻⁴ Pa, the deposition boat containing HAT-CN was first heated to conduct deposition so as to give a film thickness of 10 nm to thereby form a hole injection layer, and the deposition boat containing the compound (209) was then heated to conduct deposition so as to give a film thickness of 30 nm to thereby form a hole transport layer. Subsequently, the deposition boat containing CBP and the deposition boat containing Ir(PPy)₃ were simultaneously heated to conduct deposition so as to give a film thickness of 30 nm to thereby form a luminescent layer. The deposition velocity was controlled so that the weight ratio of CBP to Ir(PPy)₃ became approximately 95 to 5. Subsequently, the deposition boat containing TPBi was heated to conduct deposition so as to give a film thickness of 50 nm to thereby form an electron transport layer. The above-mentioned deposition velocities were 0.01 to 1 nm/sec.

Thereafter, the deposition boat containing LiF was heated to conduct deposition so as to give a film thickness of 1 nm at a deposition velocity of 0.01 to 0.1 nm/sec. Subsequently, the deposition boat containing aluminum was heated to conduct deposition so as to give a film thickness of 100 nm at a deposition velocity of 0.01 to 2 nm/sec to thereby form a cathode and an organic EL element was obtained.

When a direct-current voltage was applied by using the ITO electrode as an anode and the LiF/aluminum electrode as a cathode, green light emission at a wavelength of 515 nm was obtained. In addition, a driving voltage for obtaining an initial luminance of 1000 cd/m² was 6.8 V and the current efficiency at that time was 27.2 cd/A.

### <Example 28>

### <Element using compound (366) in electron transport layer>

A glass substrate of 26 mm × 28 mm × 0.7 mm (manufactured by OPTO SCIENCE, INC.), which was obtained by grinding ITO formed into a film at a thickness of 180 nm to have a thickness of 150 nm by sputtering, was used as a transparent support substrate. This transparent support substrate was fixed on a substrate holder of a commercially available deposition apparatus (manufactured by Showa Shinku Co., Ltd.), and a molybdenum deposition boat containing HAT-CN, a molybdenum deposition boat containing TBB, a molybdenum deposition boat containing CBP, a molybdenum deposition boat containing Ir(PPy)₃, a molybdenum deposition boat containing the compound (366) of the present invention, a molybdenum deposition boat containing LiF and a tungsten deposition boat containing aluminum were attached thereto.

The following respective layers were successively formed on the ITO film of the transparent support substrate. The pressure in a vacuum bath was reduced to 5 x 10⁻⁴ Pa, the deposition boat containing HAT-CN was first heated to conduct deposition so as to give a film thickness of 10 nm to thereby form a hole injection layer, and the deposition boat containing TBB was then heated to conduct deposition so as to give a film thickness of 30 nm to thereby form a hole transport layer. Subsequently, the deposition boat containing CBP and the deposition boat containing Ir(PPy)₃ were simultaneously heated to conduct deposition so as to give a film thickness of 30 nm to thereby form a luminescent layer. The deposition velocity was controlled so that the weight ratio of CBP to Ir(PPy)₃ became approximately 95 to 5. Subsequently, the deposition boat containing the compound (366) was heated to conduct deposition so as to give a film thickness of 50 nm to thereby form an electron transport layer. The above-mentioned deposition velocities were 0.01 to 1 nm/sec.

Thereafter, the deposition boat containing LiF was heated to conduct deposition so as to give a film thickness of 1 nm at a deposition velocity of 0.01 to 0.1 nm/sec. Subsequently, the deposition boat containing aluminum was heated to conduct deposition so as to give a film thickness of 100 nm at a deposition velocity of 0.01 to 2 nm/sec to thereby form a cathode and an organic EL element was obtained.

When a direct-current voltage was applied by using the ITO electrode as an anode and the LiF/aluminum electrode as a cathode, green light emission at a wavelength of 515 nm was obtained. In addition, a driving voltage for obtaining an initial luminance of 1000 cd/m² was 6.6 V and the current efficiency at that time was 26.1 cd/A.

### <Example 29>

### <Element using compound (424) in electron transport layer>

An organic EL element was obtained by a process according to Example 28, except that the compound (366) that was the electron transport layer material in Example 28 was changed to the compound (424). When a direct-current voltage was applied to the both electrodes, green light emission at a wavelength of 515 nm was obtained. In addition, a driving voltage for obtaining an initial luminance of 1000 cd/m² was 6.4 V and the current efficiency at that time was 27.5 cd/A.

### <Comparative Example 5>

An organic EL element was obtained by a process according to Example 28, except that the compound (366) that was the electron transport layer material in Example 28 was changed to TPBi. When a direct-current voltage was applied to the both electrodes, green light emission at a wavelength of 515 nm was obtained. In addition, a driving voltage for obtaining an initial luminance of 1000 cd/m² was 5.5 V and the current efficiency at that time was 27.1 cd/A.

The above-mentioned results are summarized in Table 9.

**[Table 9]**

| | Hole transport layer material | Host material | Electron transport layer material | Driving voltage (V) | Current efficiency (cd/A) |
|---|---|---|---|---|---|
| Example 15 | TBB | Compound (1) | TPBi | 5.2 | 28.9 |
| Example 16 | TBB | Compound (66) | TPBi | 4.8 | 37.0 |
| Example 17 | TBB | Compound (84) | TPBi | 5.6 | 35.9 |
| Example 18 | TBB | Compound (86) | TPBi | 5.0 | 29.0 |
| Example 19 | TBB | Compound (197) | TPBi | 4.9 | 32.4 |
| Example 20 | TBB | Compound (51) | TPBi | 5.1 | 39.2 |
| Example 21 | TBB | Compound (214) | TPBi | 4.2 | 35.2 |
| Example 22 | TBB | Compound (26) | TPBi | 4.7 | 42.2 |
| Example 23 | TBB | Compound (210) | TPBi | 5.1 | 32.7 |
| Example 24 | TBB | Compound (212) | TPBi | 5.3 | 27.0 |
| Example 25 | TBB | Compound (215) | TPBi | 5.5 | 27.7 |
| Example 26 | TBB | Compound (48) | TPBi | 5.5 | 29.2 |
| Example 27 | Compound (209) | CBP | TPBi | 6.8 | 27.2 |
| Example 28 | TBB | CBP | Compound (366) | 6.6 | 26.1 |
| Example 29 | TBB | CBP | Compound (424) | 6.4 | 27.5 |
| Comparative Example 5 | TBB | CBP | TPBi | 5.5 | 27.1 |

### <Measurement of carrier mobility>

### <Measurement of carrier mobility of compound represented by formula (1)>

A glass substrate (26mm × 28mm × 0.5mm, manufactured by Nippon Sheet Glass Co., Ltd.) was used as a transparent support substrate. This transparent support substrate was mounted in the substrate holder of a commercially available vapor deposition apparatus together with a metal mask to obtain a lower aluminum electrode of 2 mm width. Subsequently, a tungsten vapor deposition boat having aluminum thereon was set in the vapor deposition apparatus. The vacuum chamber was decompressed to 5 × 10⁻³ Pa or lower, and the vapor deposition boat was heated to form a translucent lower aluminum electrode in such a manner that its film thickness would become 10 nm. The vapor deposition rate was 0.05 to 1 nm/sec.

Subsequently, a metal mask for forming an organic layer that was designed to cover the lower aluminum electrode was mounted on the substrate holder and set in a vapor deposition apparatus together with a vapor deposition boat made of molybdenum that held the compound represented by the formula (1) therein. The vacuum chamber was decompressed to 5 × 10⁻³ Pa or lower and the vapor deposition boat was heated to deposit the compound represented by the formula (1). Here, the film thickness was 6 µm and the deposition rate was 0.1 to 10 nm/sec.

Subsequently, a metal mask for forming an upper aluminum electrode was mounted on the substrate holder and it was set in a vapor deposition apparatus together with a vapor deposition boat made of tungsten having aluminum thereon. The metal mask was designed so that the overlapping area having the organic layers of the upper and lower aluminum electrodes therebetween became 4 mm². The vacuum chamber was decompressed to 5 × 10⁻³ Pa or lower, and the vapor deposition boat was warmed to form an upper electrode having a film thickness of 50 nm. The deposition rate was 0.05 to 1 nm/sec.

The carrier mobility was measured using a time-of-flight method. The measurement was performed using a commercially available measurement apparatus, TOF-401 (manufactured by Sumitomo Heavy Industries Advanced Machinery Co., Ltd.). A nitrogen gas laser was used as the excitation light source. While applying an appropriate voltage across the upper and the lower aluminum electrodes, light was irradiated from the translucent lower aluminum electrode side, and the transient photocurrent was observed to obtain the mobility. The procedure for deriving the mobility based on analysis of the transient photocurrent waveform is disclosed in pp. 69-70 of "Organic electroluminescence materials and displays" (published by CMC Co., Ltd.).

The measurement results revealed that when an electric field strength of 0.5 MV/cm was applied, the compound represented by the formula (1) had an electron mobility of 2 × 10⁻³ (cm²/Vsec) and a hole mobility of 4 × 10⁻⁴ (cm²/Vsec).

### <Measurement of mobility in compound represented by formula (4)>

A sample was prepared in the same manner except that the compound represented by the formula (1) was changed to the compound represented by the formula (4) and the thickness of the organic layer deposited became 8.2 µm, and the mobility was observed in the same manner.

The measurement results revealed that when an electric field strength of 0.5 MV/cm was applied, the compound represented by the formula (4) had a hole mobility of 4.6 × 10⁻⁴ (cm²/Vsec).

### Industrial Applicability

According to the preferable embodiments of the present invention, an organic electroluminescent element having improved driving voltage and current efficiency, a display device equipped with the organic electroluminescent element and a lighting device equipped with the organic electroluminescent element, and the like can be provided.

### Reference Signs List

- 100: Organic electroluminescent element
- 101: Substrate
- 102: Anode
- 103: Hole injection layer
- 104: Hole transport layer
- 105: Luminescent layer
- 106: Electron transport layer
- 107: Electron injection layer
- 108: Cathode

## Claims

1. A material for organic electroluminescent element, containing a polycyclic aromatic compound having a partial structure represented by the following general formula (I) or a salt thereof: 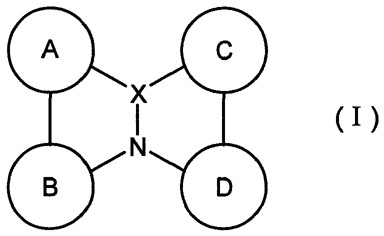 (in the formula (I),
X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
ring A, ring B, ring C and ring D are each independently an optionally substituted aromatic ring or an optionally substituted heteroaromatic ring, two adjacent rings may form a ring therebetween together with a connecting group or a single bond, and
the partial structure represented by the above described formula (I) has at least one hydrogen and at least one hydrogen in the partial structure may be substituted with deuterium.)

2. The material for organic electroluminescent element according to Claim 1, containing a polycyclic aromatic compound having a partial structure represented by the following general formula (II) or a salt thereof: 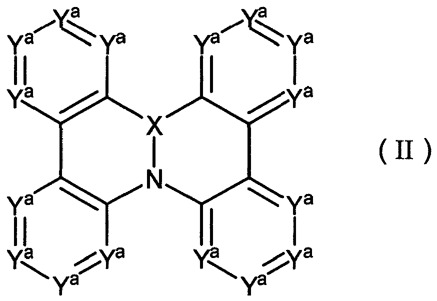 (in the formula (II),
X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
Y^{a}s each independently represent C or N; or two adjacent Y^{a}s on the same ring, together with a bond therebetween, may form N, O, S, or Se, rings may be each independently substituted or may form a cyclohexane ring, a benzene ring or a pyridine ring by connecting adjacent substituents in the same ring, or two adjacent rings may form a ring therebetween together with a connecting group or a single bond, and
the partial structure represented by the above described formula (II) has at least one hydrogen and at least one hydrogen in the partial structure may be substituted with deuterium.)

3. The material for organic electroluminescent element according to Claim 1, containing a polycyclic aromatic compound having a partial structure represented by the following general formula (III-1) or a salt thereof: 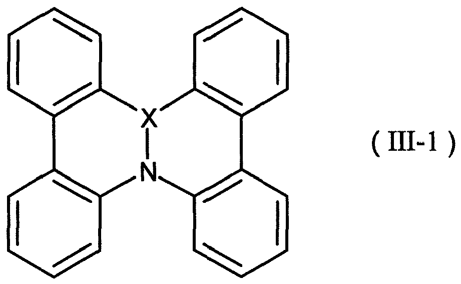 (in the formula (III-1),
X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
benzene ring in the formula may be each independently substituted or may form a cyclohexane ring, a benzene ring or a pyridine ring by connecting adjacent substituents in the same ring,
adjacent two benzene rings in the above formula may form a ring therebetween with a connecting group or a single bond, and
the partial structure represented by the above described formula (III-1) has at least one hydrogen and at least one hydrogen in the partial structure may be substituted with deuterium.)

4. The material for organic electroluminescent element according to Claim 1, containing a polycyclic aromatic compound having a partial structure represented by any of the following general formulae (III-11) to (III-13) and general formulae (III-33) to (III-36) or a salt thereof: 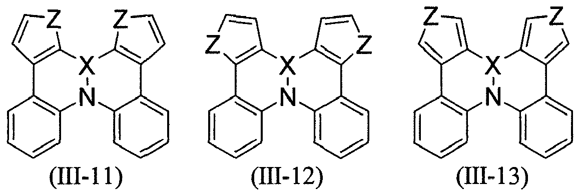 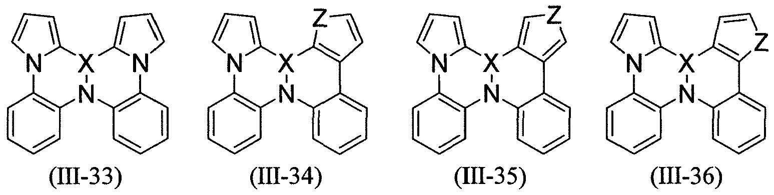 (in the above described each formula,
X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
Z represents N, O, S or Se,
a benzene ring and a five-membered ring in the above described each formula may be each independently substituted or may form a cyclohexane ring, a benzene ring or a pyridine ring by connecting adjacent substituents in the same ring,
adjacent two benzene rings in the above described each formula may form a ring therebetween with a connecting group or a single bond, and
the partial structure represented by the above described each formula has at least one hydrogen and at least one hydrogen in the partial structure may be substituted with deuterium.)

5. The material for organic electroluminescent element according to Claim 1, containing a polycyclic aromatic compound having a partial structure represented by any of the following general formula (III-33) and general formulae (III-55) to (III-57) or a salt thereof: 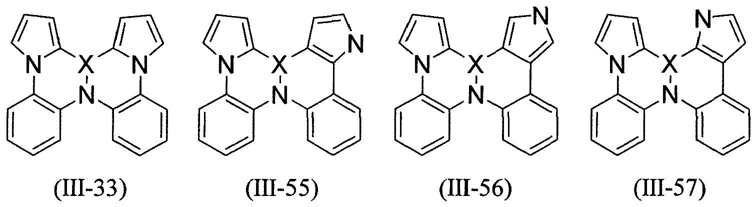 (in the above described each formula,
X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
a benzene ring and five-membered ring in the above described each formula may be each independently substituted or may form a cyclohexane ring, a benzene ring or a pyridine ring by connecting adjacent substituents in the same ring,
adjacent two benzene rings in the above described each formula may form a ring therebetween with a connecting group or a single bond, and
the partial structure represented by the above described each formula has at least one hydrogen and at least one hydrogen in the partial structure may be substituted with deuterium.)

6. The material for organic electroluminescent element according to Claim 1, containing a polycyclic aromatic compound having a partial structure represented by any of the following general formula (III-32) and general formulae (III-5) to (III-7) or a salt thereof: 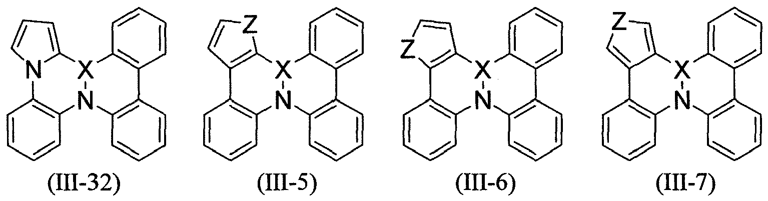 (in the above described each formula,
X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
Z represents N, O, S or Se,
a benzene ring and a five-membered ring in the above described each formula may be each independently substituted or may form a cyclohexane ring, a benzene ring or a pyridine ring by connecting adjacent substituents in the same ring,
adjacent two benzene rings in the above formula may form a ring therebetween with a connecting group or a single bond, and
the partial structure represented by the above described each formula has at least one hydrogen and at least one hydrogen in the partial structure may be substituted with deuterium.)

7. The material for organic electroluminescent element according to Claim 1, containing a polycyclic aromatic compound having a partial structure represented by any of the following general formula (III-32) and general formulae (III-58) to (III-60) or a salt thereof: 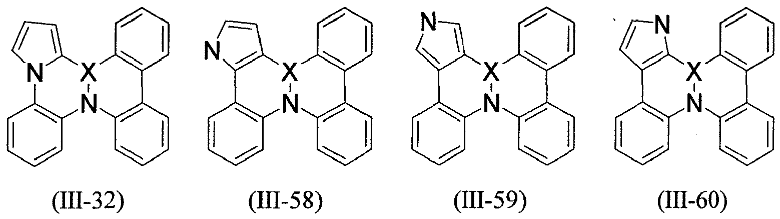 (in the above described each formula,
X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
a benzene ring and a five-membered ring in the above described each formula may be each independently substituted or may form a cyclohexane ring, a benzene ring or a pyridine ring by connecting adjacent substituents in the same ring,
adjacent two benzene rings in the above formula may form a ring therebetween with a connecting group or a single bond, and
the partial structure represented by the above described each formula has at least one hydrogen and at least one hydrogen in the partial structure may be substituted with deuterium.)

8. The material for organic electroluminescent element according to Claim 1, containing a polycyclic aromatic compound represented by the following general formula (V-1), general formula (V-3), general formula (V-5), general formula (V-15) or general formula (V-16) or a salt thereof: 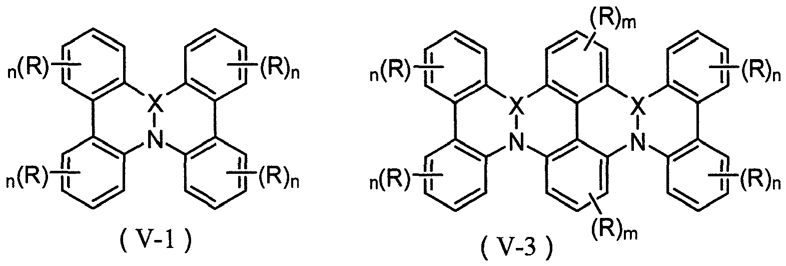 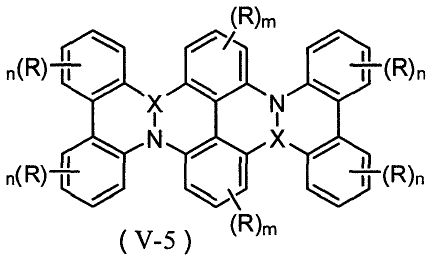 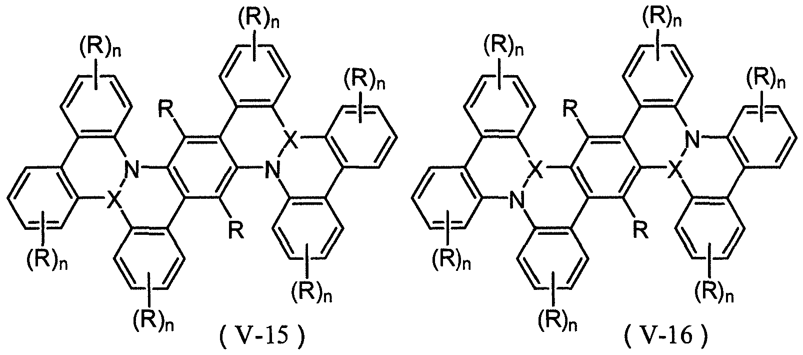 (in the above described each formula,
X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
R represents hydrogen, fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein, R^{a} each independently represents optionally substituted alkyl, optionally substituted aryl or optionally substituted heteroaryl),
adjacent two Rs in the same ring may be combined and form a cyclohexane ring, a benzene ring or a pyridine ring,
adjacent two benzene rings in the above described each formula may form a ring therebetween by connecting with a single bond, a bond with CH₂, CHR^{a}, C(R^{a})₂, NR^{a}, Si(R^{a})₂, BR^{a} (wherein R^{a} is as defined above), Se, S or O,
n represents an integer of 0 to 4, m represents an integer of 0 to 3, and
at least one hydrogen in the compound represented by the above described each formula or a salt thereof may be substituted with deuterium.)

9. The material for organic electroluminescent element according to Claim 1, containing a polycyclic aromatic compound represented by the following general formulae (V-27) to (V-30) or a salt thereof: 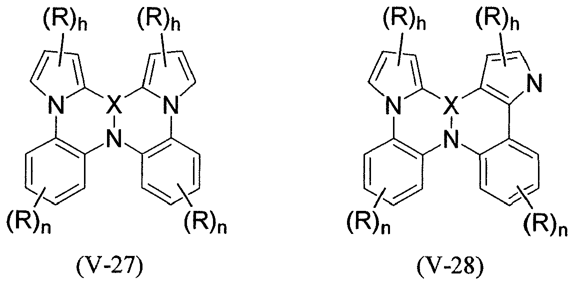 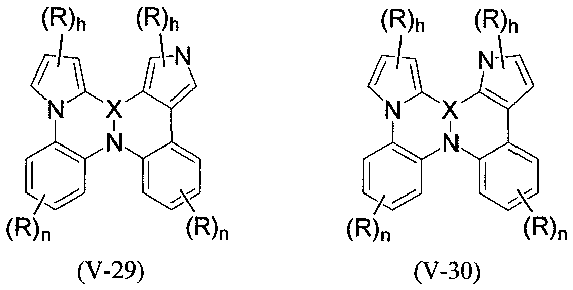 (in the above described each formula,
X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
R represents hydrogen, fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₃₋₂₀ alkylcarbonyl, cyano, nitro, diarylamino, optionally substituted aryl, optionally substituted heteroaryl, B(R^{a})₂ or Si(R^{a})₃ (wherein R^{a} each independently represents optionally substituted alkyl, optionally substituted aryl or optionally substituted heteroaryl),
adjacent two Rs in the same ring may be combined and form a cyclohexane ring, a benzene ring or a pyridine ring,
adjacent two benzene rings in the above described each formula may form a ring therebetween by connecting with a single bond, a bond with CH₂, CHR^{a}, C(R^{a})₂, NR^{a}, Si(R^{a})₂, BR^{a} (wherein R^{a} is as defined above), Se, S or O,
n represents an integer of 0 to 4, h represents an integer of 0 to 3, and
at least one hydrogen in the compound represented by the above described each formula or a salt thereof may be substituted with deuterium.)

10. The material for organic electroluminescent element according to Claim 1, containing a polycyclic aromatic compound represented by the following general formulae (V-31) to (V-34) or a salt thereof: 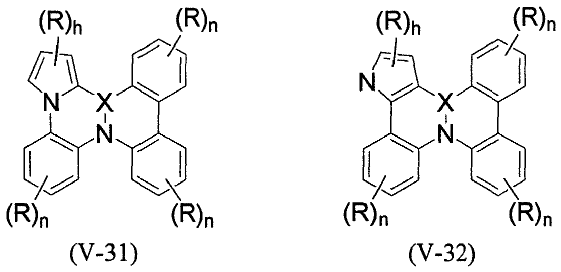 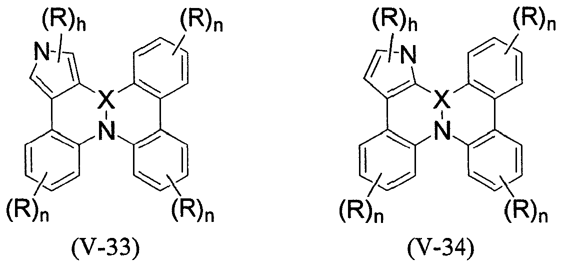 (in the above described each formula,
X represents B, P, P=O, P=S, P=Se, As, As=O, As=S, As=Se, Sb, Sb=O, Sb=S, Sb=Se, an optionally substituted metal element in groups 3 to 11 of the periodic table, or an optionally substituted metal element or metalloid element in group 13 or 14 of the periodic table,
R represents hydrogen, fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein, R^{a} each independently represents optionally substituted alkyl, optionally substituted aryl or optionally substituted heteroaryl),
adjacent two Rs in the same ring may be combined and form a cyclohexane ring, a benzene ring or a pyridine ring,
adjacent two benzene rings in each formula described above may form a ring therebetween by connecting with a single bond, a bond with CH₂, CHR^{a}, C(R^{a})₂, NR^{a}, Si(R^{a})₂, BR^{a} (wherein R^{a} is as defined above), Se, S or O,
n represents an integer of 0 to 4, h represents an integer of 0 to 3, and
at least one hydrogen in the compound represented by the above described each formula and a salt thereof may be substituted with deuterium.)

11. The material for organic electroluminescent element according to Claim 1, containing a polycyclic aromatic compound represented by the following general formulae (V-1') to (V-3') or a salt thereof: 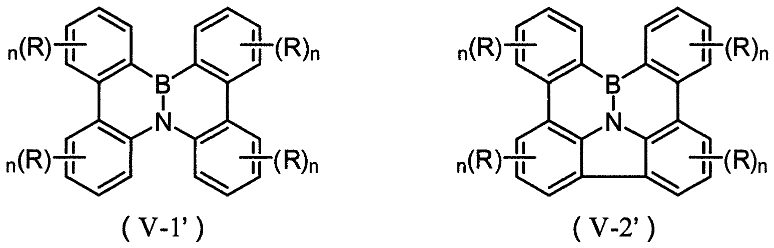 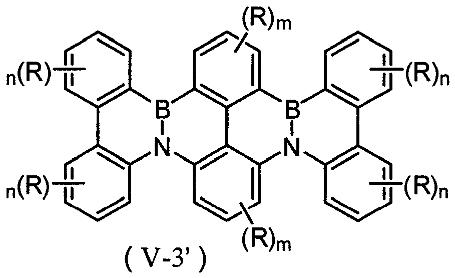 (in the above described each formula,
R represents fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein R^{a} each independently represents optionally substituted alkyl, optionally substituted aryl or optionally substituted heteroaryl),
adjacent two Rs in the same ring may be combined and form a cyclohexane ring, a benzene ring or a pyridine ring,
n represents an integer of 0 to 4, m represents an integer of 0 to 3, and
at least one hydrogen in the compound represented by the above described each formula and a salt thereof may be substituted with deuterium.)

12. The material for organic electroluminescent element according to Claim 1, containing a polycyclic aromatic compound represented by the following general formula (V-27') or a salt thereof: 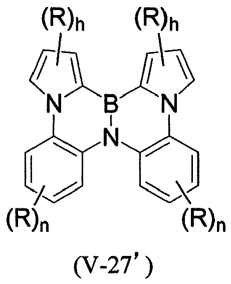 (in the above described formula,
R represents fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein R^{a} each independently represents optionally substituted alkyl, optionally substituted aryl or optionally substituted heteroaryl),
adjacent two Rs in the same ring may be combined and form a cyclohexane ring, a benzene ring or a pyridine ring,
n represents an integer of 0 to 4, h represents an integer of 0 to 3, and
at least one hydrogen in the compound represented by the above described formula and a salt thereof may be substituted with deuterium.)

13. The material for organic electroluminescent element according to Claim 1, containing a polycyclic aromatic compound represented by the following general formula (V-32') or a salt thereof: 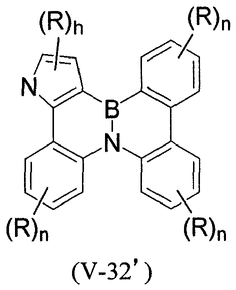 (in the above described formula,
R represents fluorine-substituted or nonsubstituted C₁₋₂₀ alkyl, C₃₋₈ cycloalkyl, C₂₋₂₀ alkenyl, mono- or diaryl substituted C₂₋₁₂ alkenyl, mono- or diheteroaryl substituted C₂₋₁₂ alkenyl, fluorine-substituted or nonsubstituted C₁₋₂₀ alkoxy, C₁₋₂₀ alkylcarbonyl, cyano, nitro, diarylamino, optionally substituted aryl, optionally substituted heteroaryl, B(R^{a})₂ or Si(R^{a})₃ (wherein R^{a} each independently represents optionally substituted alkyl, optionally substituted aryl or optionally substituted heteroaryl),
adjacent two Rs in the same ring may be combined and form a cyclohexane ring, a benzene ring or a pyridine ring,
n represents an integer of 0 to 4, h represents an integer of 0 to 3, and
at least one hydrogen in the compound represented by the above described formula and a salt thereof may be substituted with deuterium.)

14. The material for organic electroluminescent element according to Claim 1, containing a polycyclic aromatic compound represented by the following general formula (1), (66), (197), (198) or (251) or a salt thereof:

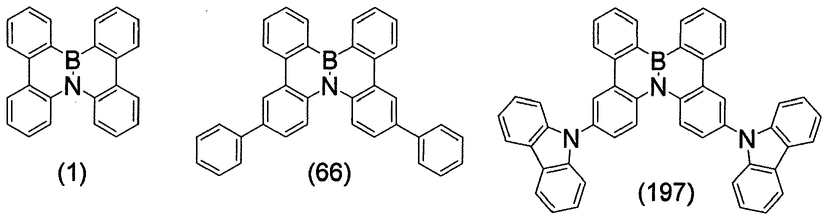

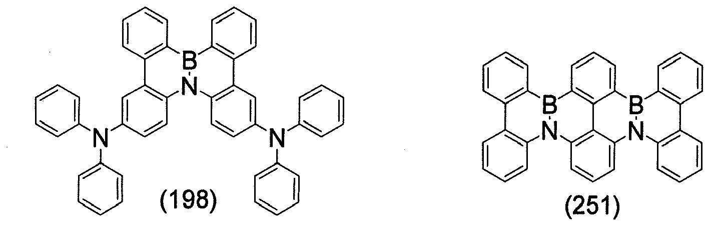

15. The material for organic electroluminescent element according to Claim 1, containing a polycyclic aromatic compound represented by the following general formula (301), (391), (392), (501), (551) or (687) or a salt thereof:

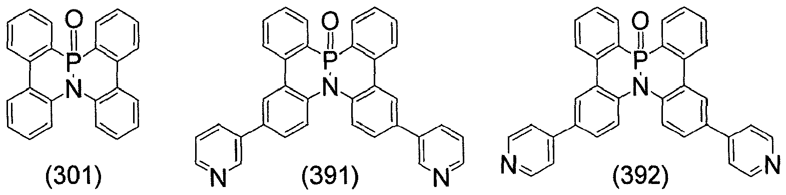

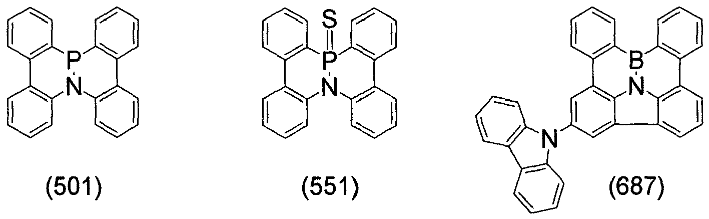

16. The material for organic electroluminescent element according to Claim 1, containing a polycyclic aromatic compound represented by the following general formula (26), (48), (51), (84), (86), (209), (210), (212), (214), (215), (366) or (424) or a salt thereof:

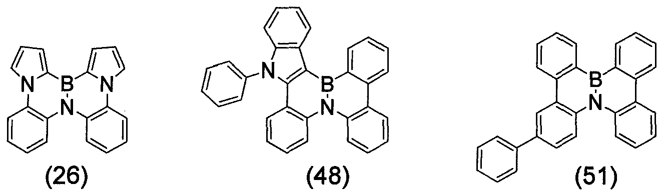

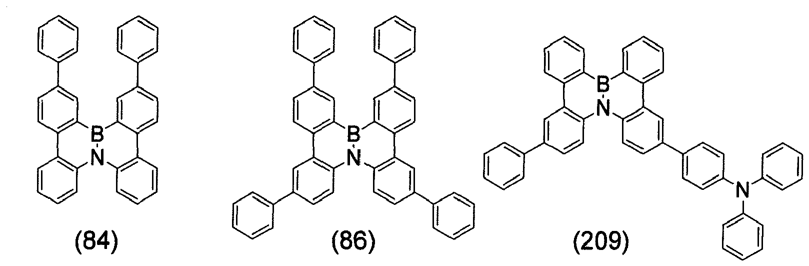

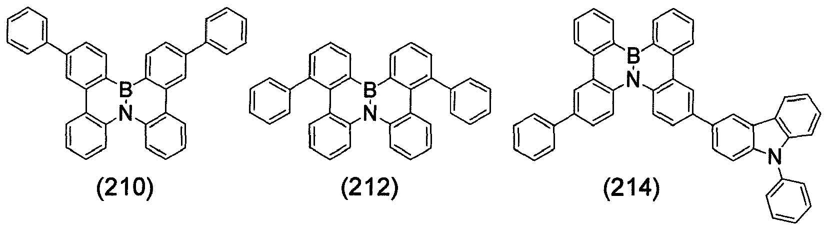

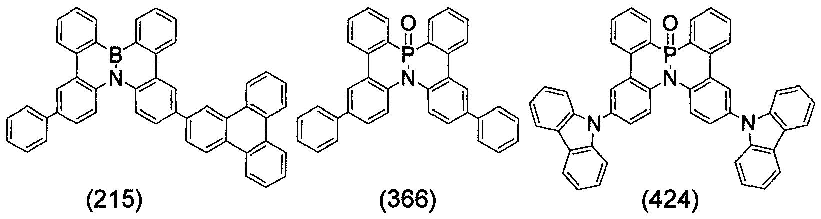

17. The material for organic electroluminescent element according to any of Claims 1 to 16, which is a material for a luminescent layer.

18. The material for organic electroluminescent element according to any of Claims 1 to 16, which is a material for a hole injection layer or a hole transport layer.

19. The material for organic electroluminescent element according to any of Claims 1 to 16, which is a material for a hole inhibition layer or an electron transport layer.

20. An organic electroluminescent element having a pair of electrodes constituted with the anode and the cathode and a luminescent layer that is disposed between a pair of the electrodes and contains the material for a luminescent layer according to Claim 17.

21. An organic electroluminescent element having a pair of electrodes constituted with the anode and the cathode, a luminescent layer that is disposed between a pair of the electrodes, and the hole injection layer and/or the hole transport layer that is disposed between the anode and the luminescent layer and contains the hole layer material according to Claim 18.

22. An organic electroluminescent element having a pair of electrodes constituted with the anode and the cathode, a luminescent layer that is disposed between a pair of the electrodes, and the hole inhibition layer and/or the electron transport layer that is disposed between the cathode and the luminescent layer and contains the material for the hole inhibition layer or the electron transport layer according to Claim 19.

23. The organic electroluminescent element according to Claim 20 or 21, further having an electron transport layer and/or an electron injection layer that is disposed between the cathode and the luminescent layer, wherein at least one of the electron transport layer and the electron injection layer contains at least one selected from the group consisting of a quinolinol metal complex, a pyridine derivative, a phenanthroline derivative, a borane derivative and a benzimidazole derivative.

24. The organic electroluminescent element according to Claim 22, wherein at least one of the hole inhibition layer and the electron transport layer contains at least one selected from the group consisting of a quinolinol metal complex, a pyridine derivative, a phenanthroline derivative, a borane derivative and a benzimidazole derivative.

25. The organic electroluminescent element according to Claim 23 or 24, wherein the hole inhibition layer, the electron transport layer and/or the electron injection layer further contains at least one selected from the group consisting of alkali metals, alkali earth metals, rare-earth metals, oxides of alkali metals, halides of alkali metals, oxides of alkali earth metals, halides of alkali earth metals, oxides of rare-earth metals, halides of rare-earth metals, organic complexes of alkali metals, organic complexes of alkali earth metals and organic complexes of rare-earth metals.

26. A display device, having the organic electroluminescent element according to any of Claims 20 to 25.

27. A lighting device, having the organic electroluminescent element according to any of Claims 20 to 25.
